# EUROPEAN PATENT APPLICATION

(11) **EP 3 904 363 A1**
(43) Date of publication of application: **03.11.2021**
(21) Application number: 21170475.4
(22) Date of filing: 26.04.2021
(51) Int. Cl.: C07F 15/00, C09K 11/06, H01L 51/00

(54) **ORGANOMETALLIC COMPOUND, ORGANIC LIGHT-EMITTING DEVICE INCLUDING THE SAME, AND ELECTRONIC APPARATUS INCLUDING THE ORGANIC LIGHT-EMITTING DEVICE**

(30) Priority: 29.04.2020 KR 20200052884
(71) Applicant: Samsung Electronics Co., Ltd., Gyeonggi-do 16677 (KR)
(72) Inventor: KWAK, Seungyeon, 16678 Gyeonggi-do (KR); KANG, Byungjoon, 16678 Gyeonggi-do (KR); LEE, Kum Hee, 16678 Gyeonggi-do (KR); LEE, Sunghun, 16678 Gyeonggi-do (KR); JEON, Aram, 16678 Gyeonggi-do (KR); CHOI, Byoungki, 16678 Gyeonggi-do (KR); CHOI, Hyeonho, 16678 Gyeonggi-do (KR); HWANG, Kyuyoung, 16678 Gyeonggi-do (KR)
(74) Representative: Elkington and Fife LLP

(57) **Abstract**

Provided are an organometallic compound, an organic light-emitting device including the same, and an electronic apparatus including the organic light-emitting device, the organometallic compound having a charge capture ability (CCA) of about 4.0 to about 10.5 and including a transition metal and a ligand(s) in the number of n linked to the transition metal, wherein n is an integer from 1 to 6, and the ligand(s) in the number of n includes at least one ligand linked to the transition metal through carbon, nitrogen, or a combination thereof, and the ligand(s) in the number of n does not include a ligand linked to the transition metal through two oxygens.

## Description

### FIELD OF THE INVENTION

One or more embodiments relate to an organometallic compound, an organic light-emitting device including the same, and an electronic apparatus including the organic light-emitting device.

### BACKGROUND OF THE INVENTION

Organic light-emitting devices are self-emission devices, which have improved characteristics in terms of viewing angles, response times, brightness, driving voltage, and response speed, and produce full-color images.

In an example, an organic light-emitting device includes an anode, a cathode, and an organic layer between the anode and the cathode, wherein the organic layer includes an emission layer. A hole transport region may be between the anode and the emission layer, and an electron transport region may be between the emission layer and the cathode. Holes provided from the anode may move toward the emission layer through the hole transport region, and electrons provided from the cathode may move toward the emission layer through the electron transport region. The holes and the electrons recombine in the emission layer to produce excitons. These excitons transit from an excited state to a ground state to thereby generate light.

### SUMMARY OF THE INVENTION

One or more embodiments include a novel organometallic compound, an organic light-emitting device including the same, and an electronic apparatus including the organic light-emitting device.

Additional aspects will be set forth in part in the description which follows and, in part, will be apparent from the description, or may be learned by practice of the presented embodiments of the disclosure.

According to one or more embodiments, an organometallic compound has
a charge capture ability (CCA) of about 4.0 to about 10.5, wherein
the CCA is represented by Equation 1,
wherein the organometallic compound includes a transition metal and a ligand(s) in the number of n linked to the transition metal, wherein
n is an integer from 1 to 6,
the ligand(s) in the number of n includes at least one ligand linked to the transition metal through carbon, nitrogen, or a combination thereof, and
the ligand(s) in the number of n does not include a ligand linked to the transition metal through two oxygens: $Charge Capture Ability \left(CCA\right) = 5 \times {10}^{- 9} \times DM \times PD ,$
wherein, in Equation 1,
DM indicates a dipole moment of the organometallic compound evaluated by a density functional theory (DFT) calculation based on Hartree atomic units, and
PD indicates a polarizability determinant of the organometallic compound evaluated by a DFT calculation based on Hartree atomic units.

According to one or more embodiments, an organic light-emitting device includes: a first electrode; a second electrode facing the first electrode; and an organic layer including an emission layer and at least one organometallic compound, wherein the organic layer is between the first electrode and the second electrode.

The organometallic compound may be included in the emission layer, and the organometallic compound included in the emission layer may act as a dopant.

According to one or more embodiments, an electronic apparatus includes the organic light-emitting device.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a schematic cross-sectional view of an organic light-emitting device according to an exemplary embodiment; and
FIG. 2 shows data of Tables 2 and 3 represented in contour plots, wherein the x-axis represents charge capture ability (CCA), the y-axis represents a dopant amount (mol%) per 100 mol% of an emission layer, and the z-axis represents a relative lifespan (%) of an organic light-emitting device shown in shades, the organic light-emitting device including an emission layer including a dopant with CCA of the corresponding x-axis at an amount (mol%) of the corresponding y-axis.

### DETAILED DESCRIPTION OF THE EMBODIMENTS

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

It will be understood that when an element is referred to as being "on" another element, it can be directly on the other element or intervening elements may be present therebetween. In contrast, when an element is referred to as being "directly on" another element, there are no intervening elements present.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

The terminology used herein is for the purpose of describing particular embodiments only and is not intended to be limiting. As used herein, "a," "an," "the," and "at least one" do not denote a limitation of quantity, and are intended to cover both the singular and plural, unless the context clearly indicates otherwise. For example, "an element" has the same meaning as "at least one element," unless the context clearly indicates otherwise.

"Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The exemplary term "lower," can therefore, encompasses both an orientation of "lower" and "upper," depending on the particular orientation of the figure. Similarly, if the device in one of the figures is turned over, elements described as "below" or "beneath" other elements would then be oriented "above" the other elements. The exemplary terms "below" or "beneath" can, therefore, encompass both an orientation of above and below.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10% or 5% of the stated value.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims. According to one or more embodiments, an organometallic compound has a charge capture ability (CCA) of about 4.0 to about 10.5.

For example, the organometallic compound may have a CCA of about 4.30 to about 10.25.

The CCA refers to charge-capturing characteristics of the organometallic compound, and may be represented by Equation 1: $Charge Capture Ability \left(CCA\right) = 5 \times {10}^{- 9} \times DM \times PD .$

In Equation 1, DM indicates a dipole moment of the organometallic compound evaluated by a density functional theory (DFT) calculation based on Hartree atomic units, and
PD indicates a polarizability determinant of the organometallic compound evaluated by a DFT calculation based on Hartree atomic units.

In one or more embodiments, the constant "5 x 10⁻⁹" introduced in Equation 1 is a constant introduced to control the number of digits of the CCA.

The Hartree atomic units are also referred to as atomic units (au, or a.u.), and are a system of natural units of measurement which is widely known in the fields of atomic physics and computational chemistry calculations. The Hartree atomic units are clearly distinguished from the Rydberg atomic units and atomic mass units, and are a unit system for focusing especially on the characteristics of electrons. In this regard, in the Hartree atomic units, all four fundamental physical constants including 1) electron mass, 2) elementary charge, 3) reduced Planck constant, and 4) inverse Coulomb constant are defined as "1". In Equation 1 calculated based on such Hartree atomic units, DM and PM do not have a measurement unit such as debye, and it would be easily recognized by those skilled in the art.

The DFT calculation may be performed by using various quantum mechanical calculation programs. For example, the quantum mechanical calculation programs include Gaussian, Games, Psi4, and the like.

In one or more embodiments, the DFT calculation may be performed by a Gaussian program, such as a Gaussian 09 program.

In one or more embodiments, when using the Gaussian program, the B3LYP/LanL2DZ function is used for a metal included in a compound to be measured for DM and PM and the B3LYP/6-31G(D,P) function is used for an organic ligand included in a compound to be measured for DM and PM, so as to optimize the molecular structure of the compound to be measured for DM and PM.

In one or more embodiments, a process of calculating DM of Equation 1 by using the Gaussian program may include: 1) a step of calculating a dipole moment in debye units represented by "Dipole moment (field-independent basis, debye): X, Y, Z, Tot" and 2) a step of applying the formula "1 debye = 0.3934 a.u." to the dipole moment in debye units and converting it into DM of Equation 1 based on the Hartree atomic units.

In one or more embodiments, a process of calculating PM of Equation 1 by using the Gaussian program may include: 1) a step of calculating polarizability represented by "Exact polarizability: αₓₓ, α_{xy}, α_{yy}, α_{xz}, α_{yz}, α_{zz}" and 2) a step of calculating PD according to Equation 1A for the polarizability and converting it into PM of Equation 1 based on the Hartree atomic units: $PD = det \left(\begin{matrix}{α}_{xx} & {α}_{xy} & {α}_{xz} \\ {α}_{xy} & {α}_{yy} & {α}_{yz} \\ {α}_{xz} & {α}_{yz} & {α}_{zz}\end{matrix}\right) = \left|\begin{matrix}{α}_{xx} & {α}_{xy} & {α}_{xz} \\ {α}_{xy} & {α}_{yy} & {α}_{yz} \\ {α}_{xz} & {α}_{yz} & {α}_{zz}\end{matrix}\right| .$

Although not intended to be limited by a specific theory, the organometallic compound included in an emission layer of an organic light-emitting device may have characteristics of capturing charges (holes and/or electrons) injected from a pair of electrodes.

In one or more embodiments, when an amount of captured charges of the organometallic compound included in an emission is too large, the charge transport in an emission layer is not smooth so that a recombination zone of holes and electrons may be formed too locally. As a result, triplet-triplet annihilation and/or triplet-polaron quenching may increase since the concentration of excitons in the recombination zone becomes too high, and in this regard, a lifespan of an organic light-emitting device may be reduced.

In one or more embodiments, when the amount of captured charges of the organometallic compound included in an emission layer is too small, the charge transport in an emission layer is active so that the recombination zone is formed too widely. As a result, charges that fail to be recombined may be accumulated at both interfaces of an emission layer, and in this regard, a lifespan of an organic light-emitting device may be reduced.

Thus, the inventors of the present disclosure discovered that a lifespan of an organic light-emitting device including the organometallic compound may be significantly improved by controlling the amount of captured charges of the organometallic compound, and that the control of the amount of captured charges of the organometallic compound related to a lifespan of an organic light-emitting device may be achieved by controlling a dipole moment (i.e., DM of Equation 1) and a polarizability determinant (i.e., PM of Equation 1) of the organometallic compound.

In detail, the dipole moment of the organometallic compound is regarded as a parameter related to a charge capture radius of the organometallic compound, and the polarizability determinant of the organometallic compound is regarded as a parameter related to an induced dipole moment generated by an electric field when driving an organic light-emitting device. Thus, both the dipole moment and the polarizability determinant should be considered to effectively control the charge capturing characteristics of the organometallic compound.

The organometallic compound may emit green light.

In one or more embodiments, the organometallic compound may emit light having a maximum emission wavelength from about 490 nm to about 550 nm.

For example, a maximum emission wavelength of a PL spectrum and/or an EL spectrum of the organometallic compound may be from about 490 nm to about 550 nm.

In one or more embodiments, the organometallic compound may include a transition metal and a ligand in the number of n linked to the transition metal.

For example, the transition metal may be a first-row transition metal, a second-row transition metal, or a third-row transition metal of the Periodic Table of Elements.

In one or more embodiments, the transition metal may be iridium (Ir), platinum (Pt), osmium (Os), titanium (Ti), zirconium (Zr), hafnium (Hf), europium (Eu), terbium (Tb), thulium (Tm), rhodium (Rh), or rhenium(Re).

In one or more embodiments, the organometallic compound may include one transition metal.

In one or more embodiments, n may be an integer from 1 to 6. In one or more embodiments, n may be 2 or 3.

The ligand(s) in the number of n may include at least one ligand linked to the transition metal through carbon, nitrogen, or a combination thereof, but may not include a ligand linked to the transition metal through two oxygens (e.g., a bidentate ligand linked to the transition metal through two oxygens).

In one or more embodiments, in the organometallic compound,
the transition metal may be Ir, Os, Rh, or Re,
n may be 3, and
each of the ligands in the number of n may be a bidentate ligand linked to the transition metal through carbon, nitrogen, or a combination thereof.

In one or more embodiments, the organometallic compound may be represented by Formula 1 or 2:

| | |
|---|---|
| Formula 1 | Formula 2 |
| M₁(L₁)ₙ₁(L₂)ₙ₂ | M₂(L₁)(L₁₁). |

In Formula 1, M₁ may be Ir, Os, Rh, or Re.

In Formula 1, n1 and n2 may each independently be 1 or 2, and the sum of n1 and n2 may be 3.

In Formula 2, M₂ may be Pt, Pd, or Ag.

In Formulae 1 and 2, L₁ and L₂ may each independently be a bidentate ligand linked to the transition metal through carbon, nitrogen or a combination thereof. In Formula 2, L₁₁ may be any bidentate ligand.

In Formula 1, i) L₁ and L₂ may be identical to each other; or ii) L₁ and L₂ may be different from each other.

In Formula 2, i) when n1 is 2, two L₁(s) may be identical to each other; ii) when n1 is 2, two L₁(s) may be different from each other; iii) when n2 is 2, two L₂(s) may be identical to each other; or iv) when n2 is 2, two L₂(s) may be different from each other.

In Formula 2, i) L₁ and L₁₁ may be identical to each other; or ii) L₁ and L₁₁ may be different from each other.

Two or more among L₁(s) in the number of n1 and L₂(s) in the number of n2 in Formula 1 may optionally be linked together through a first linking group to form a tetradentate ligand or a hexadentate ligand, and L₁ and L₁₁ in Formula 2 may optionally be linked together through a first linking group to form a tetradentate ligand. The first linking group may be understood by referring to the description of T₁ in Formula 3-1 below.

In one or more embodiments, the organometallic compound may be represented by Formula 1, and L₁ and L₂ in Formula 1 may be different from each other.

In one or more embodiments, L₁ in Formulae 1 and 2 may be a ligand represented by Formula 3-1, and L₂ in Formula 1 may be a ligand represented by Formula 3-2:

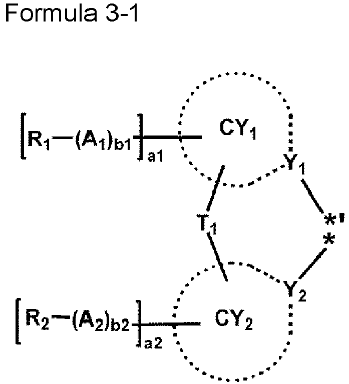

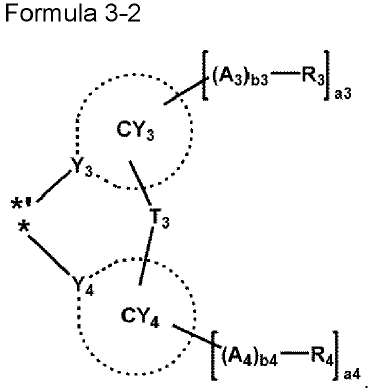

In Formulae 3-1 and 3-2, * and *' each indicate a binding site to M₁ in Formula 1 or M₂ in Formula 2.

In Formulae 3-1 and 3-2, Y₁ to Y₄ may each independently be N or C.

For example, in Formulae 3-1 and 3-2, Y₁ and Y₃ may each independently be N, and Y₂ and Y₄ may each independently be C.

A bond between Y₁ in Formula 3-1 and each of M₁ in Formula 1 and M₂ in Formula 2 may be a coordinate bond, a bond between Y₂ in Formula 3-1 and each of M₁ in Formula 1 and M₂ in Formula 2 may be a covalent bond, a bond between M₁ in Formula 1 and Y₃ in Formula 3-2 may be a coordinate bond, and a bond between M₁ in Formula 1 and Y₄ in Formula 3-2 may be a covalent bond. Thus, the organometallic compound represented by Formula 1 may be electrically neutral.

In Formulae 3-1 and 3-2, ring CY₁ to ring CY₄ may each independently be a C₅-C₃₀ carbocyclic group or a C₂-C₃₀ heterocyclic group.

For example, in Formulae 3-1 and 3-2, ring CY₁ to ring CY₄ may each independently be i) a first ring, ii) a second ring, iii) a condensed ring in which two or more first rings are condensed with each other, iv) a condensed ring in which two or more second rings are condensed with each other, or v) a condensed ring in which one or more first rings and one or more second rings are condensed with each other,
the first ring may be a cyclopentane group, a cyclopentadiene group, a furan group, a thiophene group, a pyrrole group, a silole group, a germole group, a borole group, a phosphole group, an oxazole group, an oxadiazole group, an oxatriazole group, a thiazole group, a thiadiazole group, a thiatriazole group, an isothiatriazole group, a pyrazole group, an imidazole group, a triazole group, a tetrazole group, an azasilole group, an azagermole group, an azaborole group, or an azaphosphole group, and
the second ring may be an adamantane group, a norbornane group, a norbornene group, a bicyclo[1.1.1]pentane group, a bicyclo[2.1.1]hexane group, a bicyclo[2.2.2]octane group, a cyclohexane group, a cyclohexene group, a benzene group, a pyridine group, a pyrimidine group, a pyrazine group, a pyridazine group, or a triazine group.

In one or more embodiments, ring CY₁ to CY₄ in Formulae 3-1 and 3-2 may each independently be a cyclopentene group, a cyclohexane group, a cyclohexene group, a benzene group, a naphthalene group, an anthracene group, a phenanthrene group, a triphenylene group, a pyrene group, a chrysene group, cyclopentadiene group, a 1,2,3,4-tetrahydronaphthalene group, a thiophene group, a furan group, an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluorene-9-one group, a dibenzothiophene 5,5-dioxide group, an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluorene-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, a 5,6,7,8-tetrahydroquinoline group, a 5,6,7,8-tetrahydroquinoline group, an adamantane group, a norbornane group, or a norbornene group.

In one or more embodiments, in Formulae 3-1 and 3-2, Y₁ and Y₃ may each be N, ring CY₁ and ring CY₃ may each independently be a group represented by one of Formulae CYN-1 to CYN-52, and in Formulae 3-1 and 3-2, Y₂ and Y₄ may each be C, and ring CY₂ and ring CY₄ may each independently be a group represented by one of Formulae CYC-1 to CYC-65:

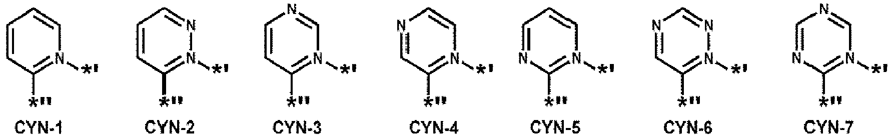

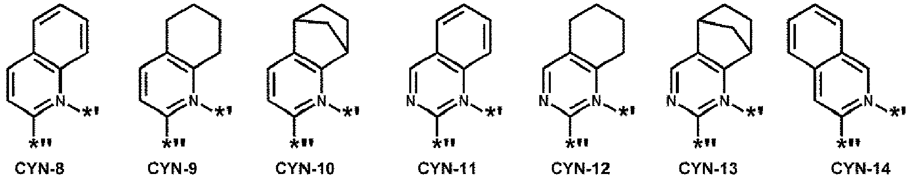

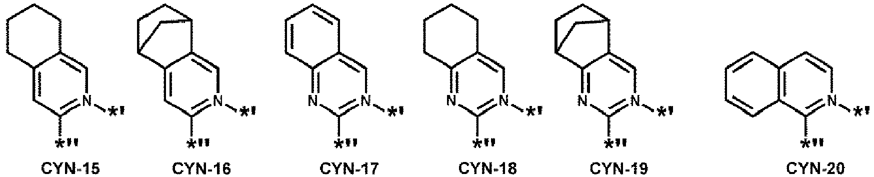

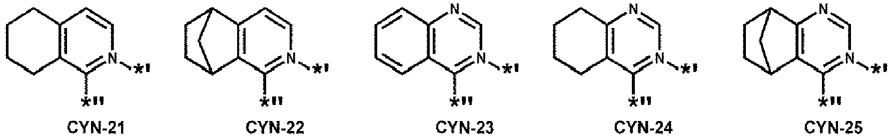

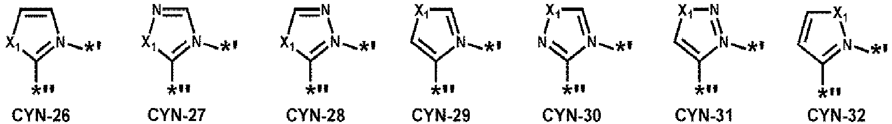

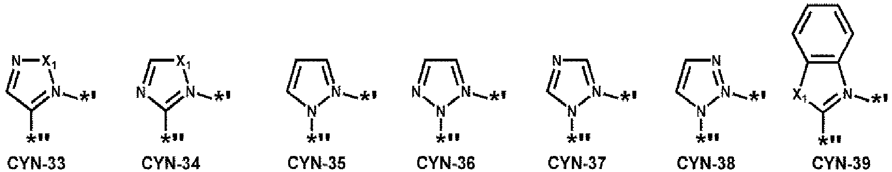

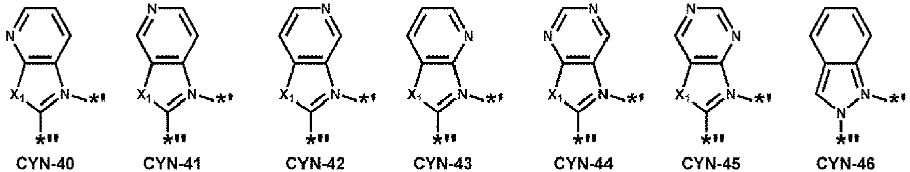

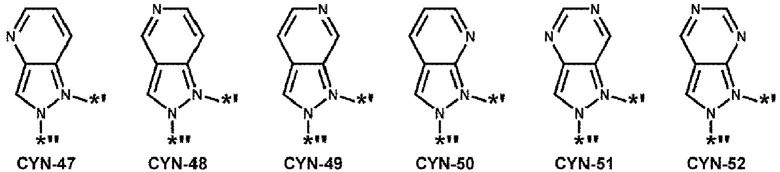

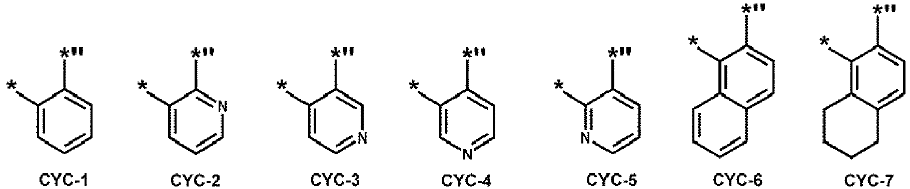

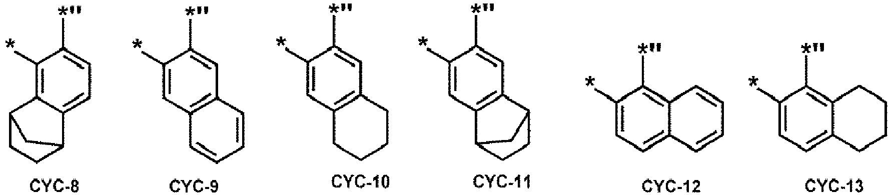

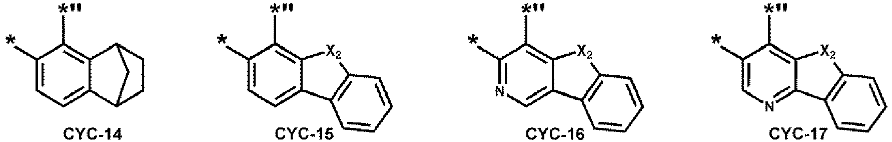

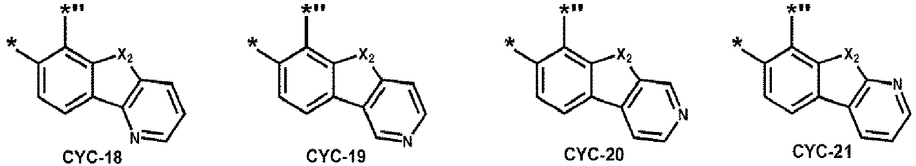

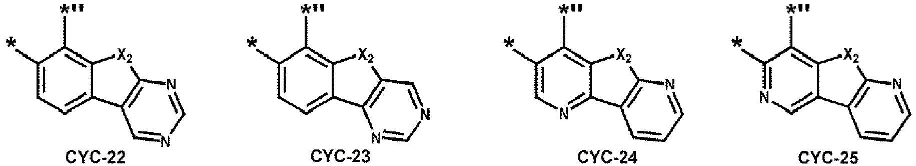

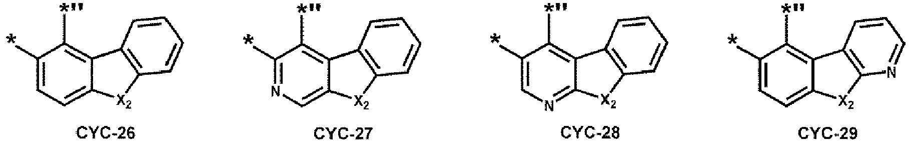

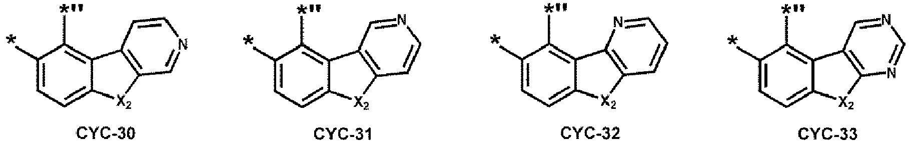

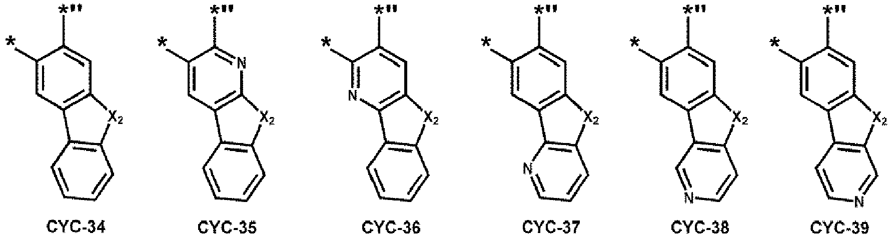

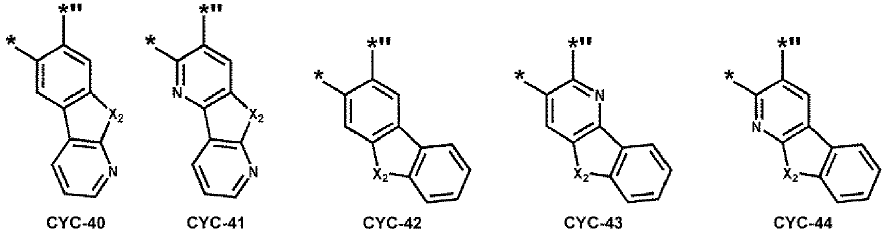

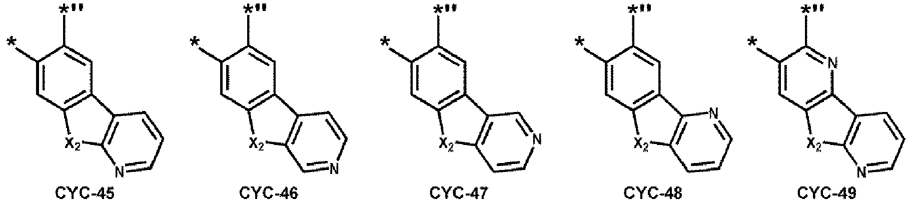

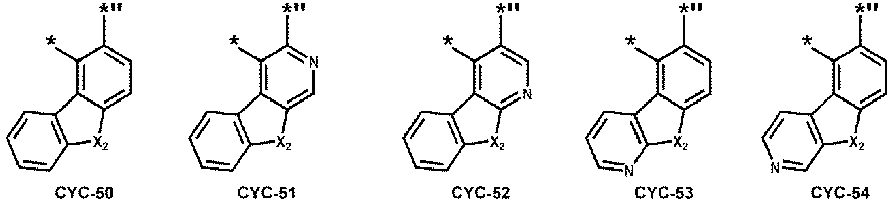

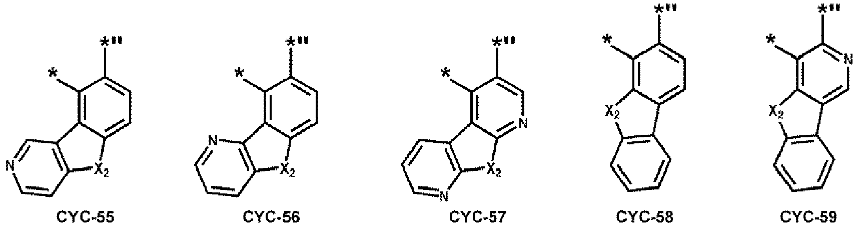

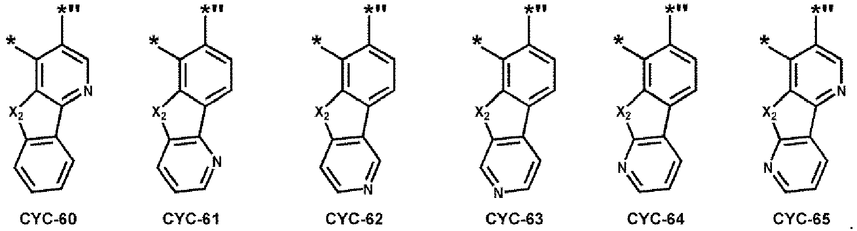

In Formulae CYN-1 to CYN-52, X₁ may be O, S, N, C, or Si (for example, O, S, N(R₁₉), C(R₁₉)(R₂₀), or Si(R₁₉)(R₂₀)), *' indicates a binding site to M₁ in Formula 1 or M₂ in Formula 2, and *" indicates a binding site to T₁ or T₃ in Formulae 3-1 and 3-2, and
in Formulae CYC-1 to CYC-65, X₂ may be O, S, N, C, or Si (for example, O, S, N(R₁₉), C(R₁₉)(R₂₀), or Si(R₁₉)(R₂₀)), * indicates a binding site to M₁ in Formula 1 or M₂ in Formula 2, and *" indicates a binding site to T₁ or T₃ in Formulae 3-1 and 3-2. It may be understood by those of ordinary skill in the art by referring Formulae 3-1 and 3-2 that at least one of N, C and Si, which are each independently a ring-forming atom in Formulae CYN-1 to CYN-52 and CYC-1 to CYC-65, may be optionally bound to a group represented by *-(A₁)_{b1}-R₁, a group represented by *-(A₂)_{b2}-R₂, a group represented by *-(A₃)_{b3}-R₃, and/or a group represented by *-(A₄)_{b4}-R₄.

In one or more embodiments,
ring CY₁ in Formula 3-1 may be a pyridine group or a pyrimidine group, and/or
ring CY₂ in Formula 3-1 may be a benzene group, a dibenzofuran group, a dibenzothiophene group, a carbazole group, a fluorene group, or a dibenzosilole group, and/or
ring CY₃ in Formula 3-2 may be a benzimidazole group, a pyridoimidazole group, a pyridine group, or a pyrimidine group, and/or
ring CY₄ in Formula 3-2 may be a dibenzofuran group, a dibenzothiophene group, a carbazole group, a fluorene group, a dibenzosilole group, an azadibenzofuran group, an azadibenzothiophene group, an azacarbazole group, an azafluorene group, or an azadibenzosilole group.

T₁ and T₃ in Formulae 3-1 and 3-2 may each independently be a single bond, a double bond, *-N(R₇)-*', *-B(R₇)-*', *-P(R₇)-*', *-C(R₇)(R₈)-*', *-Si(R₇)(R₈)-*', *-Ge(R₇)(R₈)-*', *-S-*', *-Se-*', *-O-*', *-C(=O)-*', *-S(=O)-*', *-S(=O)₂-*', *-C(R₇)=*', *=C(R₇)-*', *-C(R₇)=C(R₈)-*', *-C(=S)-*', or *-C=C-*'. Here, * and *' each indicate a binding site to a neighboring atom.

For example, T₁ and T₃ in Formulae 3-1 and 3-2 may each independently be a single bond.

In Formulae 3-1 and 3-2, A₁ to A₄ may each independently be a single bond, a C₅-C₃₀ carbocyclic group unsubstituted or substituted with at least one R₁₀ₐ, or a C₂-C₃₀ heterocyclic group unsubstituted or substituted with at least one R₁₀ₐ.

For example, A₁ to A₄ in Formulae 3-1 and 3-2 may each independently be:
a single bond; or
a cyclopentene group, a cyclohexane group, a cyclohexene group, a benzene group, a naphthalene group, an anthracene group, a phenanthrene group, a triphenylene group, a pyrene group, a chrysene group, a cyclopentadiene group, a 1,2,3,4-tetrahydronaphthalene group, a thiophene group, a furan group, an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, fluorene group, a dibenzosilole group, a dibenzogermole group, a dibenzothiophene group, a dibenzoselenophene group, a dibenzofuran group, a dibenzothiophene 5-oxide group, a 9H-fluorene-9-one group, a dibenzothiophene 5,5-dioxide group, an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluorene-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isooxazole group, a thiazole group, an isothiazole group, an oxadiazole group, a thiadiazole group, a benzopyrazole group, a benzoimidazole group, a benzoxazole group, a benzothiazole group, a benzoxadiazole group, a benzothiadiazole group, a 5,6,7,8-tetrahydroisoquinoline group, a 5,6,7,8-tetrahydroquinoline group, an adamantane group, a norbornane group, or a norbornene group, each unsubstituted or substituted with at least one R₁₀ₐ.

In Formulae 3-1 and 3-2, b1 to b4 may indicate the numbers of A₁ to A₄, respectively, and may each independently be an integer from 1 to 10 (for example, 1, 2, or 3). When b1 is 2 or more, two or more of A₁(s) may be identical to or different from each other, when b2 is 2 or more, two or more of A₂(s) may be identical to or different from each other, when b3 is 2 or more, two or more of A₃(s) may be identical to or different from each other, and when b4 is 2 or more, two or more of A₄(s) may be identical to or different from each other.

In Formulae 3-1 and 3-2, R₁ to R₄, R₇, and R₈ may each independently be hydrogen, deuterium, -F, -CI, -Br, -I, -SF₅, a hydroxyl group, a cyano group, a nitro group, an amino group, an amidino group, a hydrazine group, a hydrazone group, a carboxylic acid or a salt thereof, a sulfonic acid or a salt thereof, a phosphoric acid or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -Ge(Q₃)(Q₄)(Q₅), -B(Q₆)(Q₇), -P(=O)(Q₈)(Q₉), or -P(Q₈)(Q₉). Q₁ to Q₉ are the same as described in the present specification.

For example, R₁ to R₄, R₇, R₈, R₁₉, and R₂₀ may each independently be:
hydrogen, deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, -SF₅, a C₁-C₂₀ alkyl group, or a C₁-C₂₀ alkoxy group;
a C₁-C₂₀ alkyl group or a C₁-C₂₀ alkoxy group, substituted with deuterium, -F, -CI, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid or a salt thereof, a sulfonic acid or a salt thereof, a phosphoric acid or a salt thereof, a C₁-C₁₀ alkyl group, a cyclopentyl group, a cyclohexyl group, a cycloheptyl group, a cycloctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cycloctyl group, a (C₁-C₂₀ alkyl)adamantanyl group, a (C₁-C₂₀ alkyl)norbornanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.2]octyl group, a phenyl group, a (C₁-C₂₀ alkyl)phenyl group, a biphenyl group, a terphenyl group, a naphthyl group, a pyridinyl group, a pyrimidinyl group, or any combination thereof;
a cyclopentyl group, a cyclohexyl group, a cycloheptyl group, a cycloctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a phenyl group, a (C₁-C₂₀ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group or azadibenzothiophenyl group, each unsubstituted or substituted with deuterium, - F, -CI, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid or a salt thereof, a sulfonic acid or a salt thereof, a phosphoric acid or a salt thereof, a C₁-C₂₀ alkyl group, a C₁-C₂₀ alkoxy group, a cyclopentyl group, a cyclohexyl group, a cycloheptyl group, a cycloctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cycloctyl group, a (C₁-C₂₀ alkyl)adamantanyl group, a (C₁-C₂₀ alkyl)norbornanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.2]octyl group, a phenyl group, a (C₁-C₂₀ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, or any combination thereof; or
-N(Q₁)(Q₂), -Si(Q₃)(Q₄)(Q₅), -Ge(Q₃)(Q₄)(Q₅), -B(Q₆)(Q₇), -P(=O)(Q₈)(Q₉), or -P(Q₈)(Q₉), and
Q₁ to Q₉ may each independently be:
-CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, or -CD₂CDH₂; or
an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with deuterium, a C₁-C₁₀ alkyl group, a phenyl group, or any combination thereof.

In one or more embodiments, R₁ to R₄, R₇, and R₈ in Formulae 3-1 and 3-2 may each independently be hydrogen, deuterium, -F, cyano group, nitro group, -SF₅, -CH₃, - CD₃, -CD₂H, -CDH₂, -CF₃, -CF₂H, -CFH₂, a group represented by one of Formulae 9-1 to 9-39, a group in which at least one hydrogen in Formulae 9-1 to 9-39 is substituted with deuterium, a group represented by one of Formulae 9-201 to 9-237, a group in which at least one hydrogen in Formulae 9-201 to 9-237 is substituted with deuterium, a group represented by one of Formulae 10-1 to 10-129, a group in which at least one hydrogen in Formulae 10-1 to 10-129 is substituted with deuterium, a group represented by one of Formulae 10-201 to 10-350, a group in which at least one hydrogen in Formulae 10-201 to 10-350 is substituted with deuterium, -Si(Q₃)(Q₄)(Q₅), or -Ge(Q₃)(Q₄)(Q₅) (wherein Q₃ to Q₅ may be the same as described in the present specification):

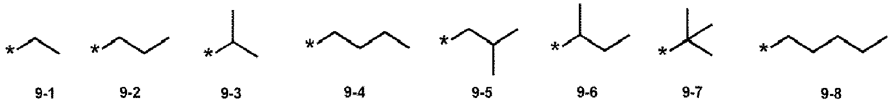

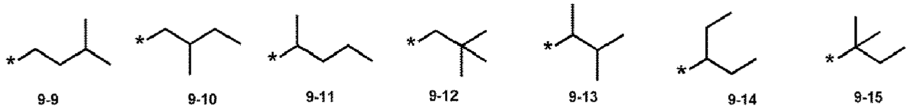

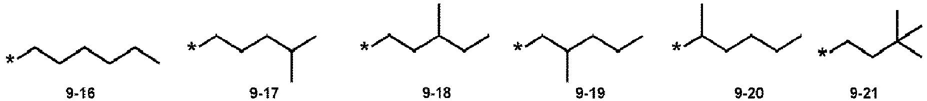

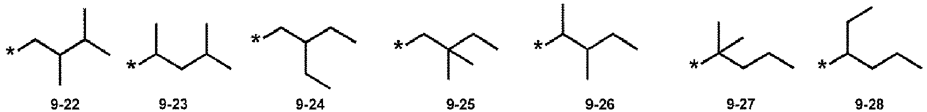

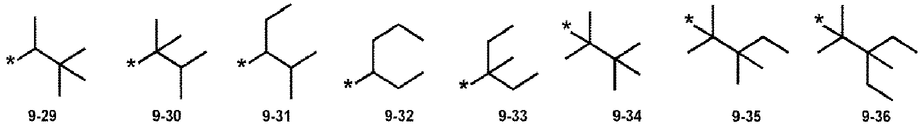

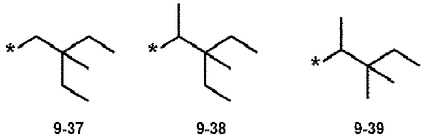

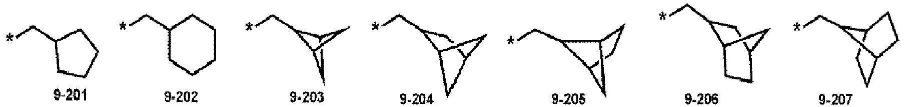

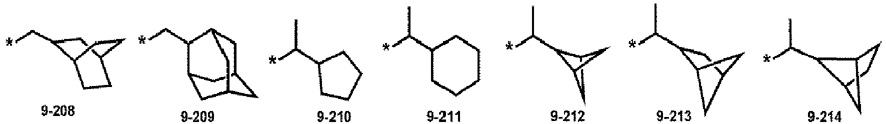

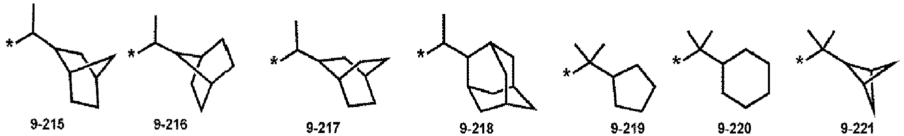

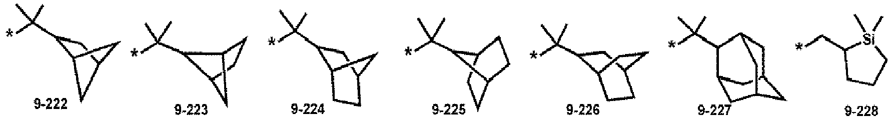

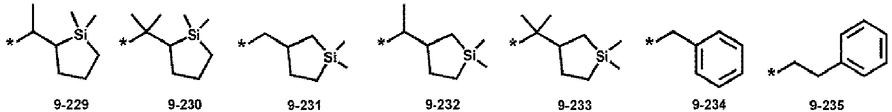

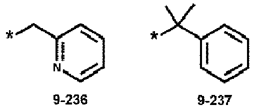

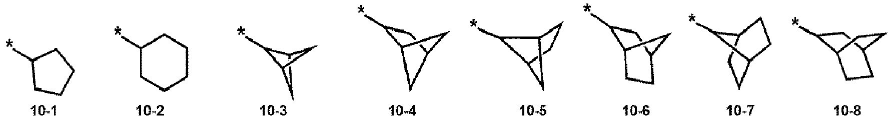

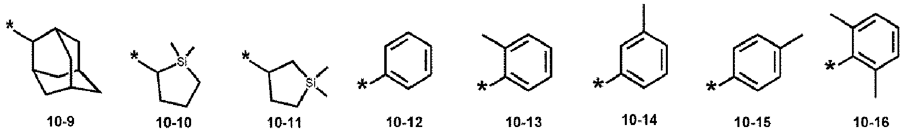

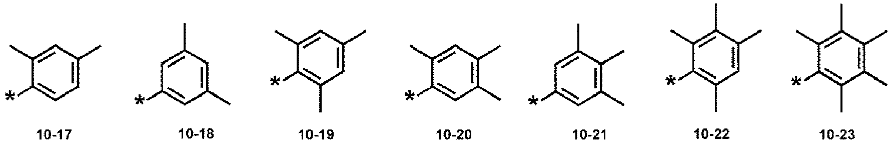

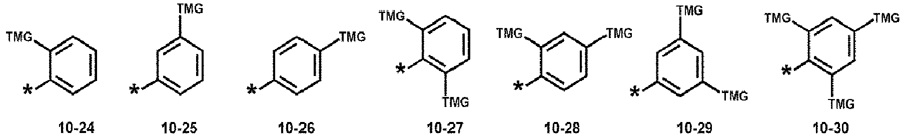

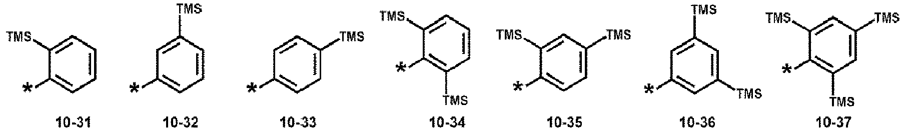

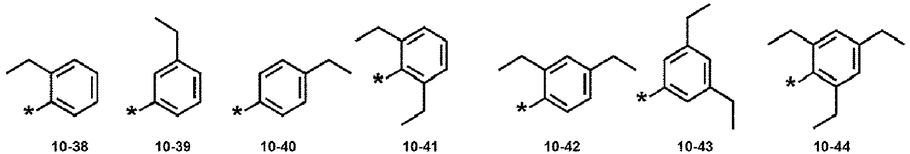

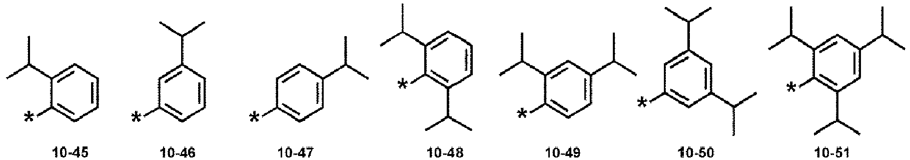

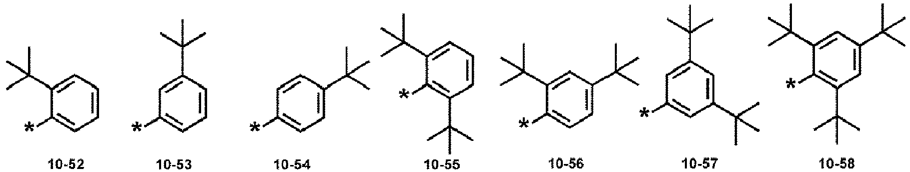

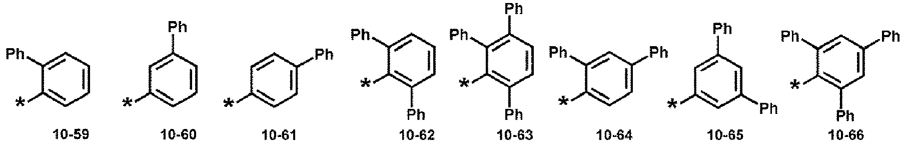

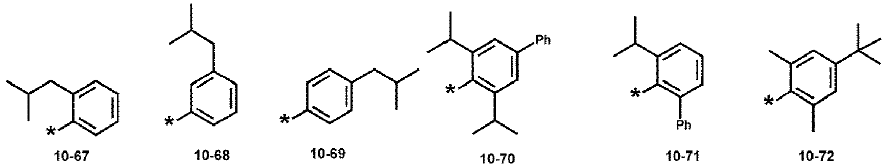

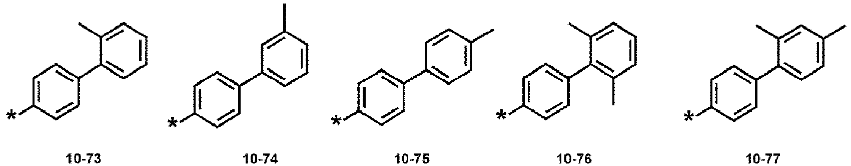

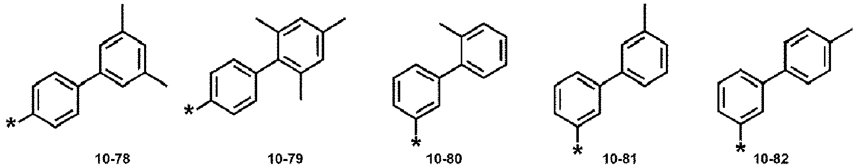

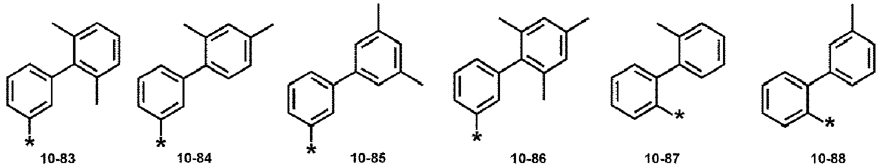

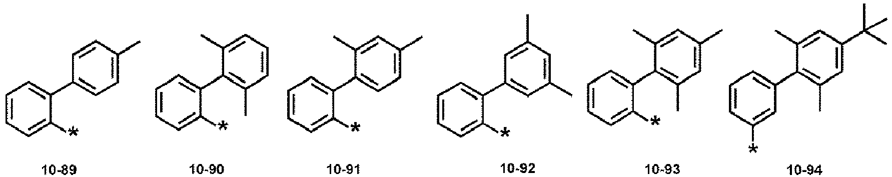

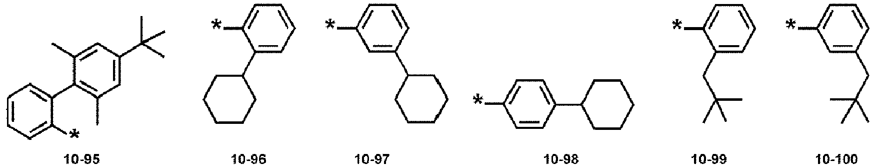

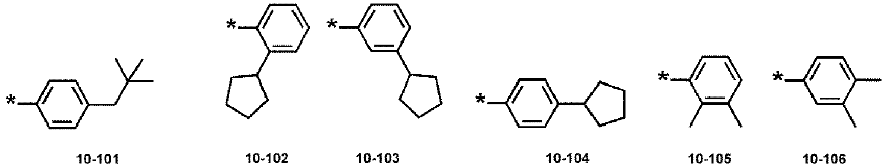

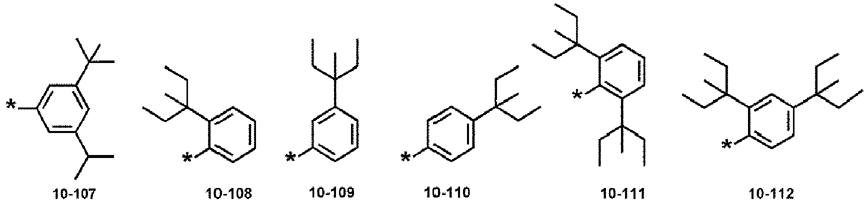

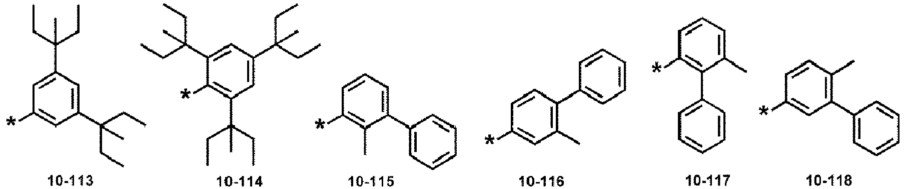

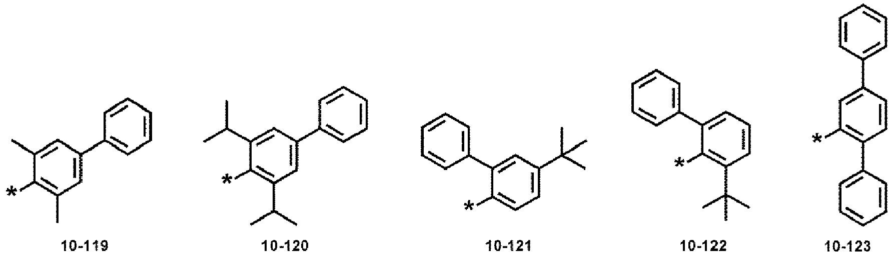

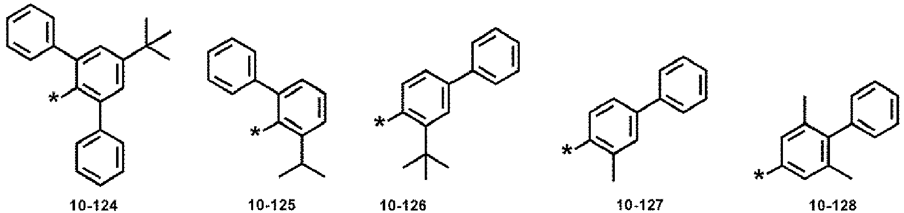

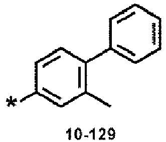

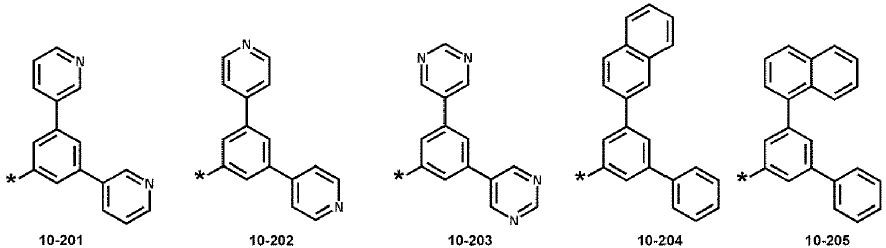

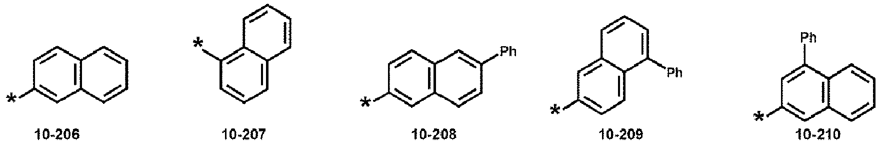

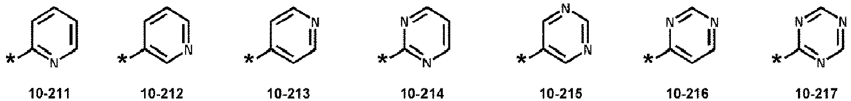

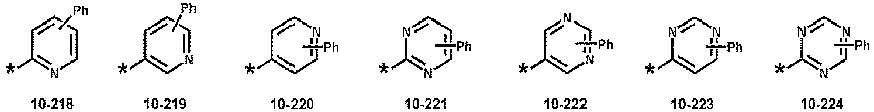

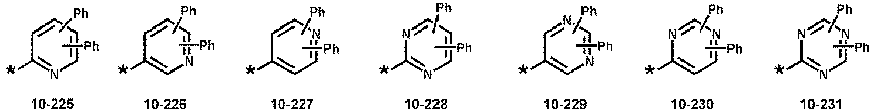

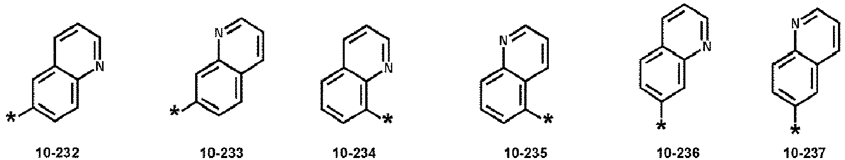

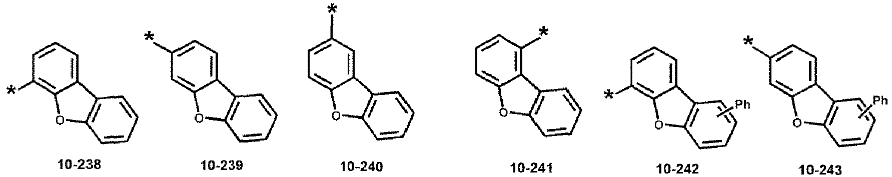

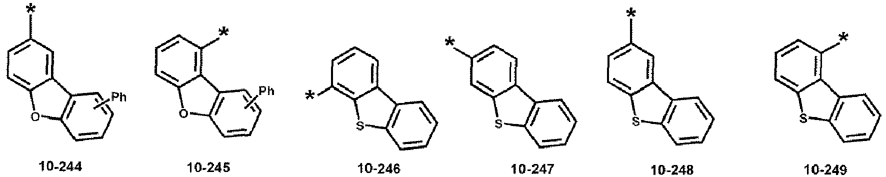

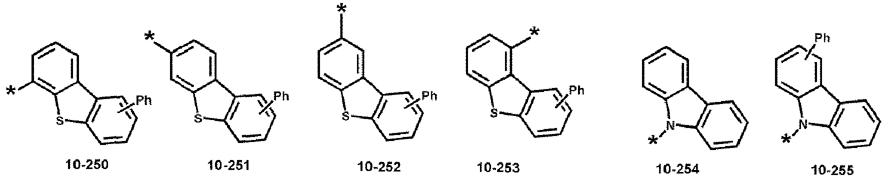

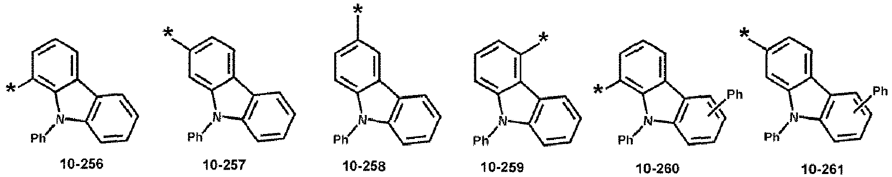

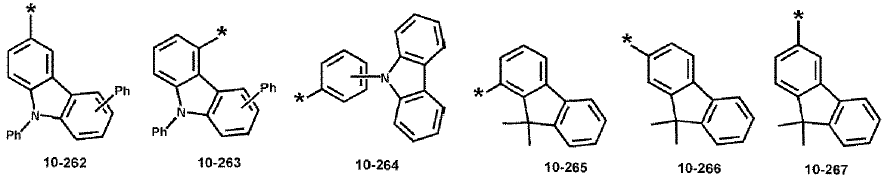

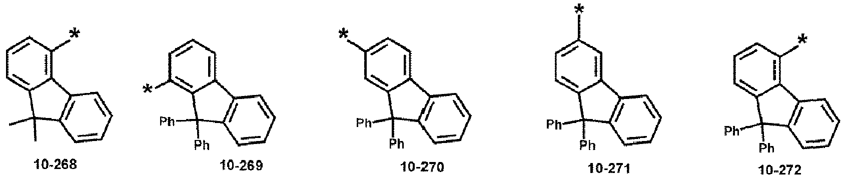

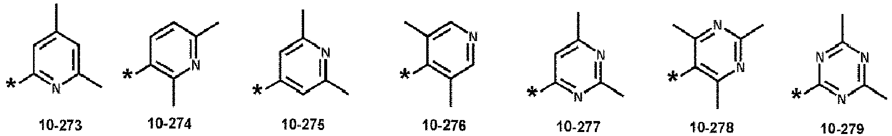

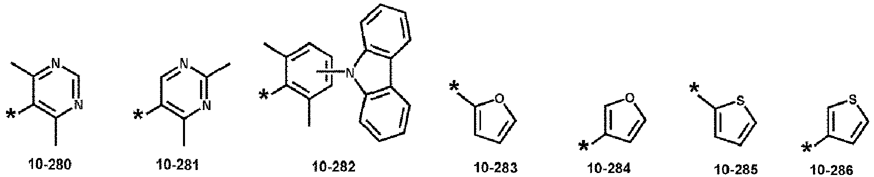

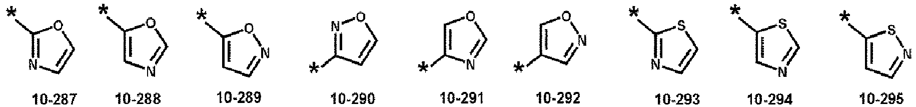

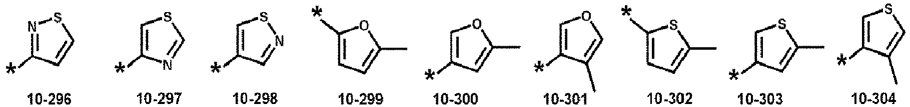

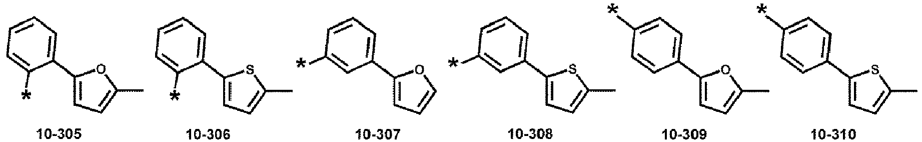

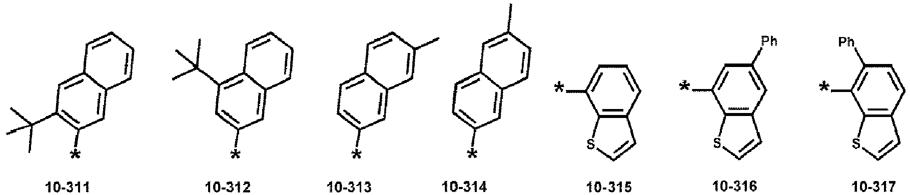

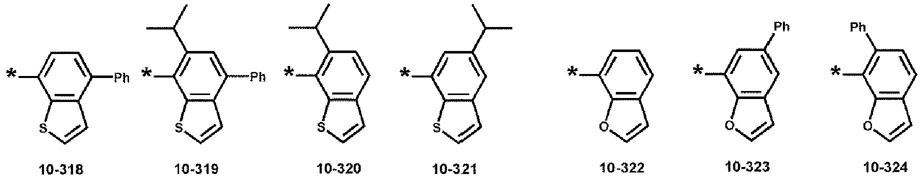

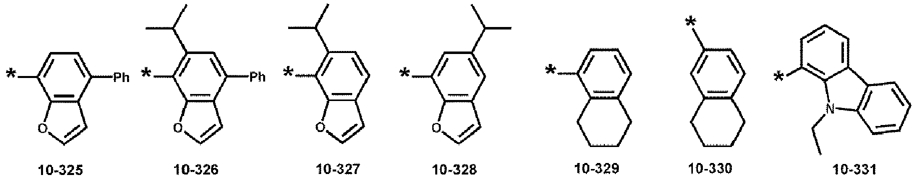

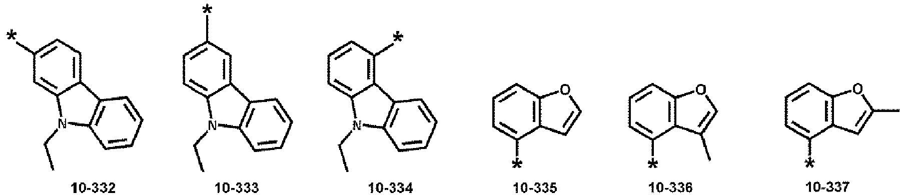

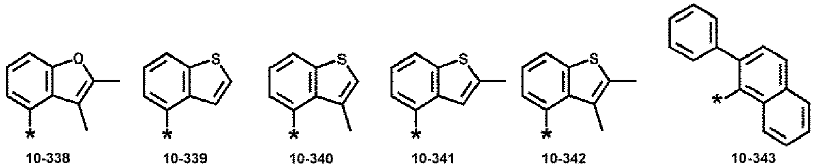

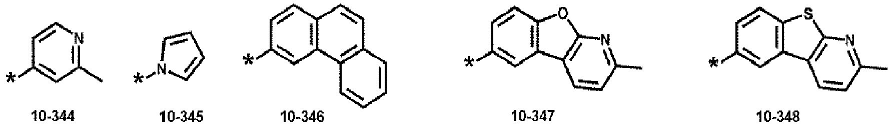

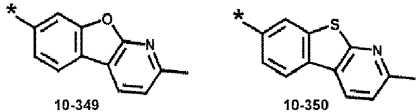

In Formulae 9-1 to 9-39, 9-201 to 9-237, 10-1 to 10-129, and 10-201 to 10-350, * indicates a binding site to a neighboring atom, Ph is a phenyl group, TMS is a trimethylsilyl group, and TMG is a trimethylgermyl group.

The "group in which at least one hydrogen in Formulae 9-1 to 9-39 is substituted with deuterium" and "the group in which at least one hydrogen in Formulae 9-201 to 9-237 is substituted with deuterium" may be, for example, a group represented by one of Formulae 9-501 to 9-514 and 9-601 to 9-636:

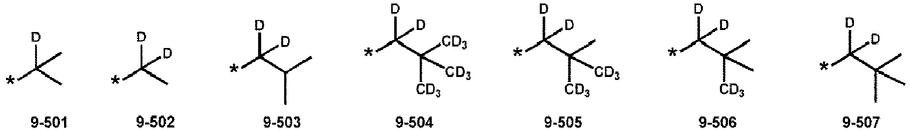

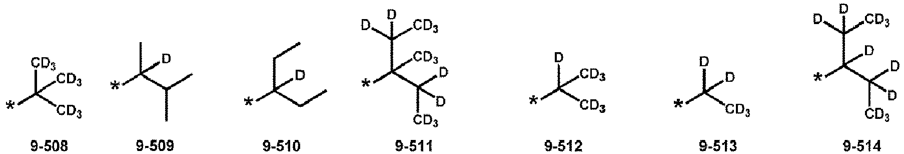

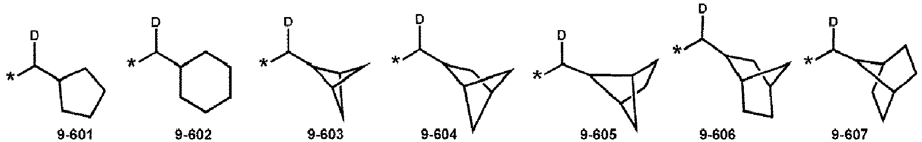

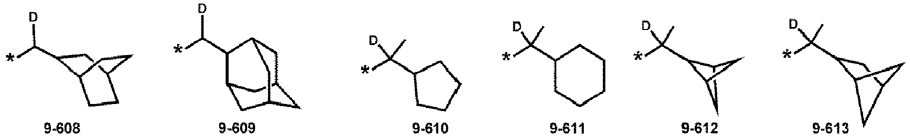

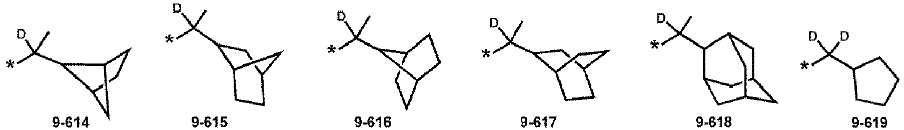

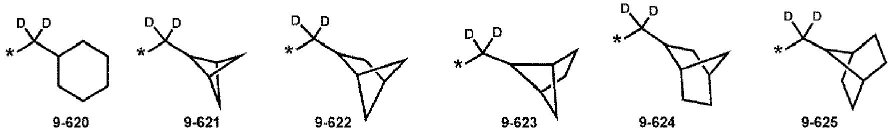

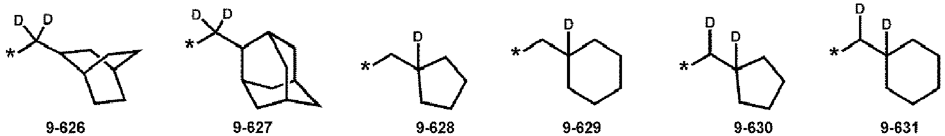

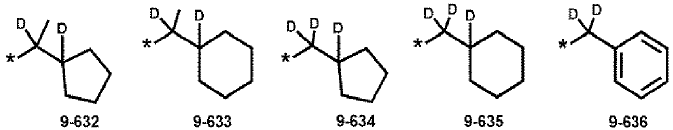

The "group in which at least one hydrogen in Formulae10-1 to 10-129 is substituted with deuterium" and the "group in which at least one hydrogen in Formulae 10-201 to 10-350 is substituted with deuterium" may be, for example, a group represented by one of Formulae 10-501 to 10-553:

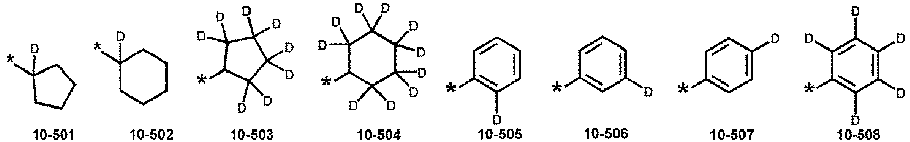

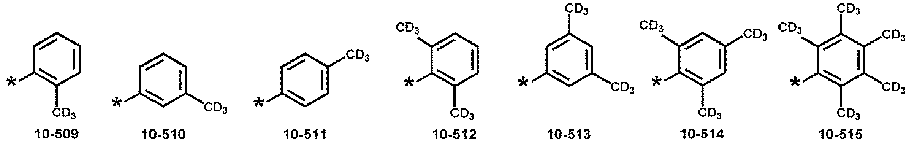

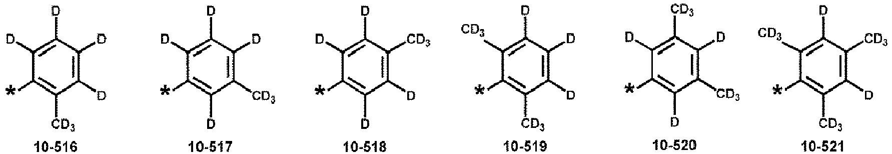

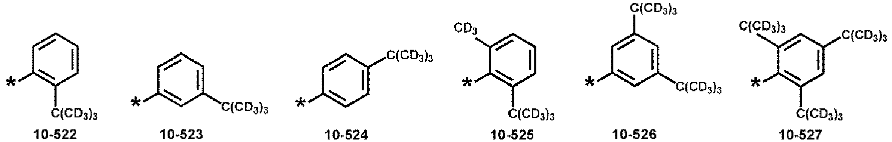

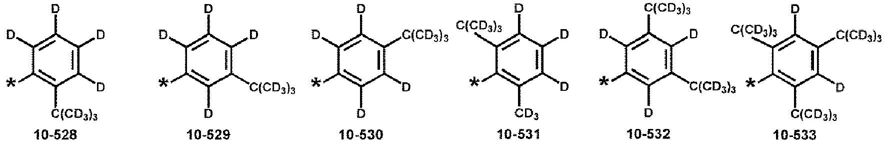

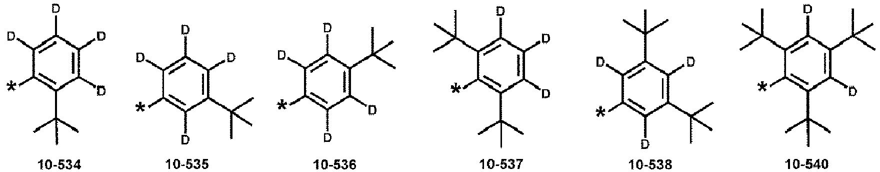

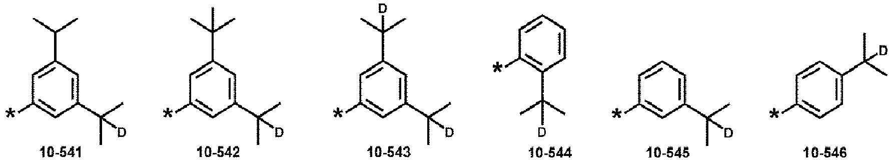

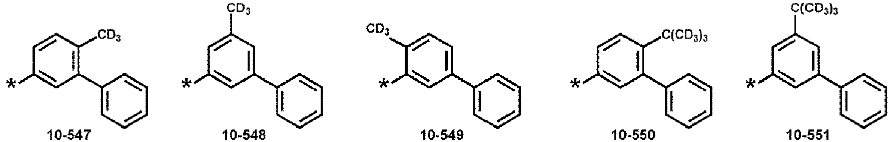

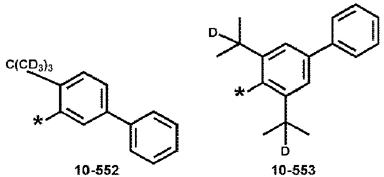

In Formulae 3-1 and 3-2, a1 to a4 may each indicate the numbers of a group represented by *-(A₁)_{b1}-R₁, a group represented by *-(A₂)_{b2}-R₂, a group represented by *-(A₃)_{b3}-R₃, and a group represented by *-(A₄)_{b4}-R₄, respectively, and may each independently be an integer from 0 to 20 (for example, an integer from 0 to 8). When a1 is 2 or more, two or more groups represented by *-(A₁)_{b1}-R₁ may be identical to or different from each other, when a2 is 2 or more, two or more groups represented by *-(A₂)_{b2}-R₂ may be identical to or different from each other, when a3 is 2 or more, two or more groups represented by *-(A₃)_{b3}-R₃ may be identical to or different from each other, and when a4 is 2 or more, two or more groups represented by *-(A₄)_{b4}-R₄ may be identical to or different from each other.

For example, in Formula 3-2, R₄ may not be hydrogen, and a4 may be an integer from 1 to 6.

In one or more embodiments, the organometallic compound may be represented by Formula 1, and Formula 1 may include a group represented by -Si(Q₃)(Q₄)(Q₅), a group represented by -Ge(Q₃)(Q₄)(Q₅), or any combination thereof.

In one or more embodiments, at least one of R₁(s) in the number of a1 in Formula 3-1 may be a group represented by -Si(Q₃)(Q₄)(Q₅) or a group represented by - Ge(Q₃)(Q₄)(Q₅).

In one or more embodiments, a group represented by

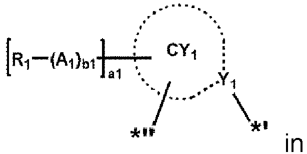

Formula 3-1 may be a group represented by one of Formulae CY1(1) to CY1(25):

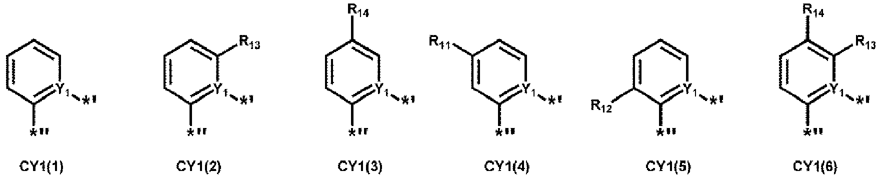

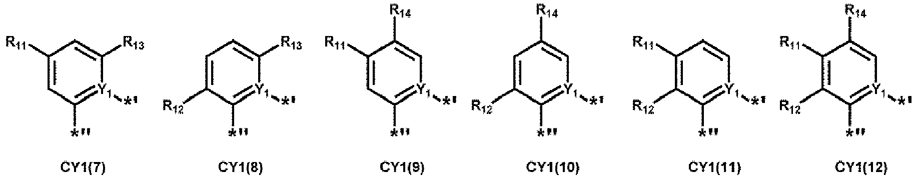

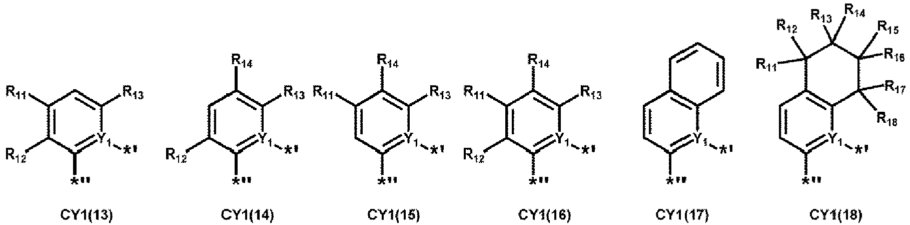

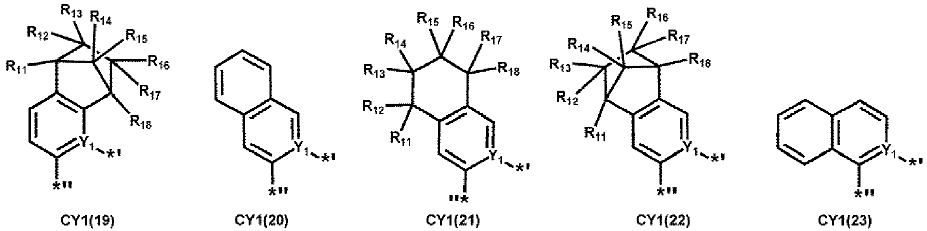

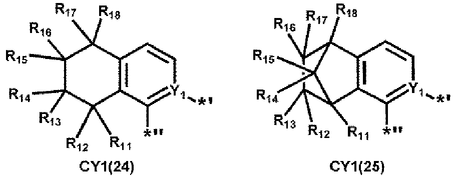

In Formulae CY1(1)-1 to CY1(25),
Y₁ may be N,
R₁₁ to R₁₈ may be the same as described in connection with R₁, wherein, in Formulae CY1(2) to CY₁ (16), R₁₁ to R₁₄ may not be each hydrogen,
*' indicates a binding site to M₁ in Formula 1 or M₂ in Formula 2, and
*" indicates a binding site to T₁ in Formula 3-1.

In one or more embodiments, a group represented by 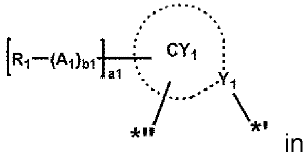 Formula 3-1 may be a group represented by one of Formulae CY1-1 to CY1-4:

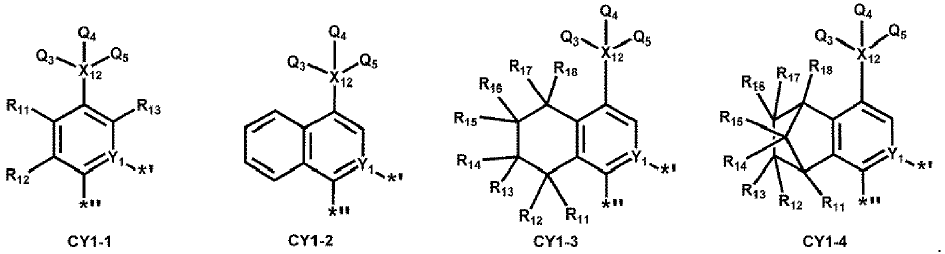

In Formulae CY1-1 to CY1-4,
Y₁ may be N,
X₁₂ may be Si or Ge,
R₁₁ to R₁₈ may each be the same as described in connection with R₁,
Q₃ to Q₅ may each be the same as described in the present specification,
*' indicates a binding site to M₁ in Formula 1 or M₂ in Formula 2, and
*" indicates a binding site to T₁ in Formula 3-1.

In one or more embodiments, R₁(s) in the number of a1 in Formula 3-1 (for example, R₁₁ to R₁₈ in Formulae CY1-1 to CY1-4) may each independently be hydrogen, deuterium, a C₁-C₂₀alkyl group, a deuterated C₁-C₂₀ alkyl group, a C₃-C₁₀ cycloalkyl group, or a deuterated C₃-C₁₀ cycloalkyl group.

In one or more embodiments, R₁(s) in the number of a1 in Formula 3-1 (for example, R₁₁ to R₁₈ in Formulae CY1-1 to CY1-4) may each independently be hydrogen, deuterium, -F, -CI, -Br, -I, a cyano group, a substituted or unsubstituted C₁-C₂₀alkyl group, or a substituted or unsubstituted C₃-C₁₀ cycloalkyl group.

In one or more embodiments, R₁(s) in the number of a1 in Formula 3-1 (for example, R₁₁ to R₁₈ in Formulae CY1-1 to CY1-4) may each independently be:
hydrogen, deuterium, -F, or a cyano group;
a C₁-C₂₀ alkyl group unsubstituted or substituted with deuterium, -F, cyano group, a C₃-C₁₀ cycloalkyl group, a (C₁-C₂₀ alkyl)C₃-C₁₀ cycloalkyl group, or any combination thereof; or
a C₃-C₁₀ cycloalkyl group unsubstituted or substituted with deuterium, -F, cyano group, a C₁-C₂₀ alkyl group, or any combination thereof.
   R₁(s) in the number of a1 in Formula 3-1 (for example, R₁₁ to R₁₈ in Formulae CY1-1 to CY1-4) may each independently be:
   hydrogen, deuterium, -F, or a cyano group;
   a C₁-C₂₀ alkyl group unsubstituted or substituted with deuterium, -F, a cyano group, a cyclopentyl group, a cyclohexyl group, a cycloheptyl group, a cycloctyl group, an adamantanyl group, a norbornanyl group(bicyclo[2.2.1]heptyl group), a norbornenyl group, a cyclo[1.1.1]pentyl group, a bicyclo[2.1.1]hexyl group, a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cycloctyl group, a (C₁-C₂₀ alkyl)adamantanyl group, a (C₁-C₂₀ alkyl)norbornanyl group, a (C₁-C₂₀ alkyl)norbornenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.2]octyl group, or any combination thereof; or
   a cyclopentyl group, a cyclohexyl group, a cycloheptyl group, a cycloctyl group, an adamantanyl group, a norbornanyl group, a norbornenyl group, a bicyclo[1.1.1]pentyl group, a bicyclo[2.1.1]hexyl group, or a bicyclo[2.2.2]octyl group, each unsubstituted or substituted with deuterium, -F, a cyano group, a C₁-C₂₀ alkyl group, or any combination thereof.

In one or more embodiments, R₁₁ in Formula CY1-1 may not be hydrogen.

In one or more embodiments, R₁₁ in Formula CY1-1 may be neither hydrogen nor a methyl group.

In one or more embodiments, R₁₁ in Formula CY1-1 may be neither hydrogen, a methyl group, nor a cyano group.

In one or more embodiments, in Formula CY1-1, R₁₁ may not be hydrogen, and R₁₂ and R₁₃ may each be hydrogen.

In one or more embodiments, R₁₁ in Formula CY1-1 may be a group including 4 or more carbons.

In one or more embodiments, R₁₁ in Formula CY1-1 may be:
a methyl group substituted with deuterium, -F, a cyano group, a C₁-C₂₀ alkyl group, a deuterated C₁-C₂₀ alkyl group, a C₃-C₁₀ cycloalkyl group, a (C₁-C₂₀ alkyl)C₃-C₁₀ cycloalkyl group, a phenyl group, a (C₁-C₂₀ alkyl)phenyl group, a naphthyl group, a pyridinyl group, a furanyl group, a thiophenyl group, a benzofuranyl group, a benzothiophenyl group, a dibenzofuranyl group, a dibenzothiophenyl group, or any combination thereof; or
a C₂-C₂₀ alkyl group, a C₃-C₁₀ cycloalkyl group, a phenyl group, a naphthyl group, a pyridinyl group, a furanyl group, a thiophenyl group, a benzofuranyl group, a benzothiophenyl group, a dibenzofuranyl group, or a dibenzothiophenyl group, each unsubstituted or substituted with deuterium, -F, a cyano group, a C₁-C₂₀ alkyl group, a deuterated C₁-C₂₀ alkyl group, a C₃-C₁₀ cycloalkyl group, a (C₁-C₂₀ alkyl)C₃-C₁₀ cycloalkyl group, a phenyl group, a (C₁-C₂₀ alkyl)phenyl group, a naphthyl group, a pyridinyl group, a furanyl group, a thiophenyl group, a benzofuranyl group, a benzothiophenyl group, a dibenzofuranyl group, a dibenzothiophenyl group, or any combination thereof.

In one or more embodiments, Q₁ to Q₉ (for example, Q₃ to Q₅ in Formula CY1-1) may each independently be a C₁-C₆₀ alkyl group or a C₆-C₆₀ aryl group, each unsubstituted or substituted with deuterium, -F, -CI, -Br, -I, -CD₃, -CD₂H, -CDH₂, -CF₃, - CF₂H, -CFH₂, a hydroxyl group, a cyano group, a nitro group, an amino group, an amidino group, a hydrazine group, a hydrazone group, a carboxylic acid or a salt thereof, a sulfonic acid or a salt thereof, a phosphoric acid or a salt thereof, a C₁-C₁₀ alkyl group, or any combination thereof.

In one or more embodiments, Q₁ to Q₉ (for example, Q₃ to Q₅ in Formula CY1-1) may each independently be a methyl group, an ethyl group, an n-propyl group, an isopropyl group, an n-butyl group, a sec-butyl group, an isobutyl group, a tert-butyl group, an n-pentyl group, a tert-pentyl group, an neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a *tert-*octyl group, an n-nonyl group, an isononyl group, a sec-nonyl group, a tert-nonyl group, an n-decyl group, an isodecyl group, a sec-decyl group, a tert-decyl group, a phenyl group, a biphenyl group, or a naphthyl group, each unsubstituted or substituted with deuterium, -F, -CI, -Br, -I, -CD₃, -CD₂H, -CDH₂, -CF₃, -CF₂H, -CFH₂, hydroxyl group, cyano group, nitro group, amino group, amidino group, a hydrazine group, a hydrazone group, carboxylic acid or a salt thereof, sulfonic acid or a salt thereof, phosphoric acid or a salt thereof, C₁-C₁₀ alkyl group, or any combination thereof.

In one or more embodiments, Q₁ to Q₉ (for example, Q₃ to Q₅ in Formula CY1-1) may each independently be -CH₃, -CH₂CH₃, -CD₃, -CD₂H, -CDH₂, -CH₂CD₃, or -CD₂CH₃.

In one or more embodiments, Q₃ to Q₅ in Formula CY1-1 may be identical to or different from each other.

In one or more embodiments, a group represented by 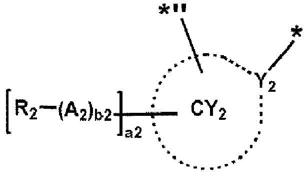 in Formula 3-1 may be a group represented by one of Formulae CY2(1) to CY2(67):

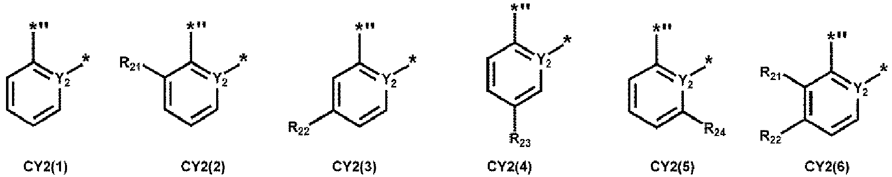

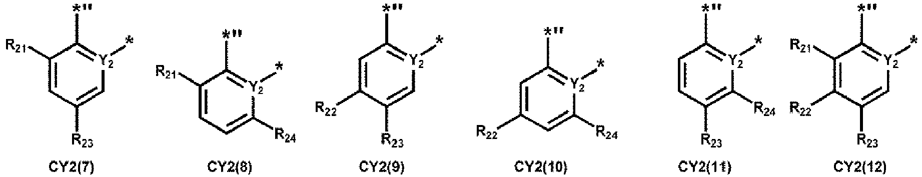

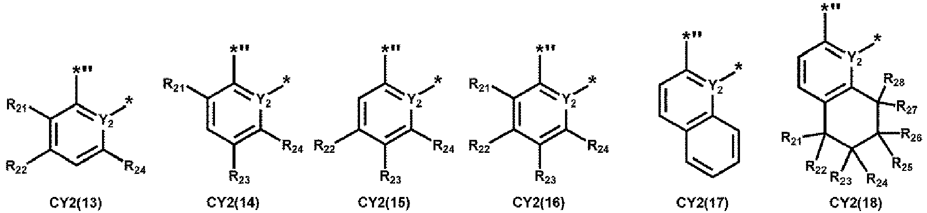

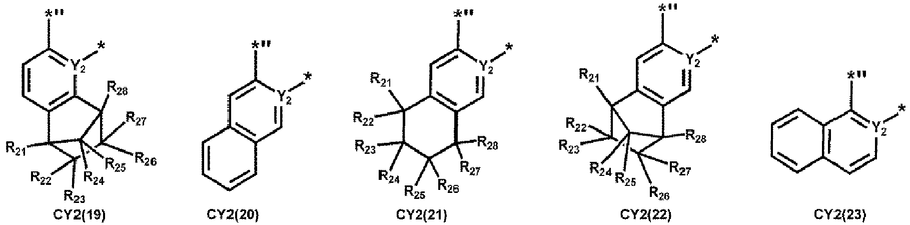

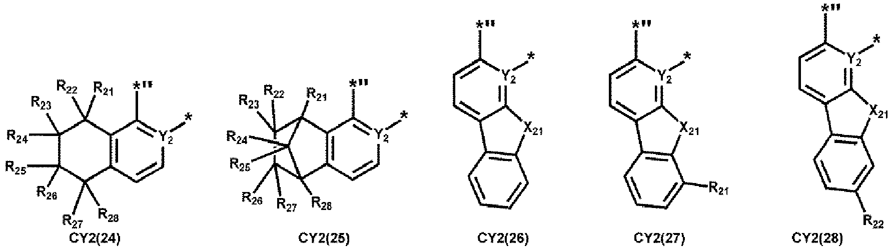

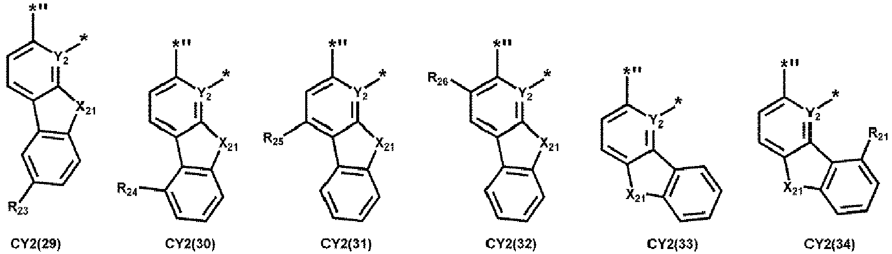

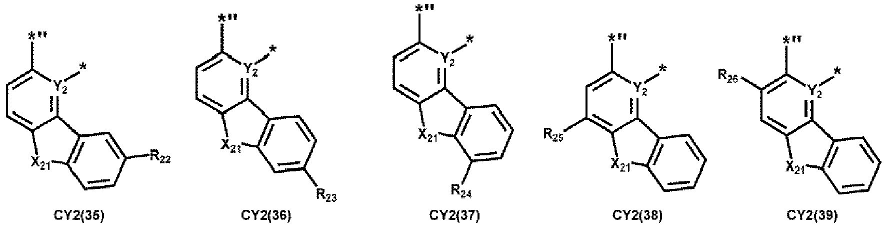

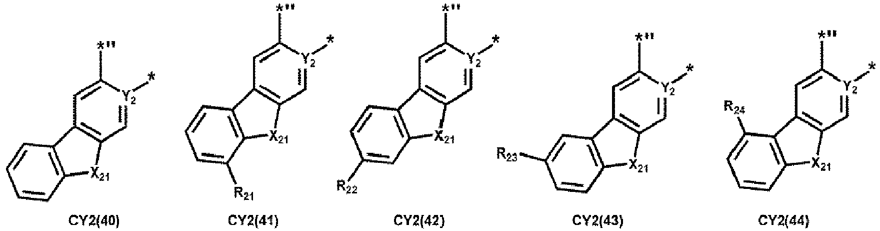

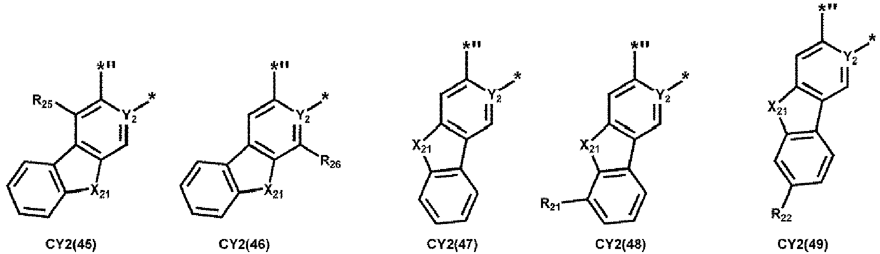

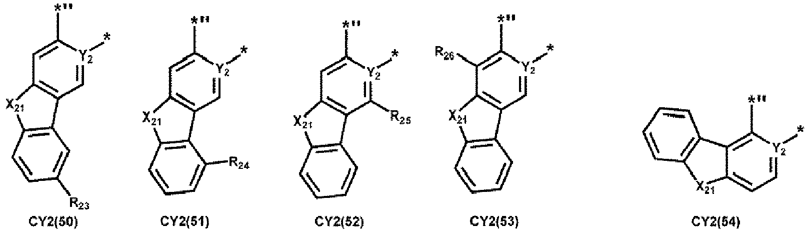

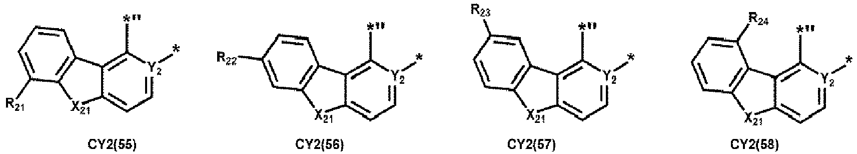

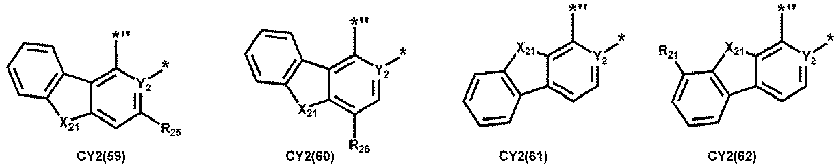

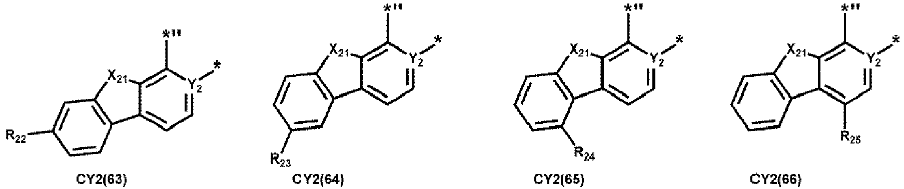

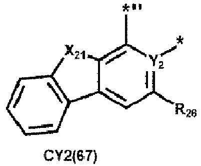

In Formulae CY2(1)-1 to CY2(67),
Y₂ may be C,
X₂₁ may be O, S, N(R₂₇), C(R₂₇)(R₂₈), Si(R₂₇)(R₂₈),
R₂₁ to R₂₈ may each be the same as described in connection with R₂, wherein, in Formulae CY2(2) to CY2(16), CY2(27) to CY2(32), CY2(34) to CY2(39), CY2(41) to CY2(46), CY2(48) to CY2(53), CY2(55) to CY2(60), and CY2(62) to CY2(67), R₂₁ to R₂₆ may not be each hydrogen,
* indicates a binding site to M₁ in Formula 1 or M₂ in Formula 2, and
*" indicates a binding site to T₁ in Formula 3-1.

In one or more embodiments, a group represented by 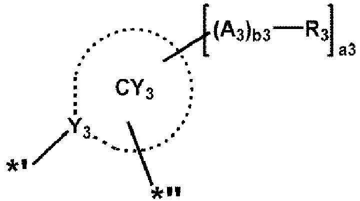 in Formula 3-2 may be a group represented by one of Formulae CY3(1) to CY3(37):

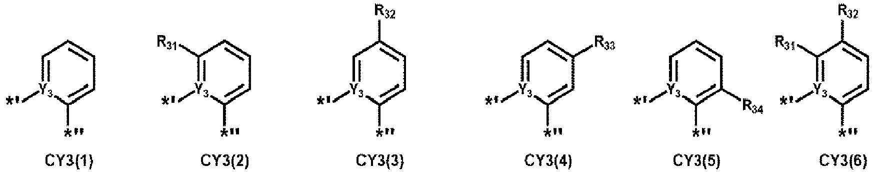

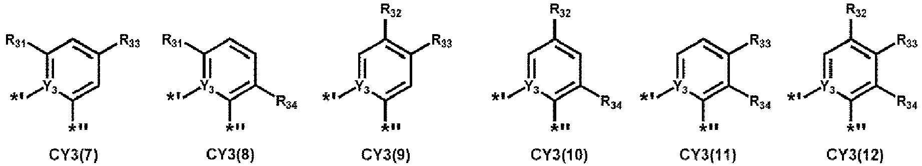

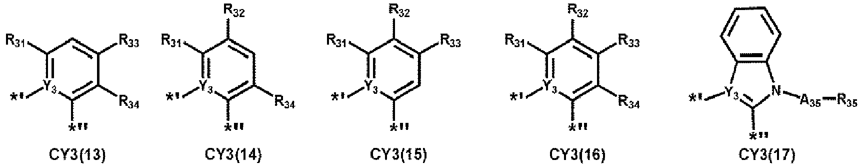

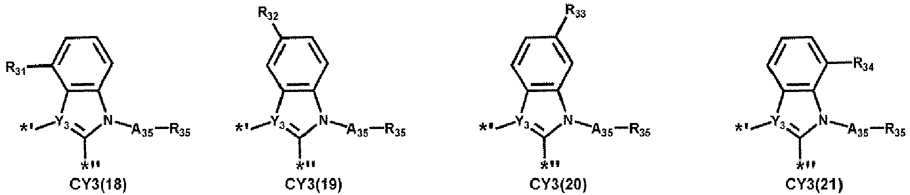

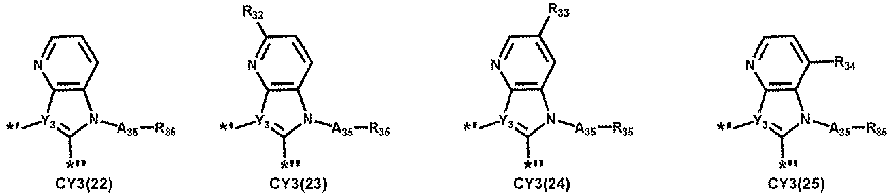

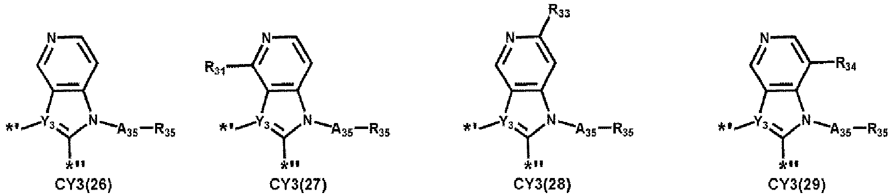

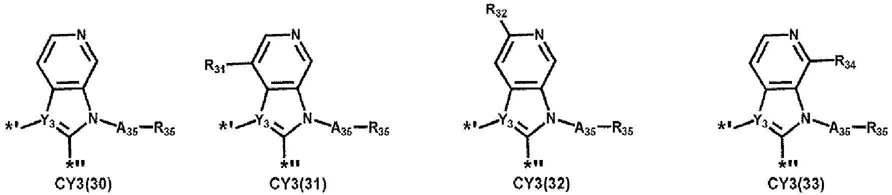

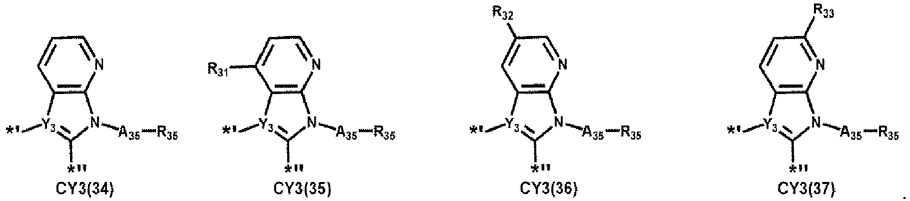

In Formulae CY3(1)-1 to CY3(37),
Y₃ may be N,
A₃₅ may be the same as described in connection with A₃,
R₃₁ to R₃₅ may each be the same as described in connection with R₃, wherein R₃₁ to R₃₅ may not be each hydrogen,
*' indicates a binding site to M₁ in Formula 1, and
*" indicates a binding site to T₃ in Formula 3-2.

In one or more embodiments, in Formulae CY3(17) to CY3(37),
A₃₅ may be:
   a single bond; or
   a benzene group, a naphthalene group, a phenanthrene group, a dibenzofuran group, or a dibenzothiophene group, each unsubstituted or substituted with deuterium, a C₁-C₂₀ alkyl group, a deuterated C₁-C₂₀ alkyl group, a phenyl group, a (C₁-C₂₀ alkyl)phenyl group, a naphthyl group, a (C₁-C₂₀ alkyl)naphthyl group, a phenanthrenyl group, a (C₁-C₂₀ alkyl)phenanthrenyl group, a dibenzofuranyl group, a dibenzothiophenyl, or any combination thereof, and
R₃₅ may be:
   hydrogen, deuterium, or a C₁-C₂₀ alkyl group; or
   a phenyl group, a naphthyl group, a phenanthrenyl group, a dibenzofuranyl group, or dibenzothiophenyl group, each unsubstituted or substituted with deuterium, a C₁-C₂₀ alkyl group, a deuterated C₁-C₂₀ alkyl group, a phenyl group, a (C₁-C₂₀ alkyl)phenyl group, a naphthyl group, a (C₁-C₂₀ alkyl)naphthyl group, a phenanthrenyl group, a (C₁-C₂₀ alkyl)phenanthrenyl group, a dibenzofuranyl group, a dibenzothiophenyl, or any combination thereof.

In one or more embodiments, in Formulae CY3(17) to CY3(37), R₃₅ may be a C₆-C₂₀ aryl group simultaneously substituted with at least one C₁-C₂₀alkyl group and at least one C₆-C₂₀ aryl group.

In one or more embodiments, a group represented by 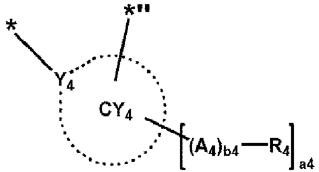 in Formula 3-2 may be a group represented by one of Formulae CY4(1) to CY4(38):

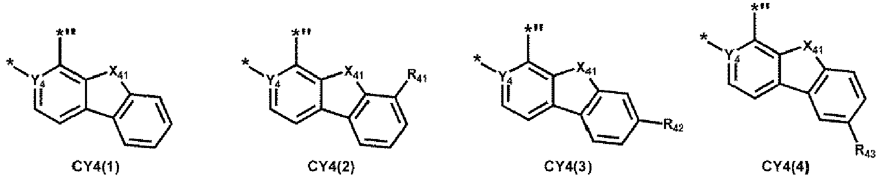

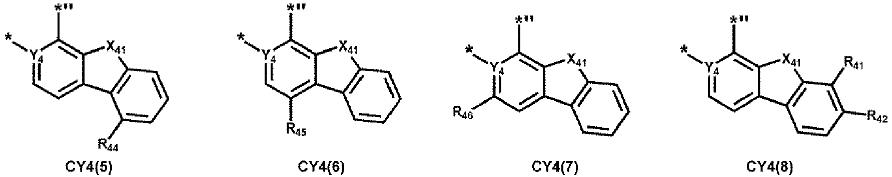

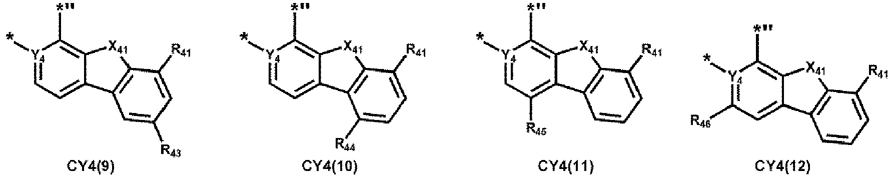

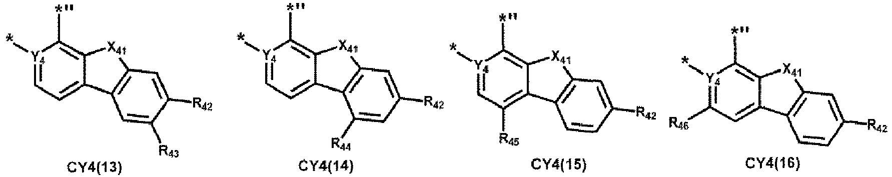

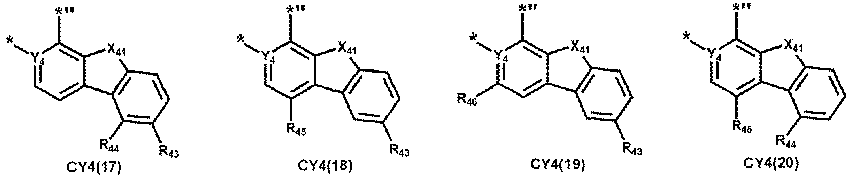

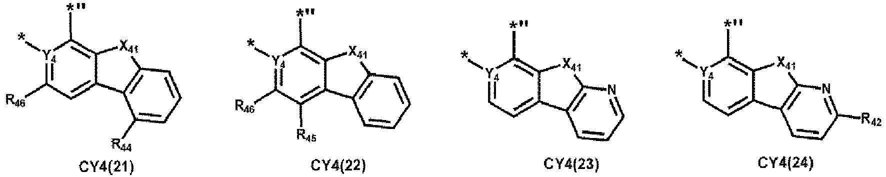

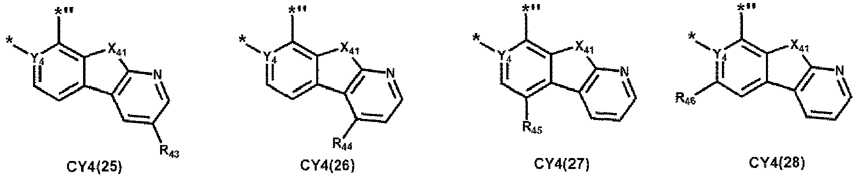

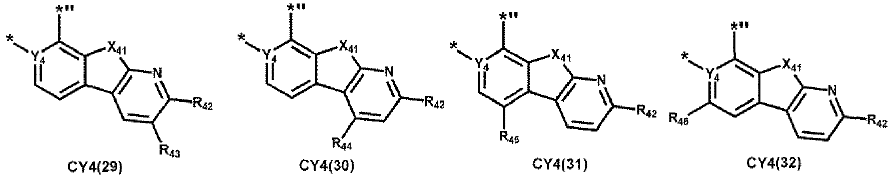

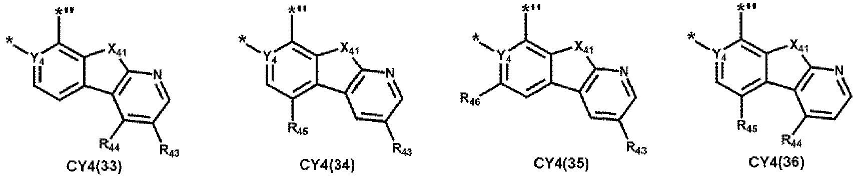

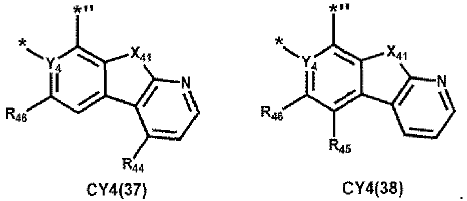

In Formulae CY4(1)-1 to CY4(38),
Y₄ may be C,
X₄₁ may be O, S, N(R₄₇), C(R₄₇)(R₄₈), or Si(R₄₇)(R₄₈),
R₄₁ to R₄₈ may each be the same as described in connection with R₄, wherein R₄₁ to R₄₆ may not be each hydrogen,
* indicates a binding site to M₁ in Formula 1, and
*" indicates a binding site to T₃ in Formula 3-2.

In one or more embodiments, R₁(s) in the number of a1 in Formula 3-1 (for example, R₁₁ to R₁₈ in Formulae CY1-1 to CY1-4) and R₄(s) in the number of a4 in Formula 3-2 (for example, R₄₁ to R₄₆ in Formulae CY4(1) to CY4(38)) may each independently be:
hydrogen, deuterium, -F, or a cyano group; or
a C₁-C₂₀ alkyl group, a C₃-C₁₀ cycloalkyl group, a phenyl group, a naphthyl group, a pyridinyl group, a furanyl group, a thiophenyl group, a benzofuranyl group, a benzothiophenyl group, a dibenzofuranyl group, or a dibenzothiophenyl group, each unsubstituted or substituted with deuterium, -F, cyano group, a C₁-C₂₀ alkyl group, a deuterated C₁-C₂₀ alkyl group, a C₃-C₁₀ cycloalkyl group, a (C₁-C₂₀ alkyl)C₃-C₁₀ cycloalkyl group, a phenyl group, a (C₁-C₂₀ alkyl)phenyl group, a naphthyl group, a pyridinyl group, a furanyl group, a thiophenyl group, a benzofuranyl group, a benzothiophenyl group, a dibenzofuranyl group, a dibenzothiophenyl group, or any combination thereof.
   Here, R₄₁ to R₄₆ in Formulae CY4(1) to CY4(38) may not be each hydrogen.

In one or more embodiments, the organometallic compound may include at least one deuterium.

In Formulae 3-1 and 3-2, 1) two or more of a plurality of R₁(s) may optionally be linked together to form a C₅-C₃₀ carbocyclic group unsubstituted or substituted with at least one R₁₀ₐ or a C₂-C₃₀ heterocyclic group unsubstituted or substituted with at least one R₁₀ₐ, 2) two or more of a plurality of R₂(s) may optionally be linked together to form a C₅-C₃₀ carbocyclic group unsubstituted or substituted with at least one R₁₀ₐ or a C₂-C₃₀ heterocyclic group unsubstituted or substituted with at least one R₁₀ₐ, 3) two or more of a plurality of R₃(s) may optionally be linked together to form a C₅-C₃₀ carbocyclic group unsubstituted or substituted with at least one R₁₀ₐ or a C₂-C₃₀ heterocyclic group unsubstituted or substituted with at least one R₁₀ₐ, 4) two or more of a plurality of R₄(s) may optionally be linked together to form a C₅-C₃₀ carbocyclic group unsubstituted or substituted with at least one R₁₀ₐ or a C₂-C₃₀ heterocyclic group unsubstituted or substituted with at least one R₁₀ₐ, and 5) two or more of R₁ to R₄, R₇, and R₈ may optionally be linked together to form a C₅-C₃₀ carbocyclic group unsubstituted or substituted with at least one R₁₀ₐ or a C₂-C₃₀ heterocyclic group unsubstituted or substituted with at least one R₁₀ₐ. In the present specification, R₁₀ₐ may be the same as described in connection with R₁.

In the present specification, symbols * and *' as used herein each indicate a binding site to a neighboring atom, unless otherwise stated.

Synthesis methods of the organometallic compound represented by Formula 1 may be understood by those of ordinary skill in the art by referring to Synthesis Examples provided below.

Examples of the organometallic compound include one of compounds of [Group 1], one of compounds of [Group 2], and one of compounds of [Group 3]:

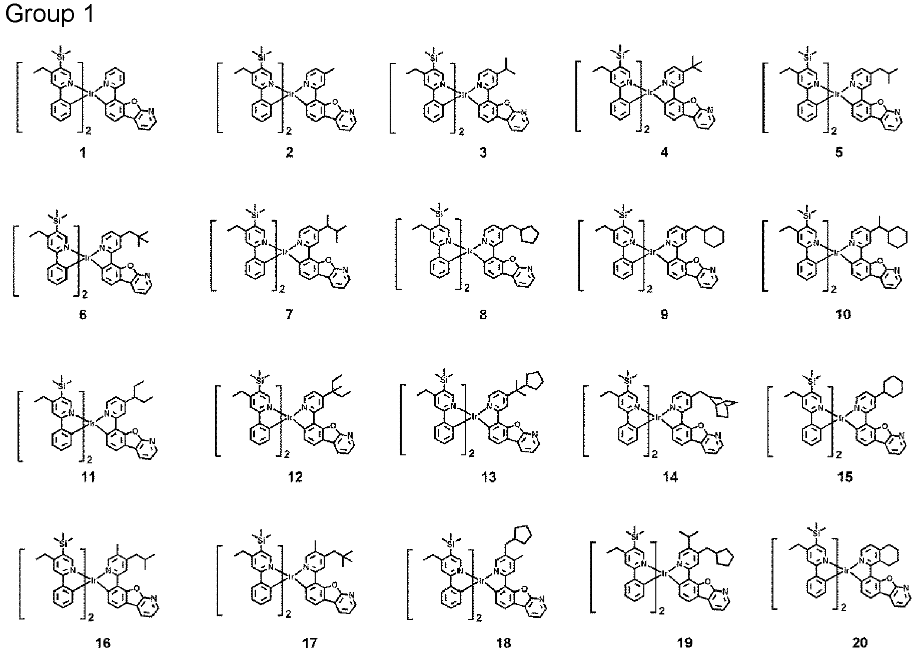

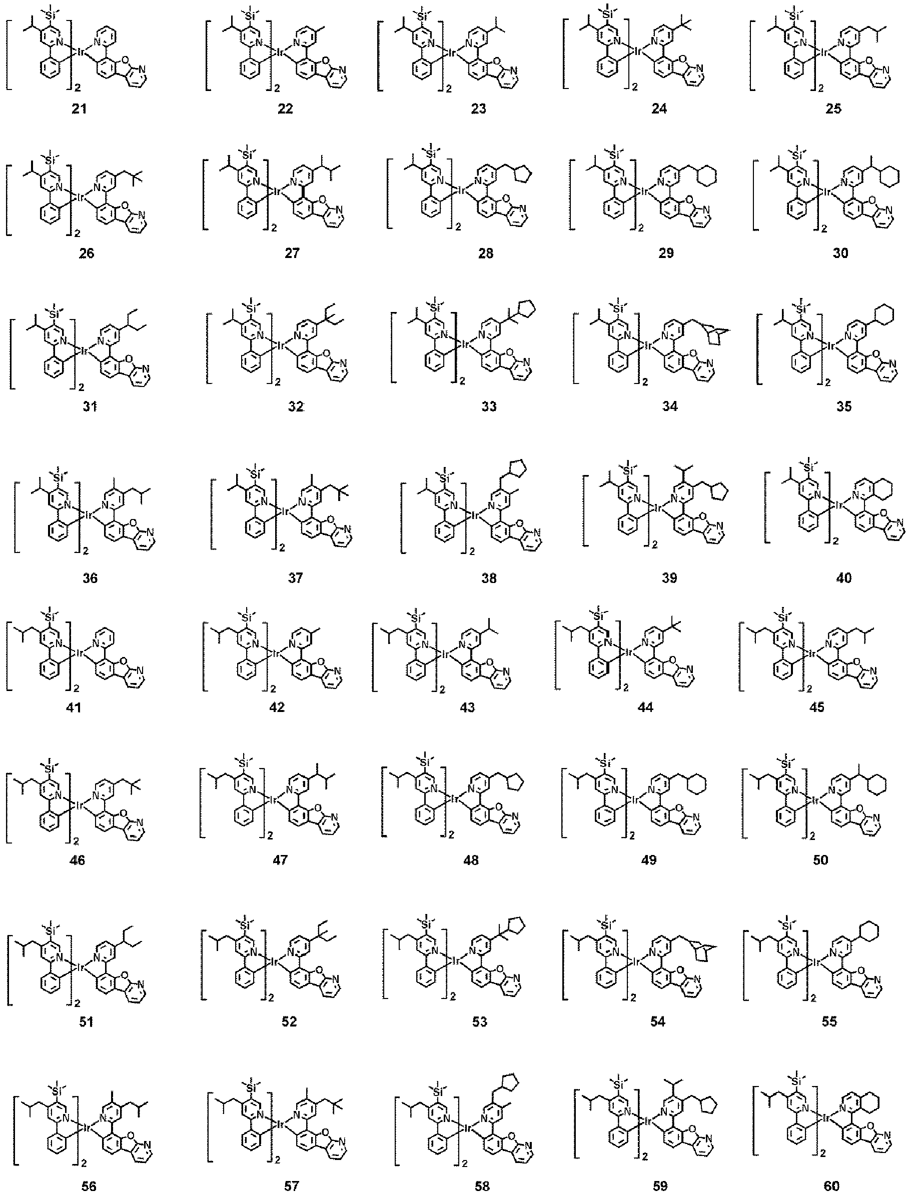

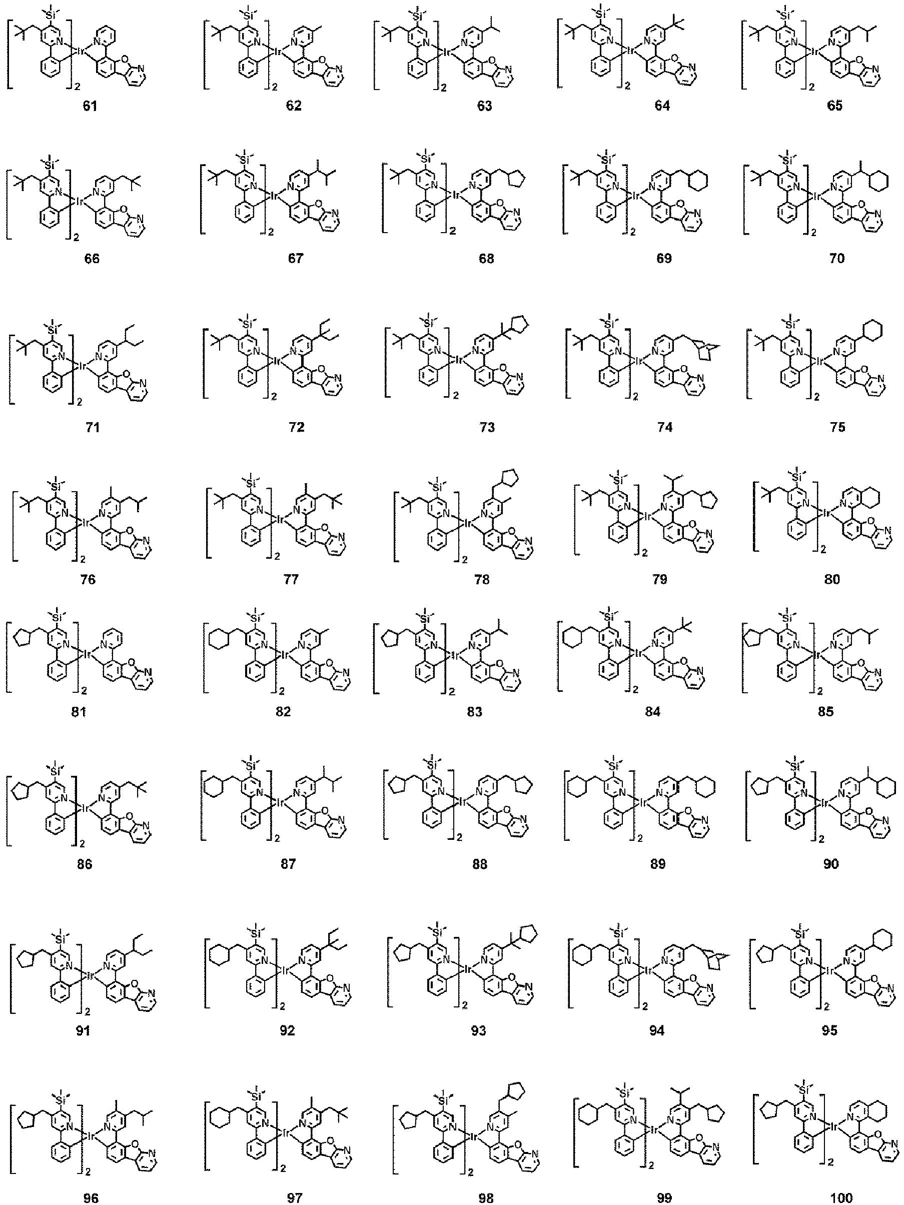

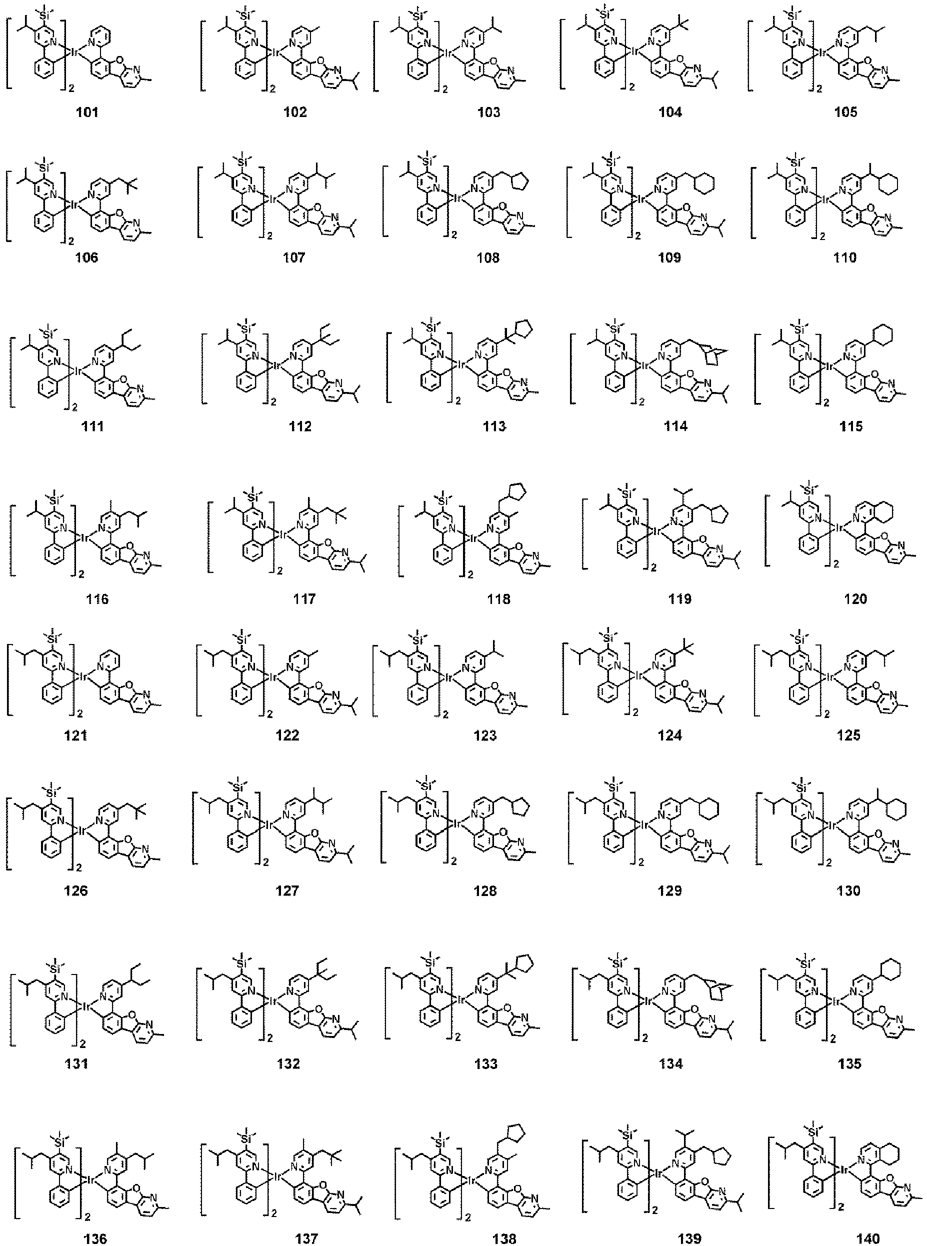

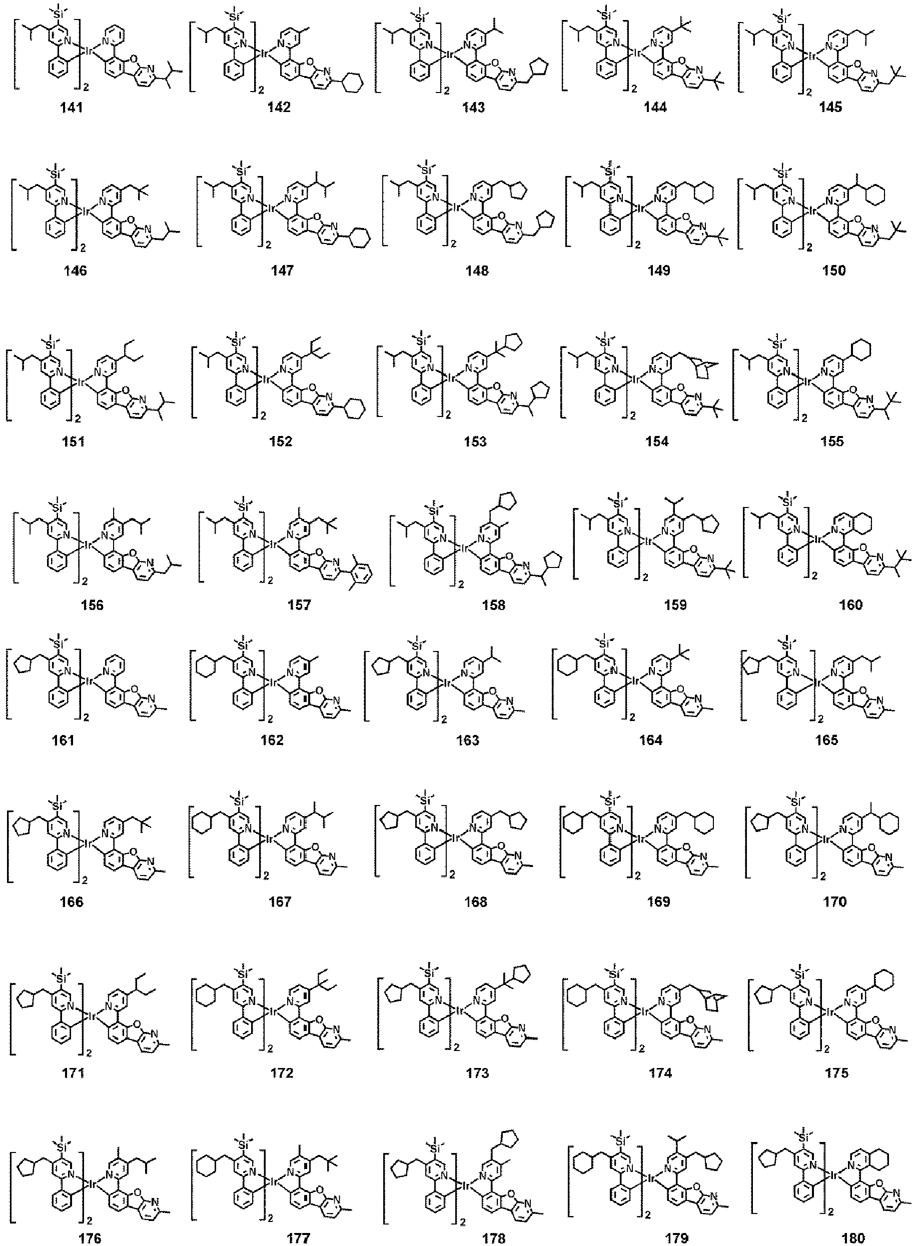

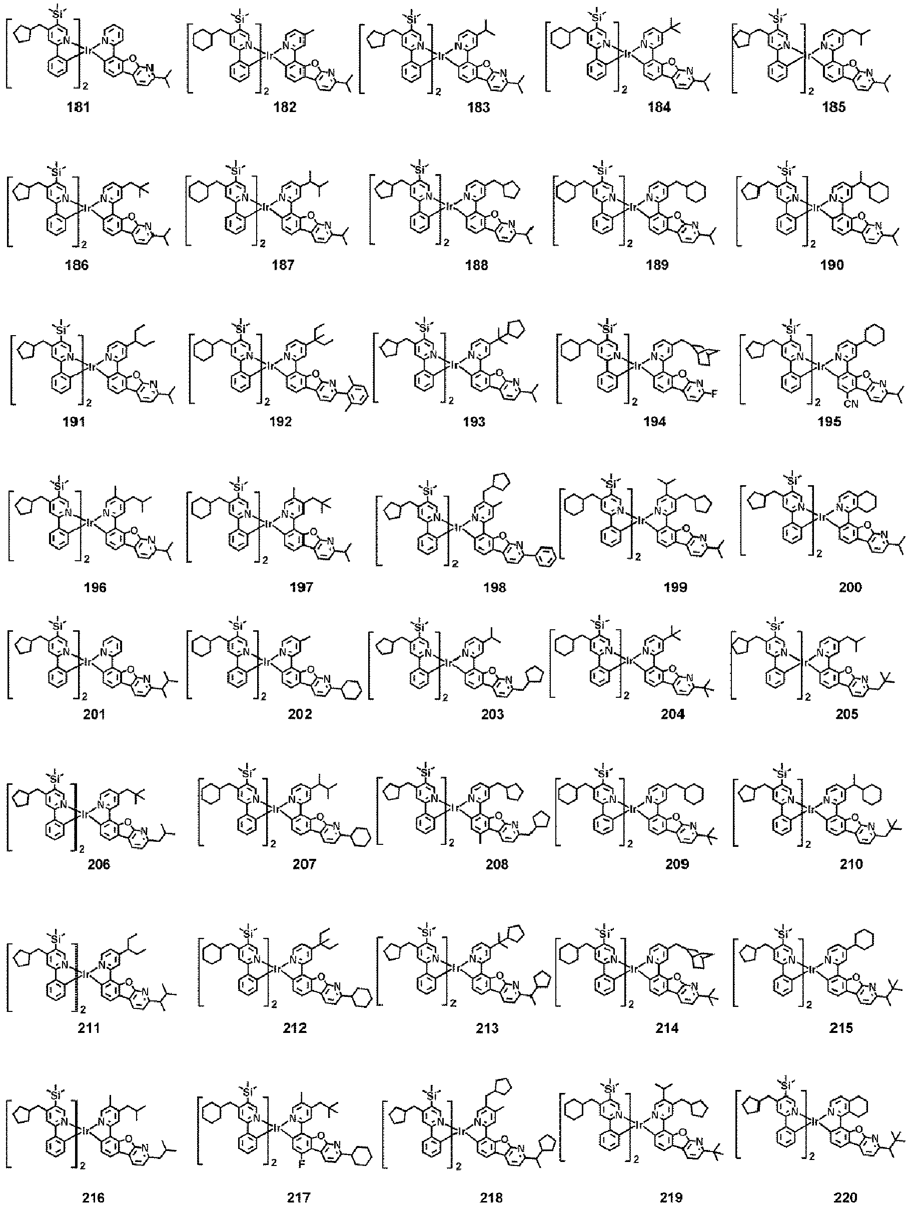

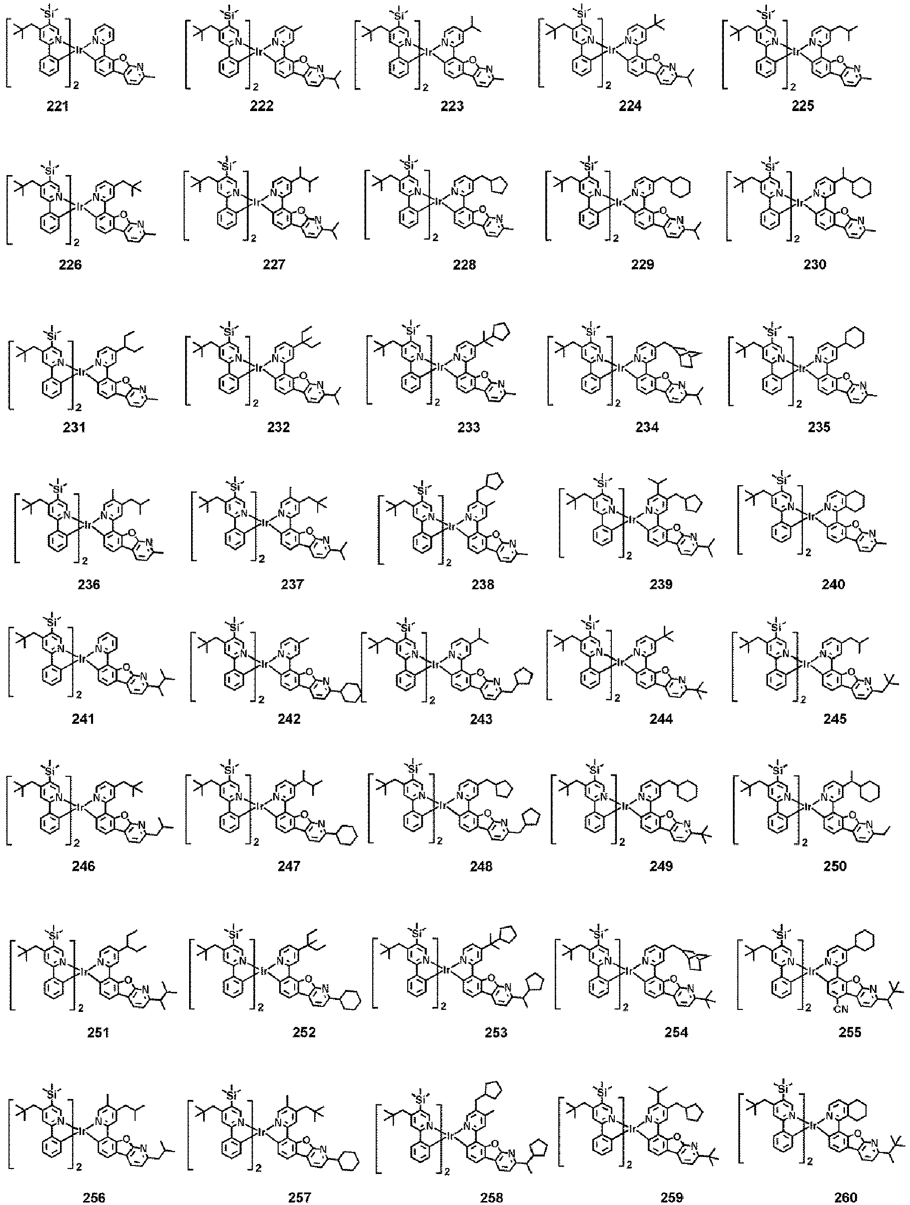

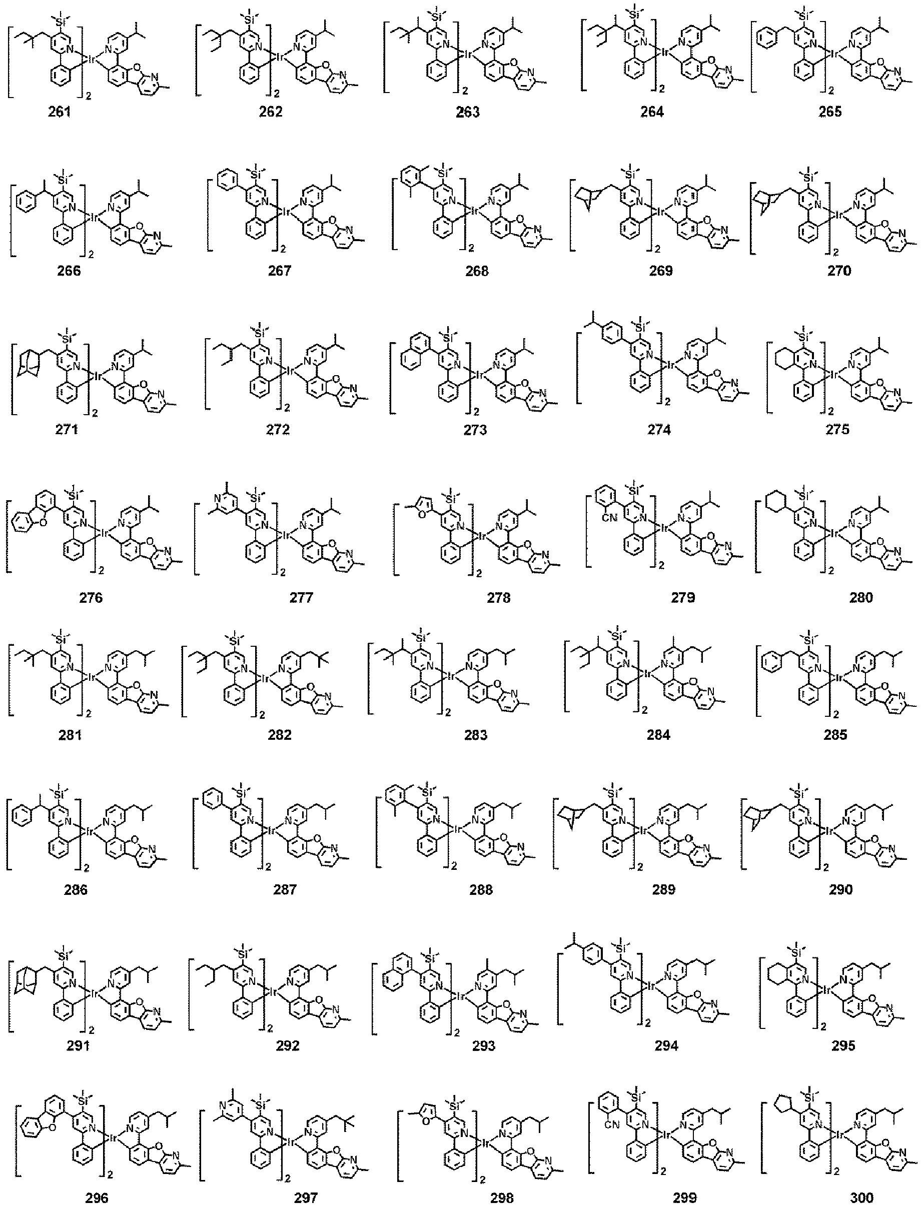

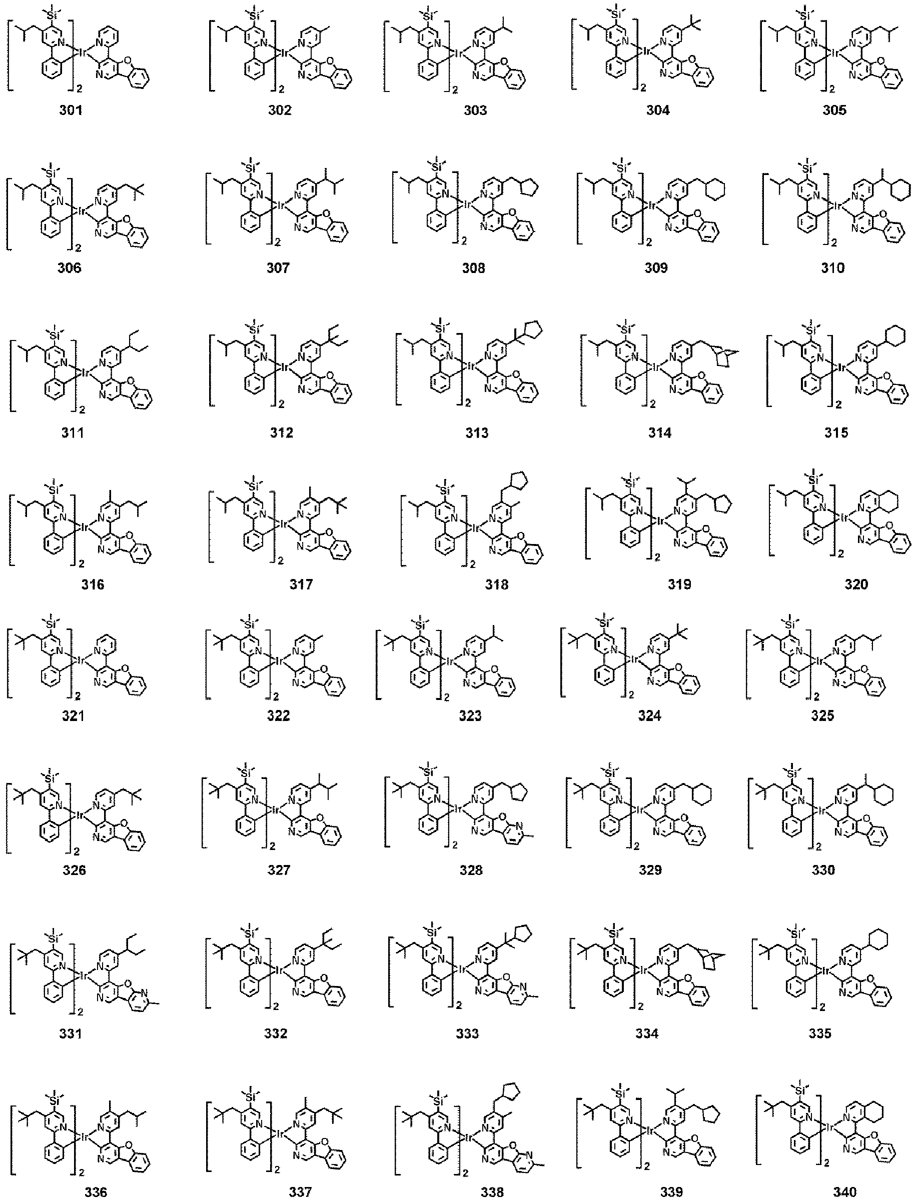

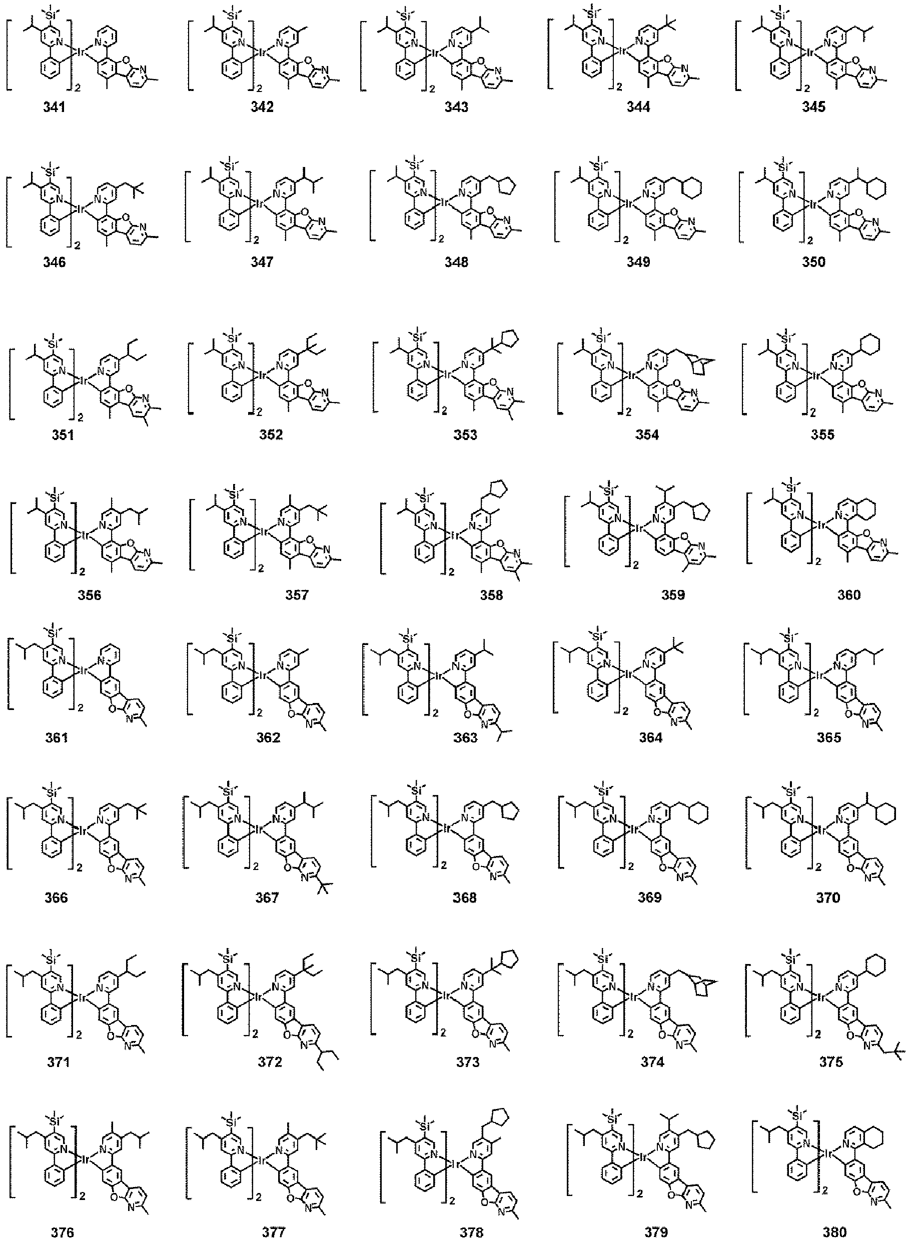

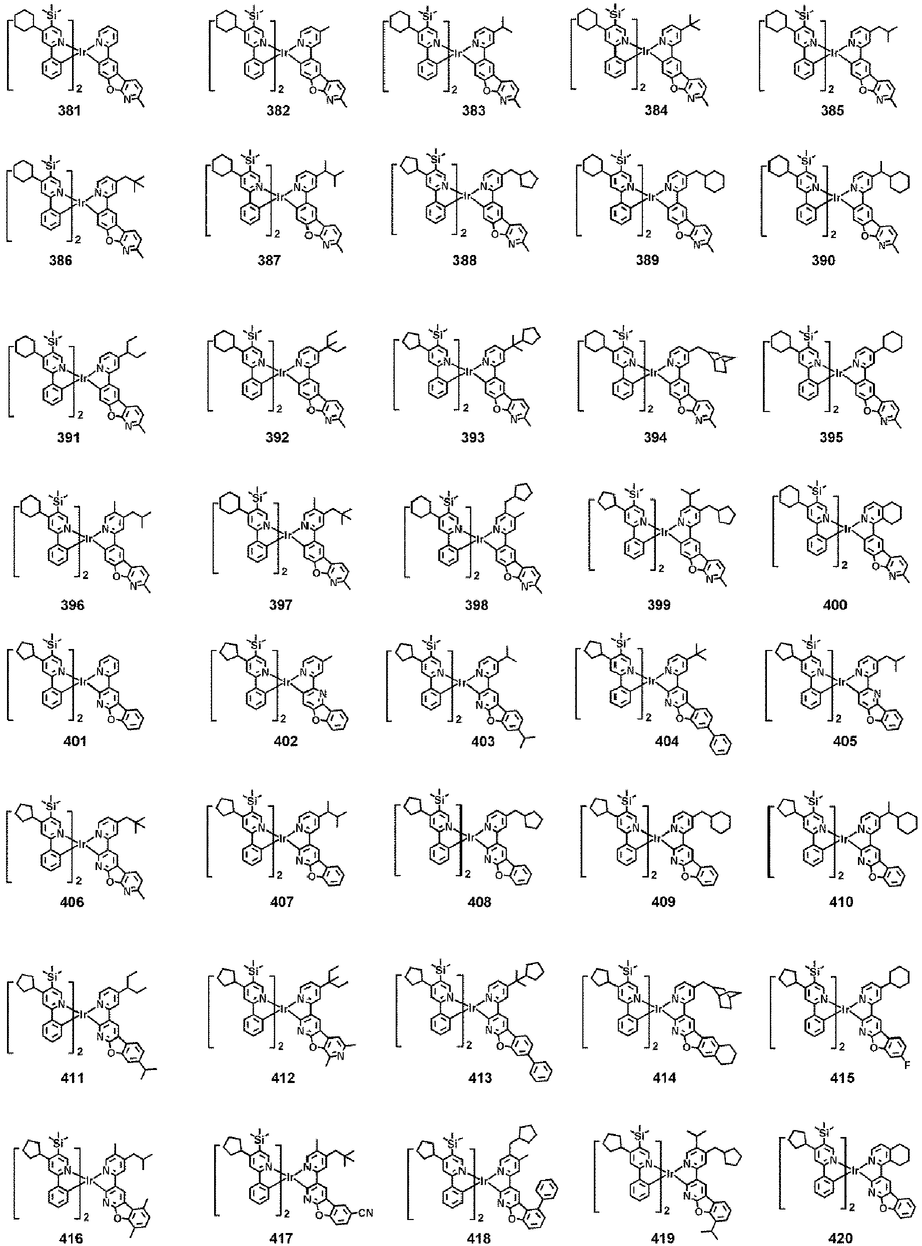

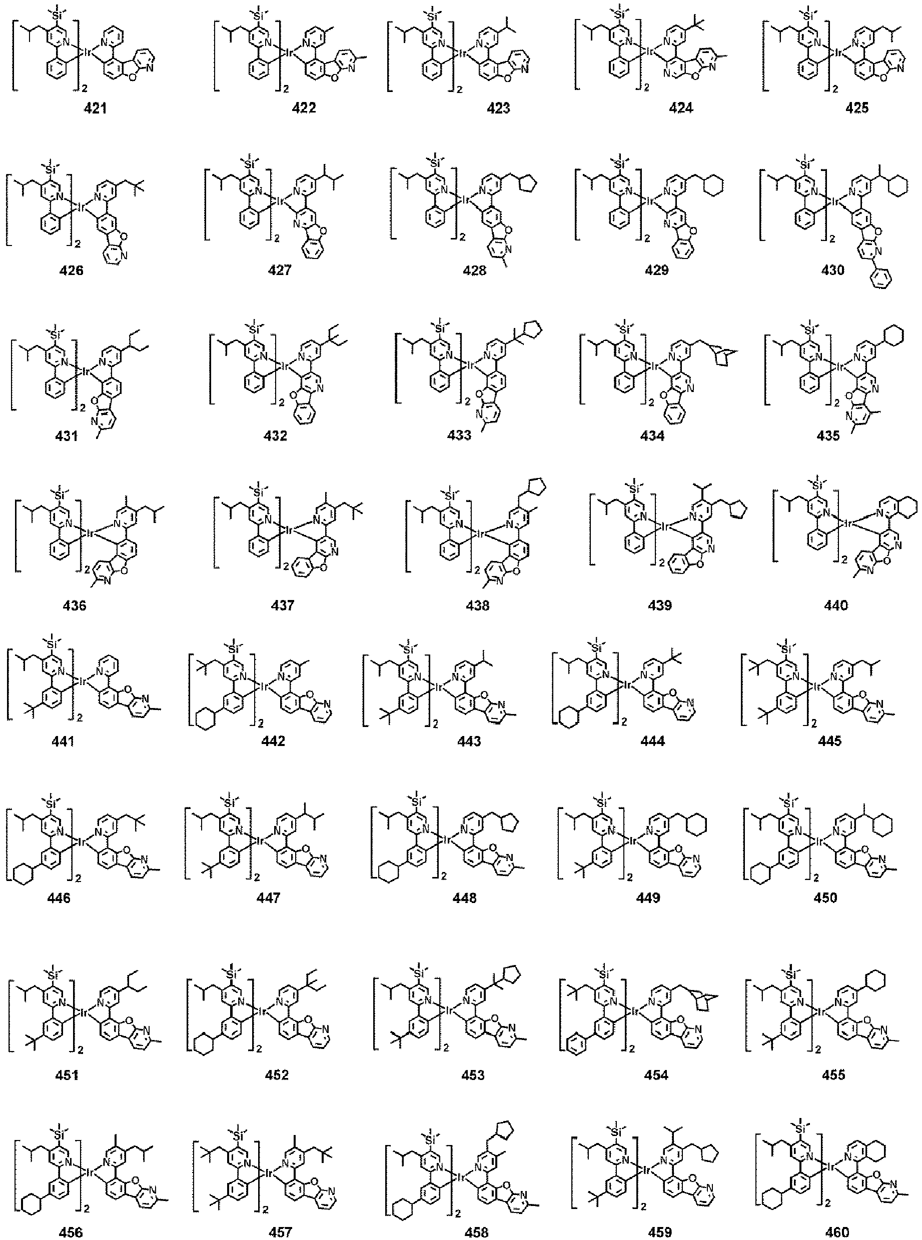

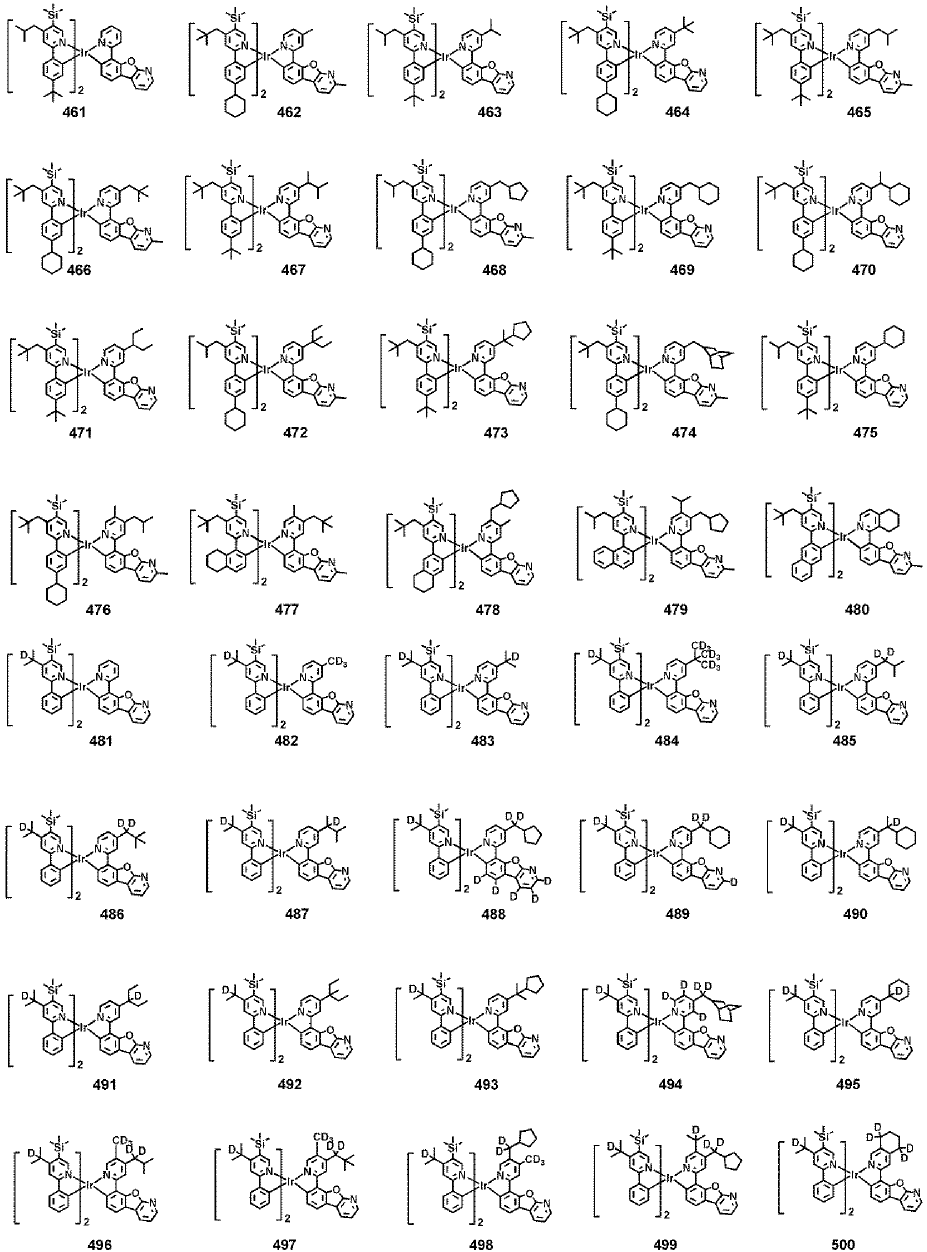

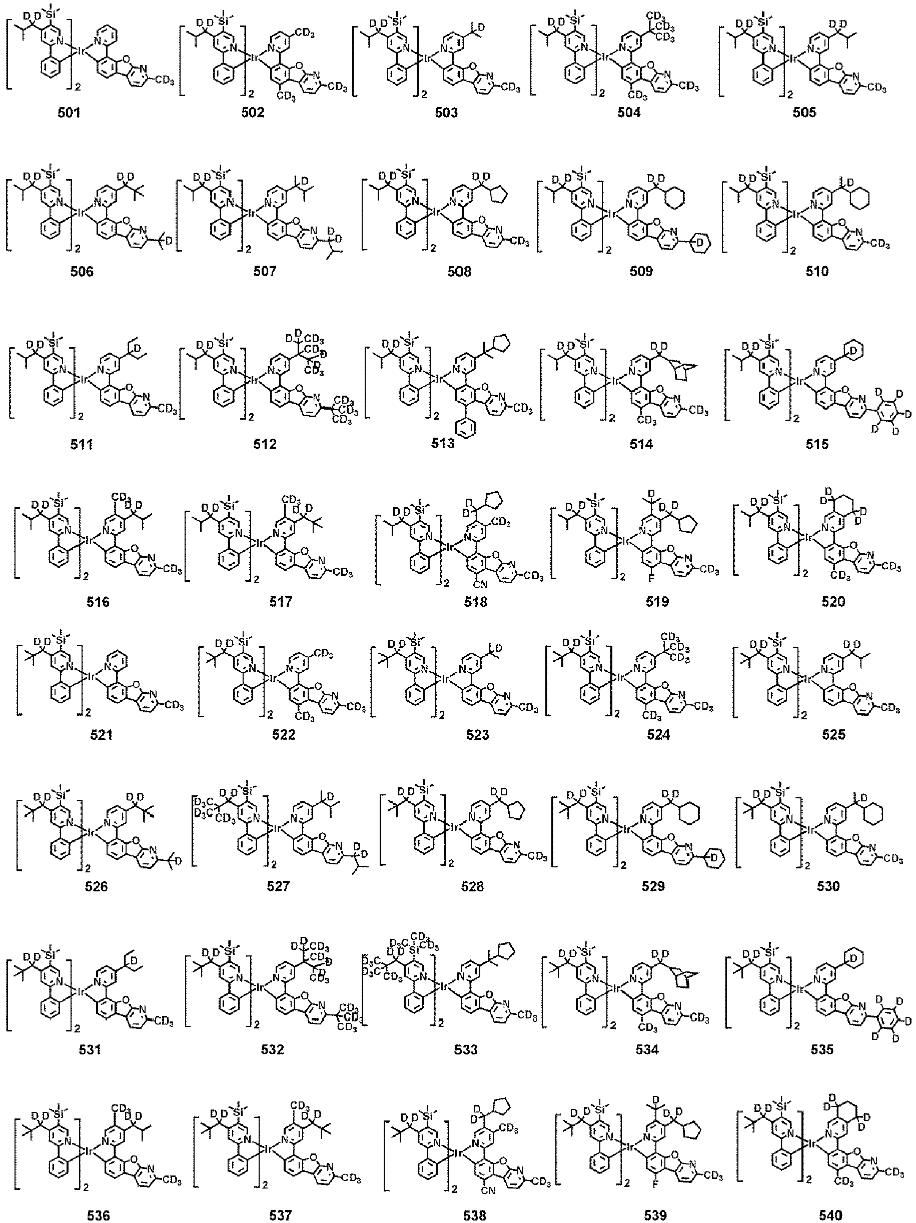

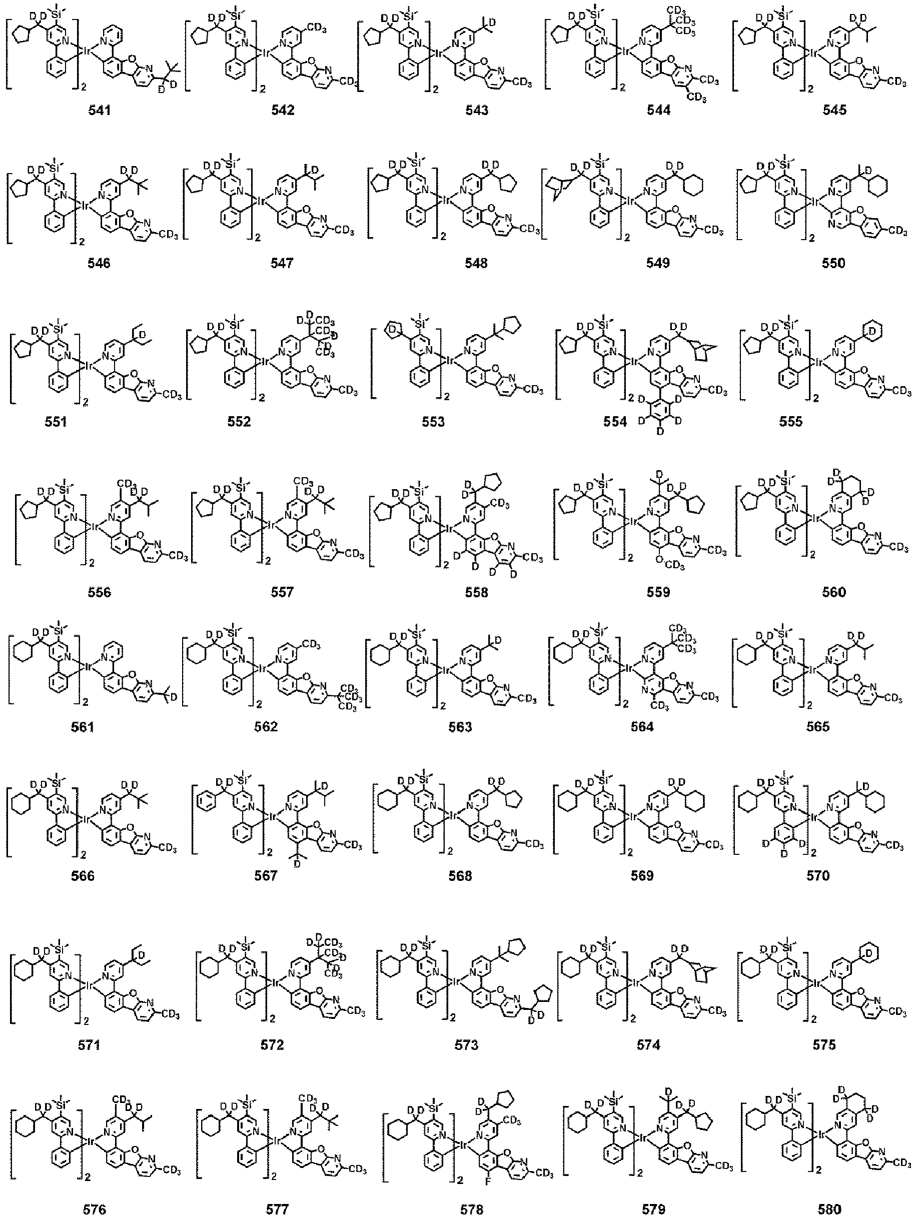

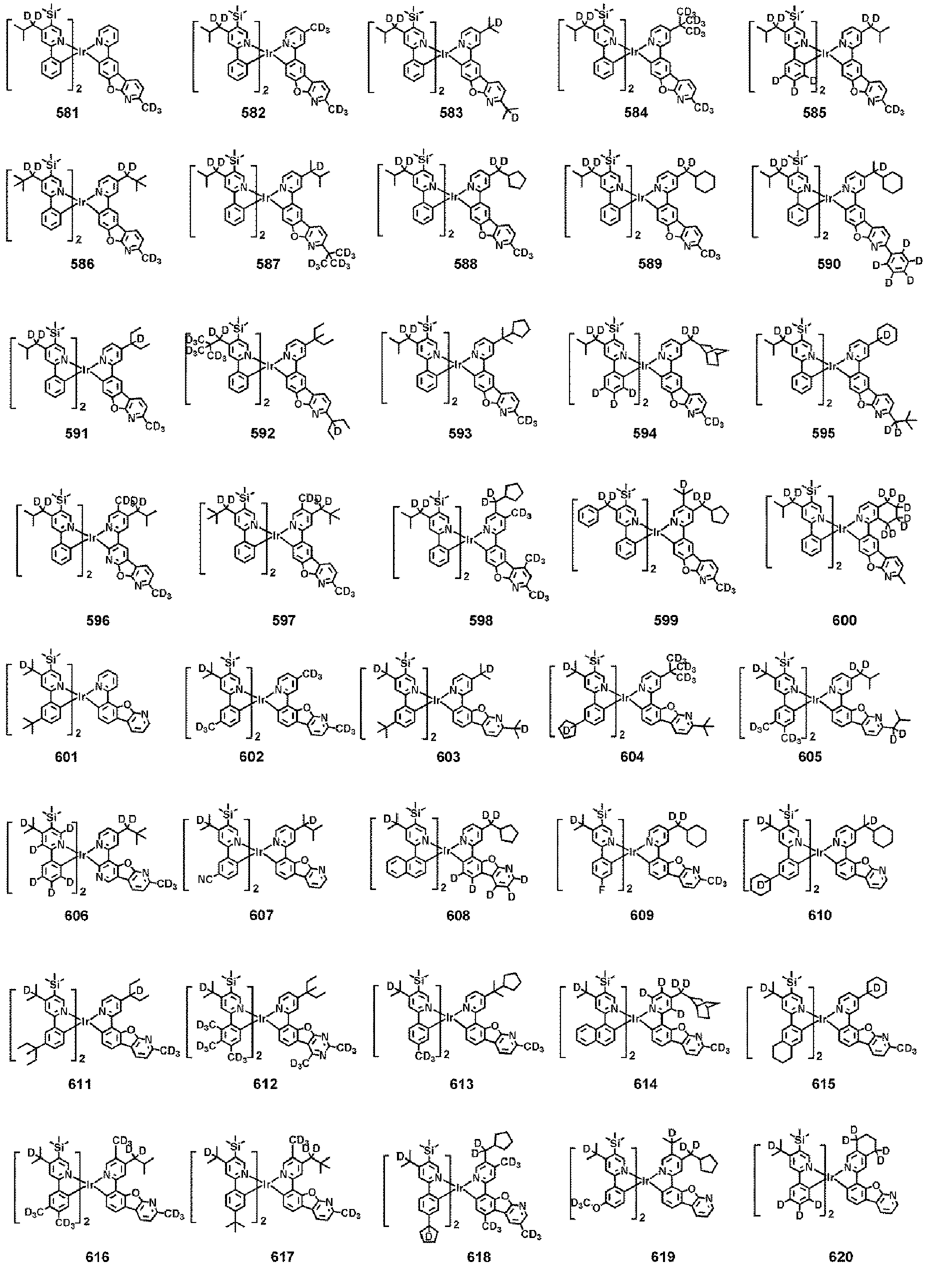

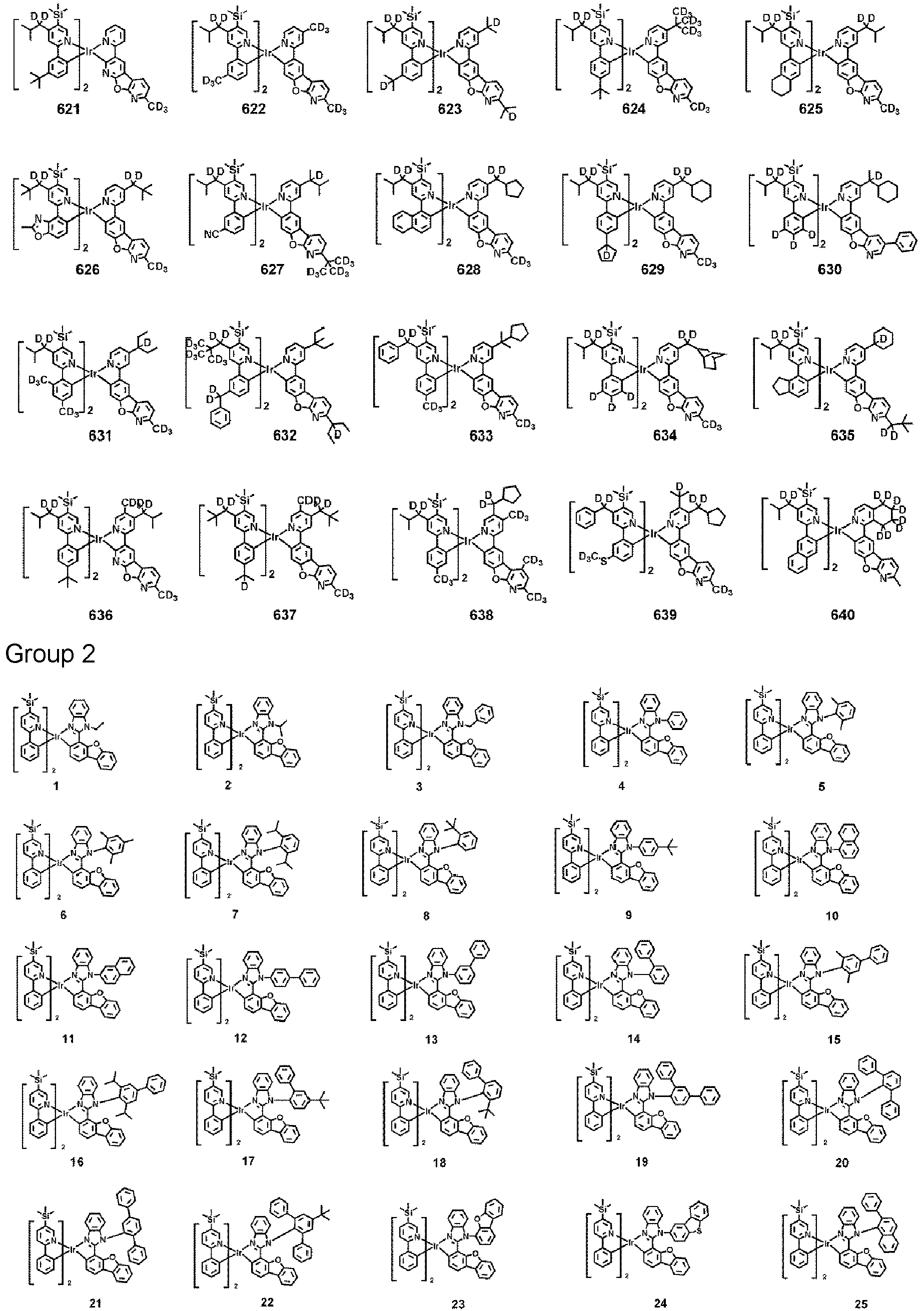

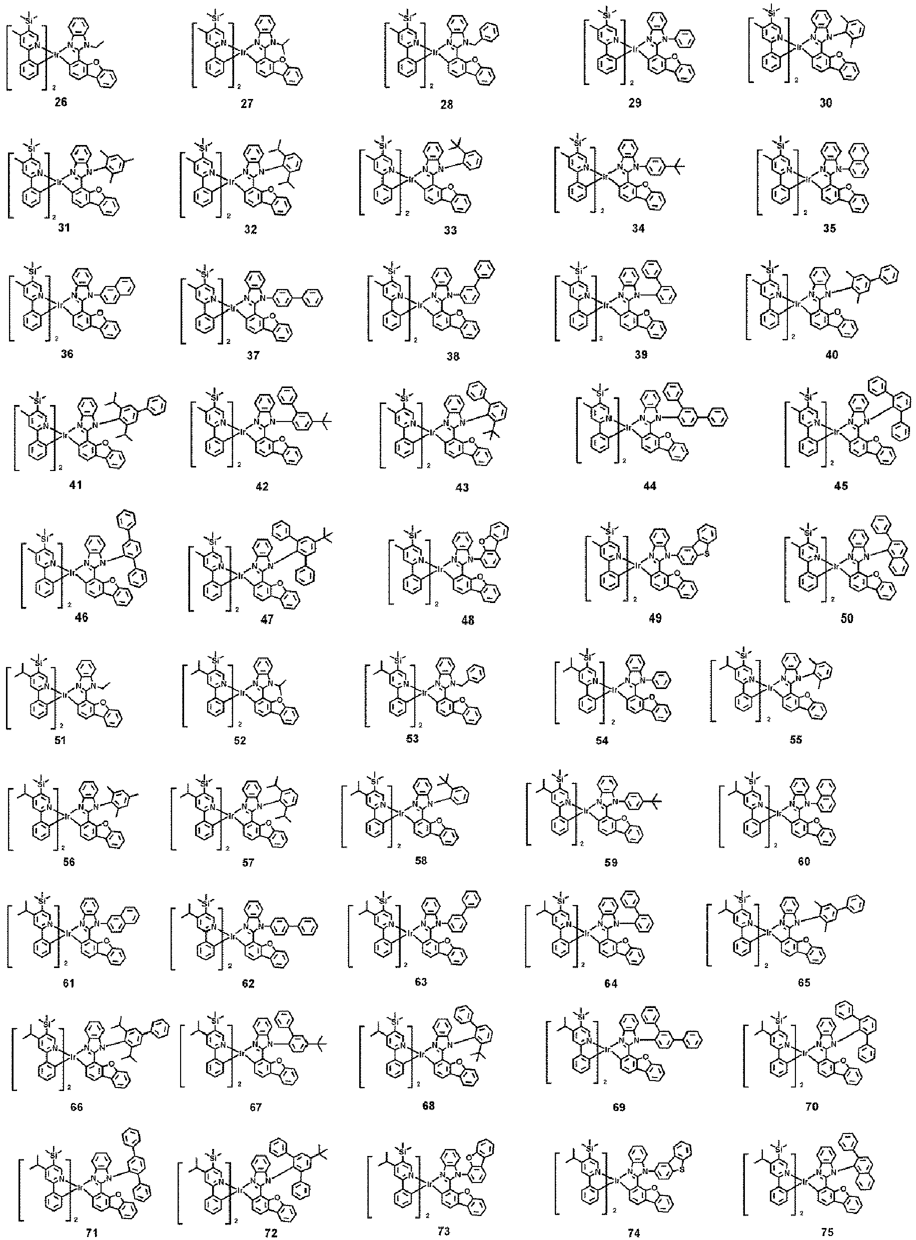

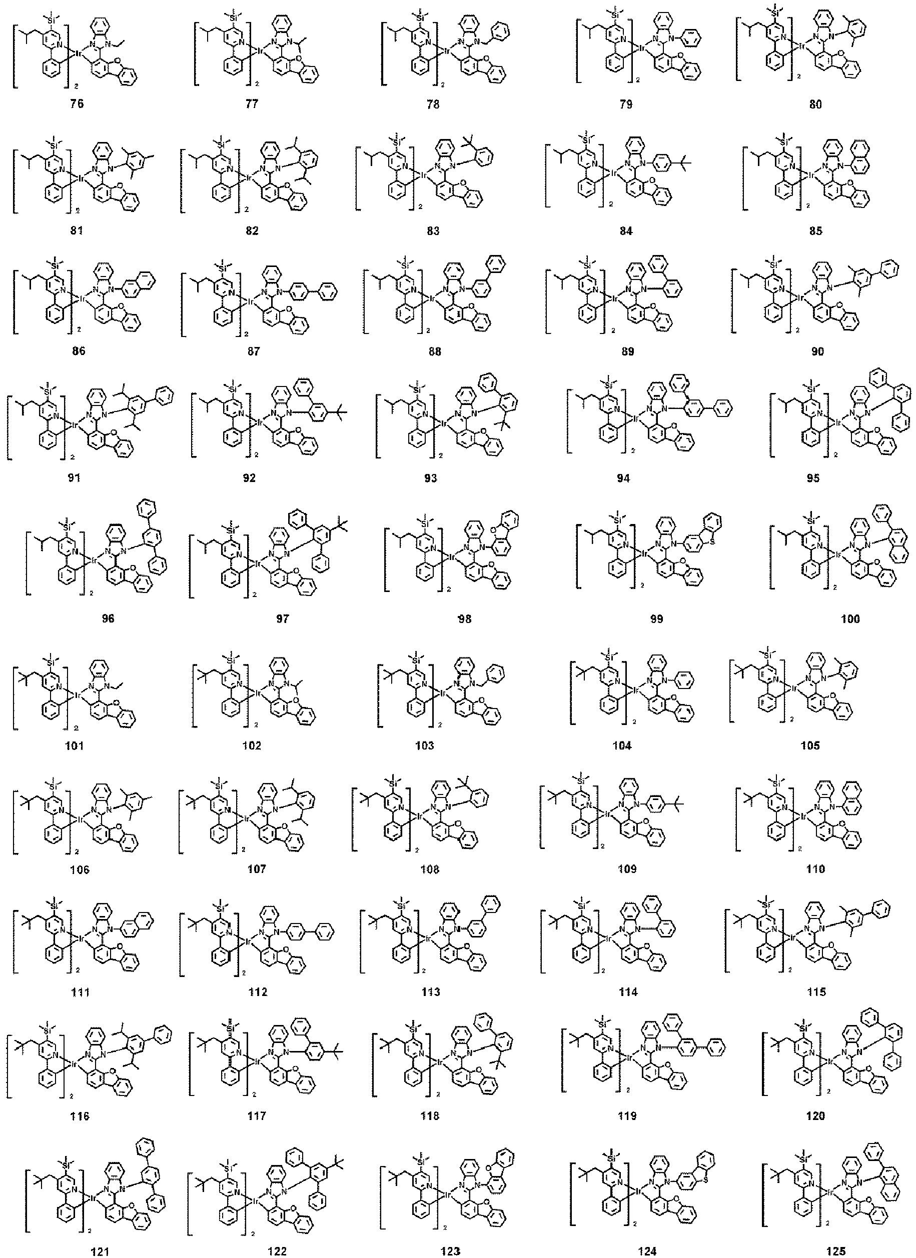

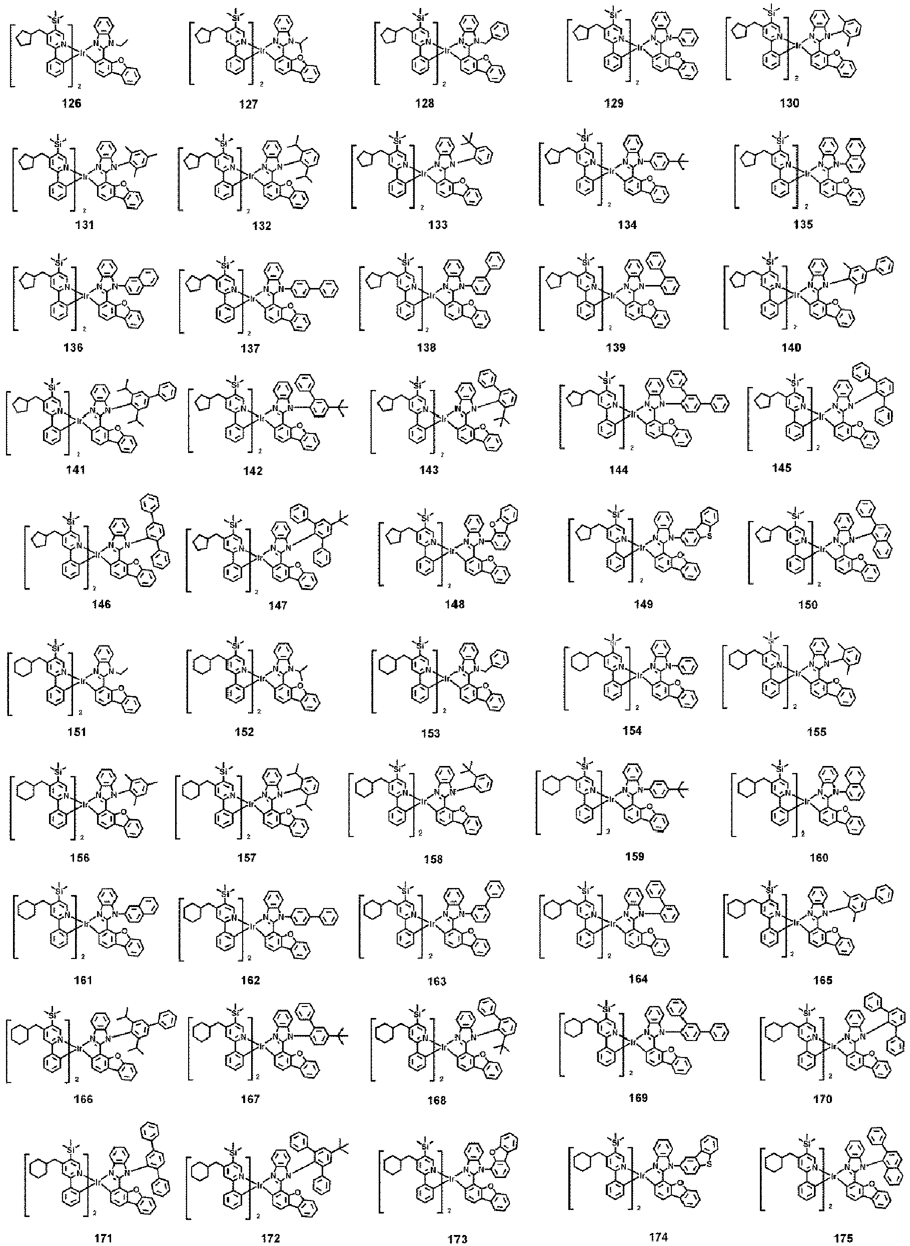

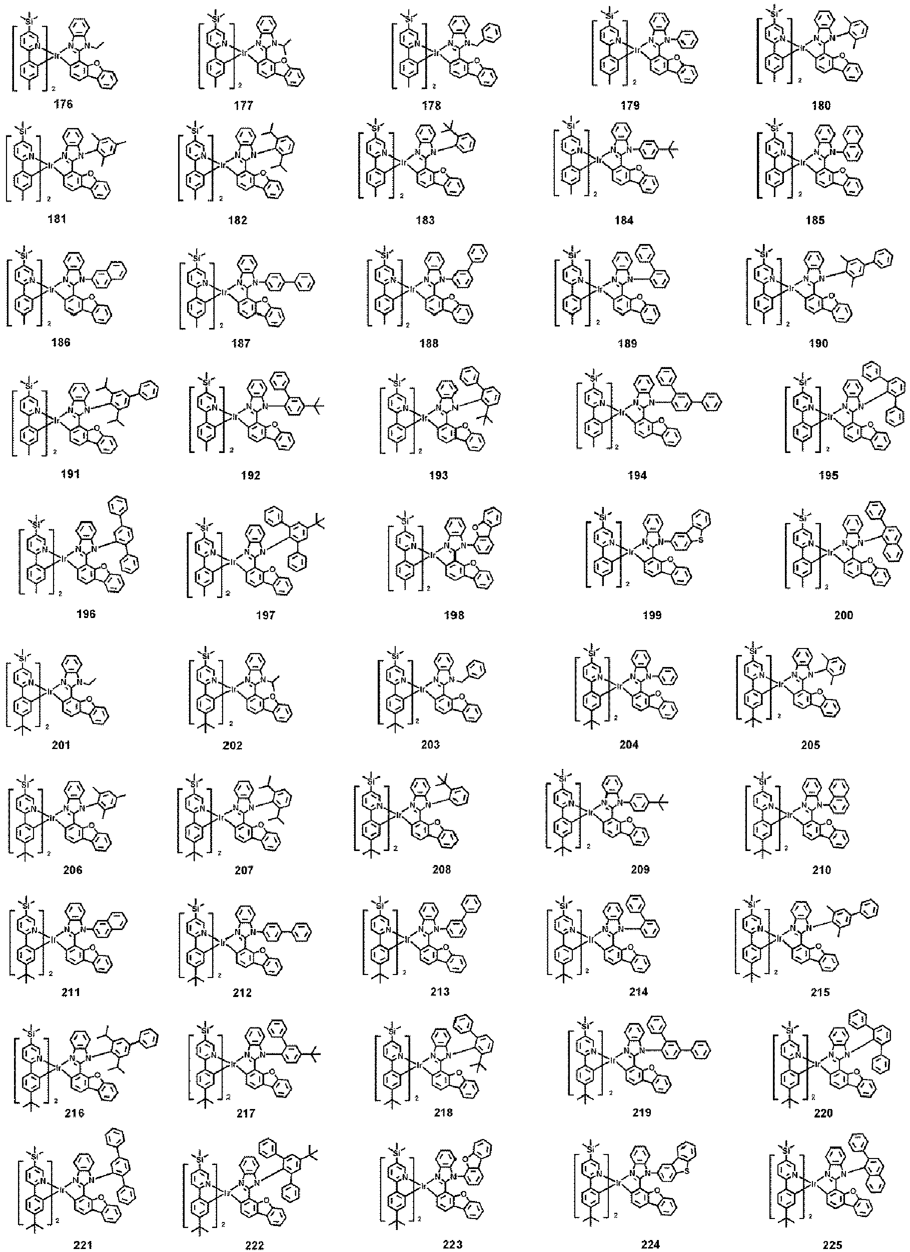

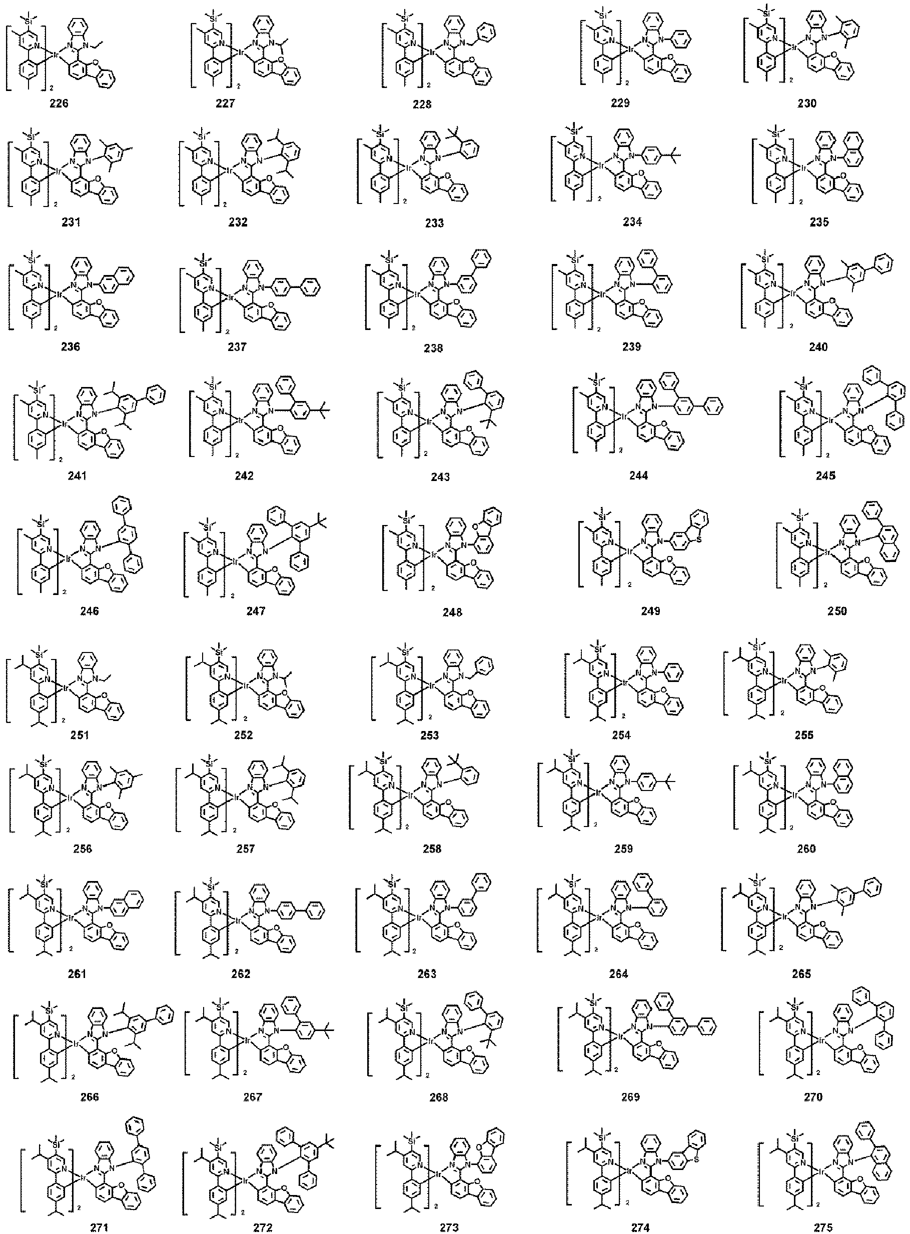

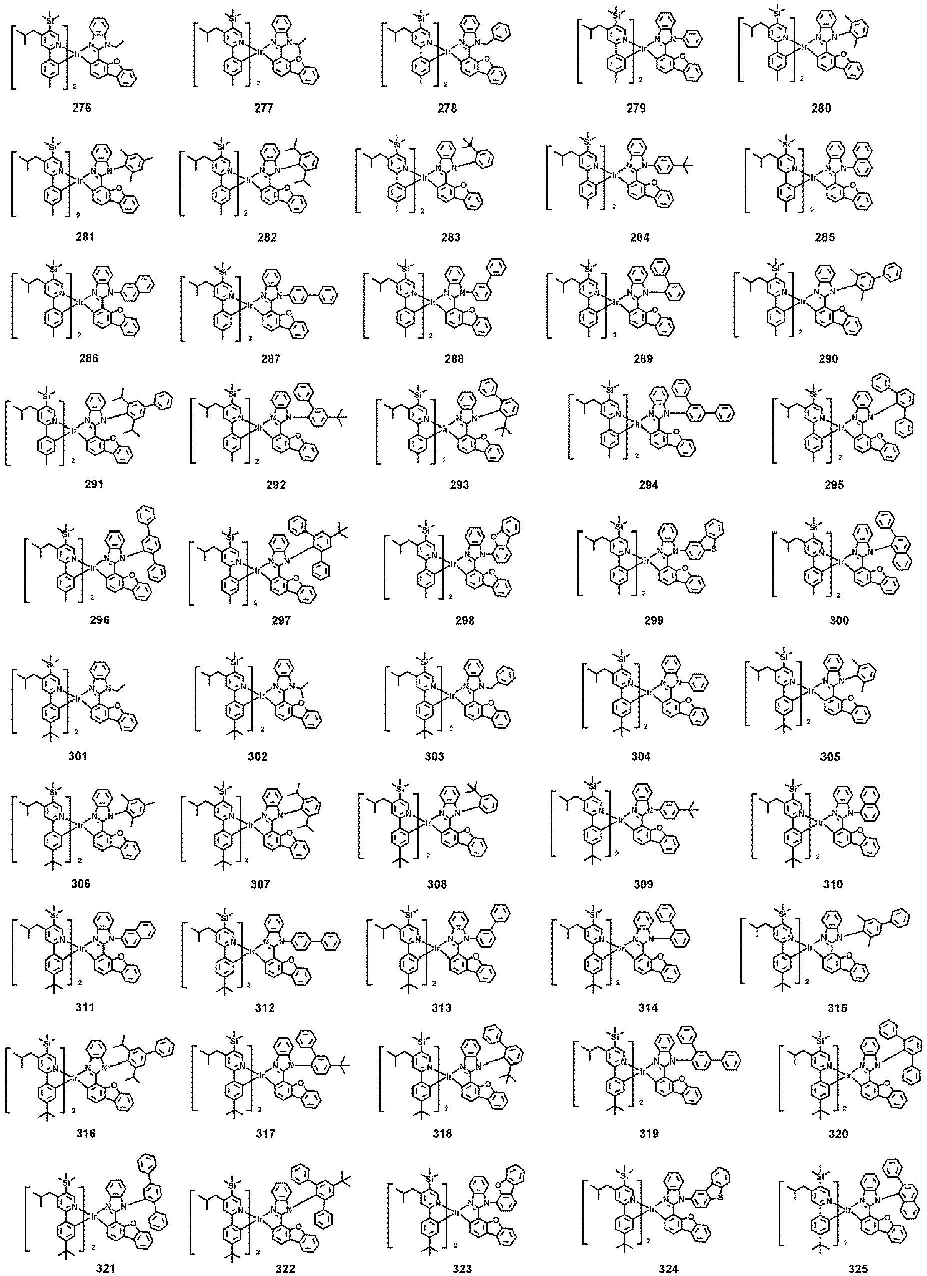

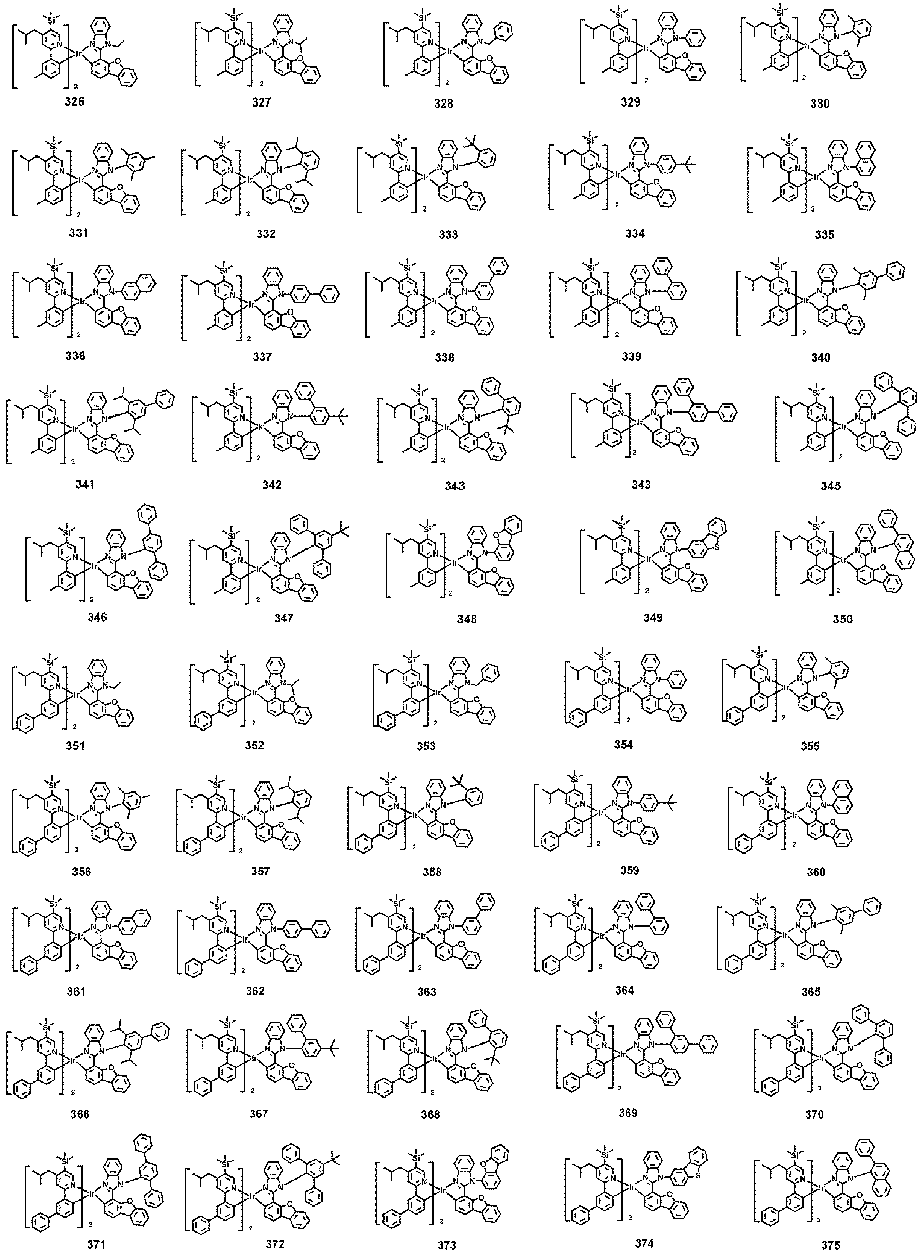

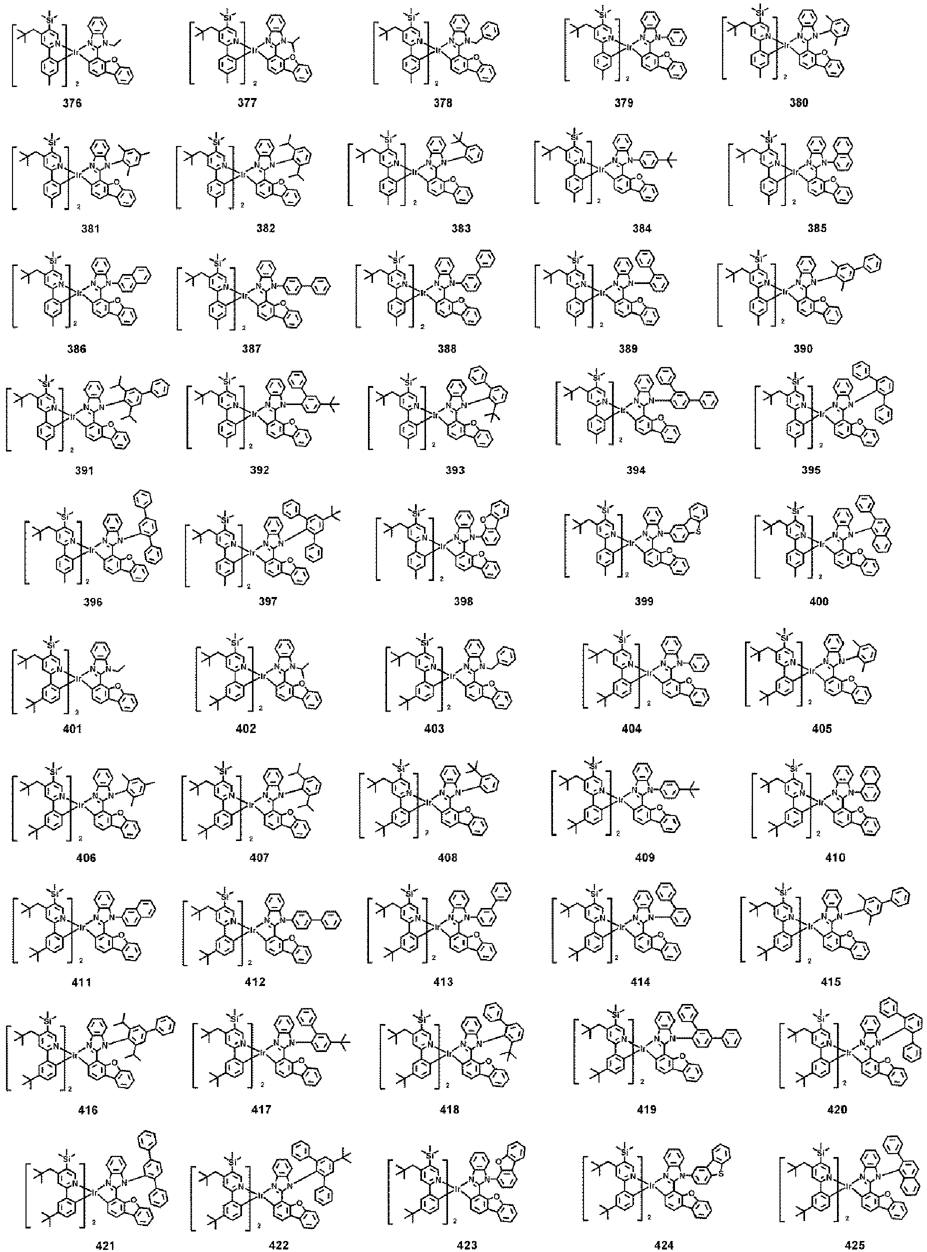

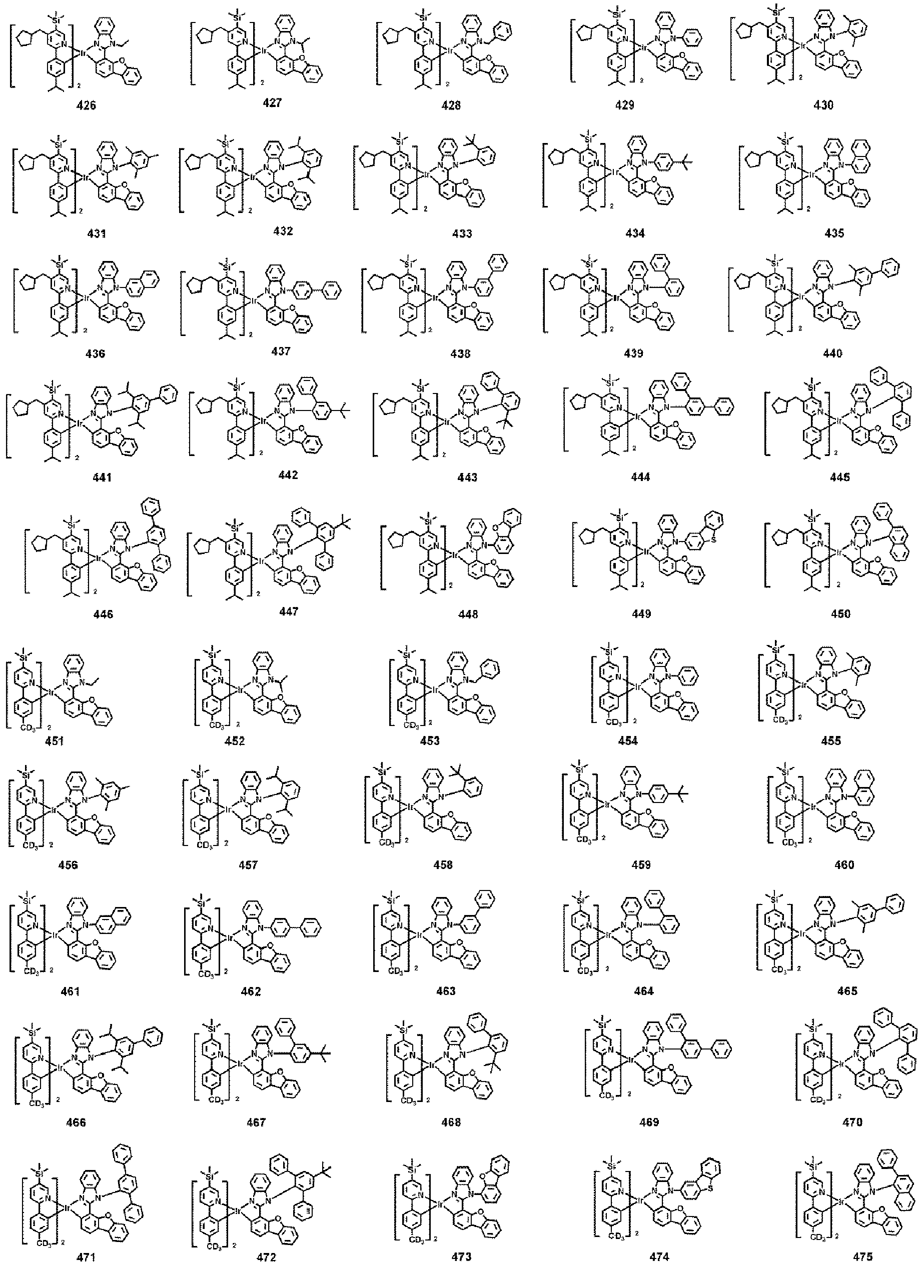

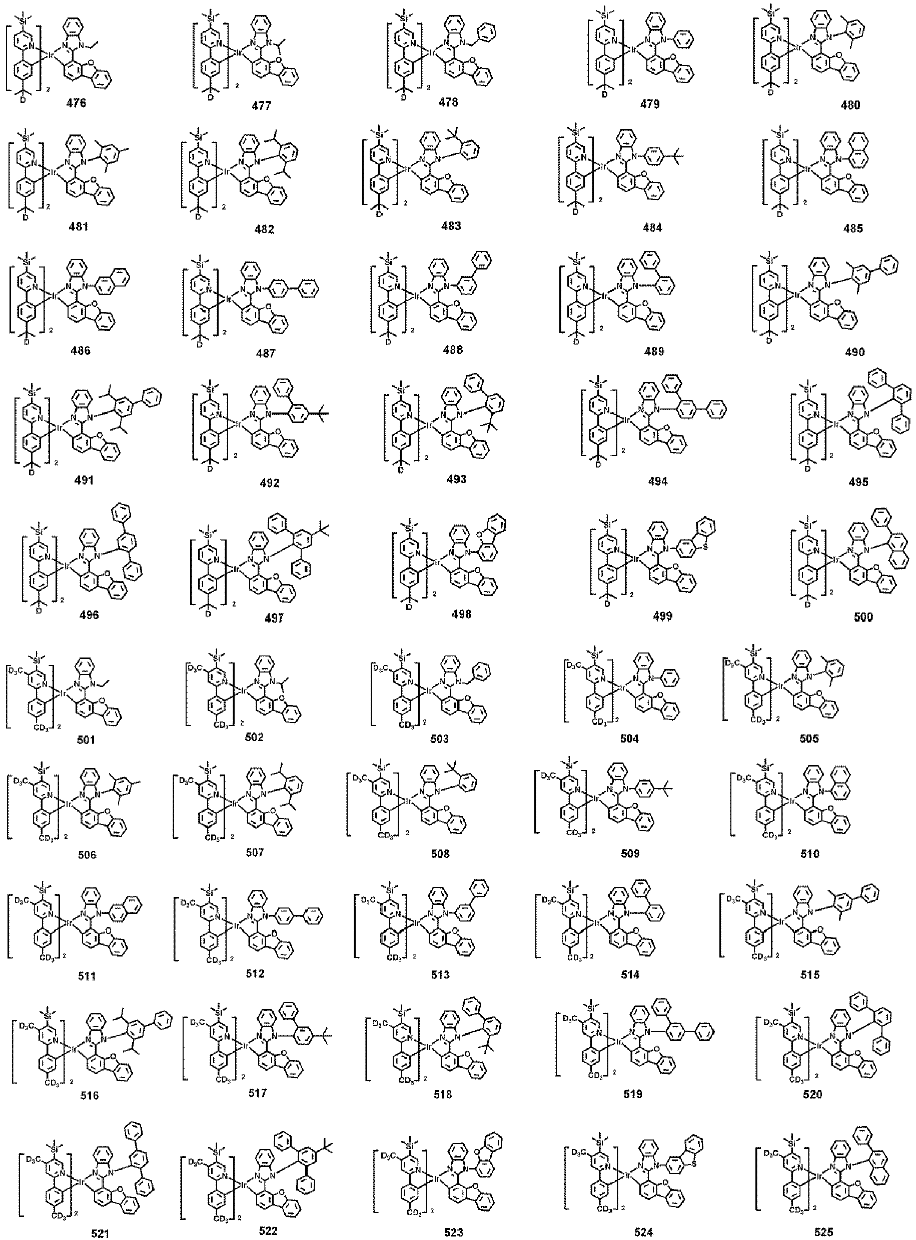

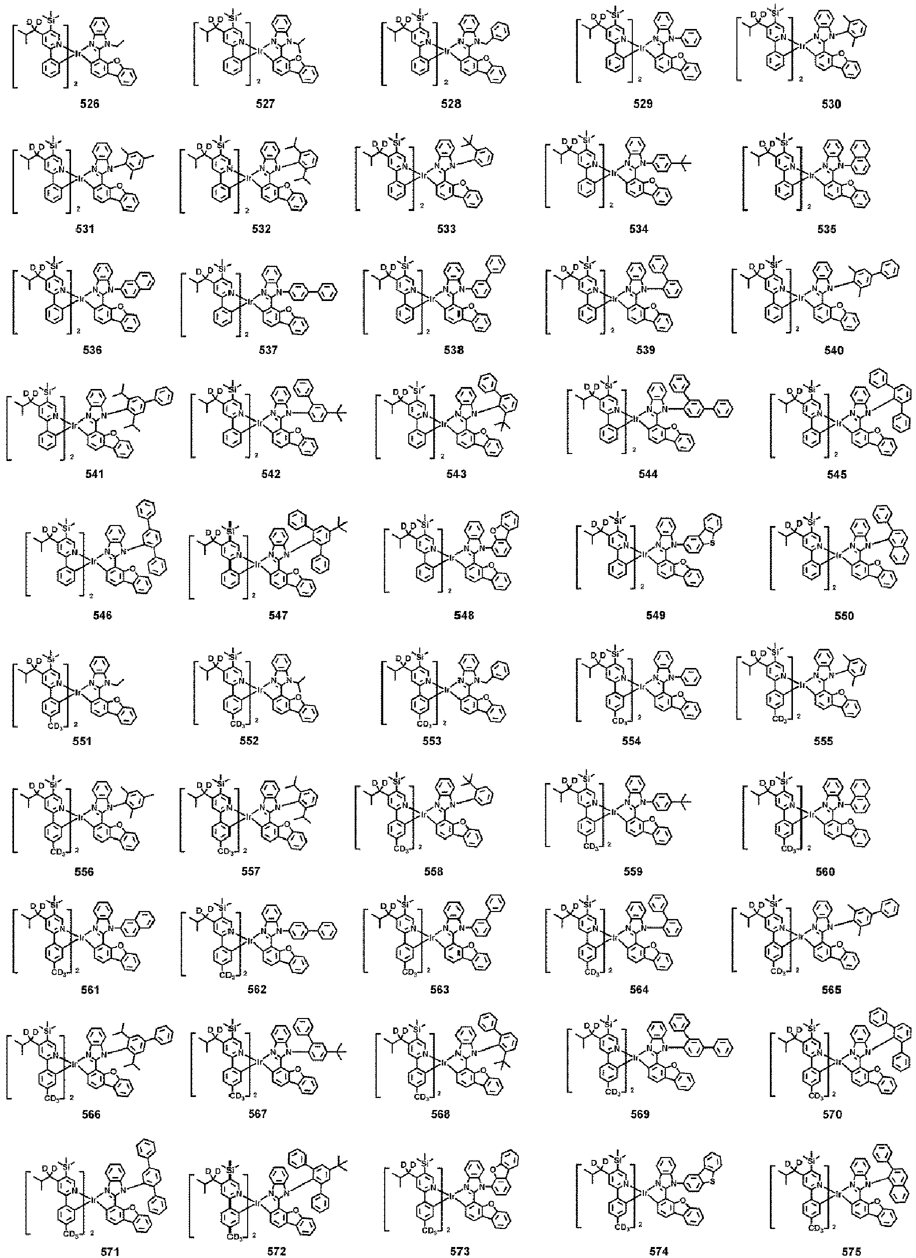

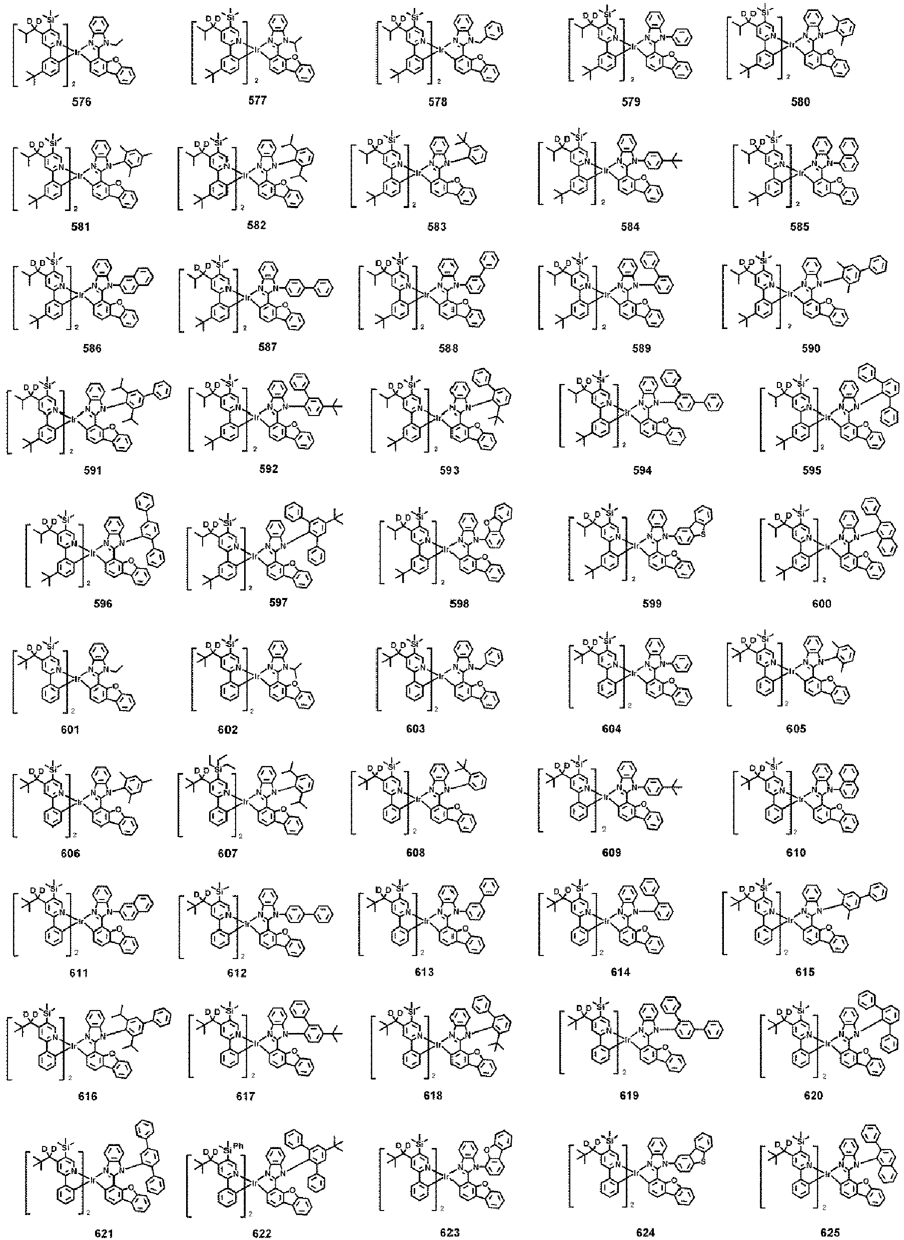

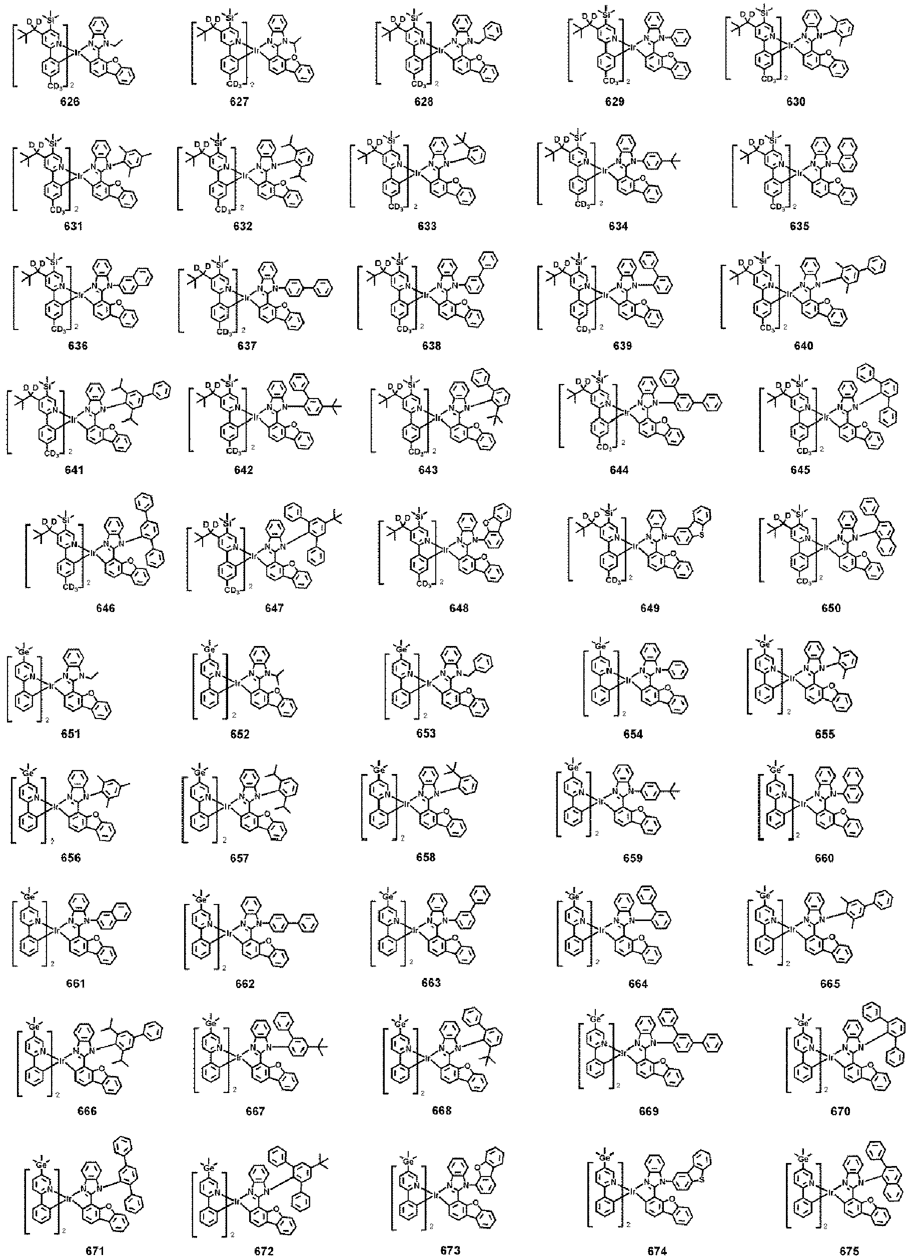

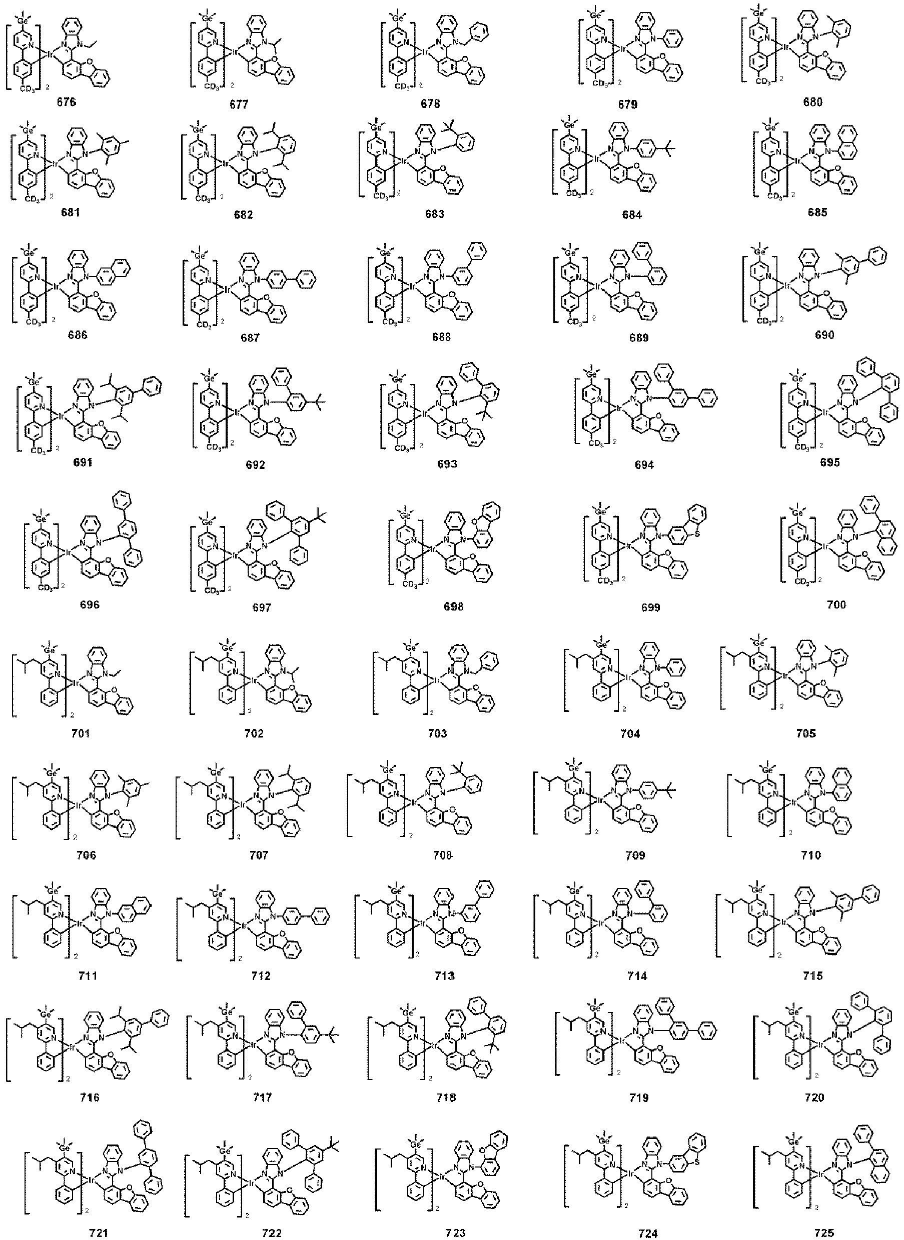

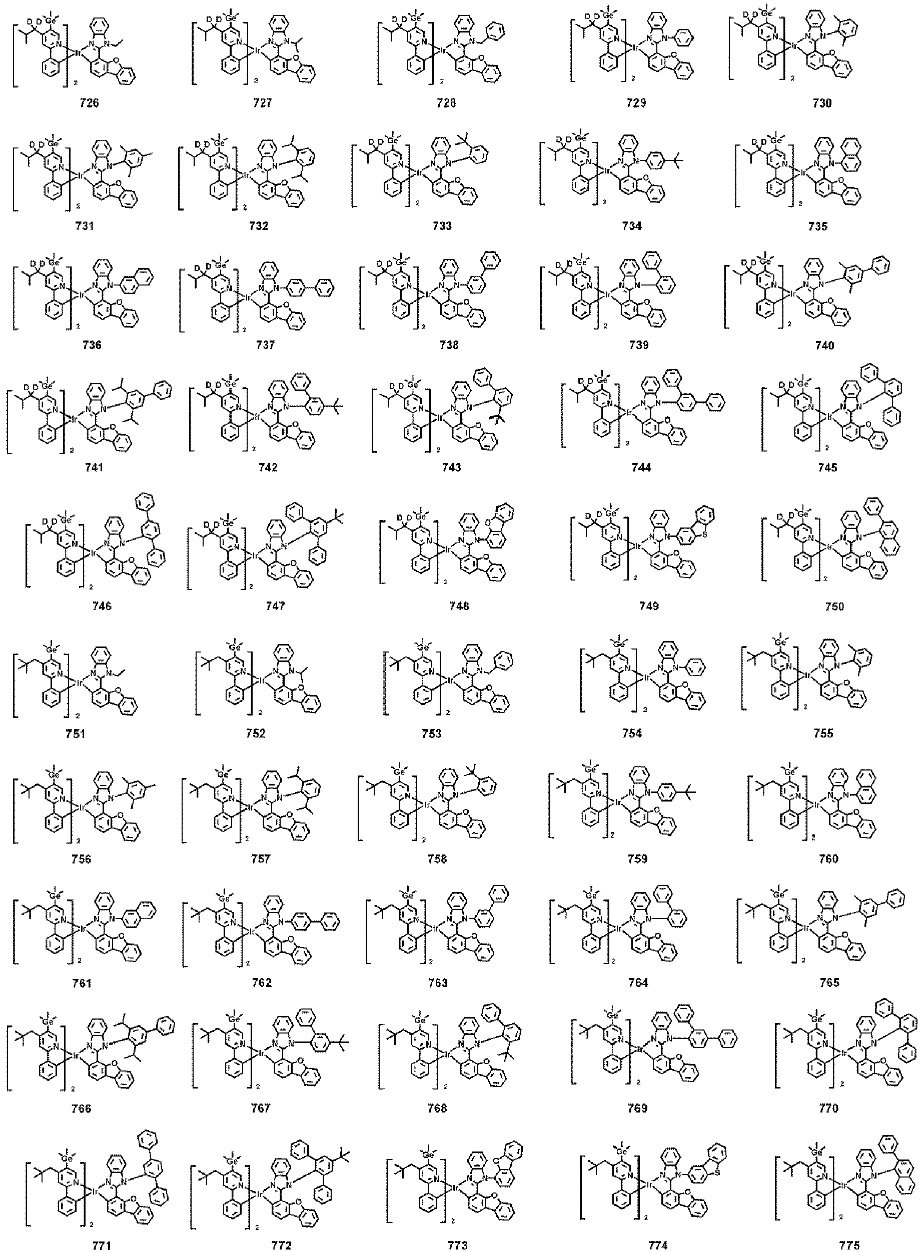

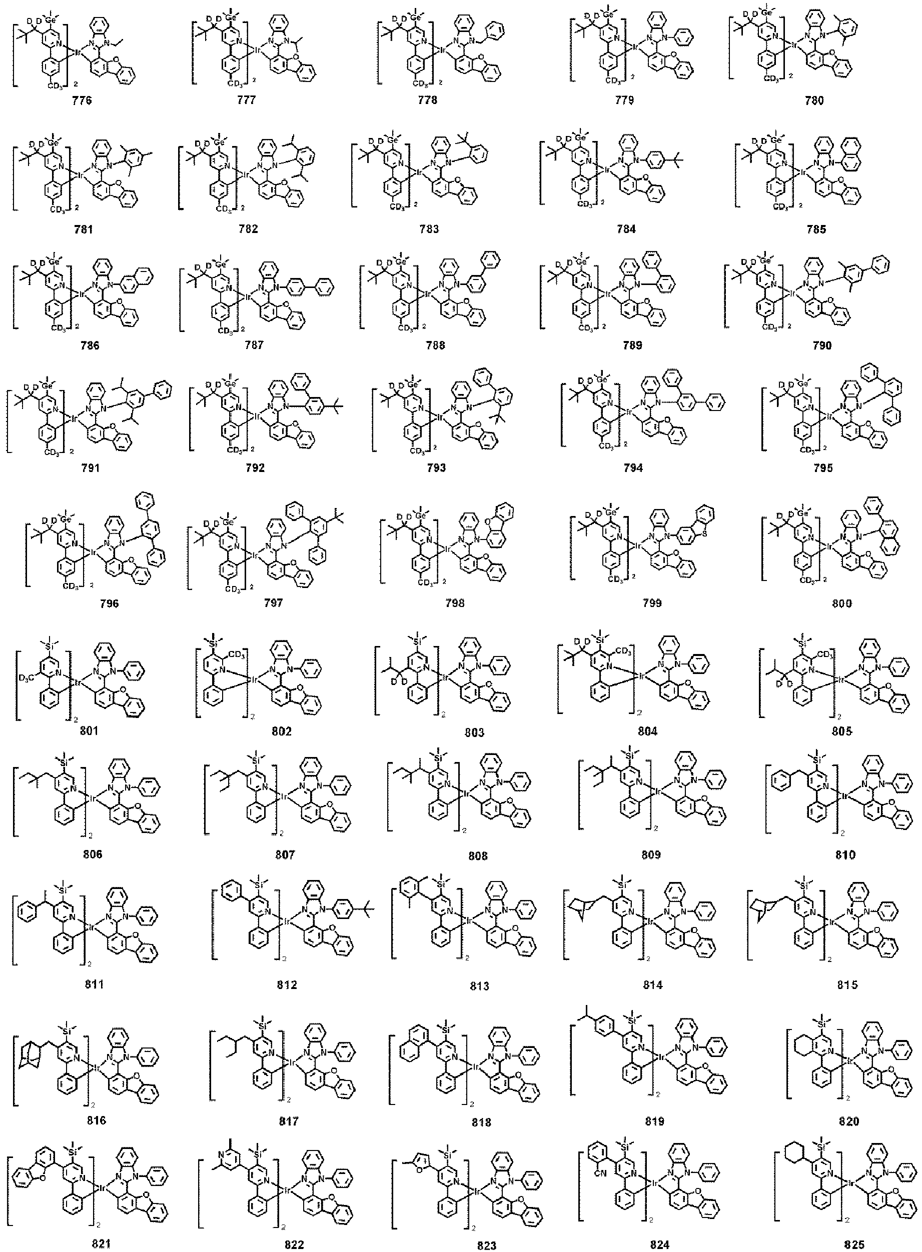

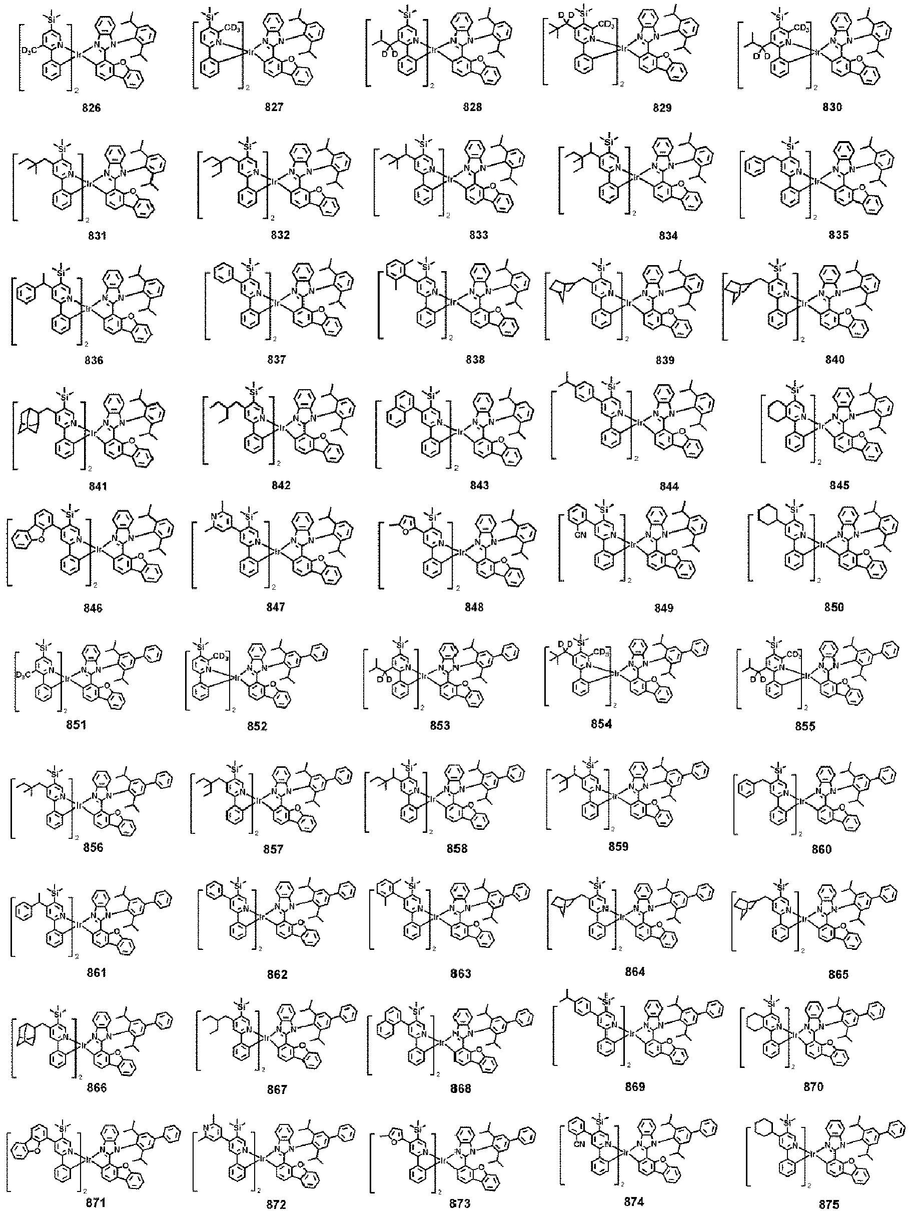

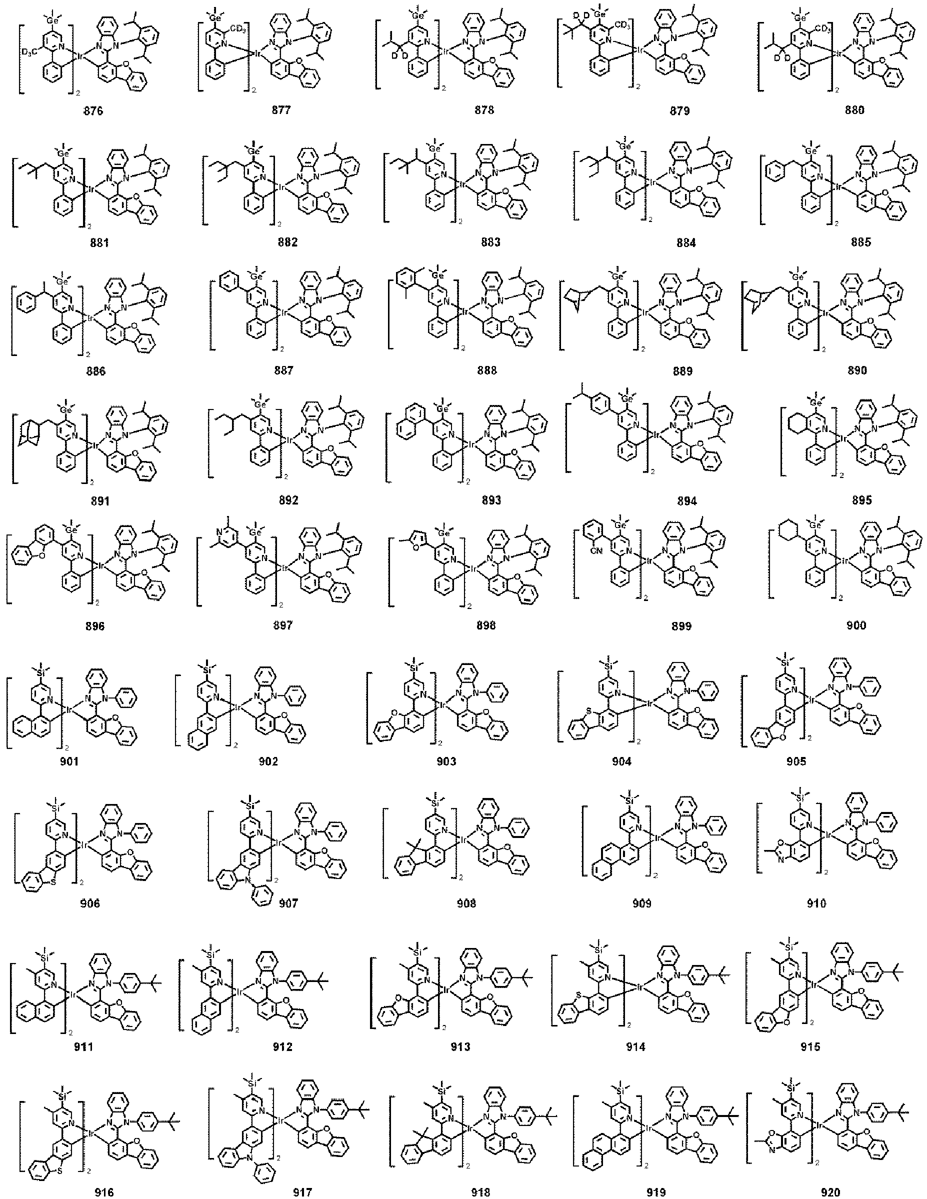

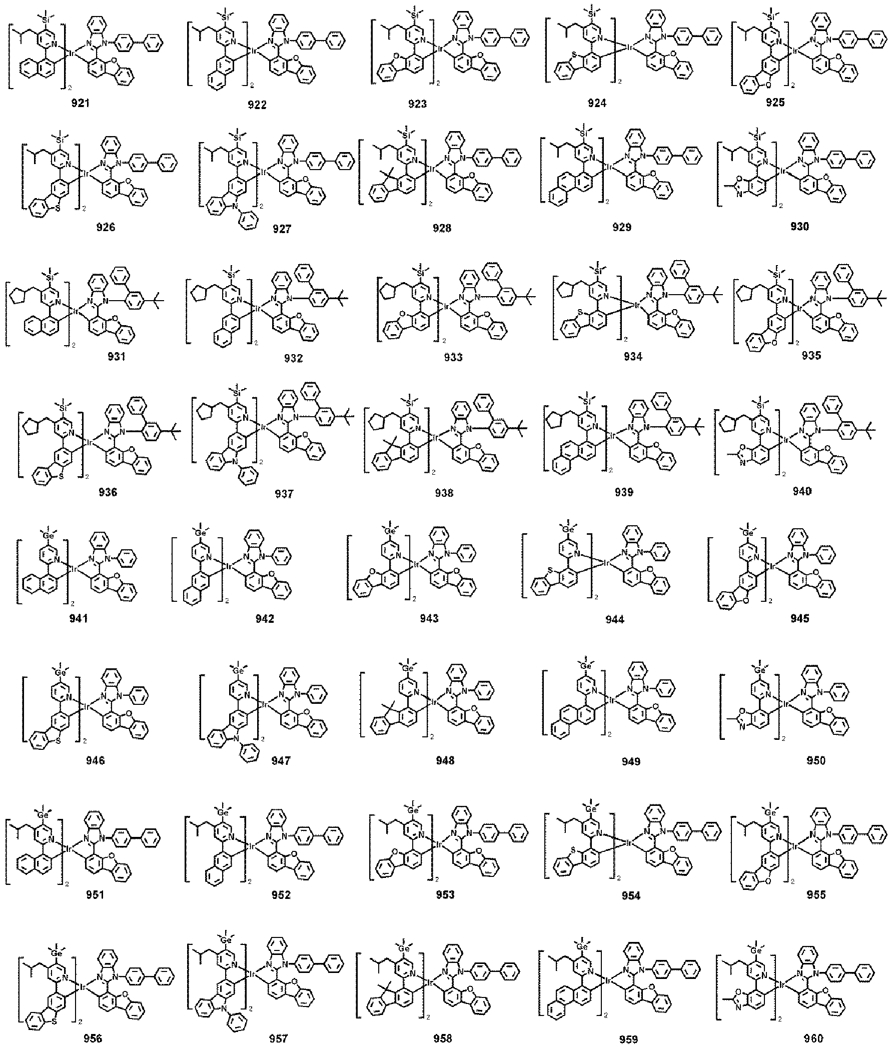

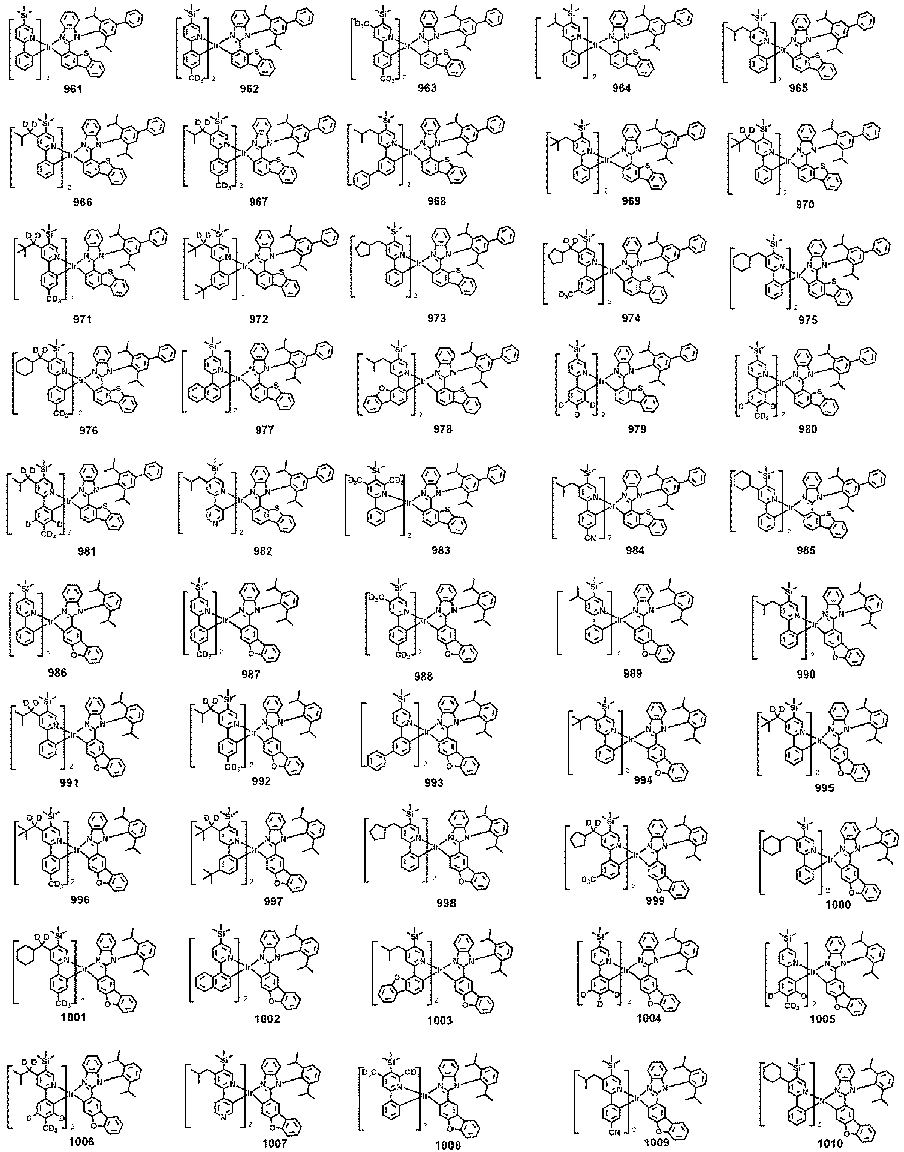

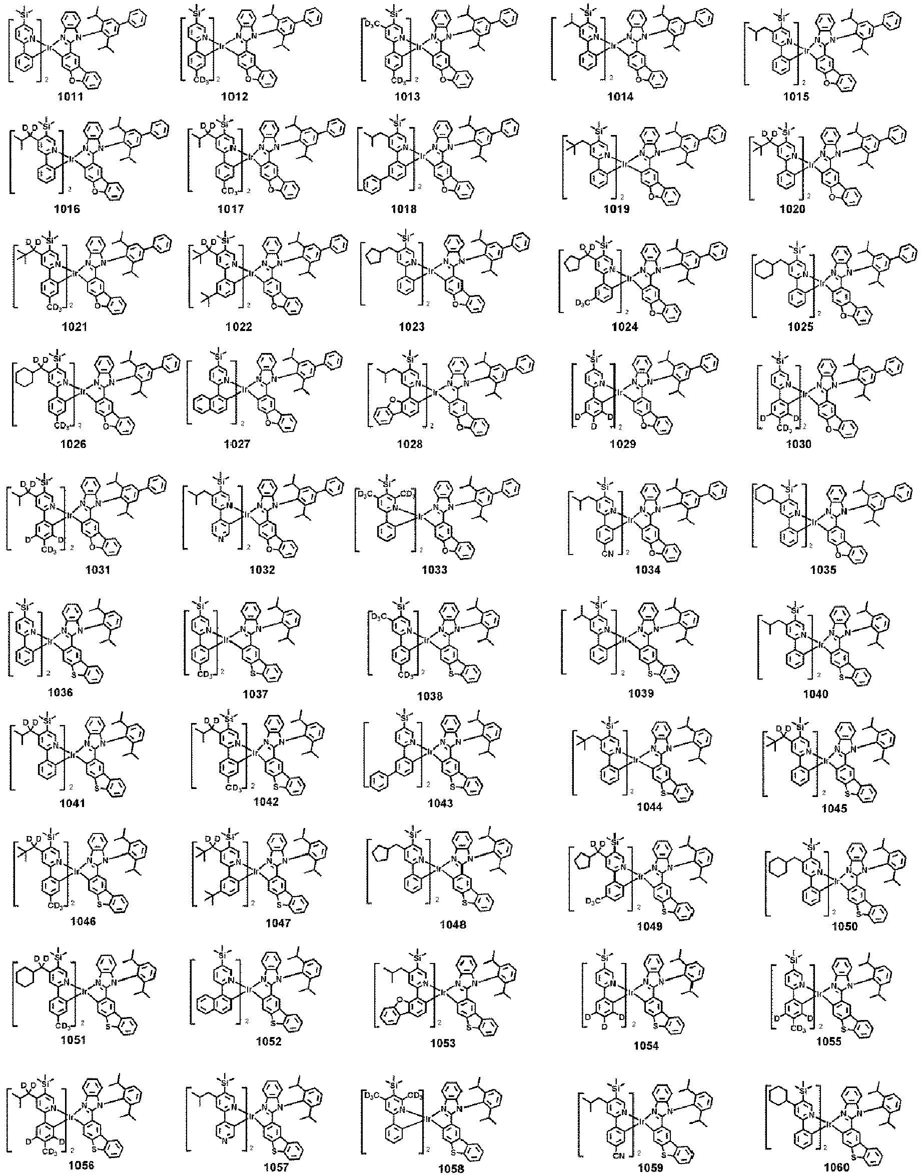

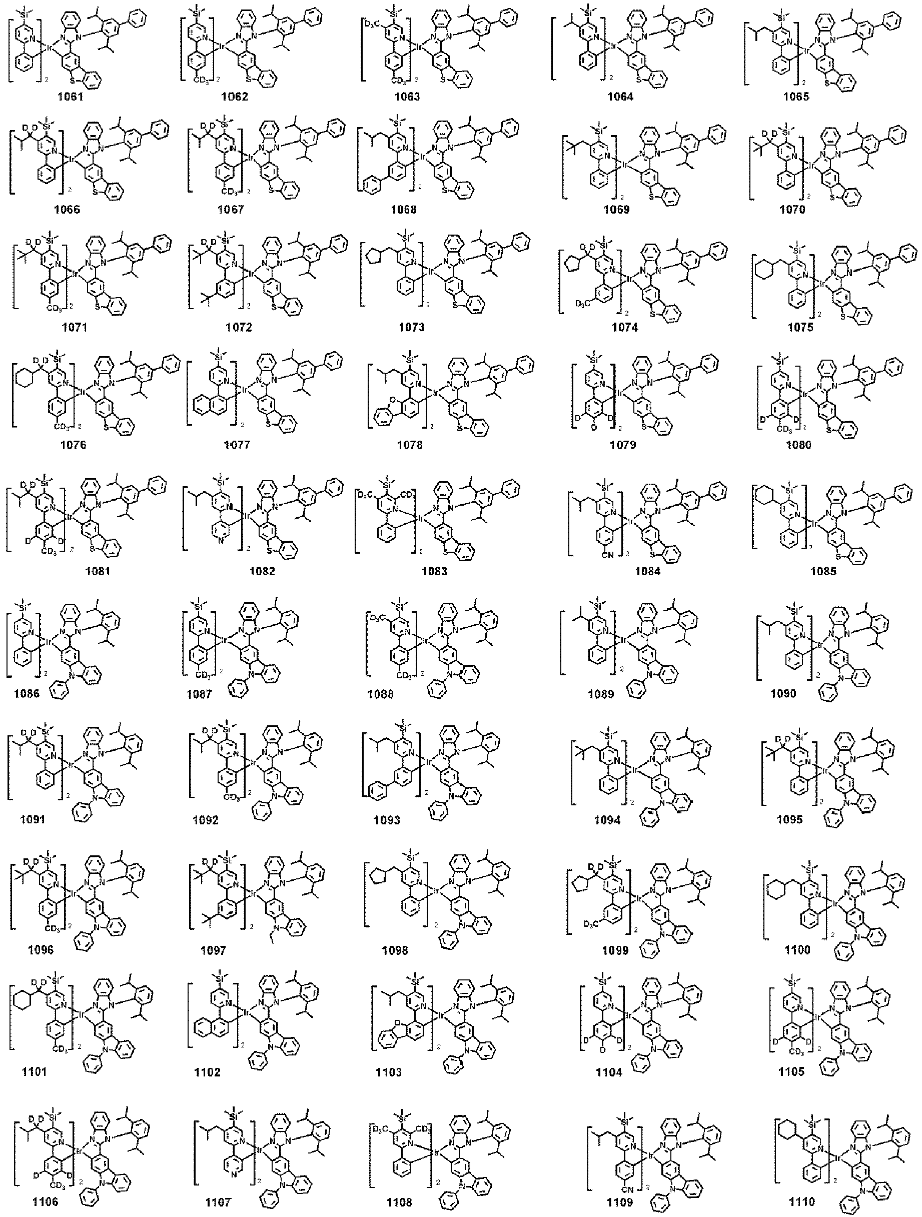

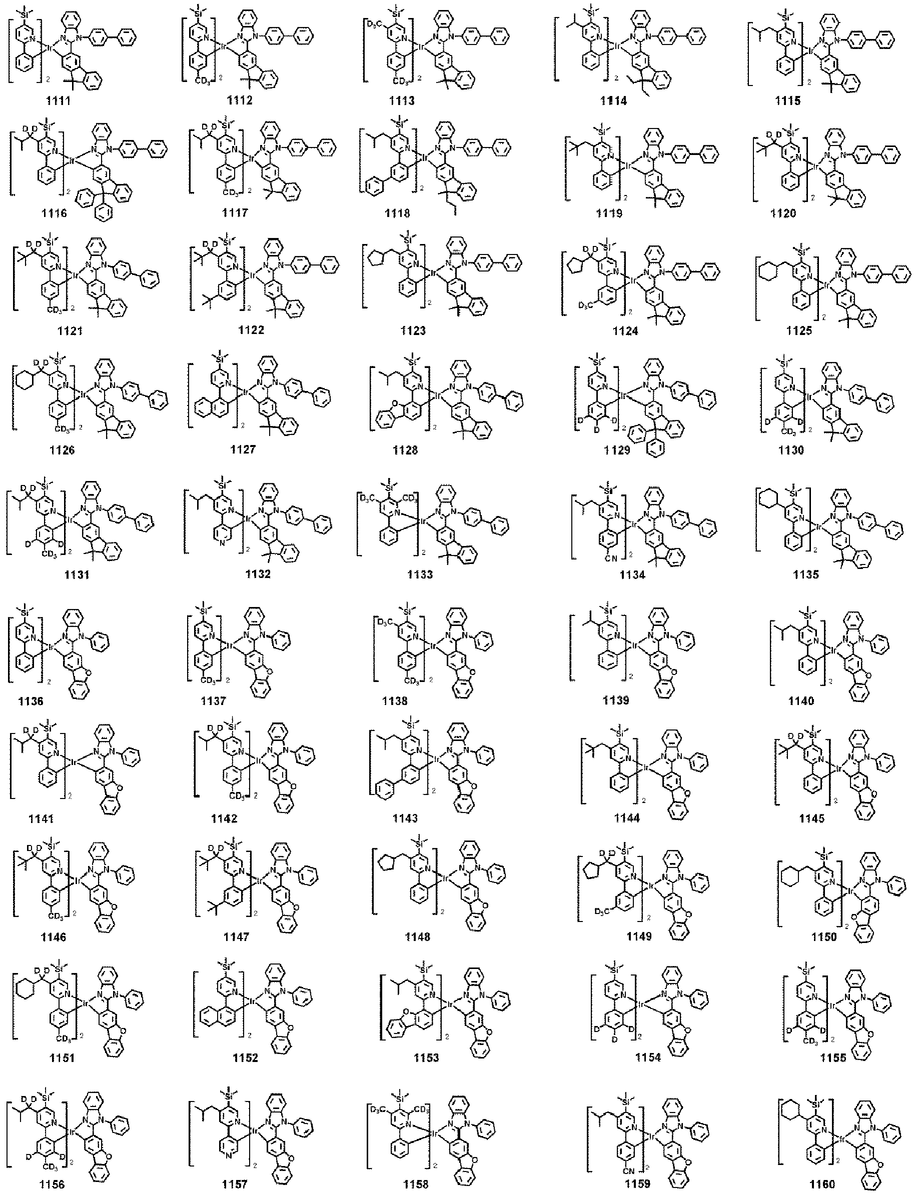

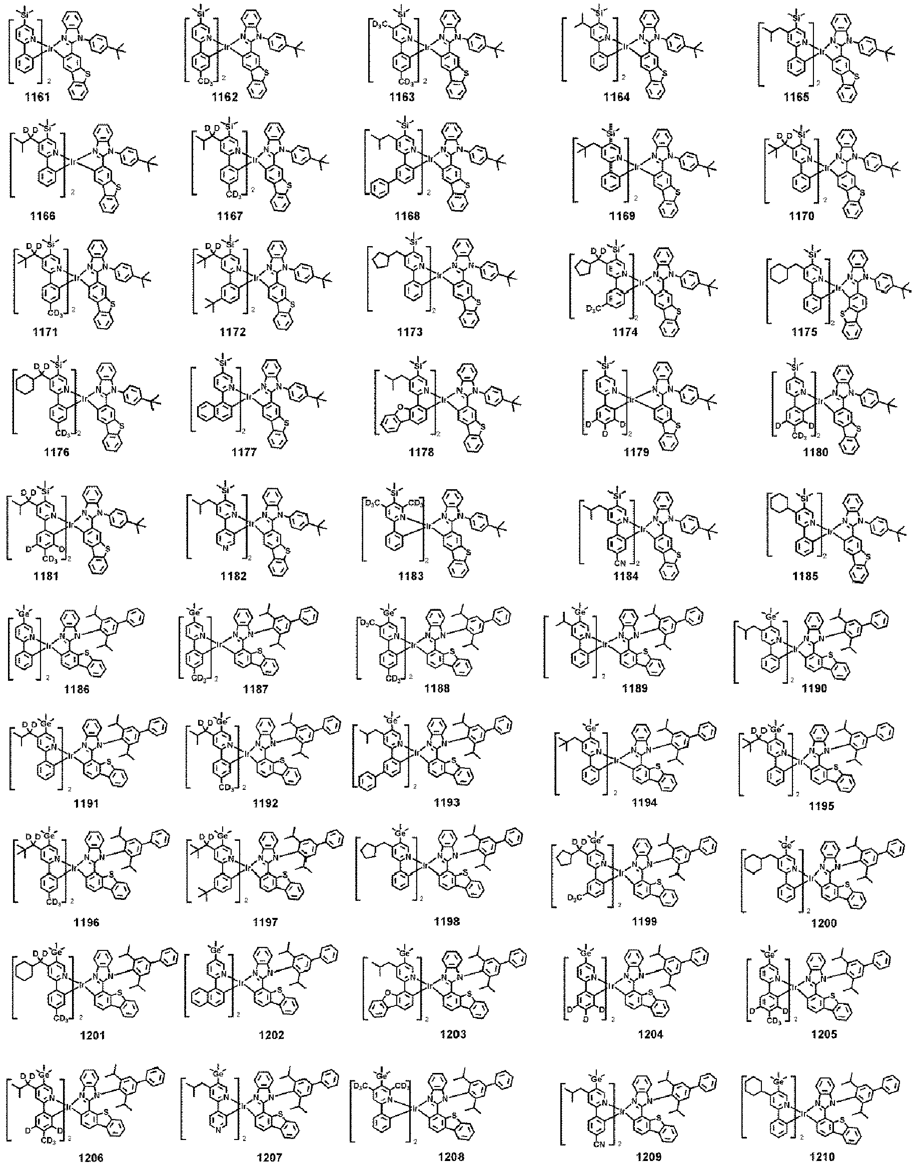

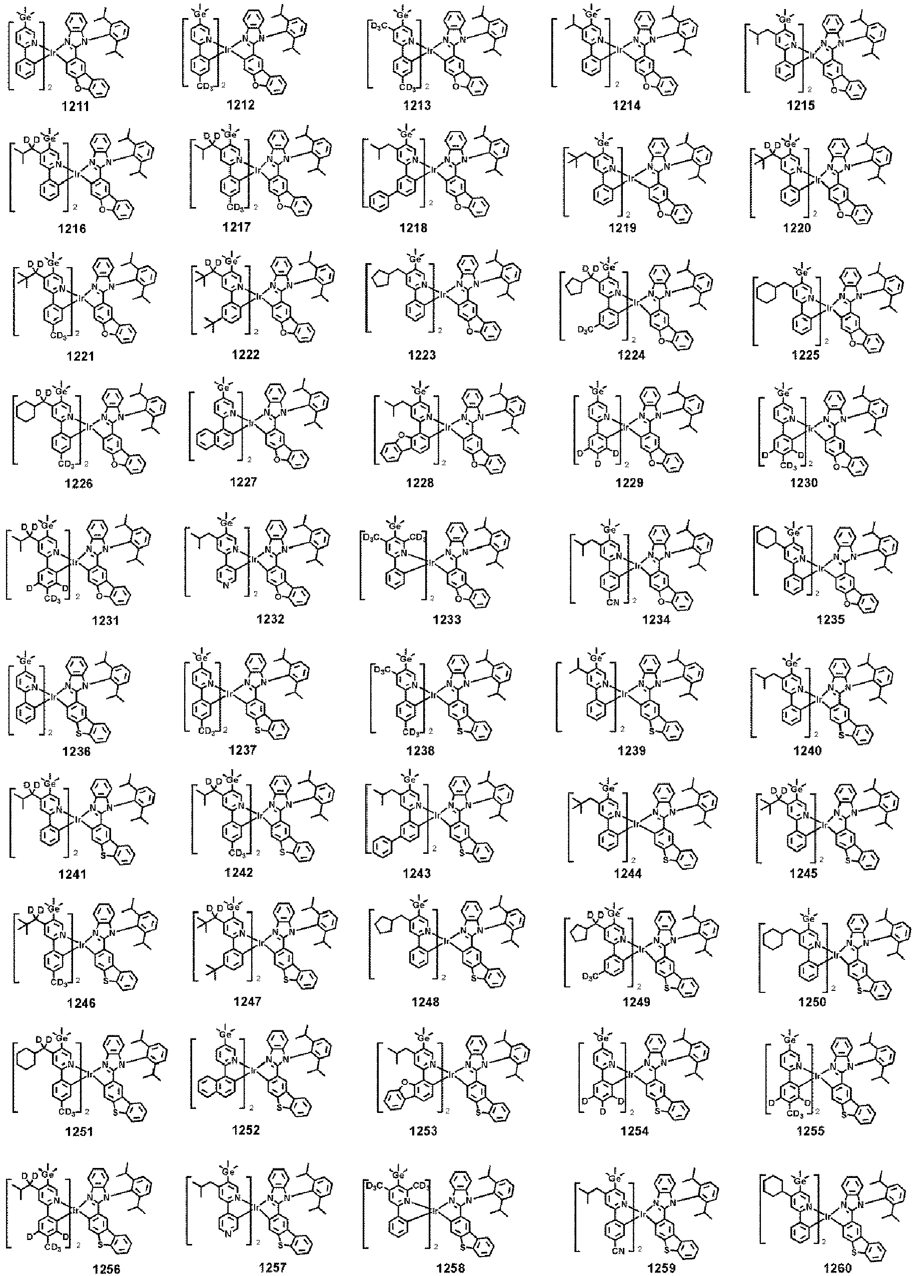

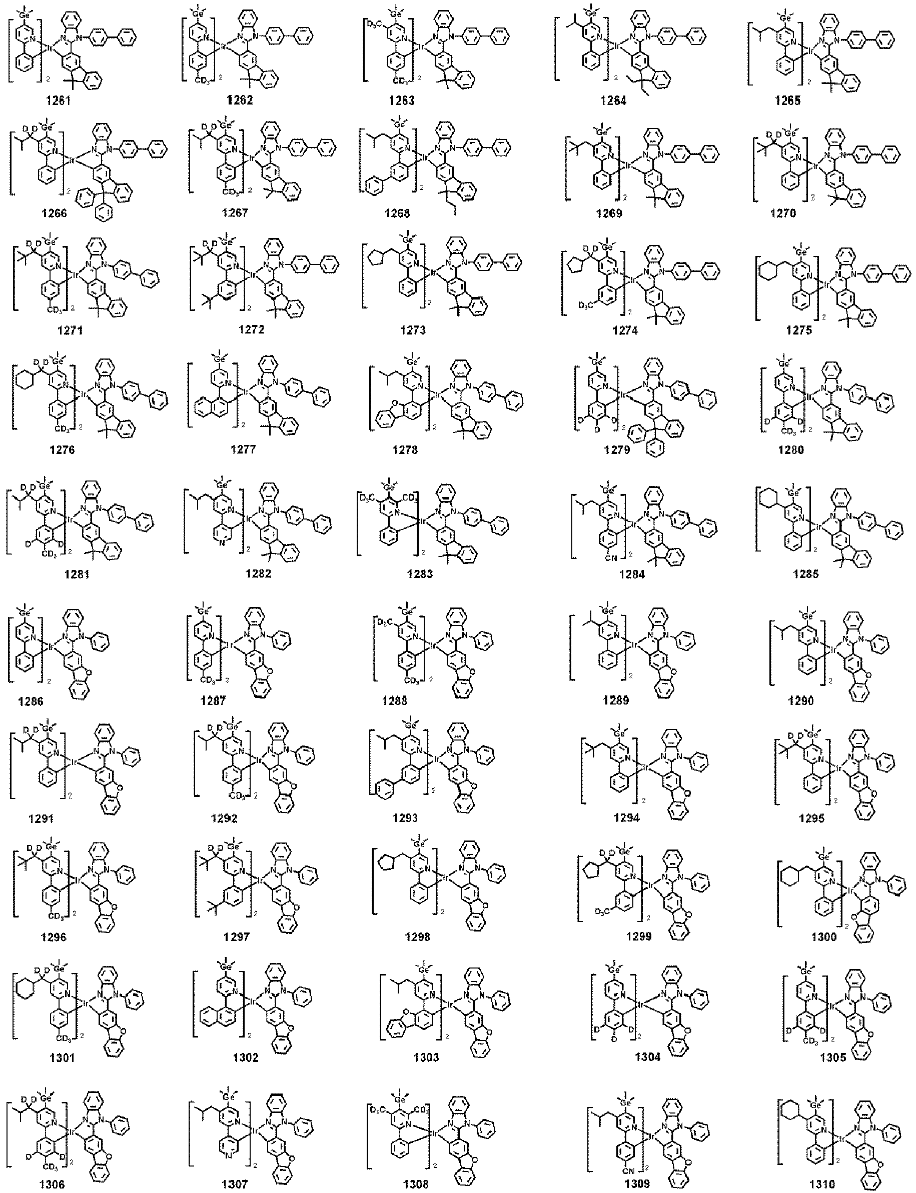

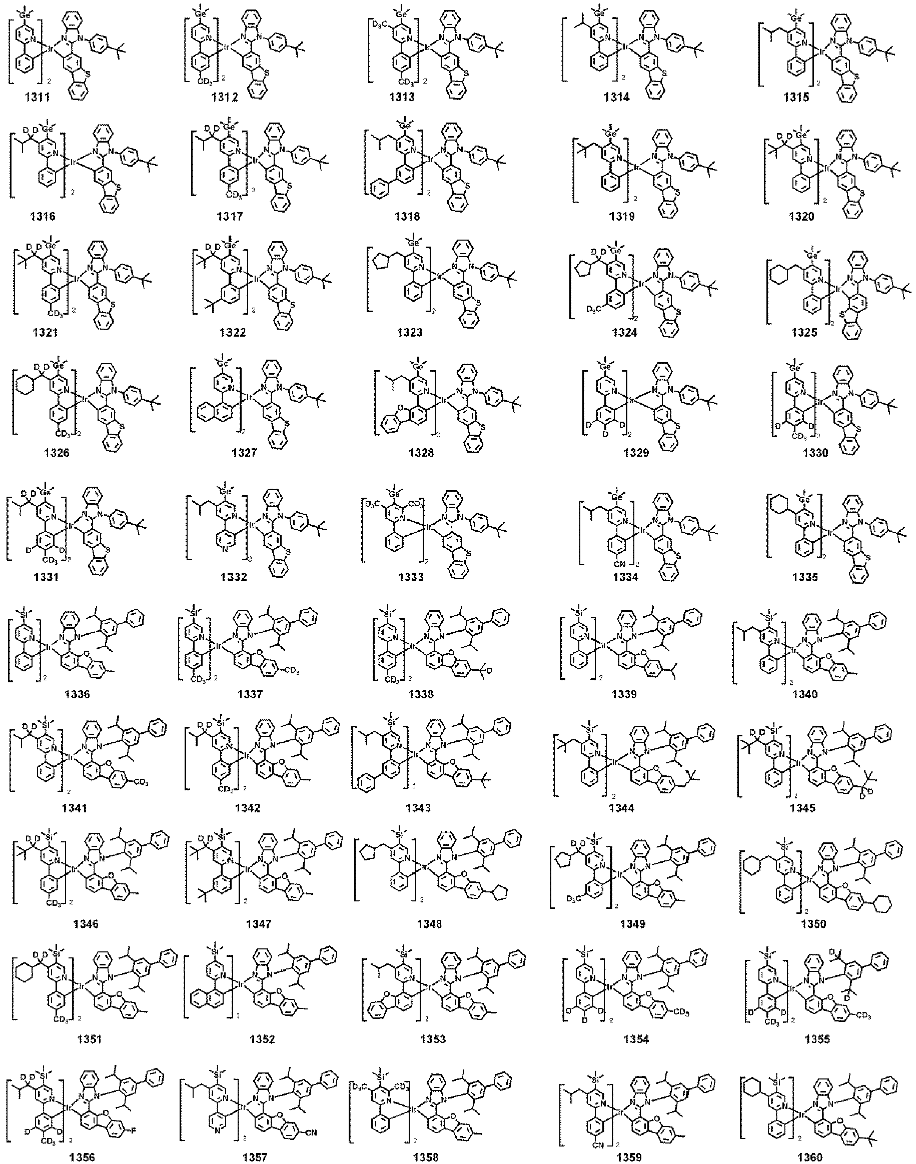

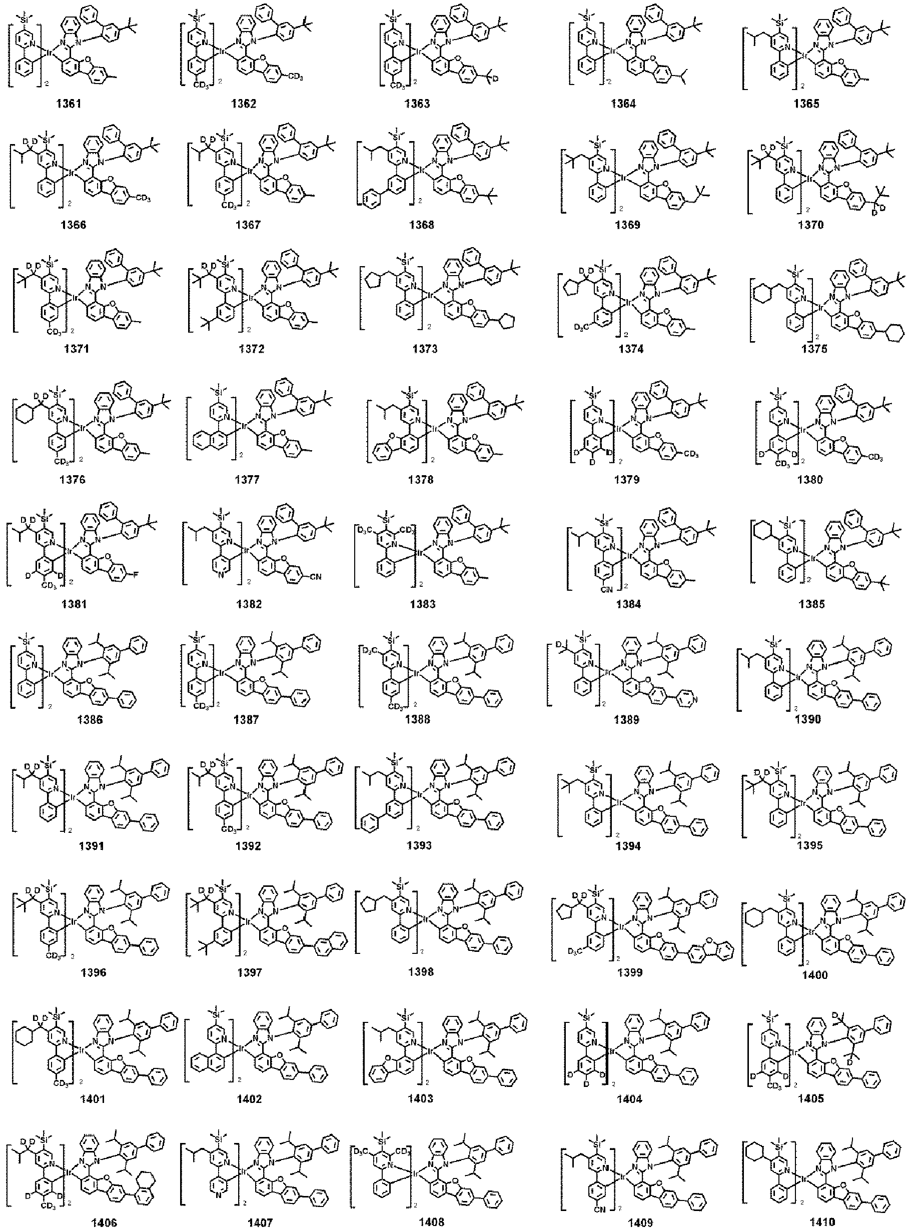

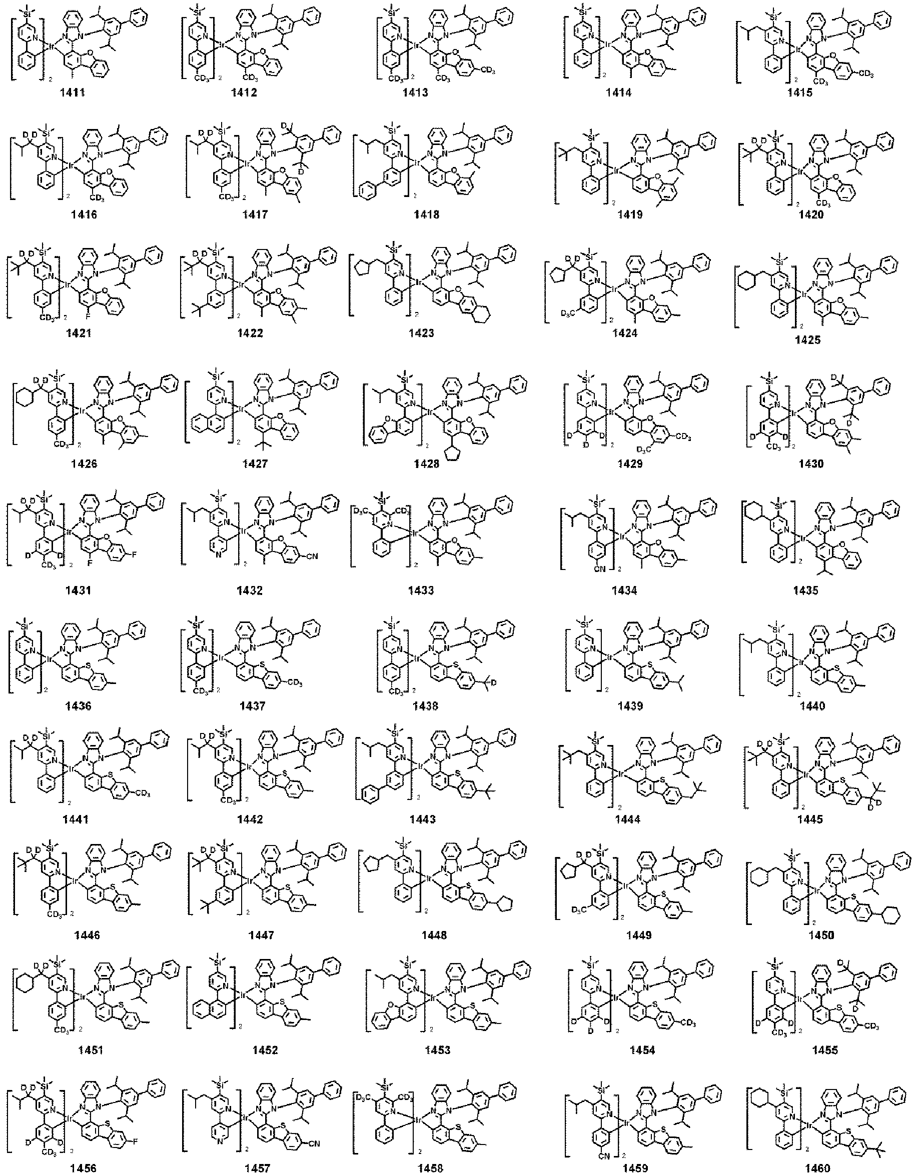

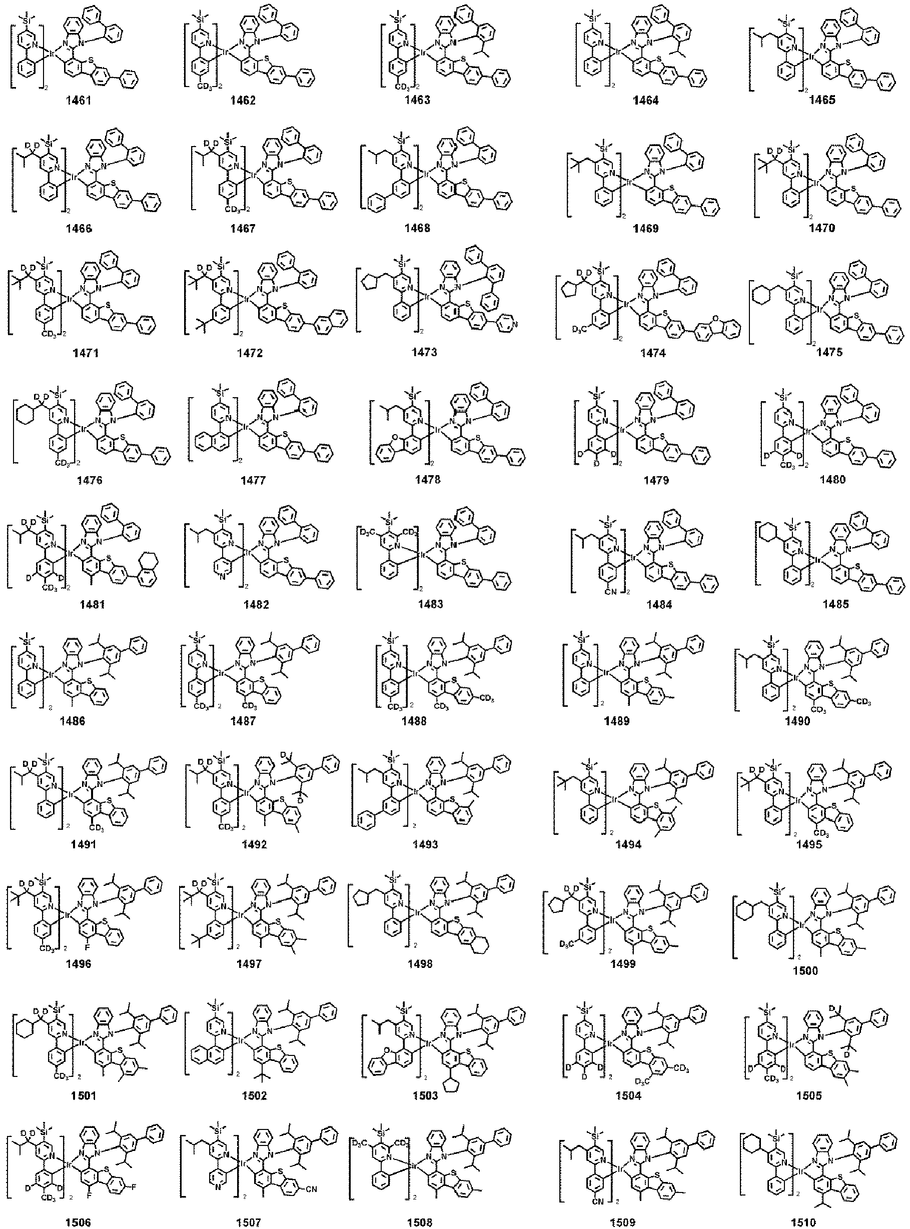

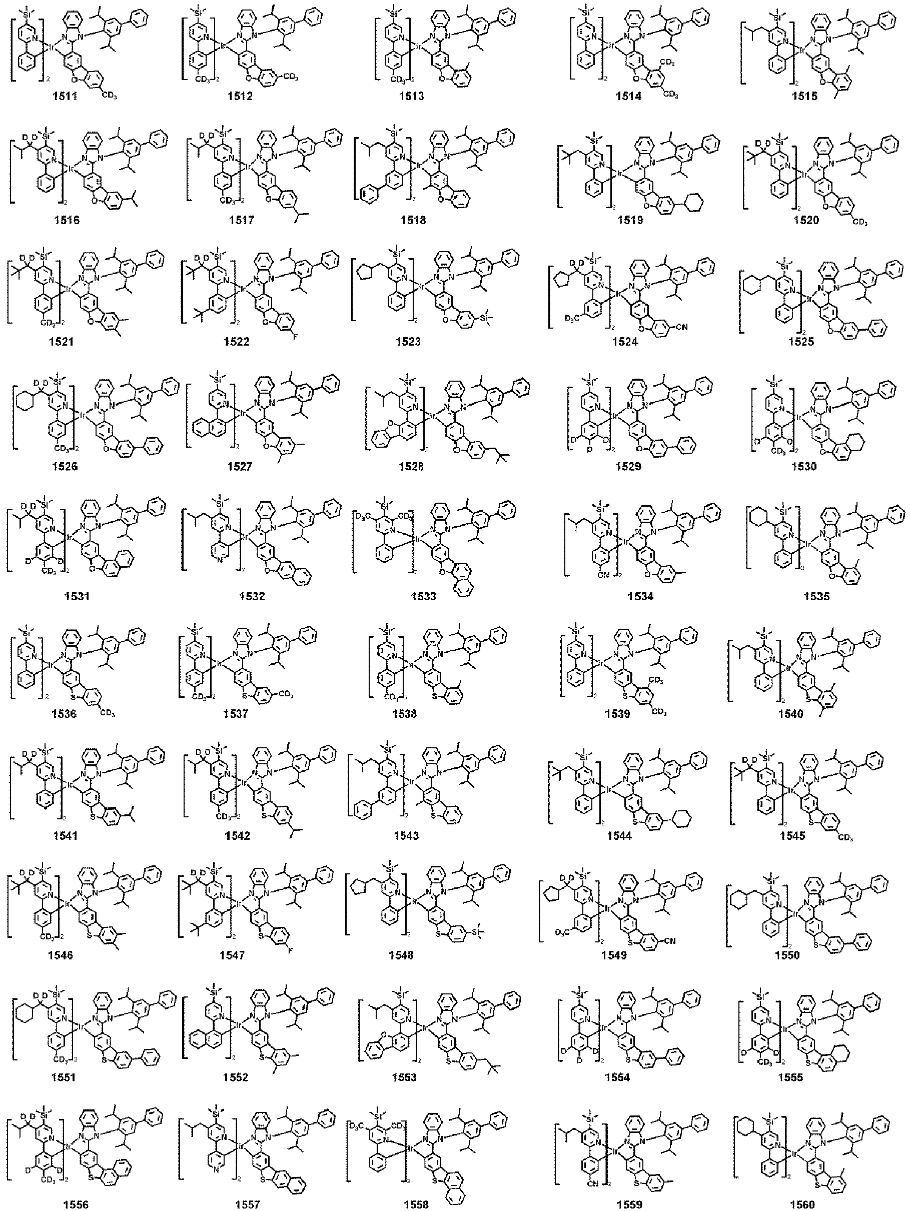

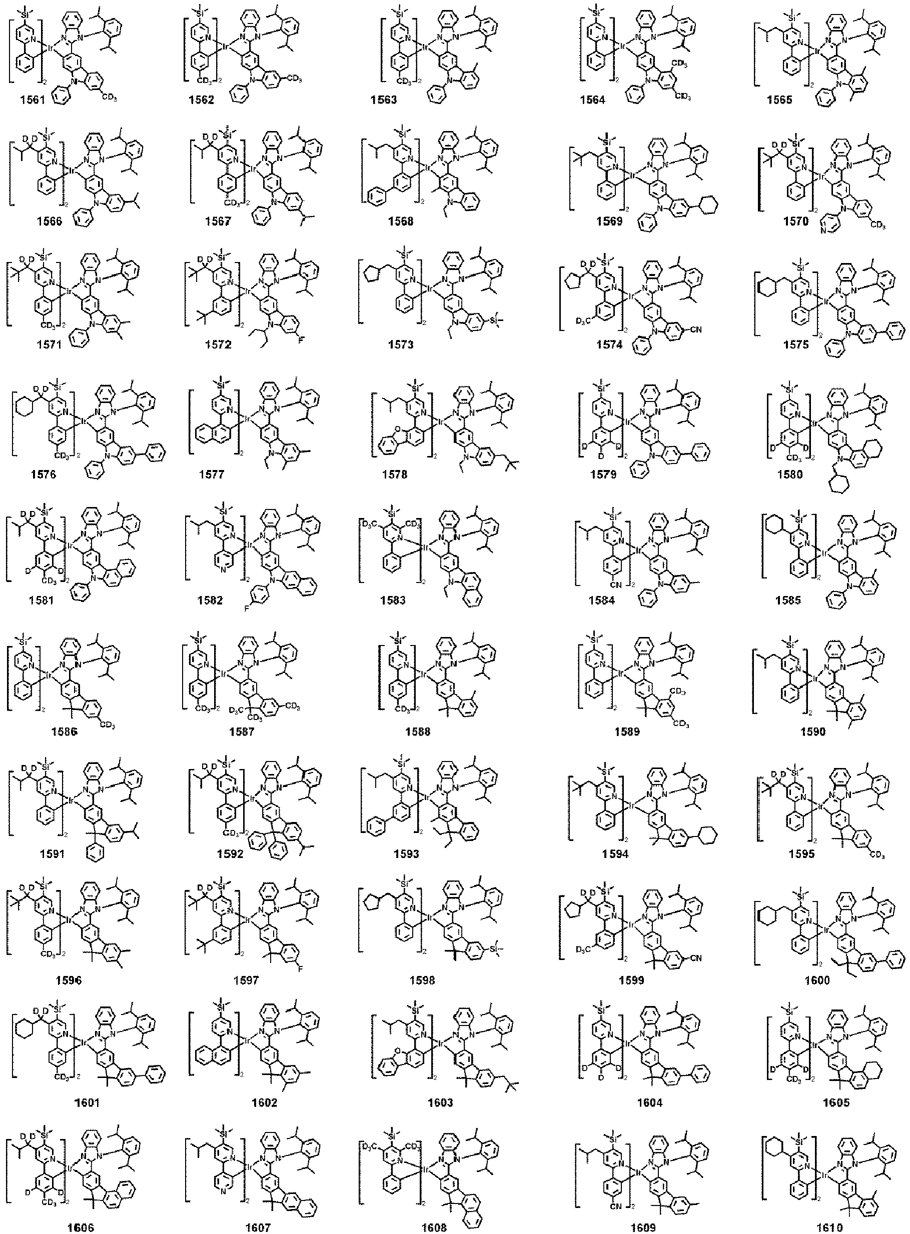

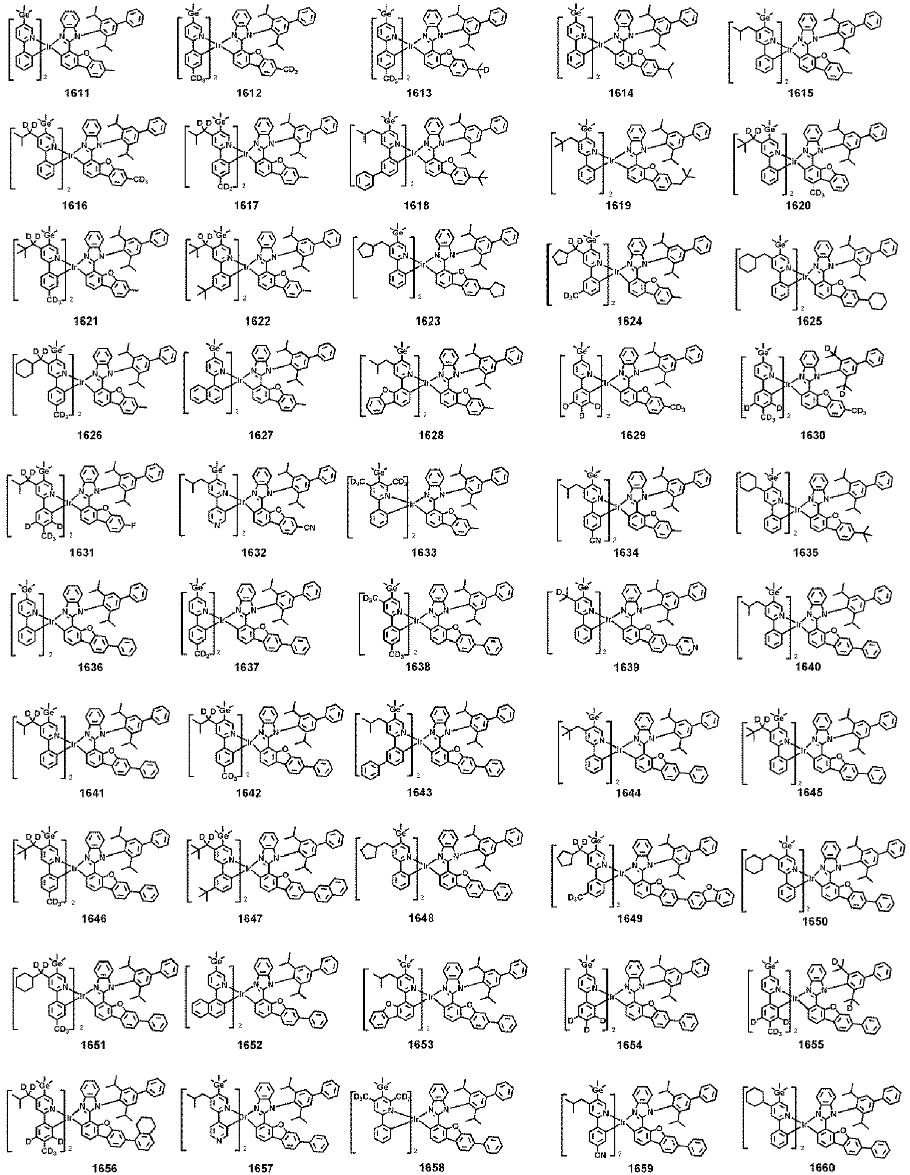

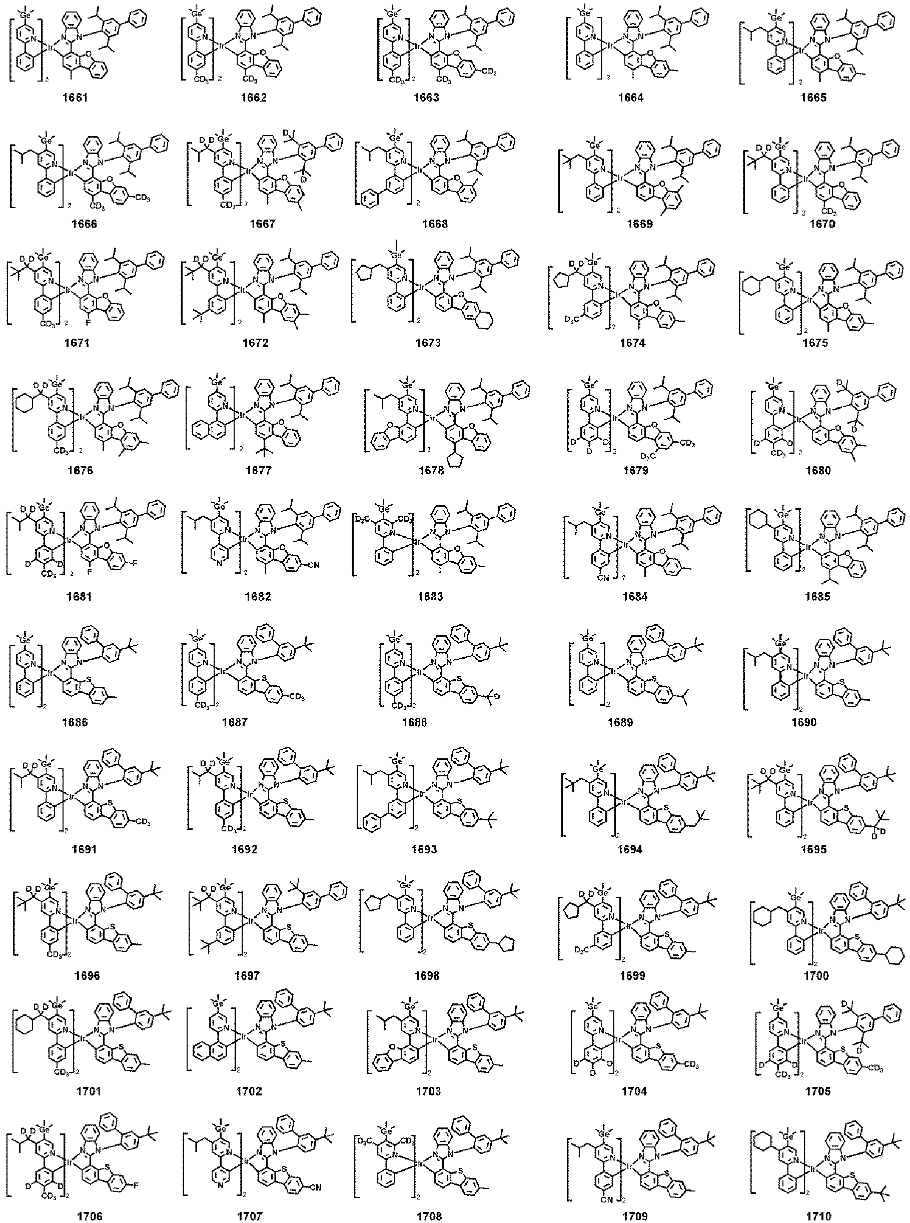

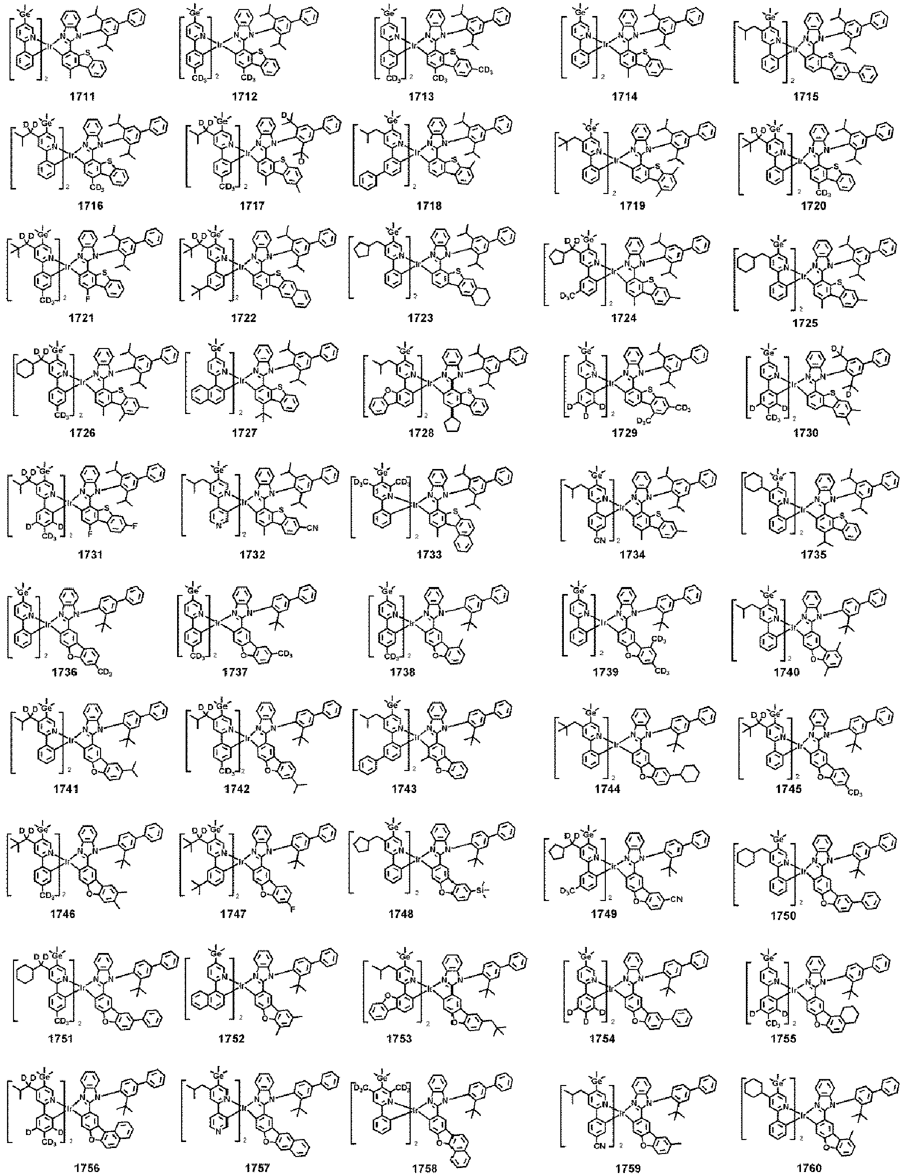

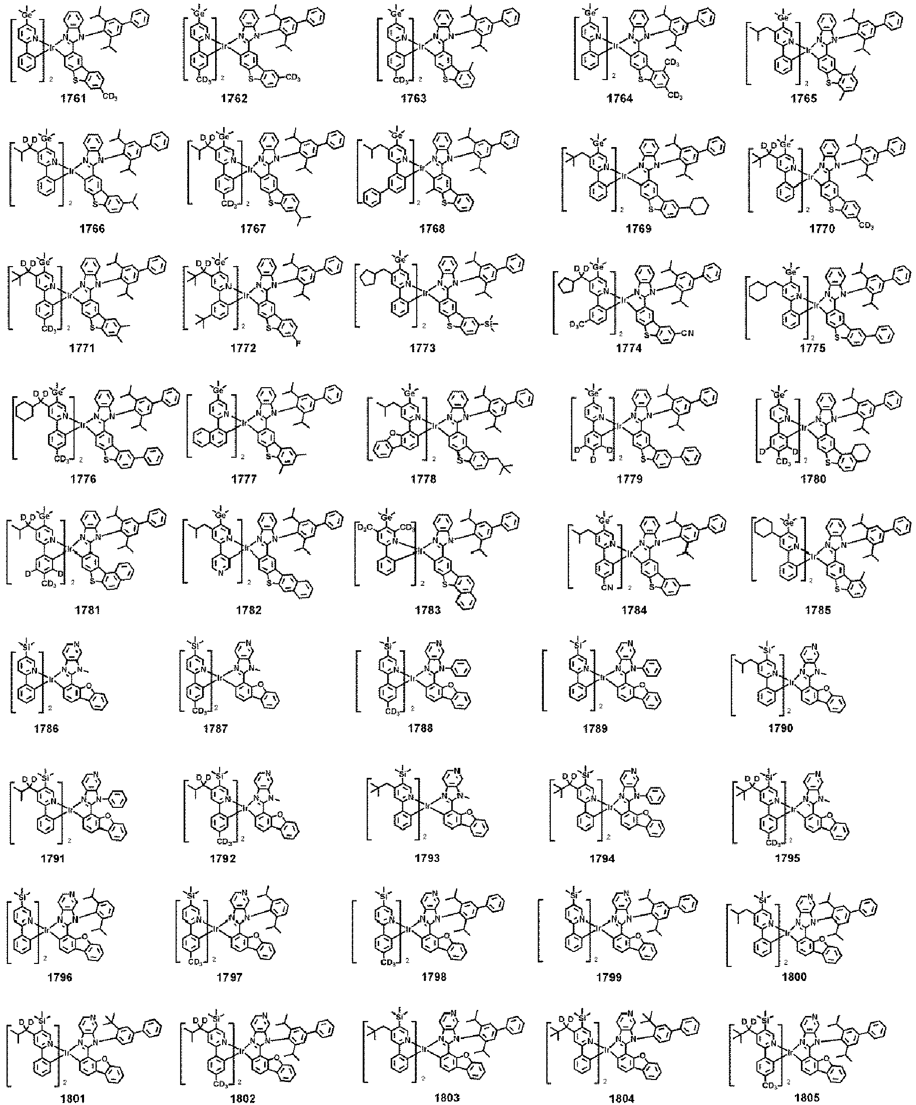

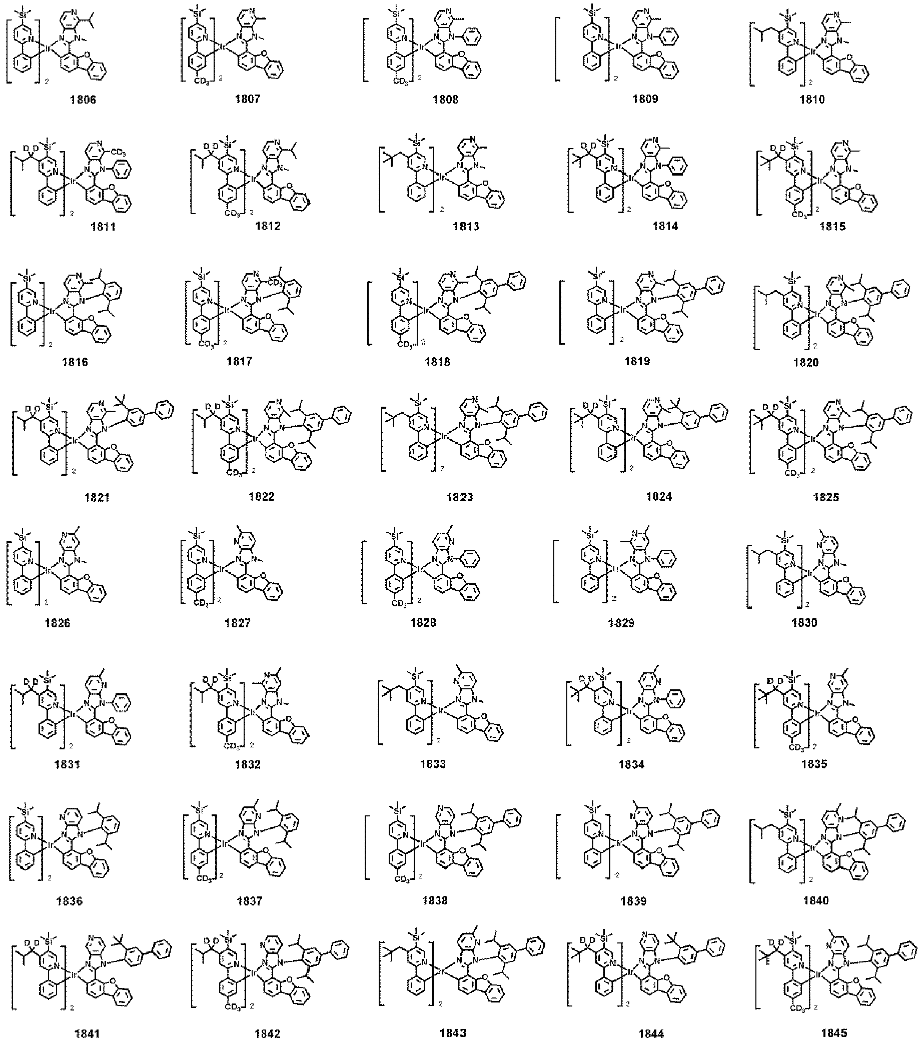

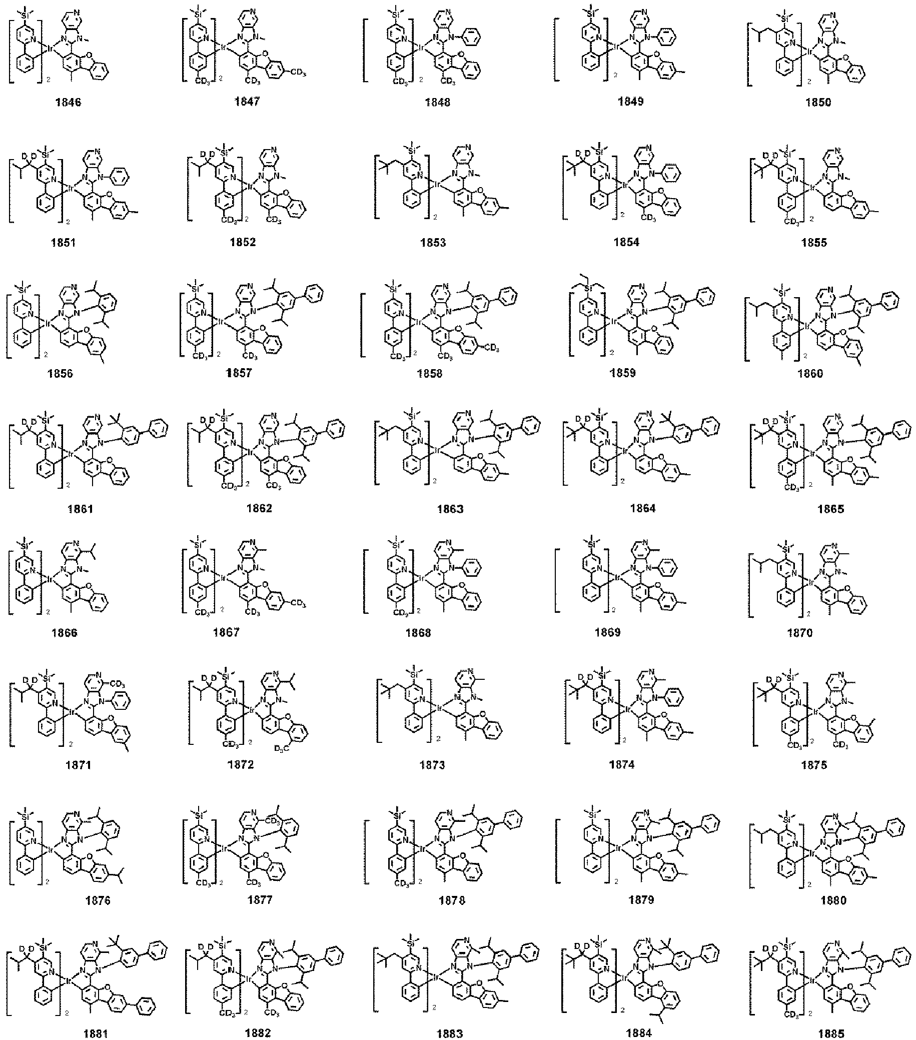

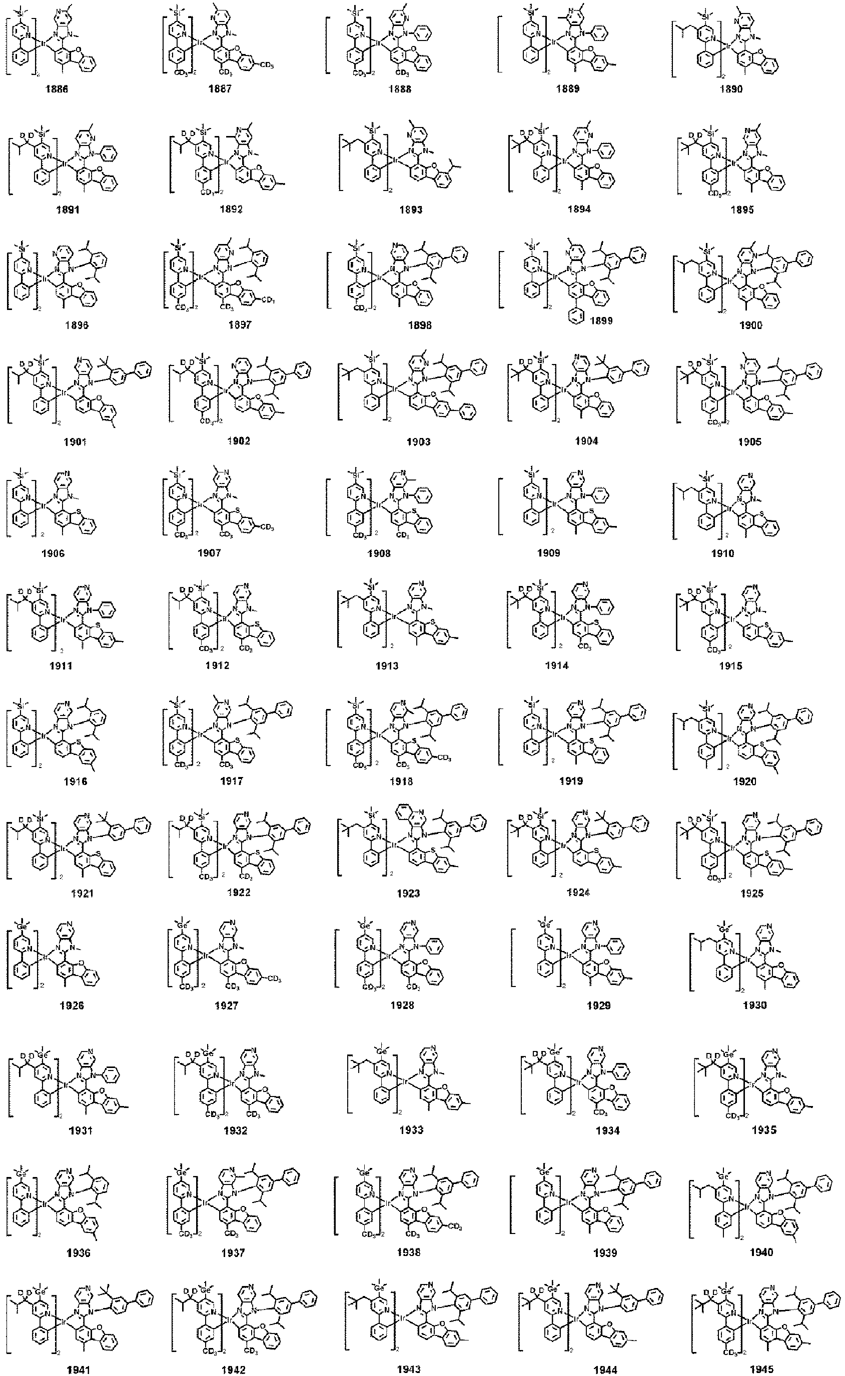

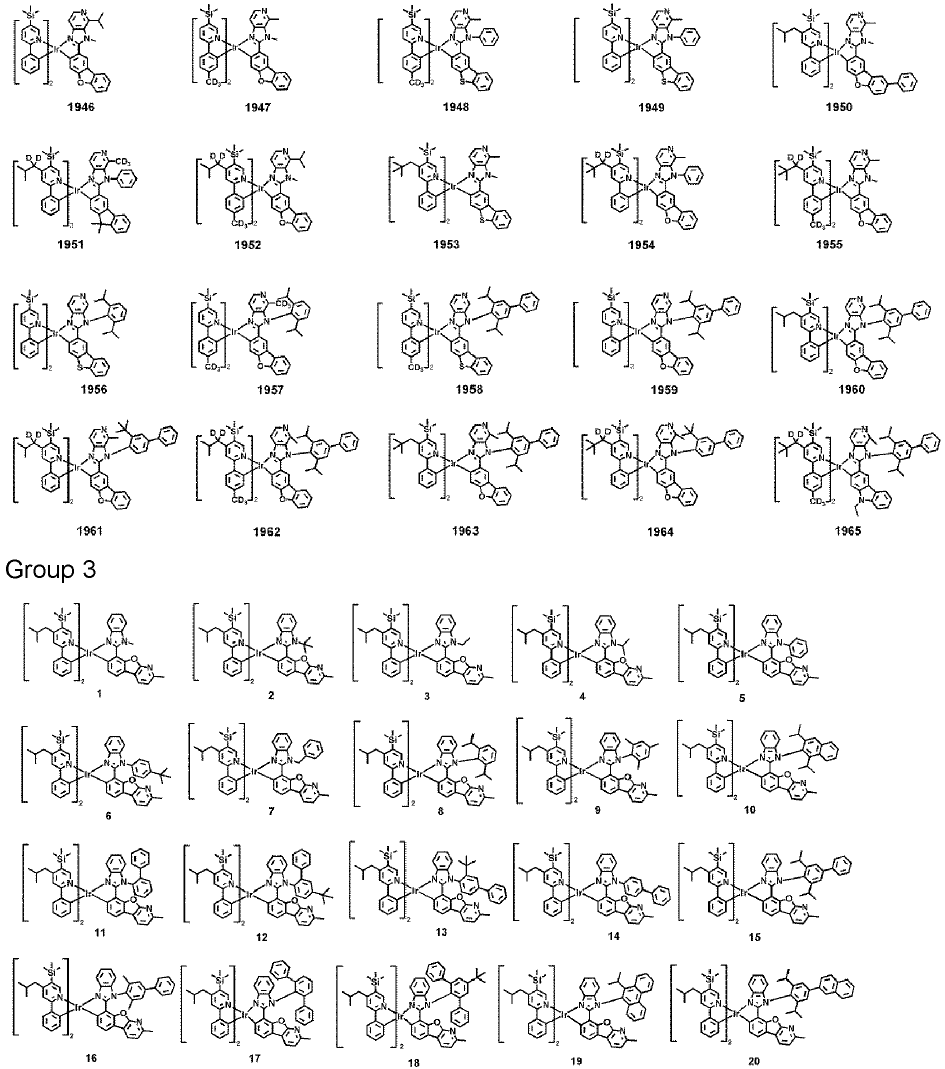

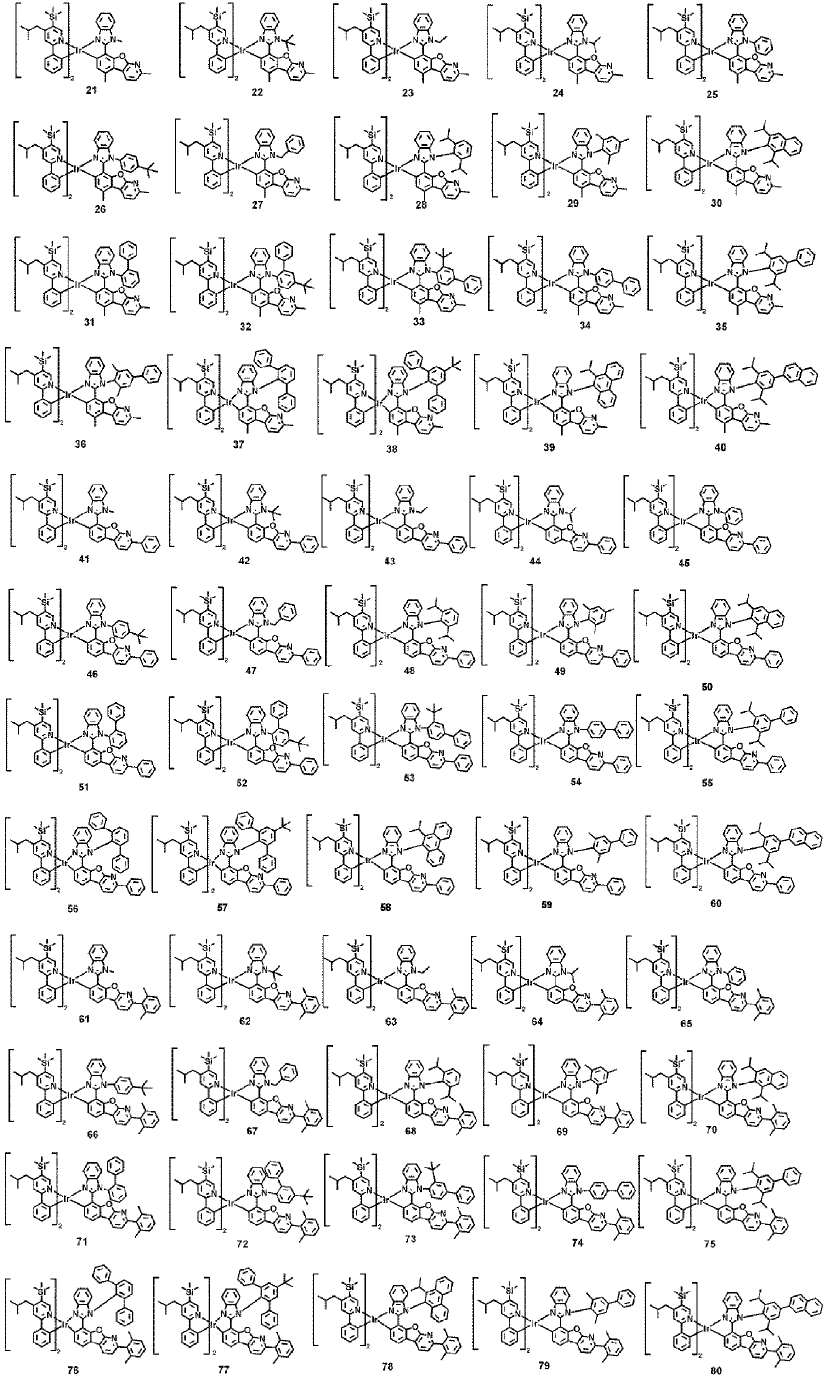

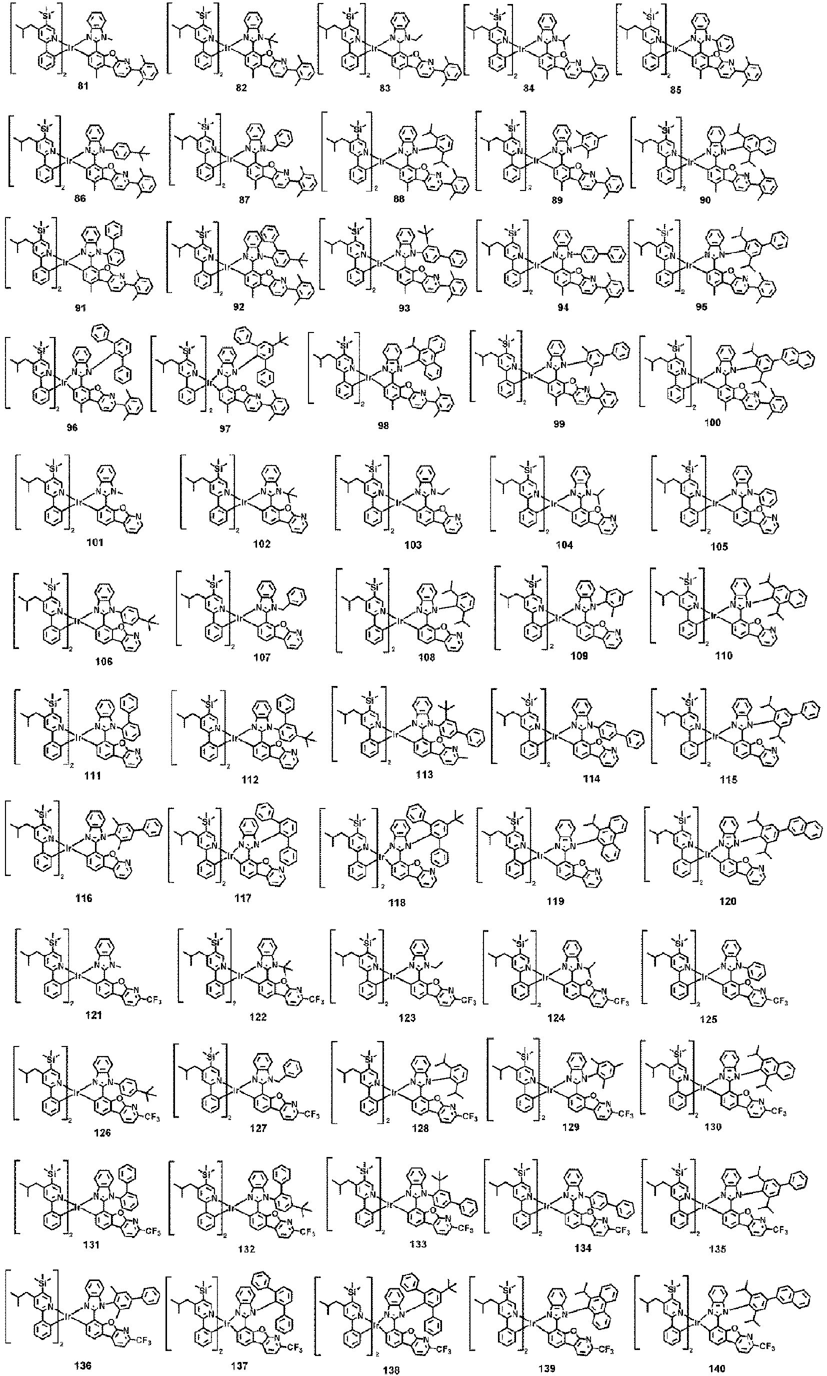

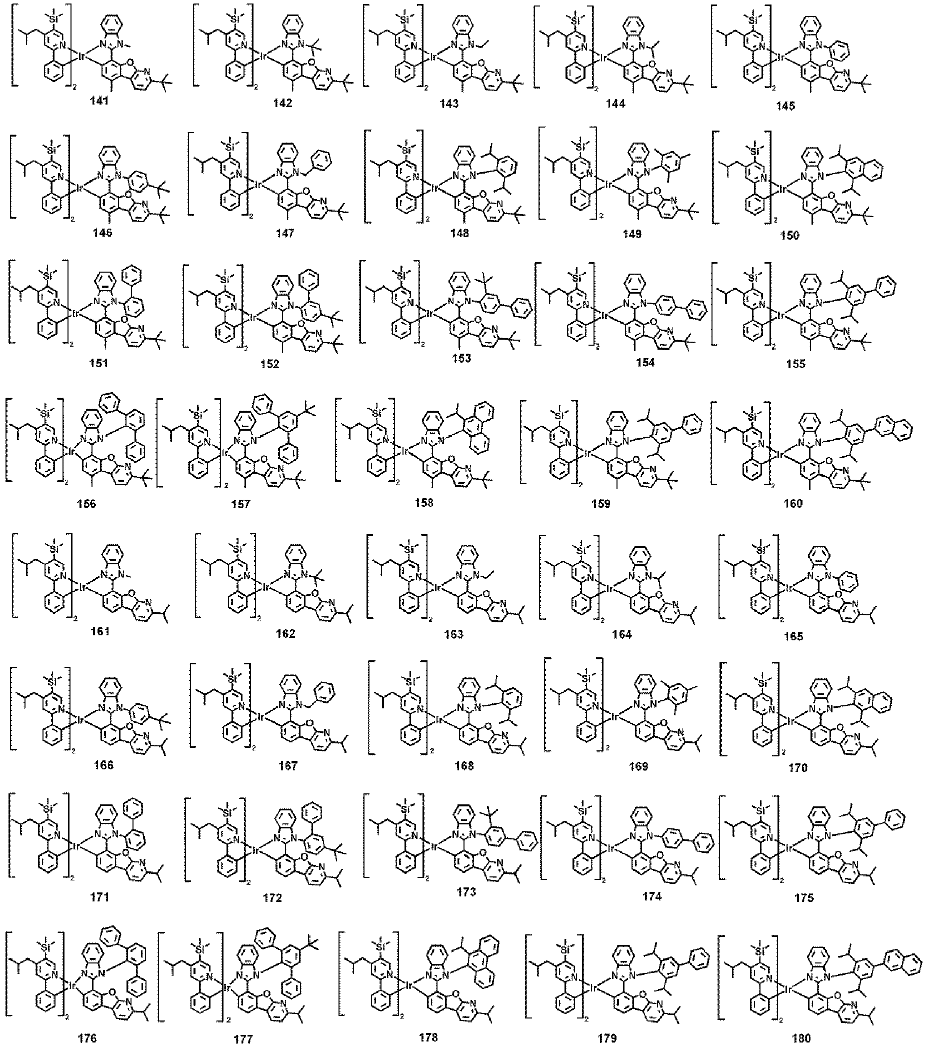

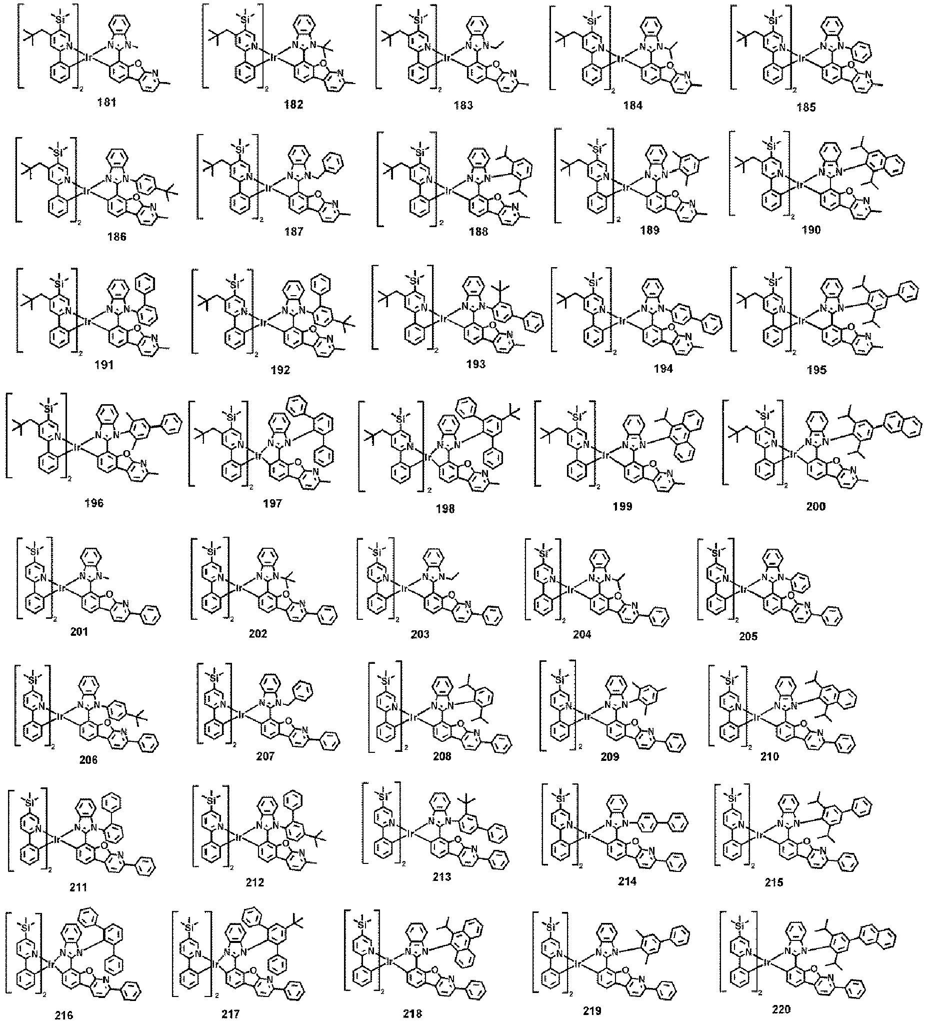

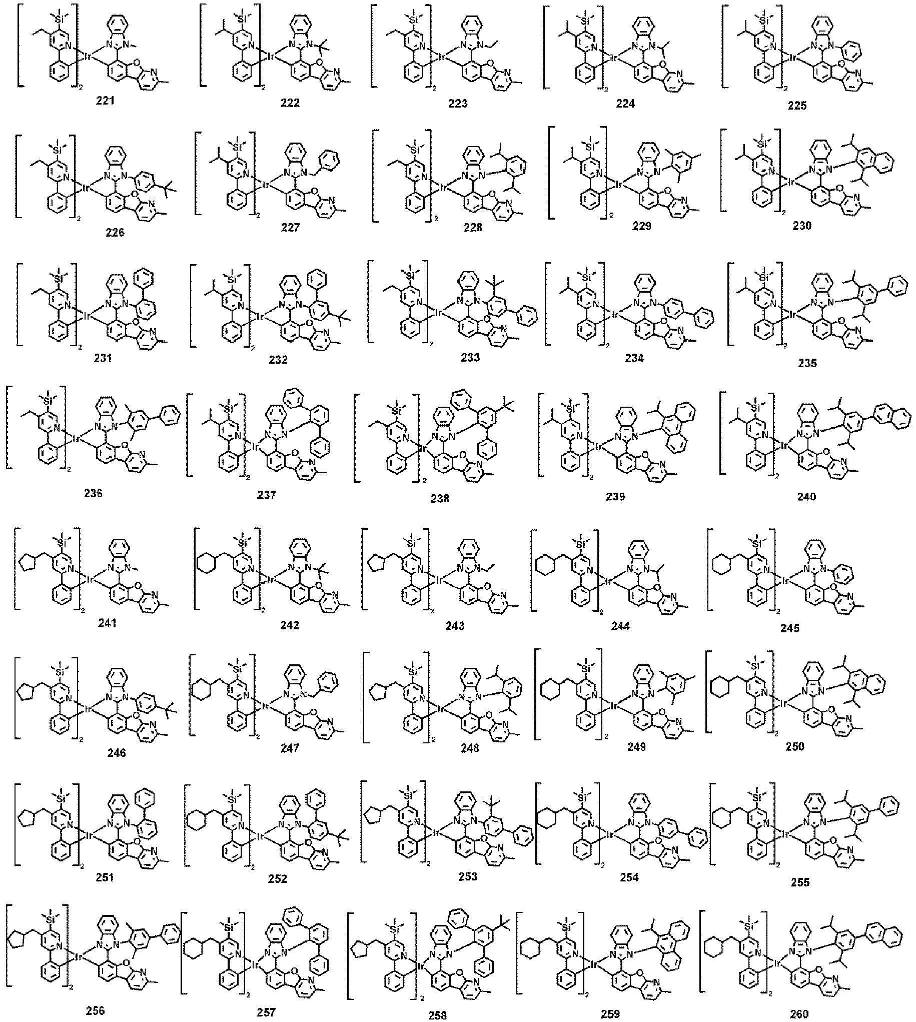

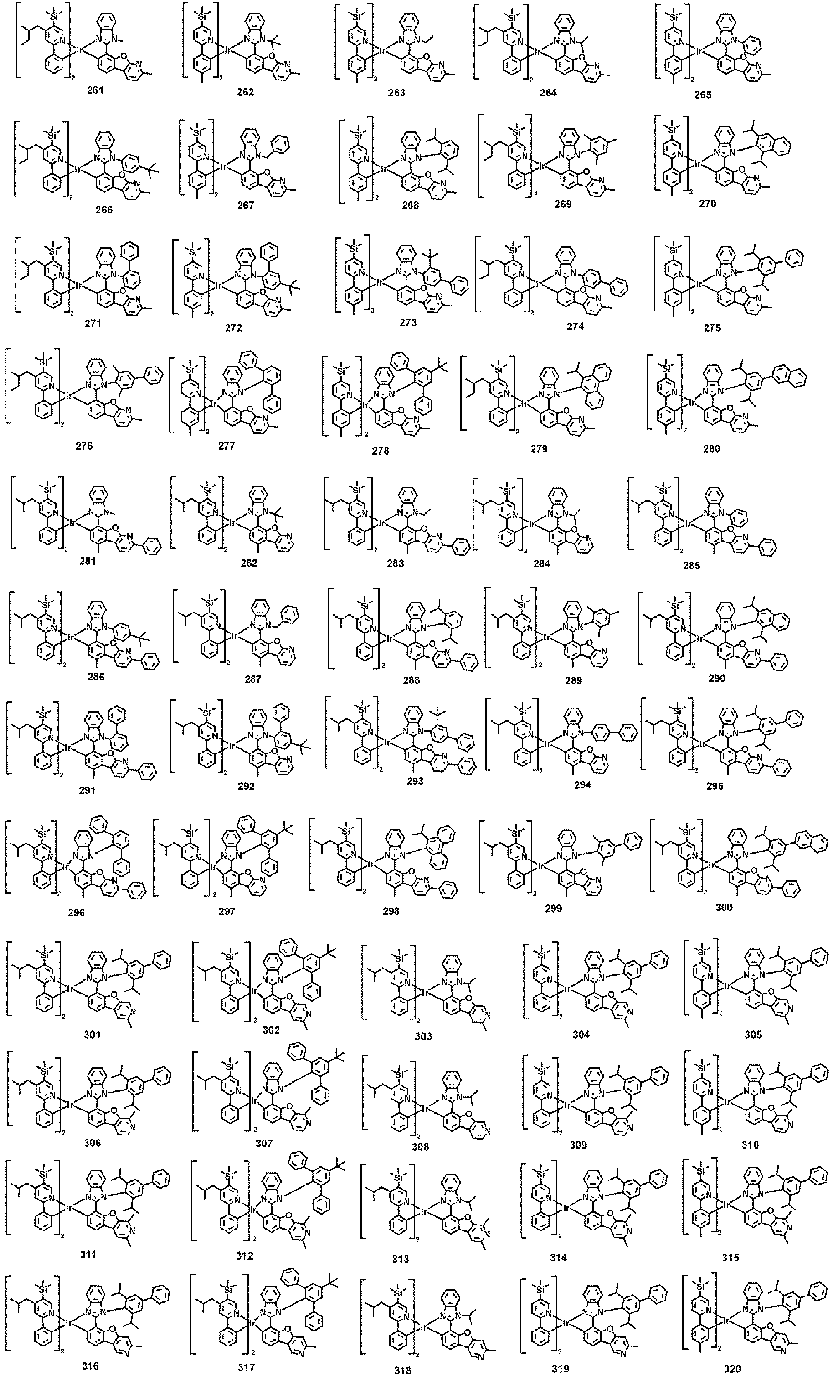

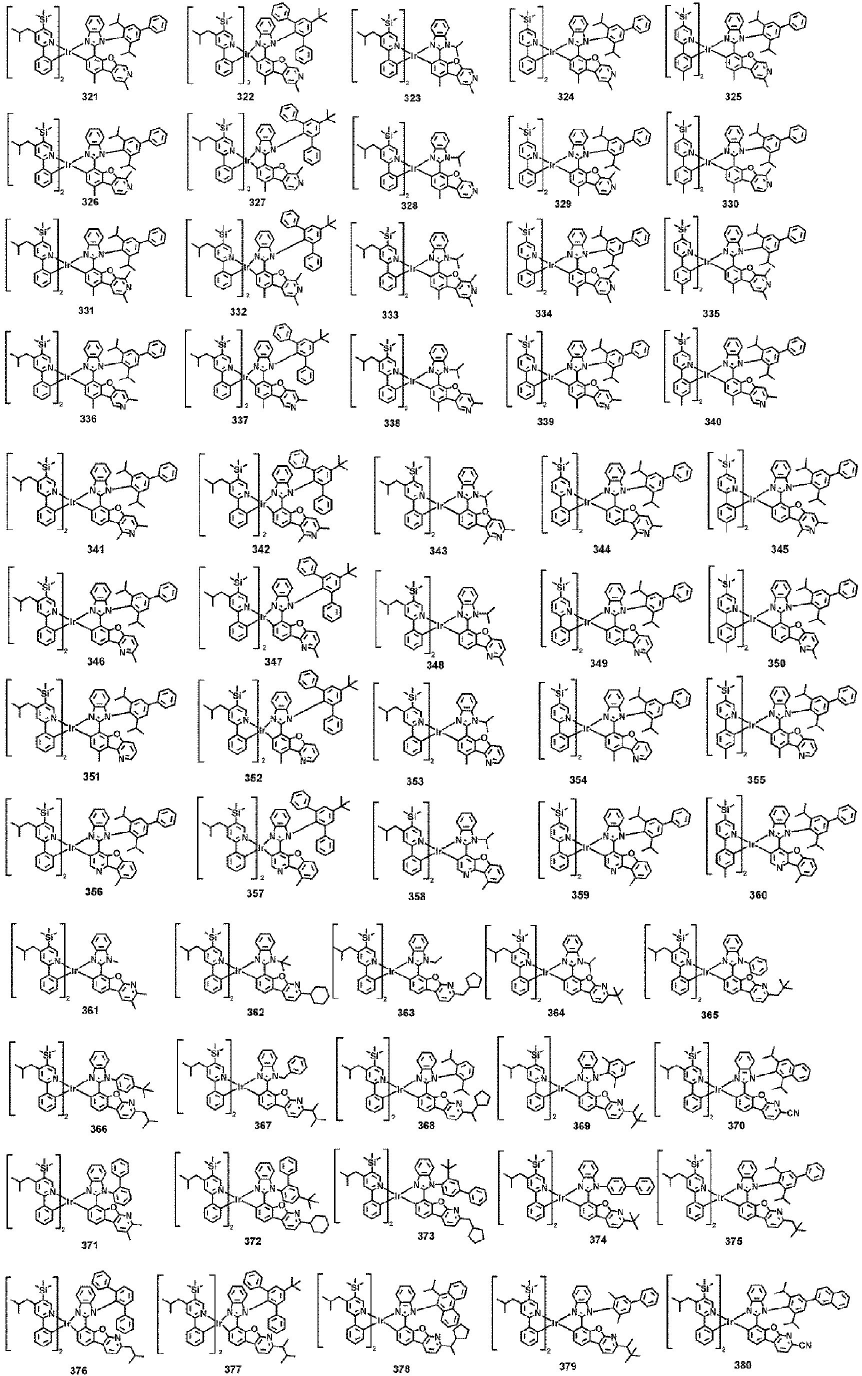

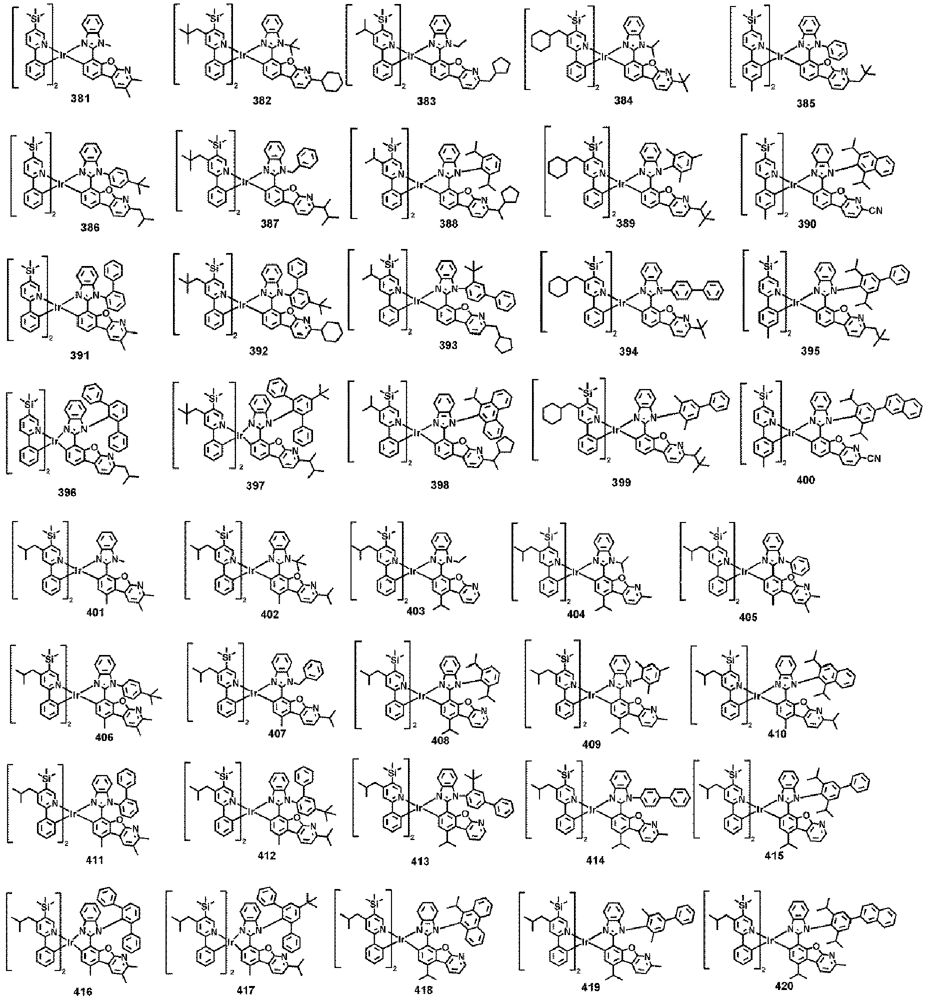

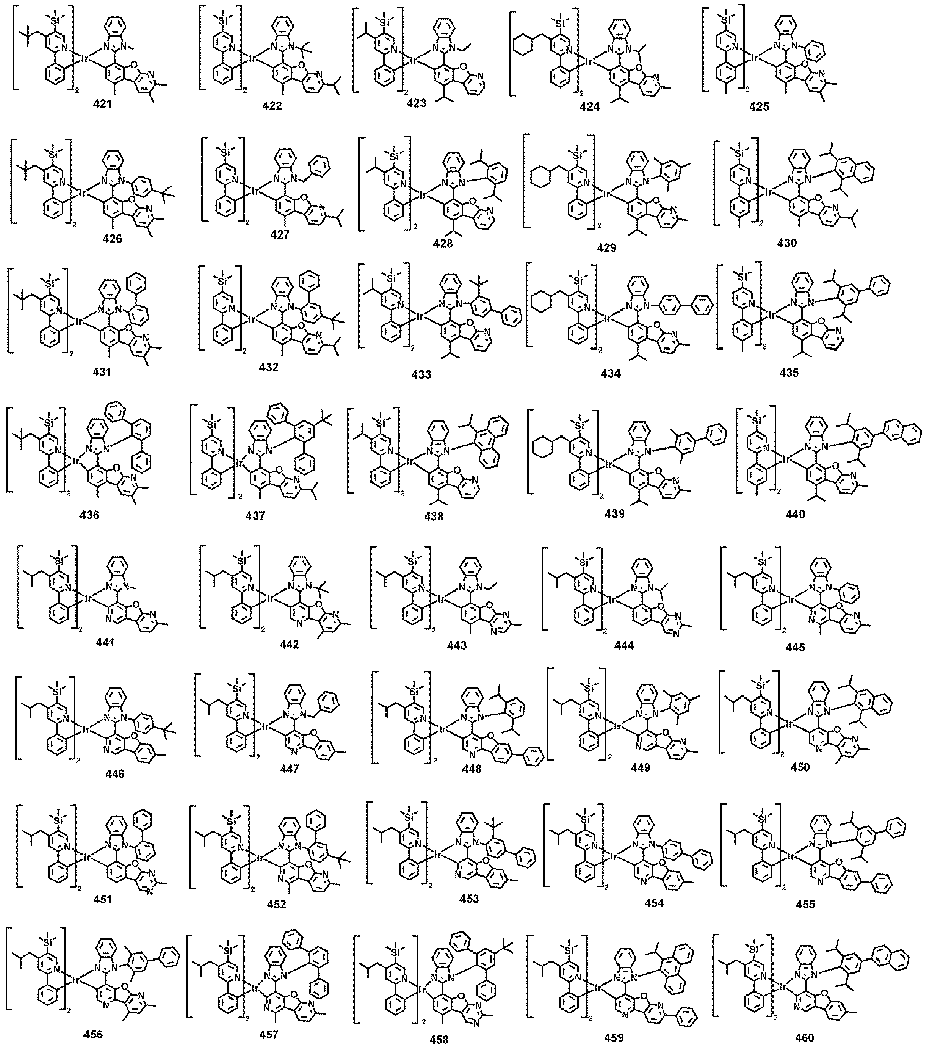

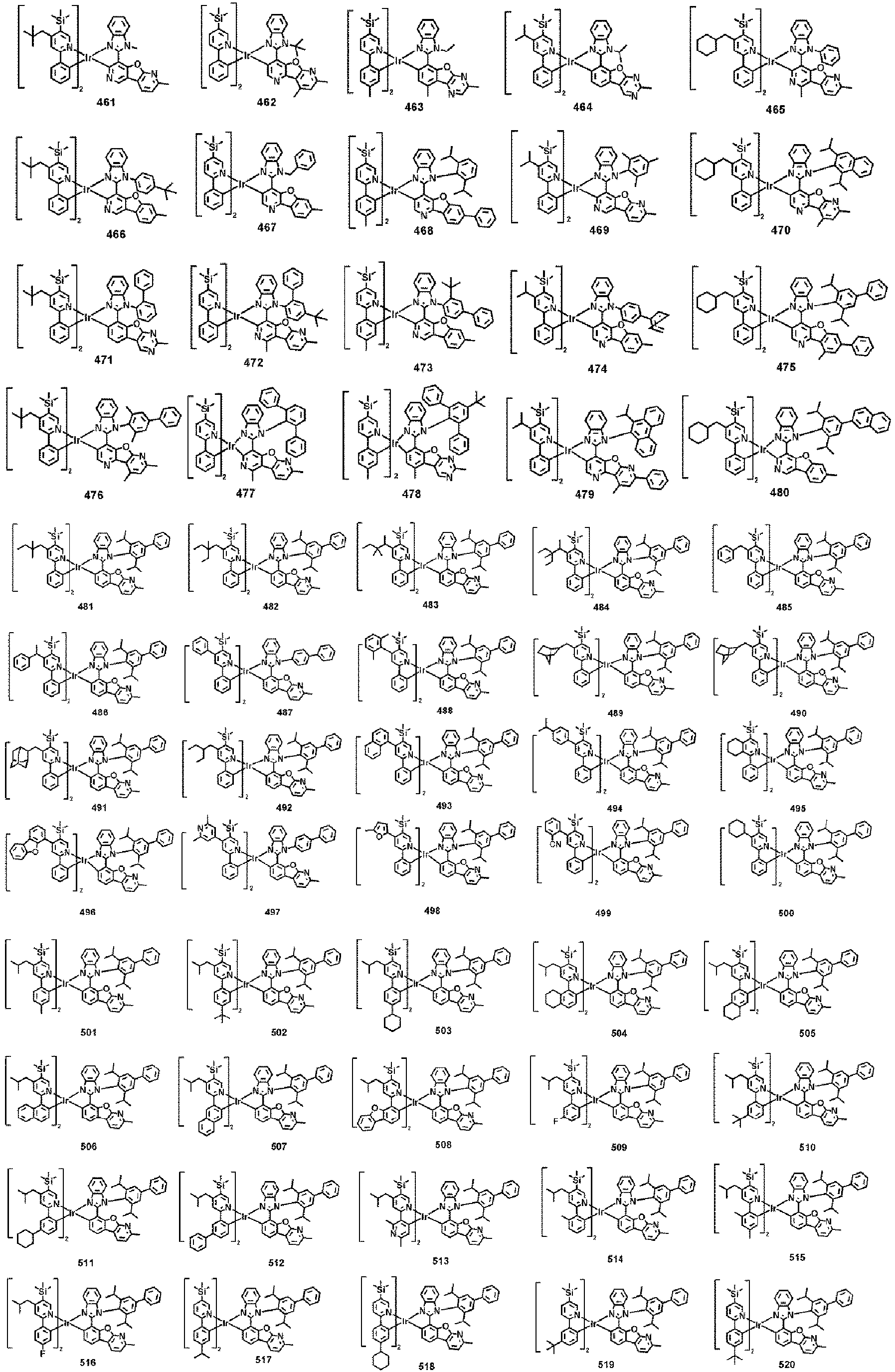

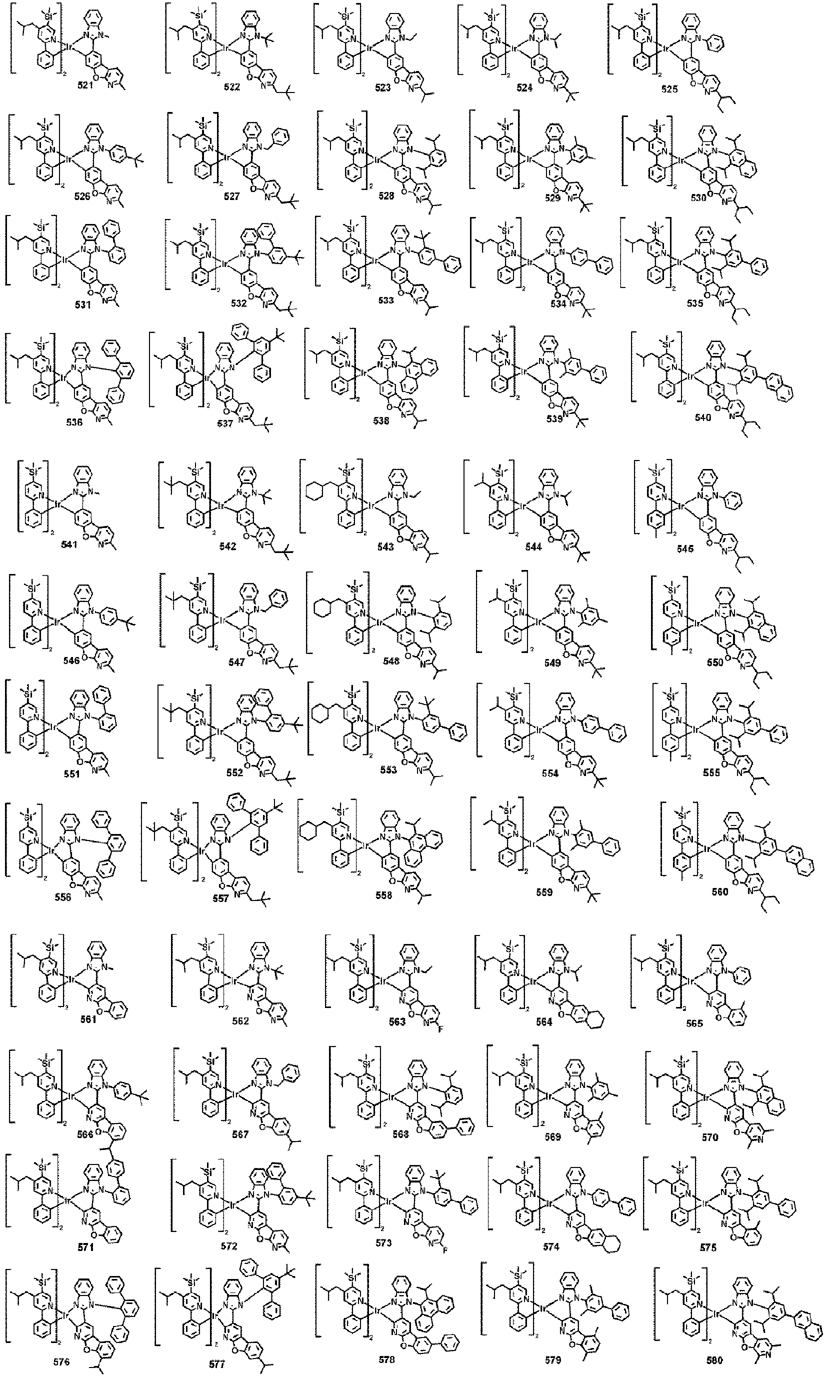

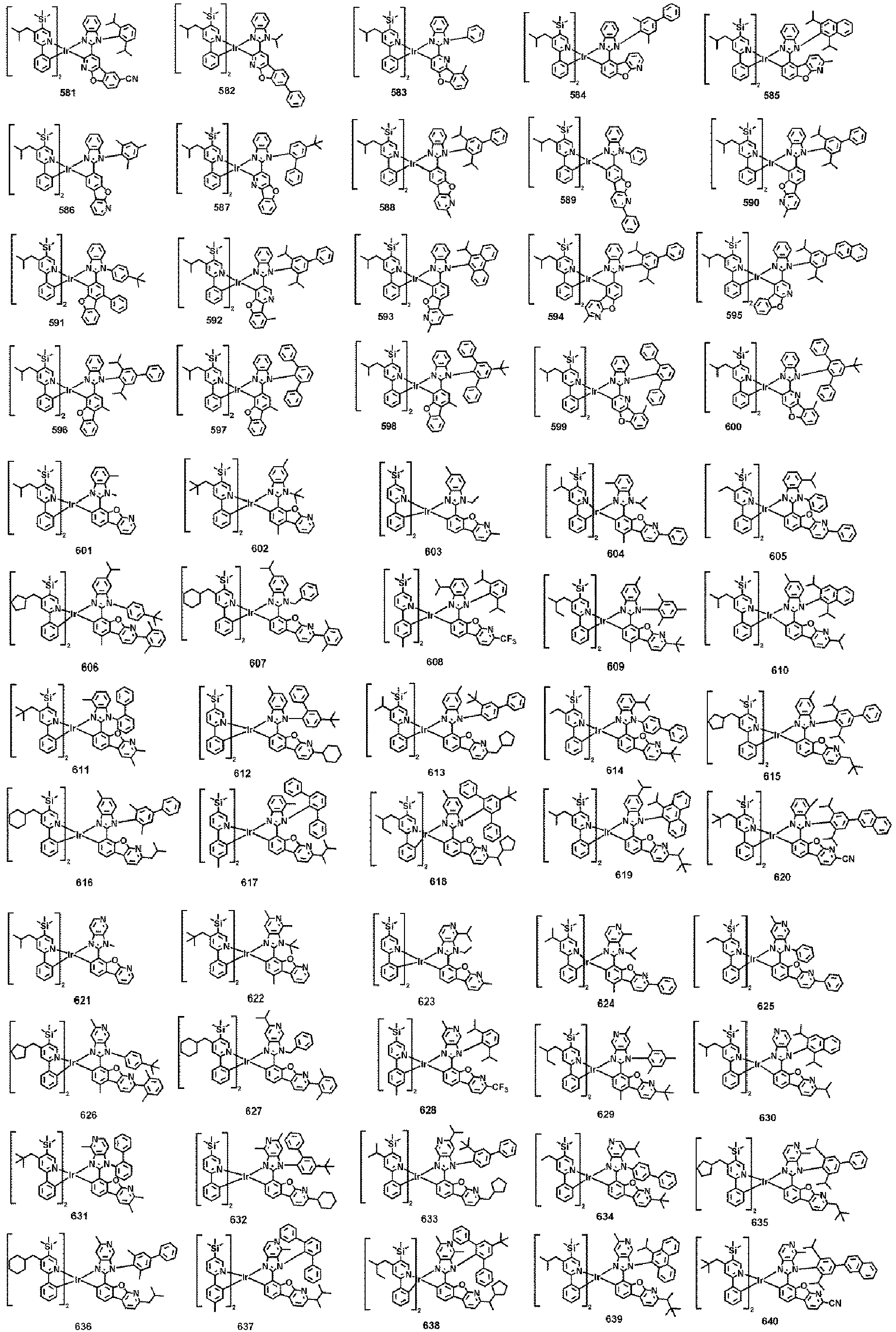

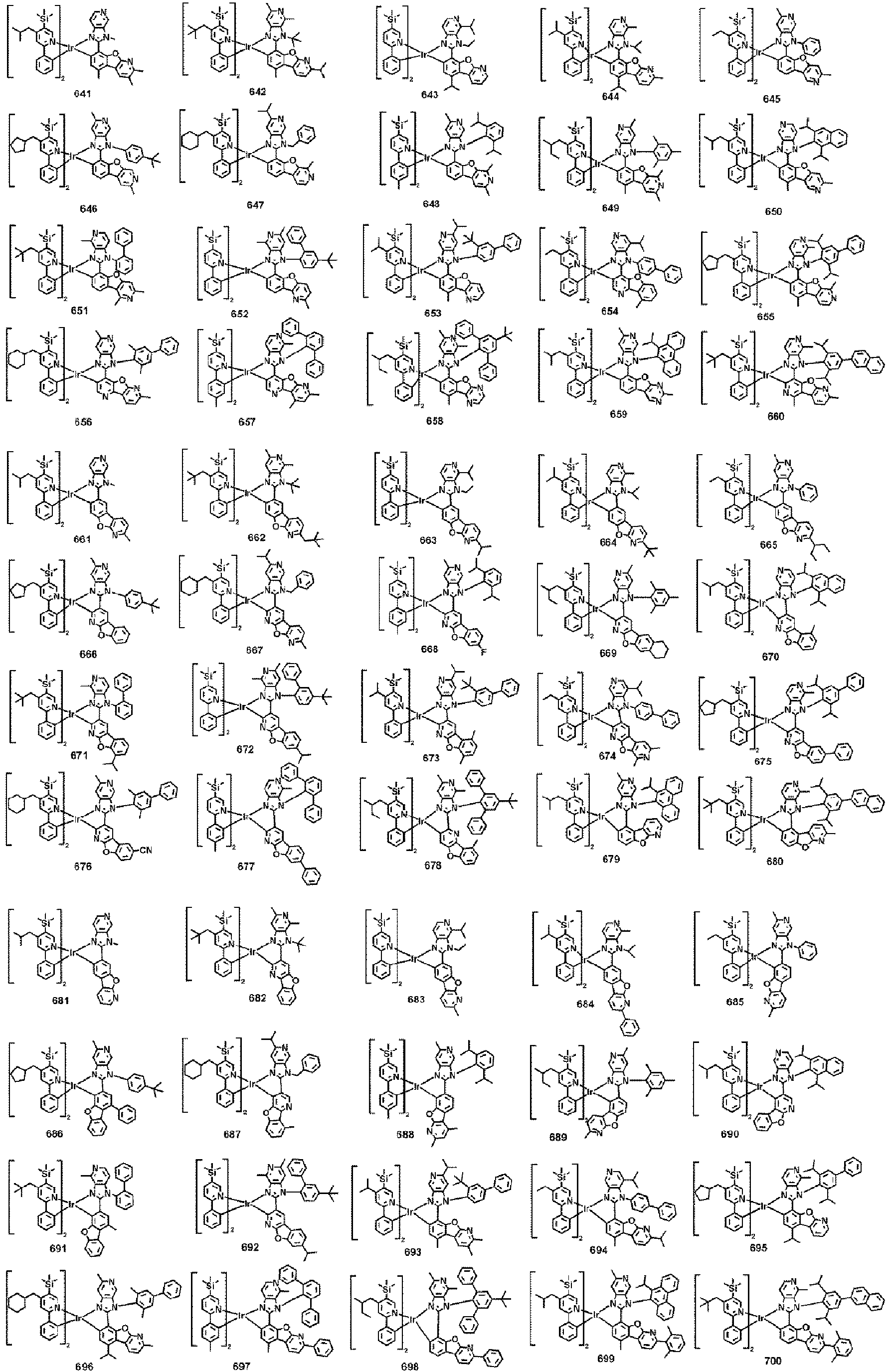

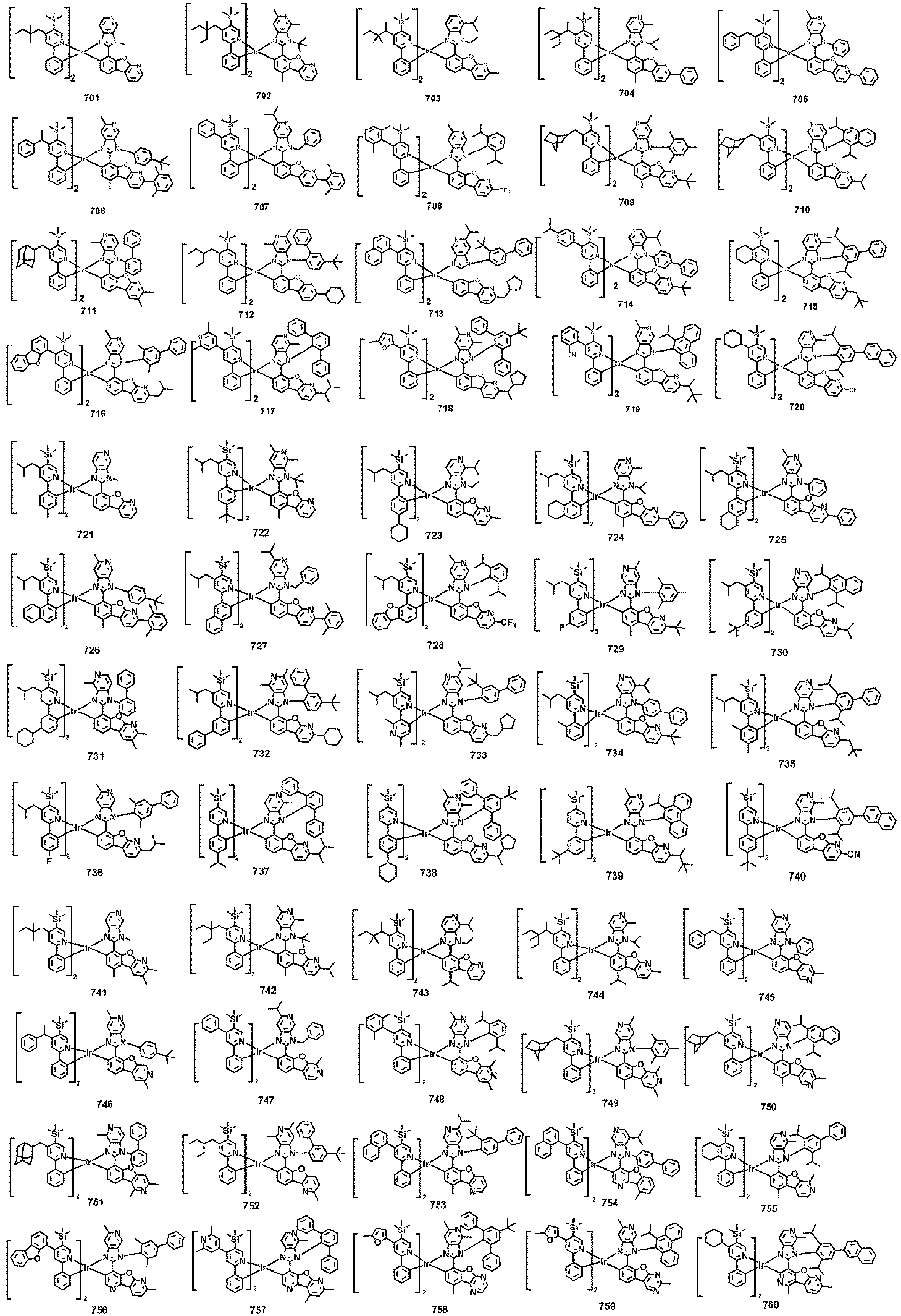

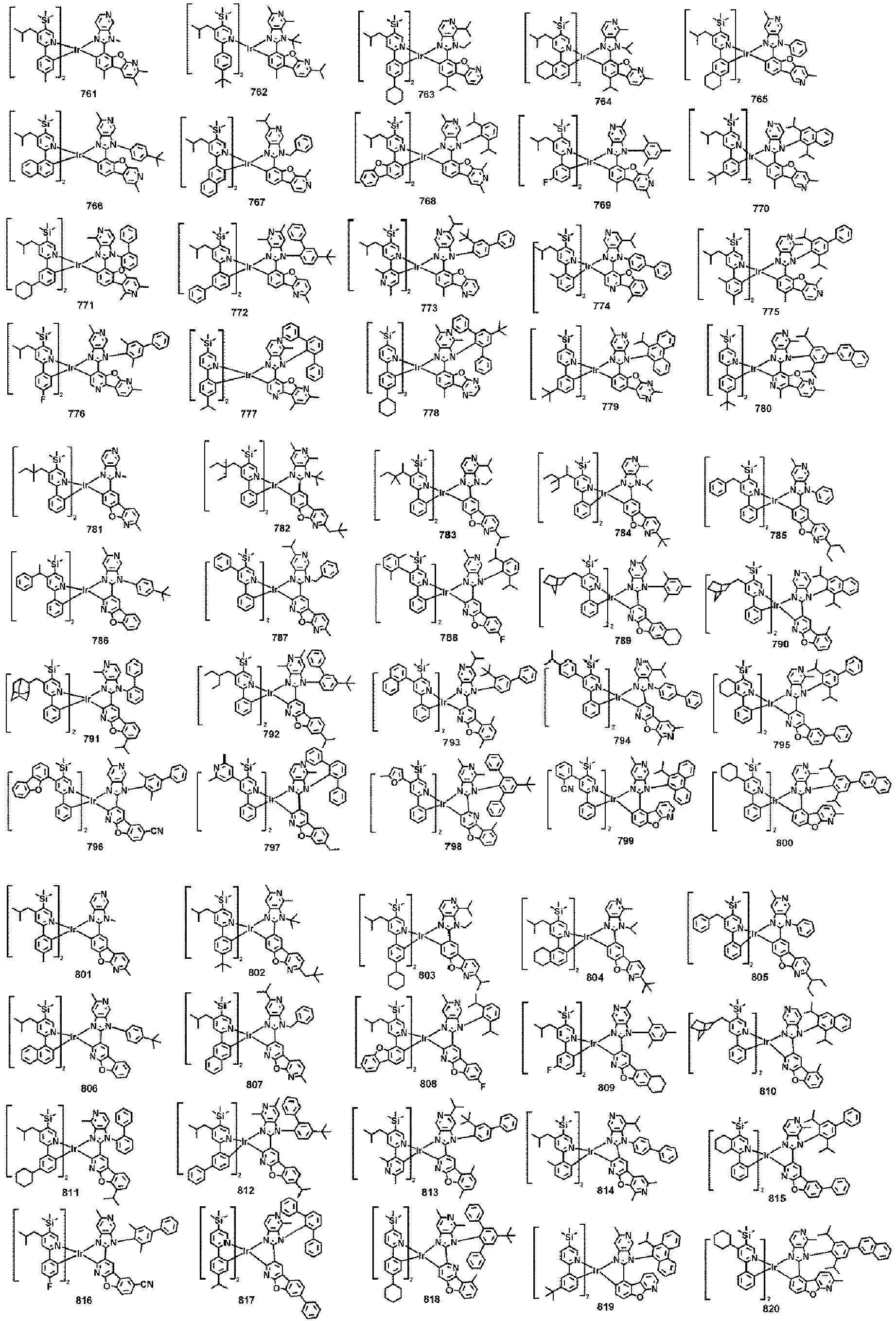

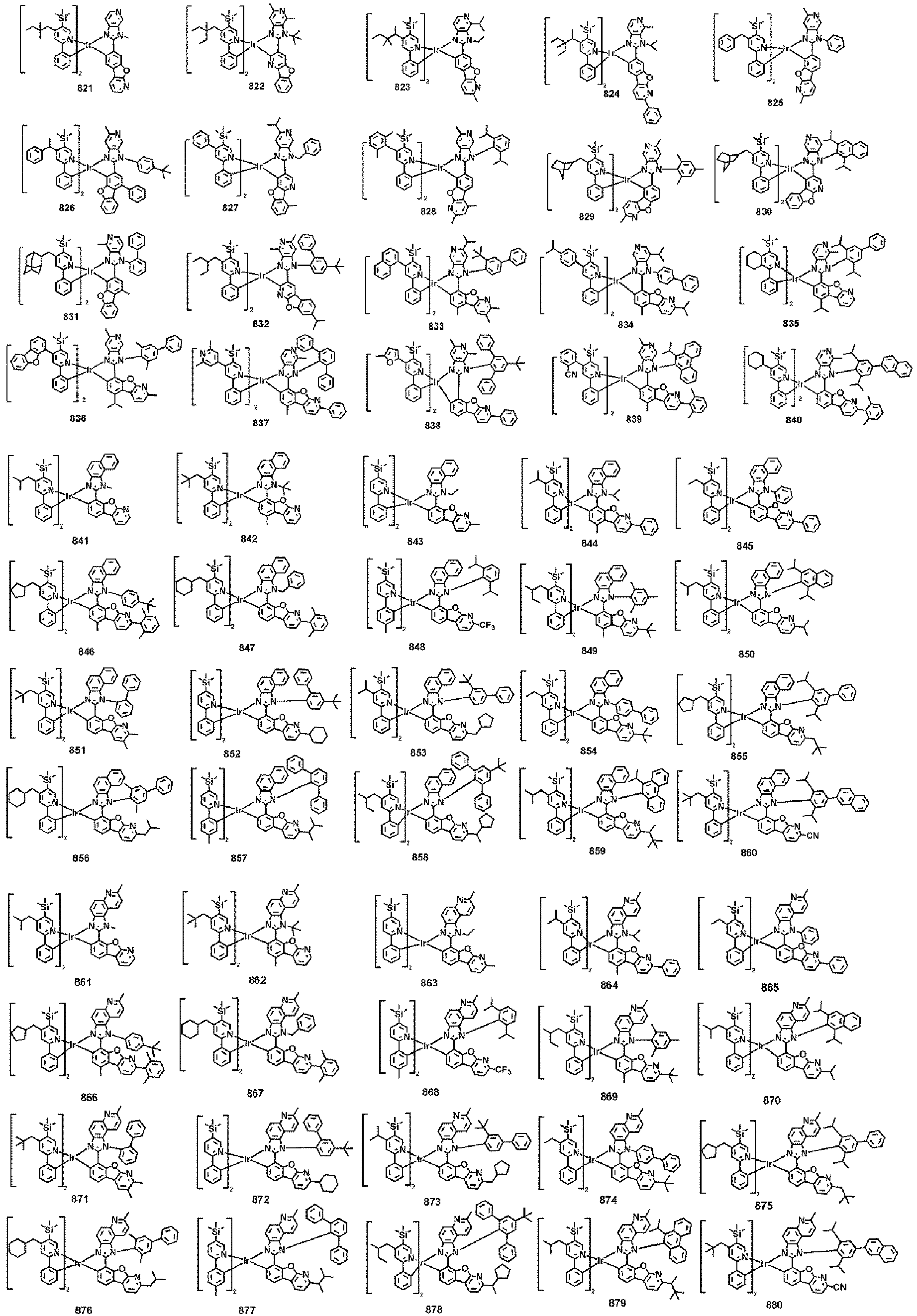

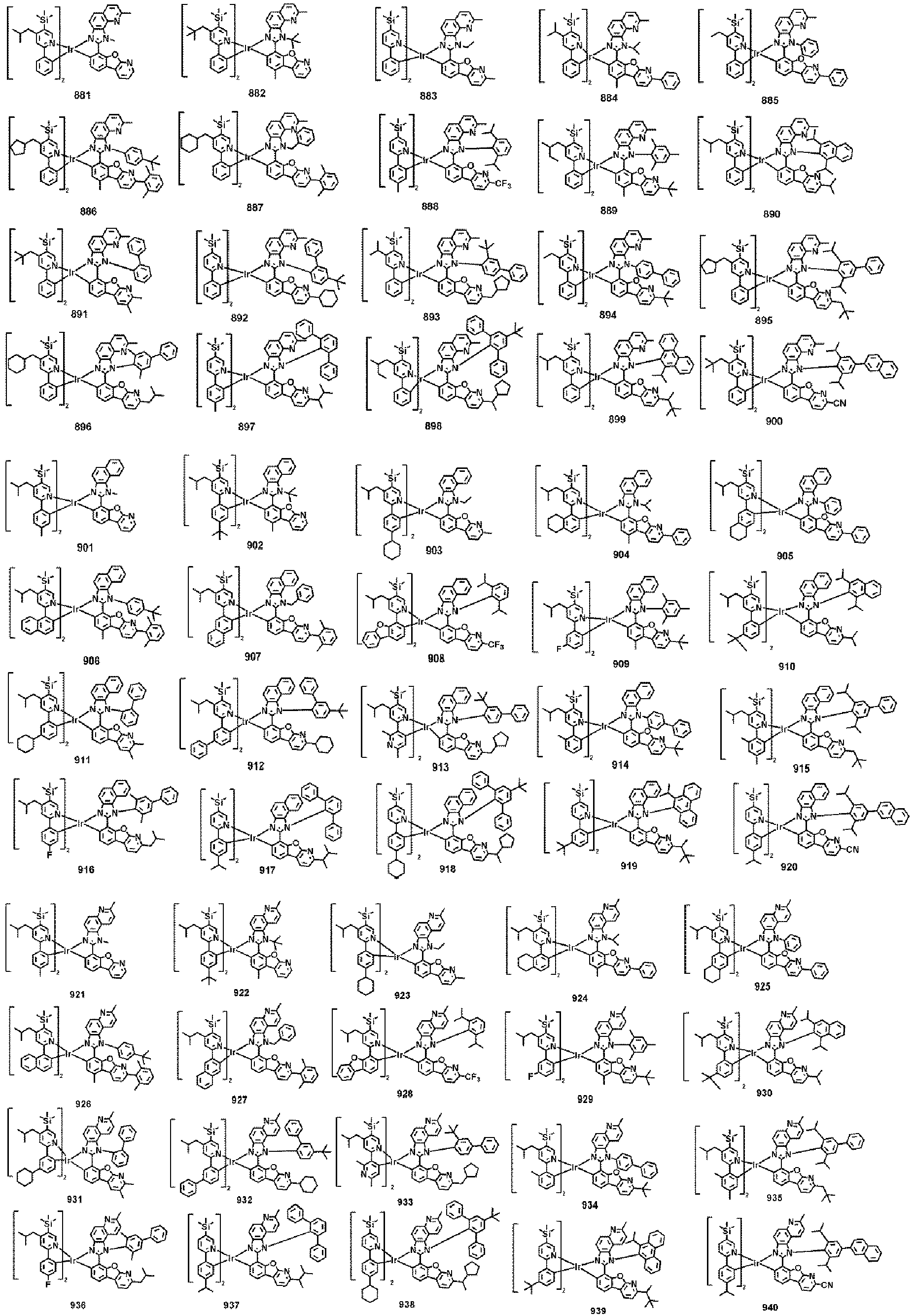

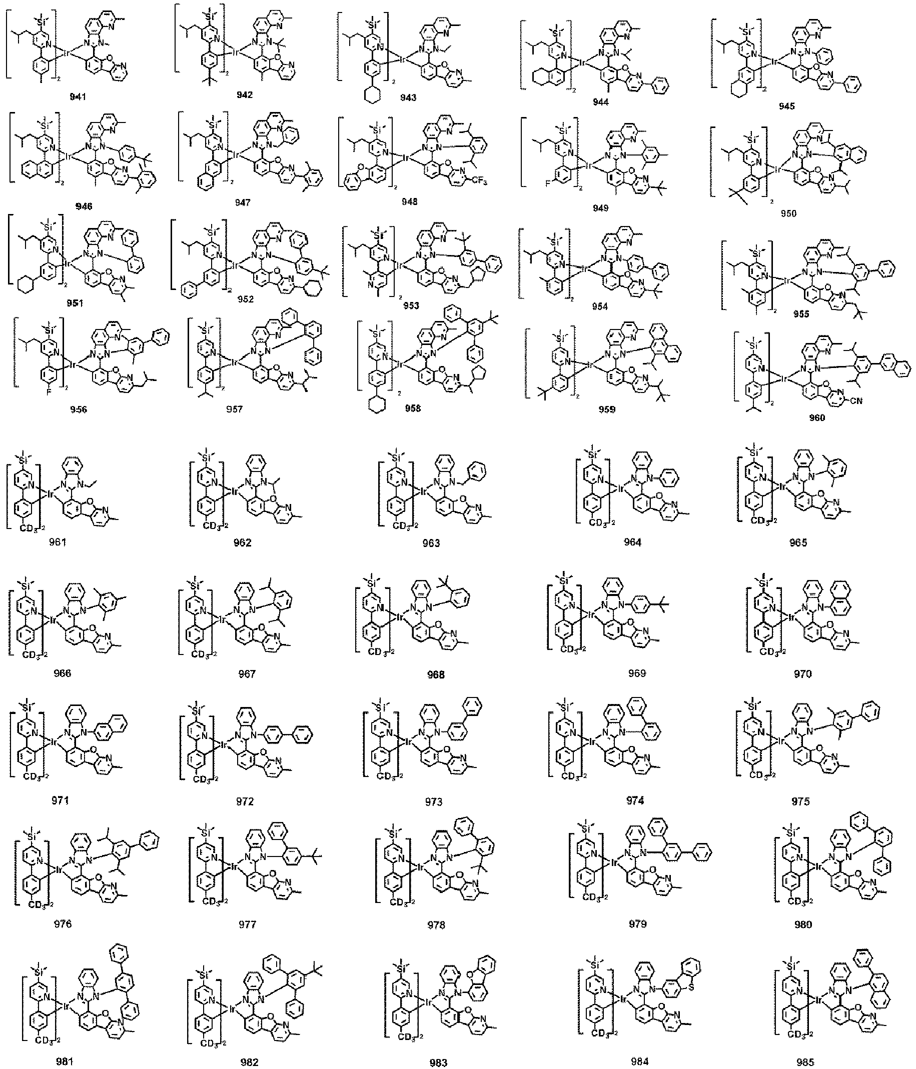

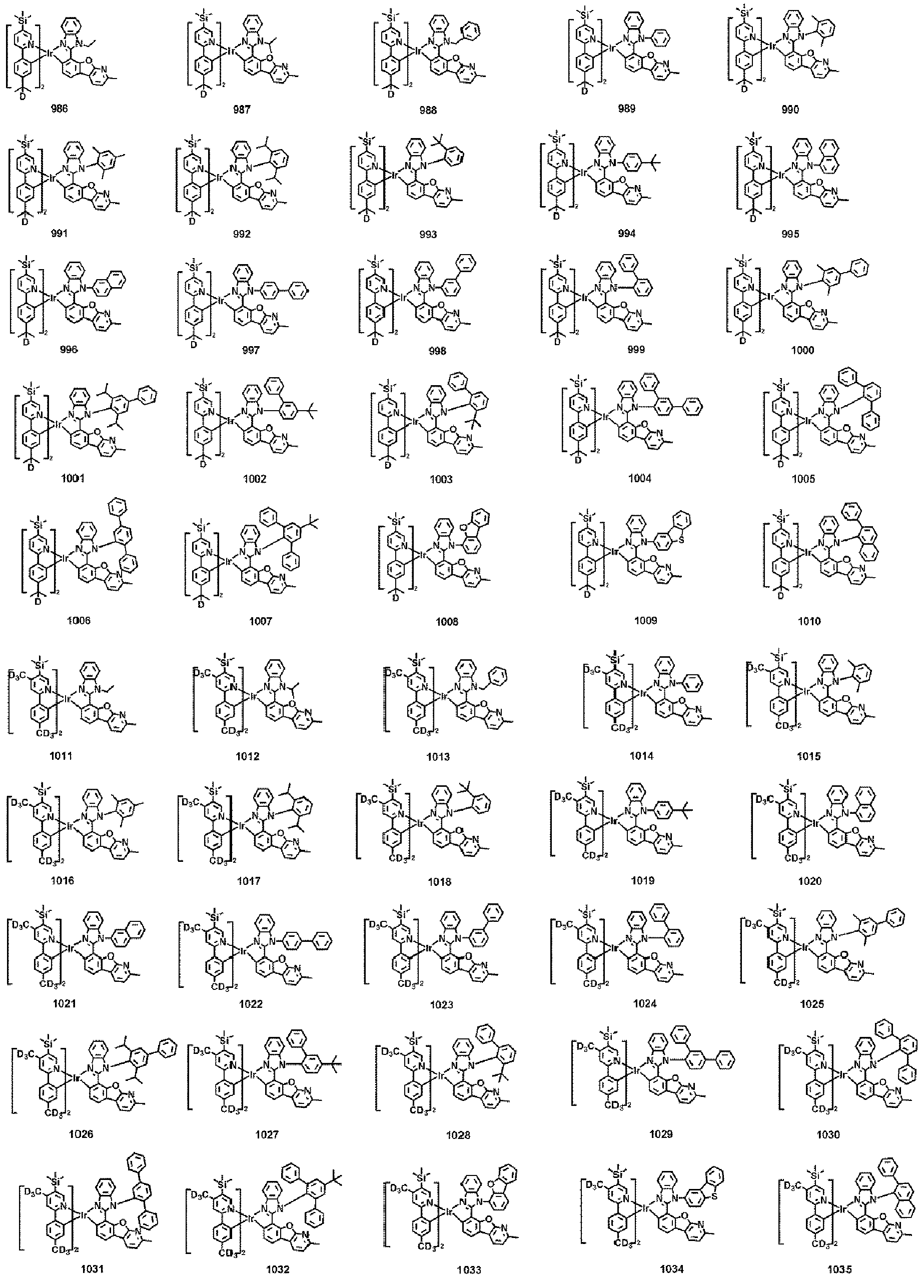

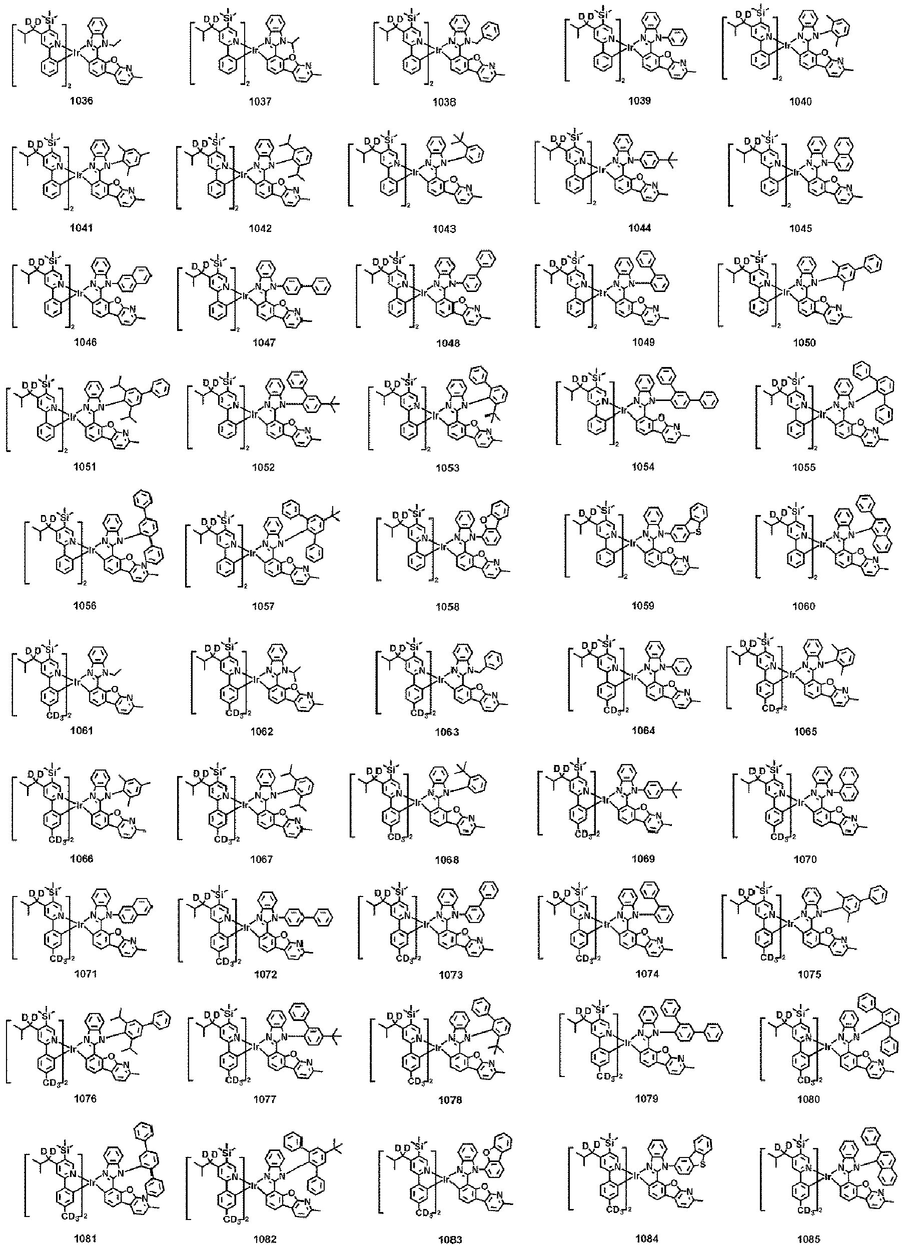

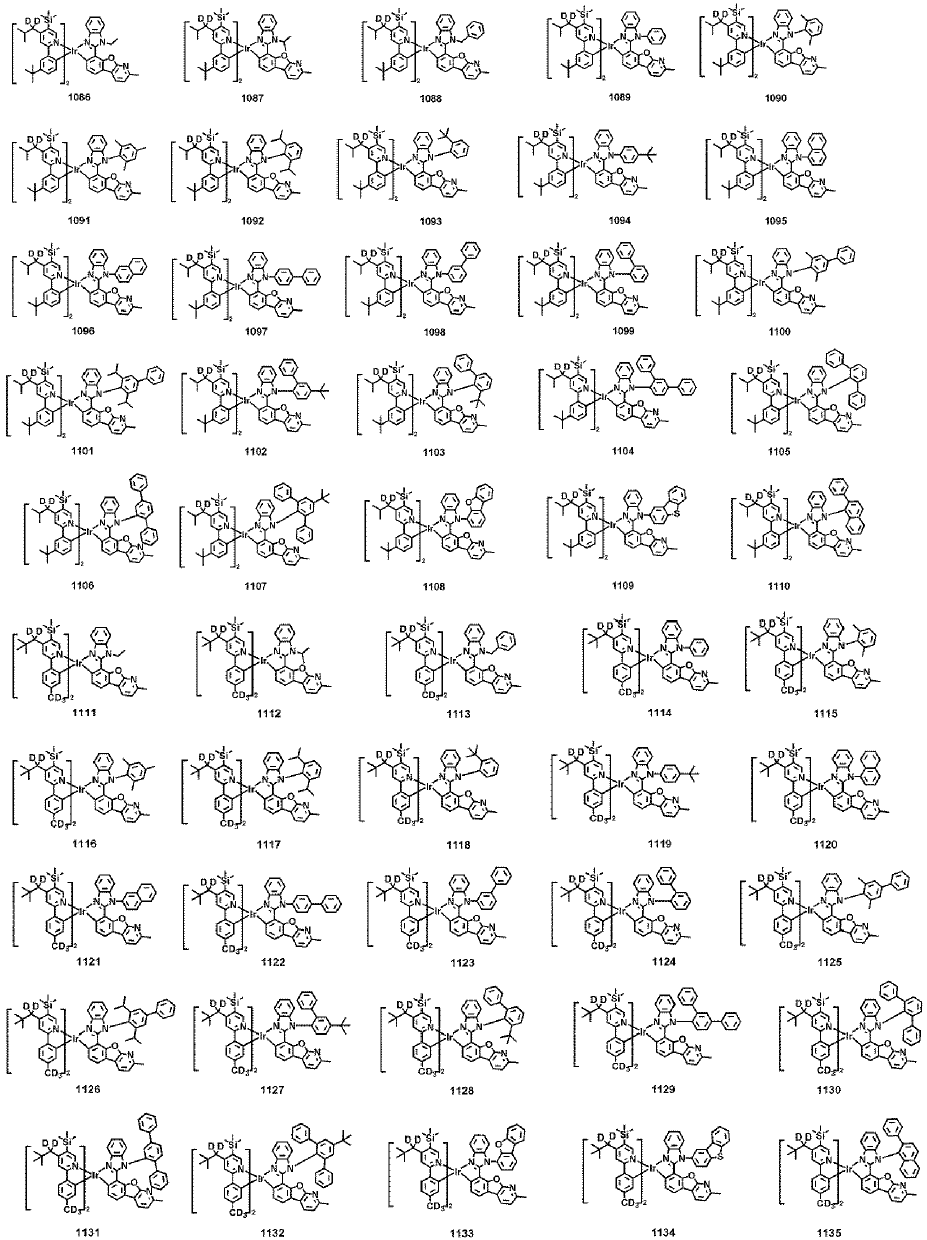

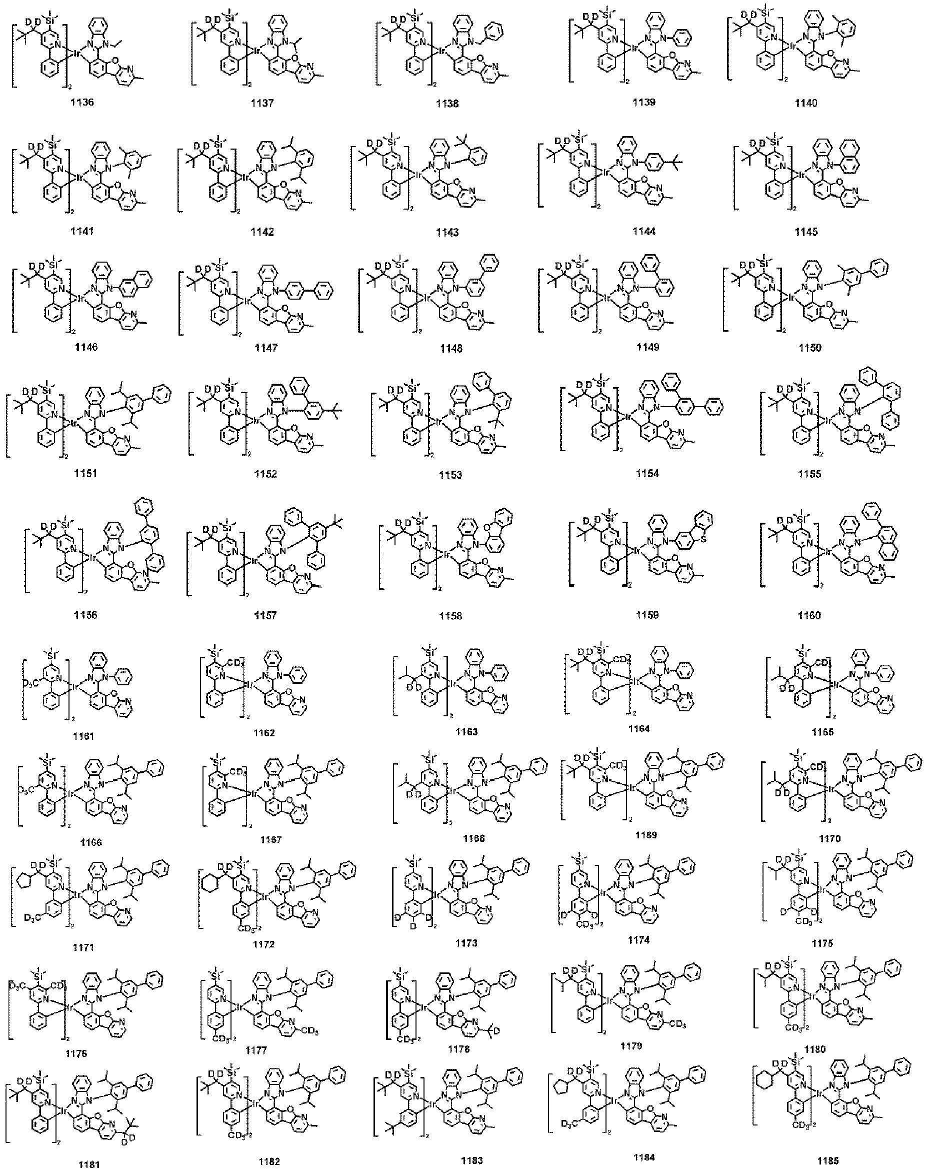

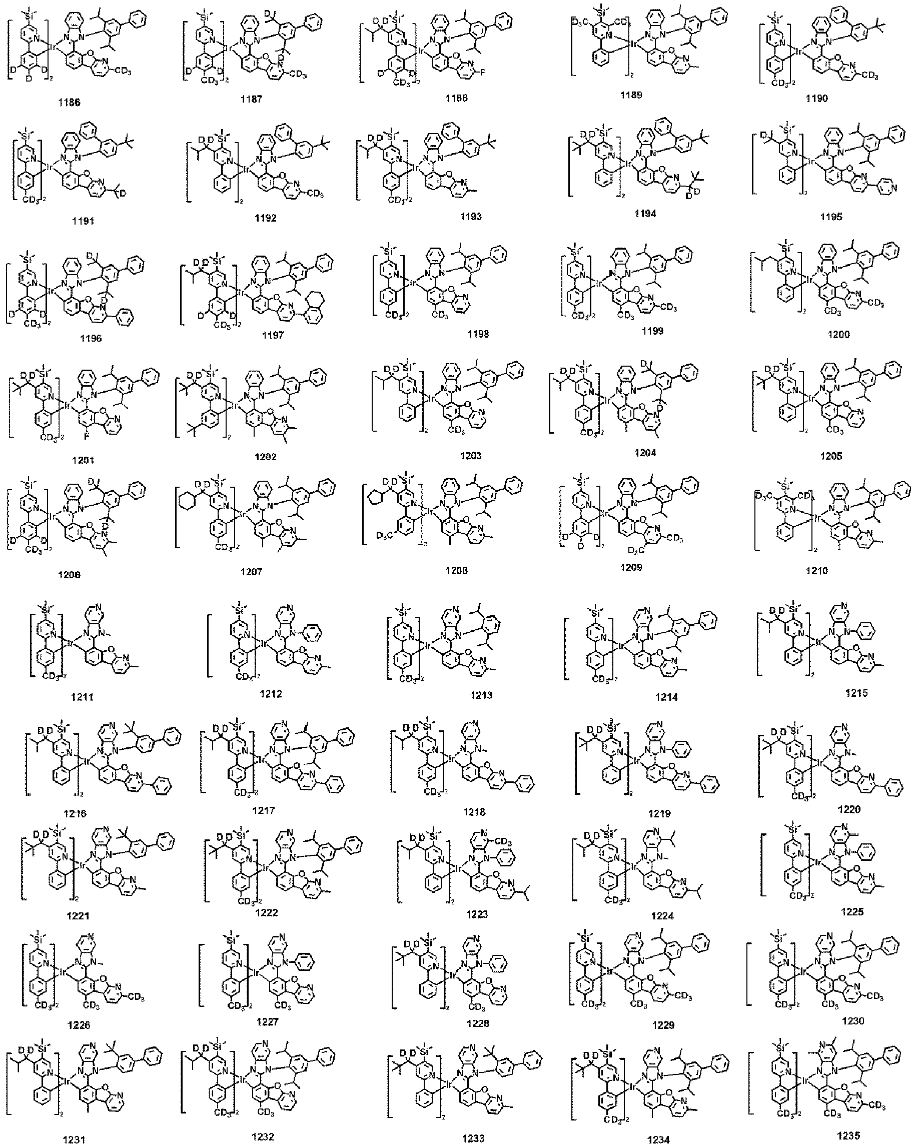

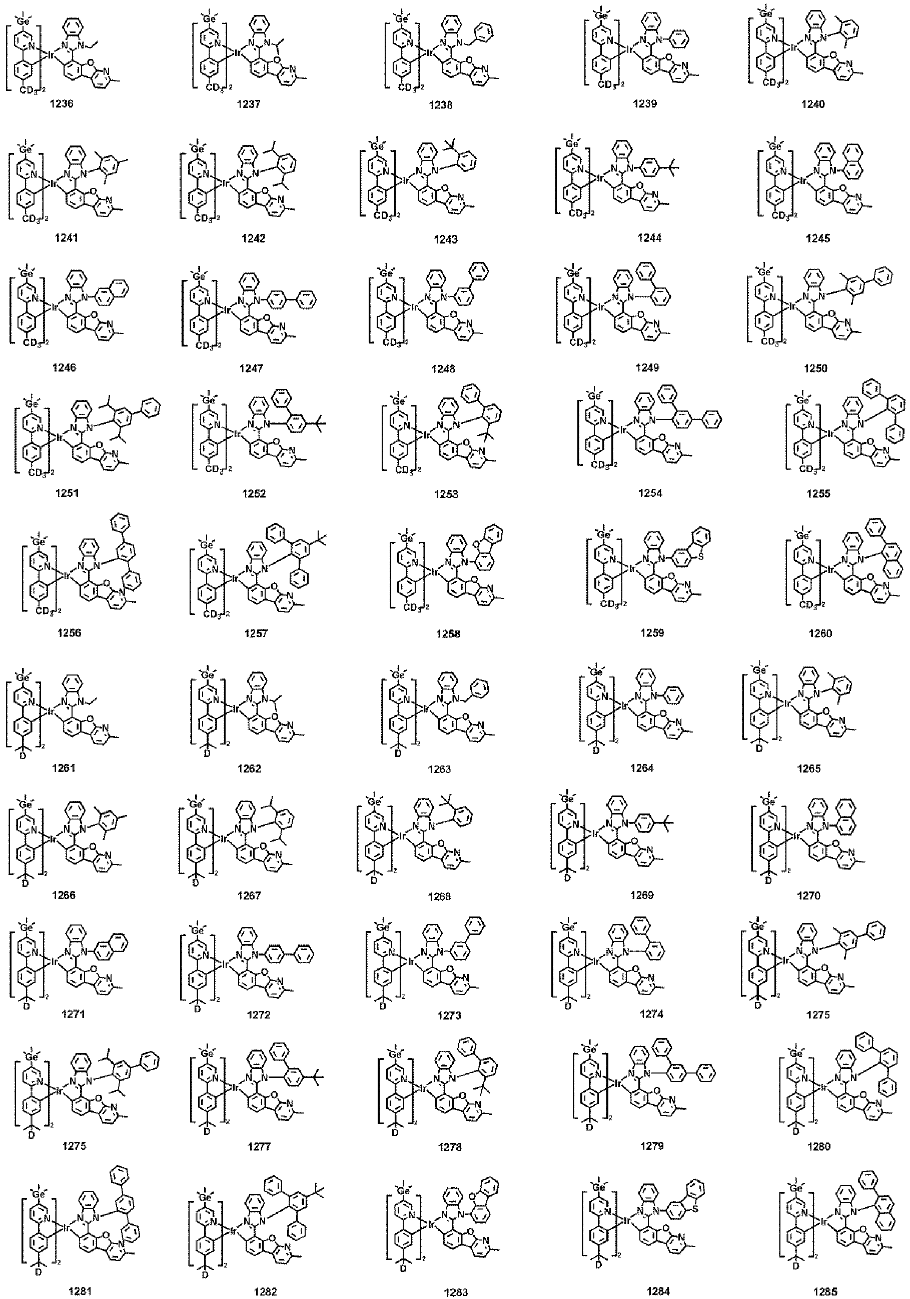

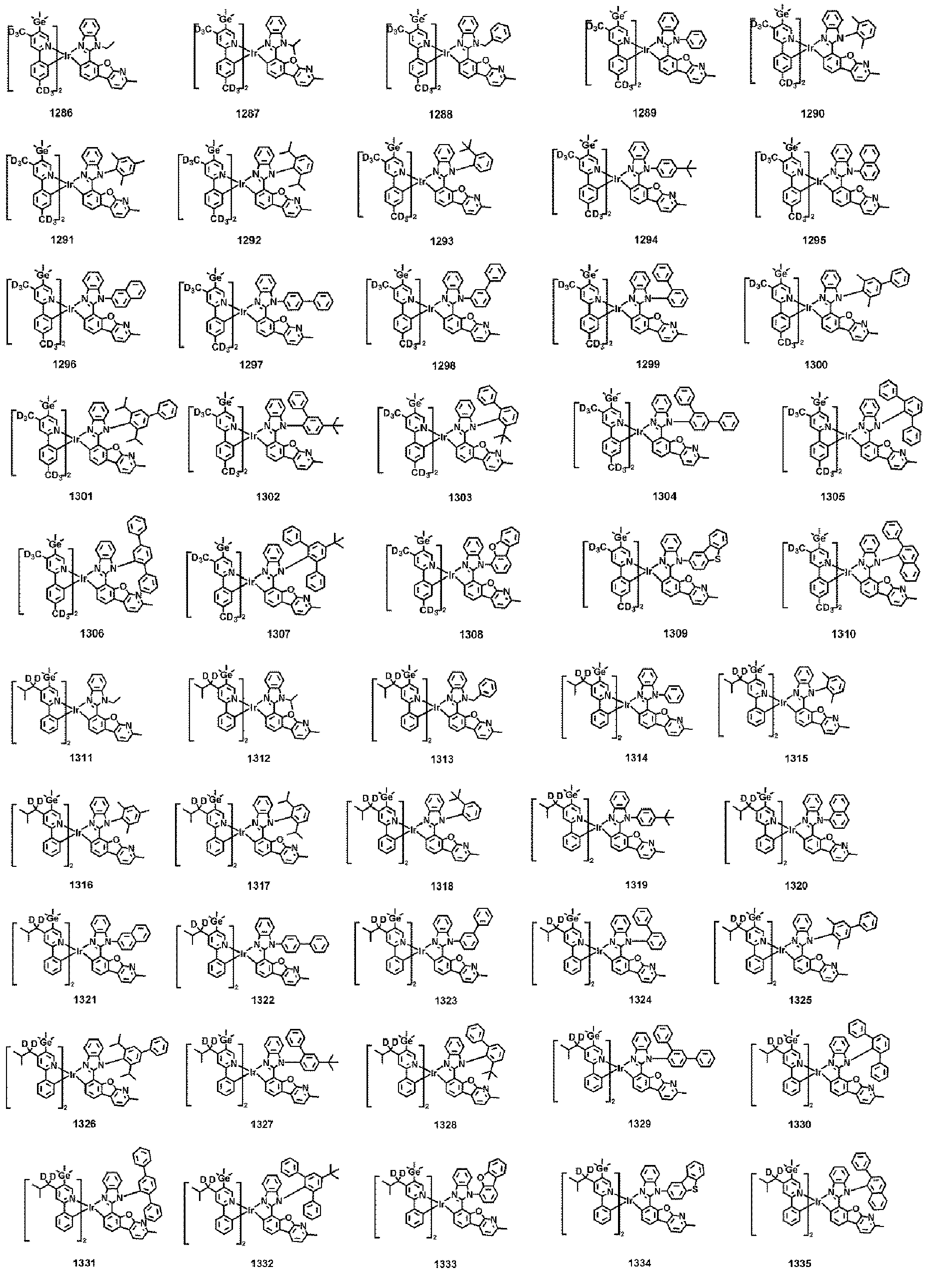

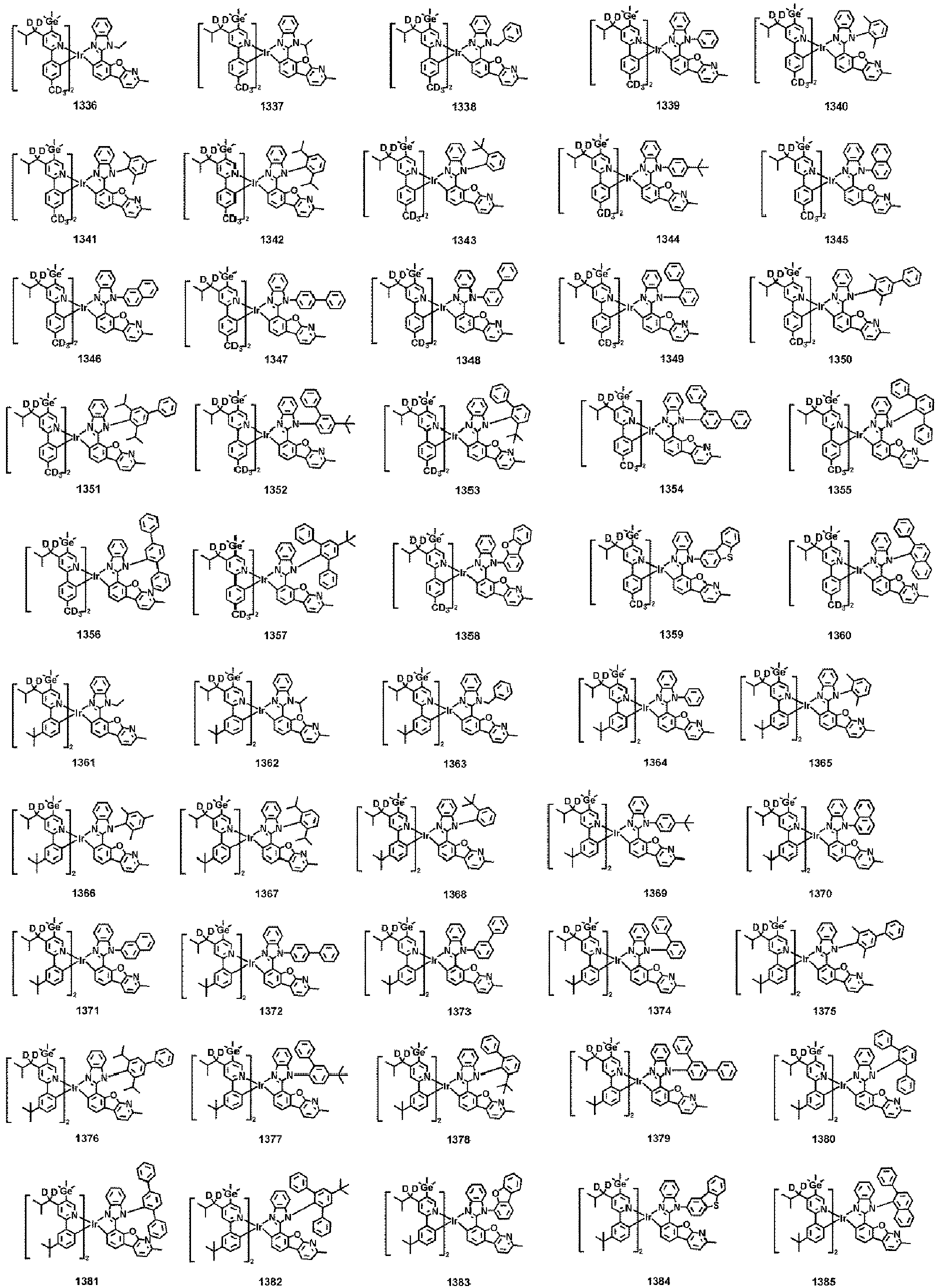

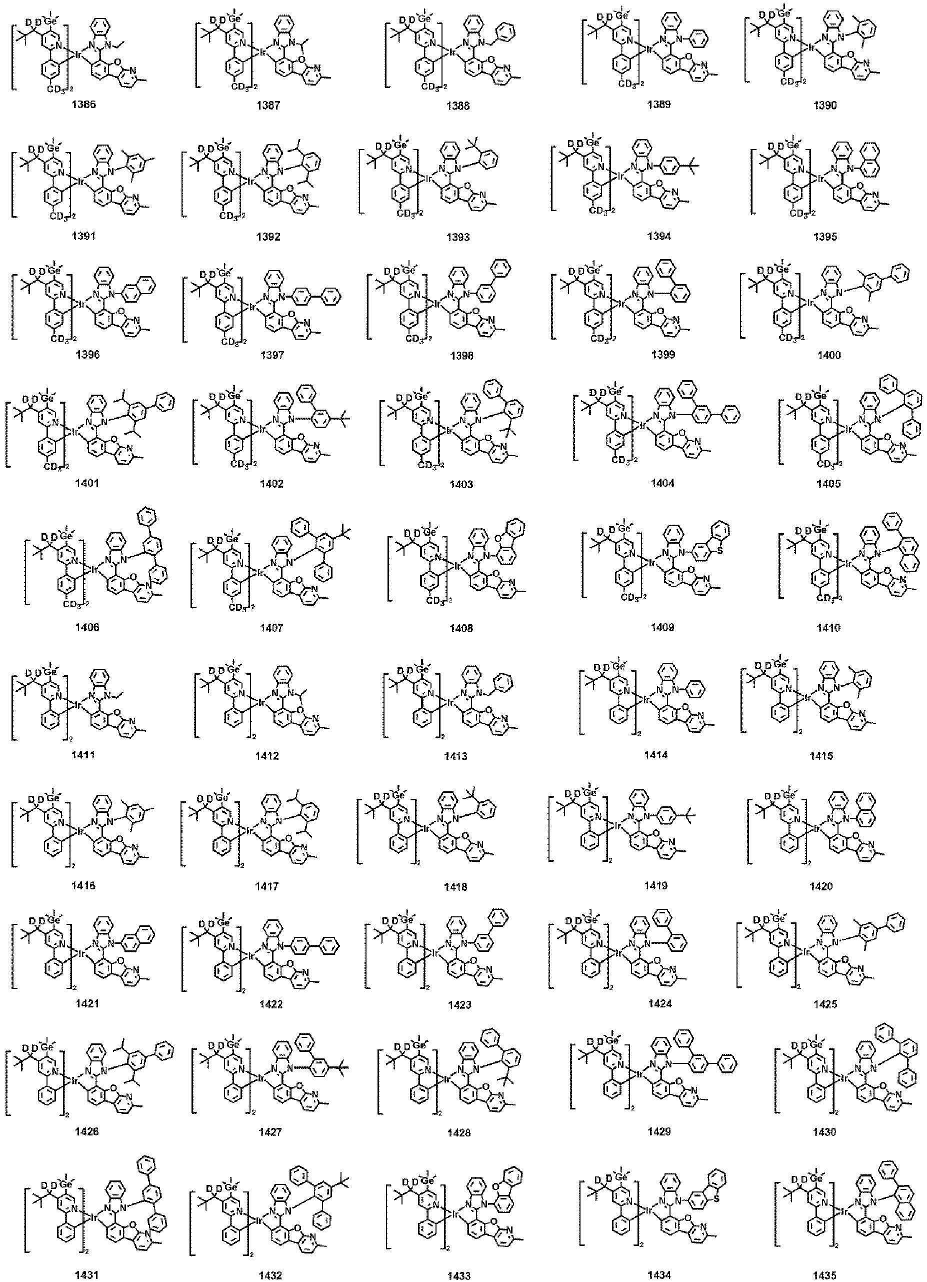

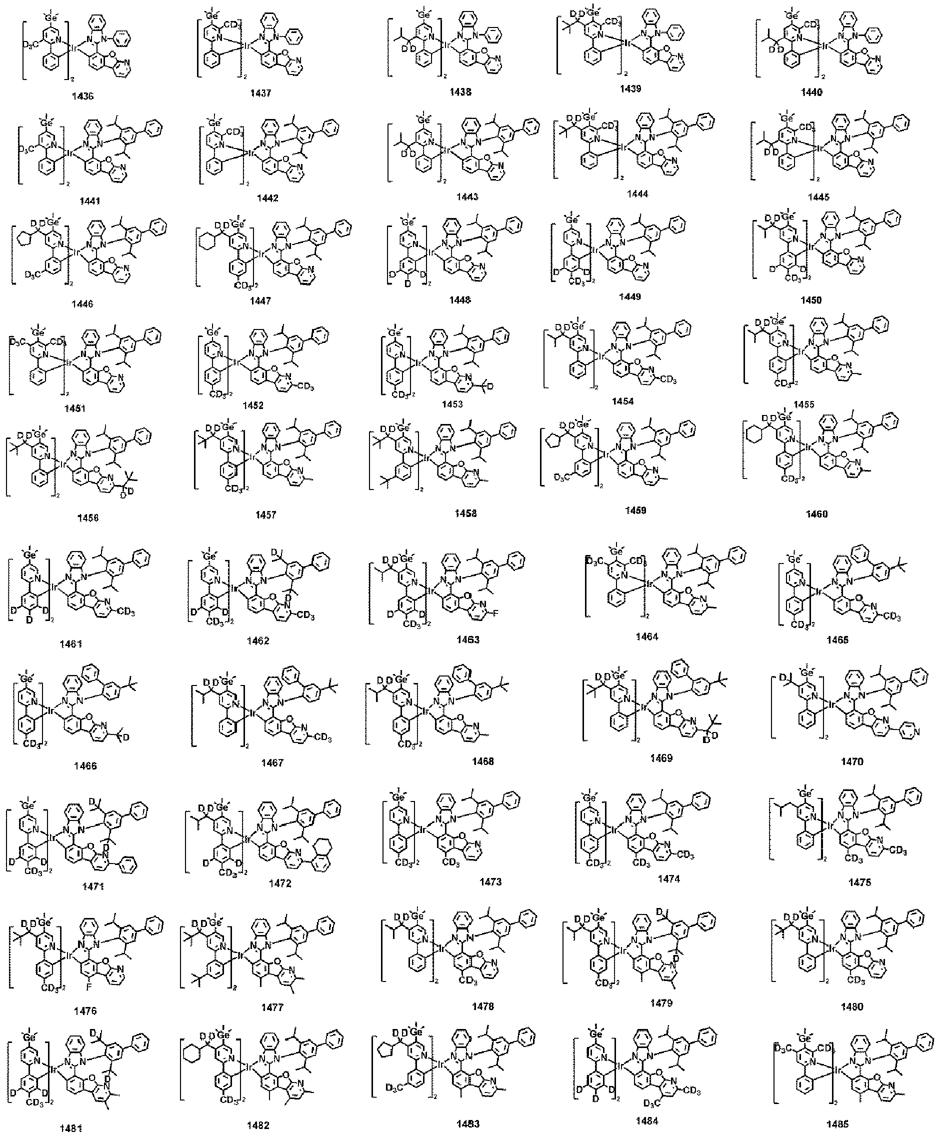

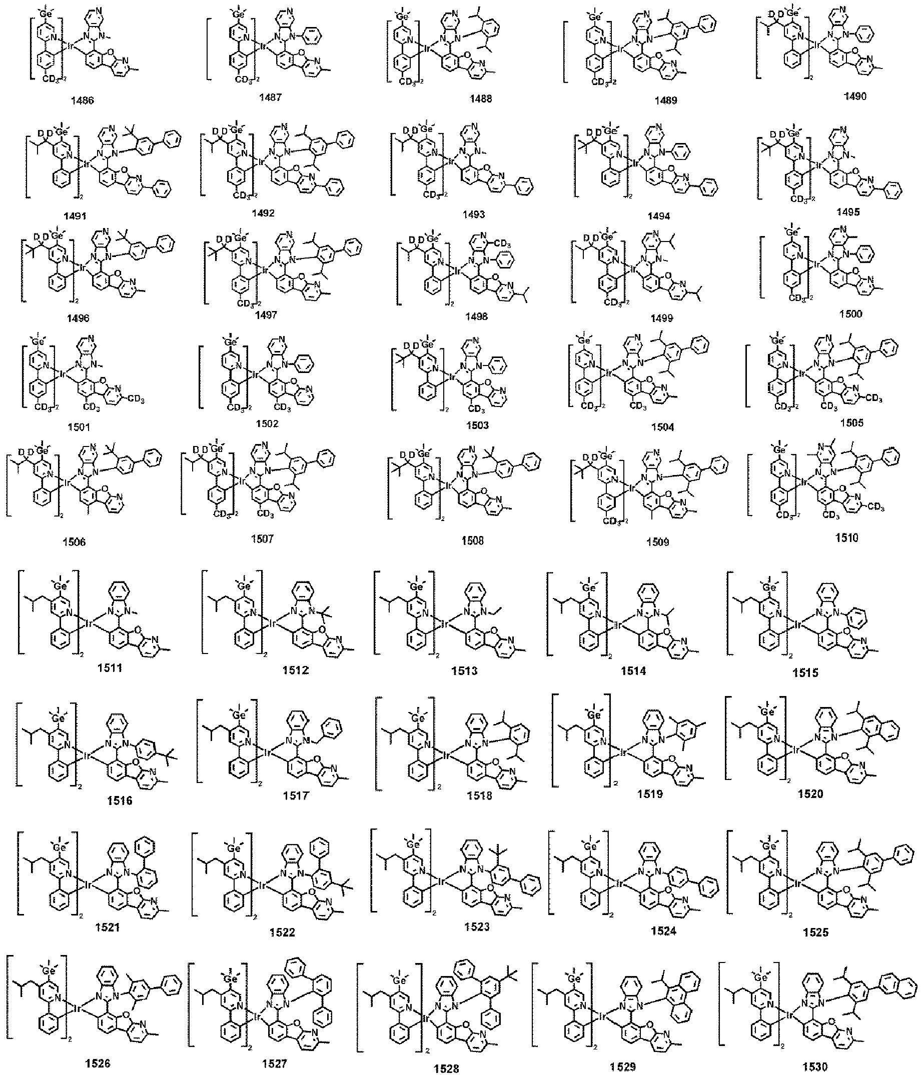

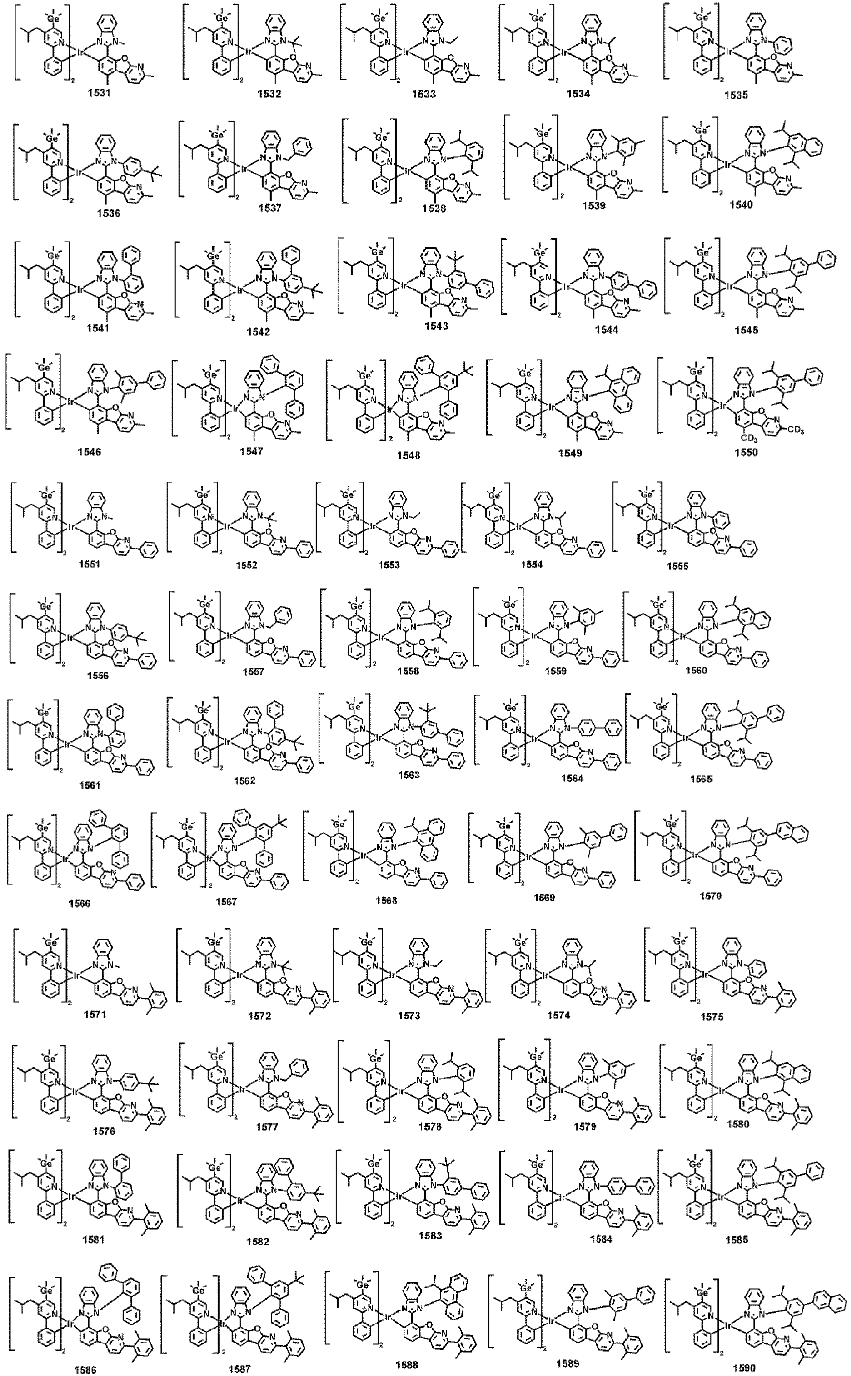

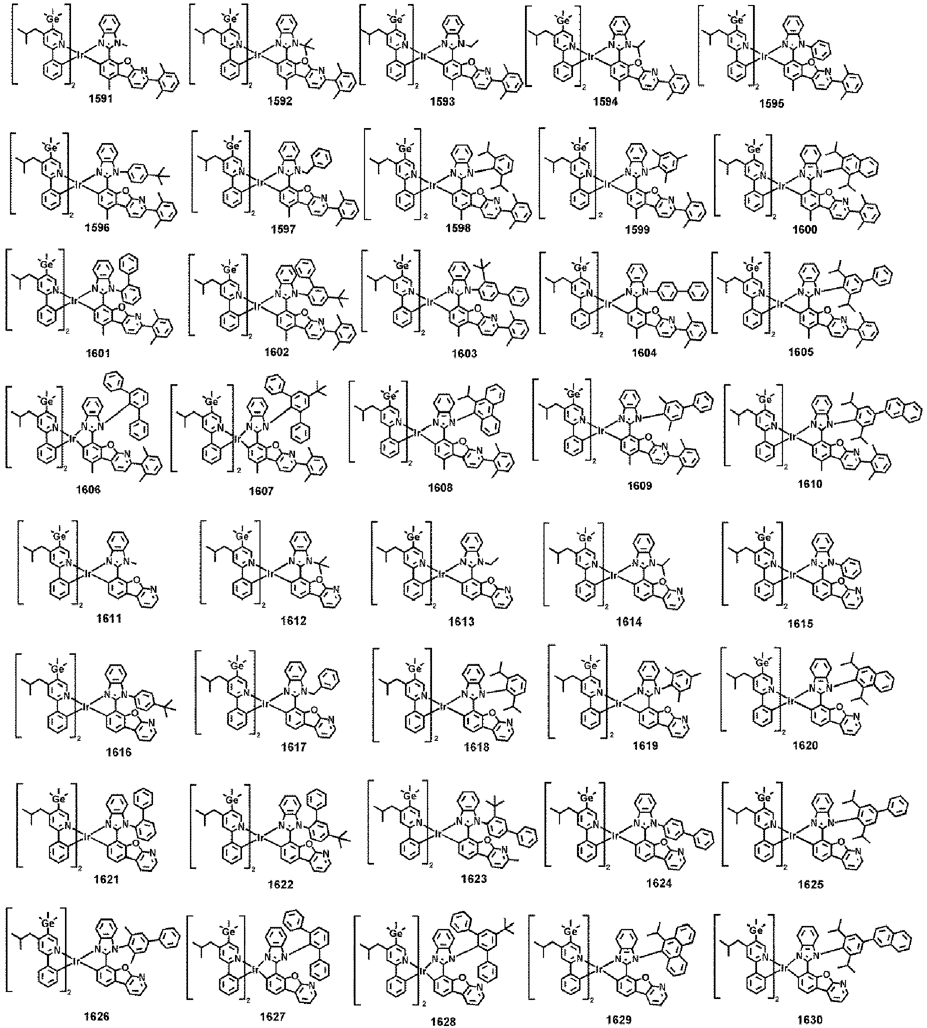

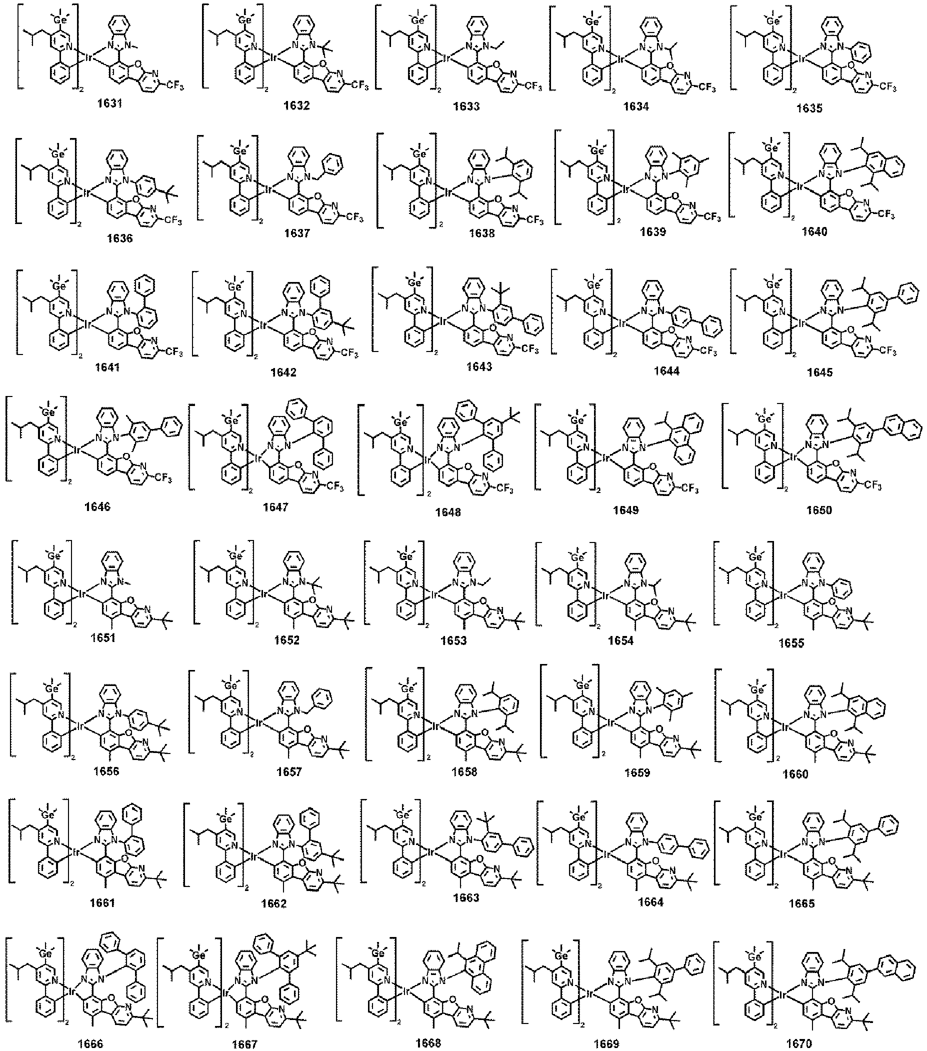

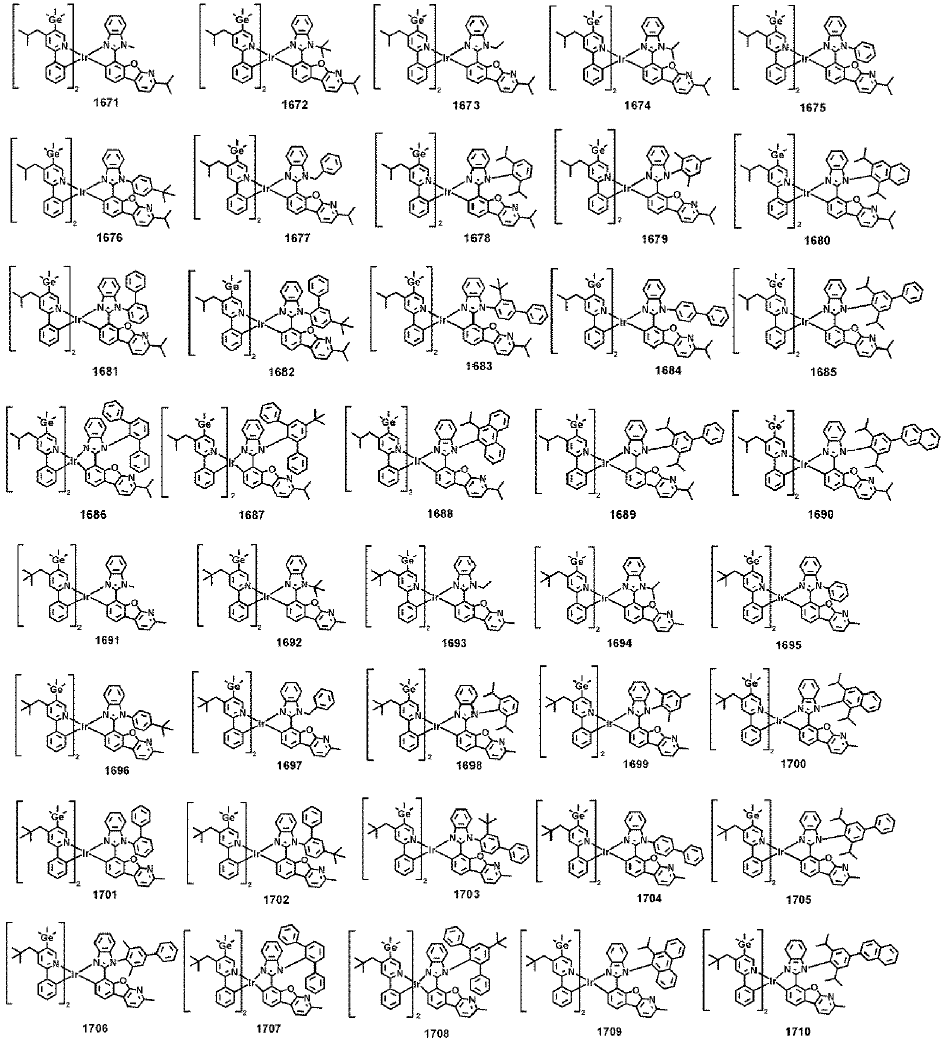

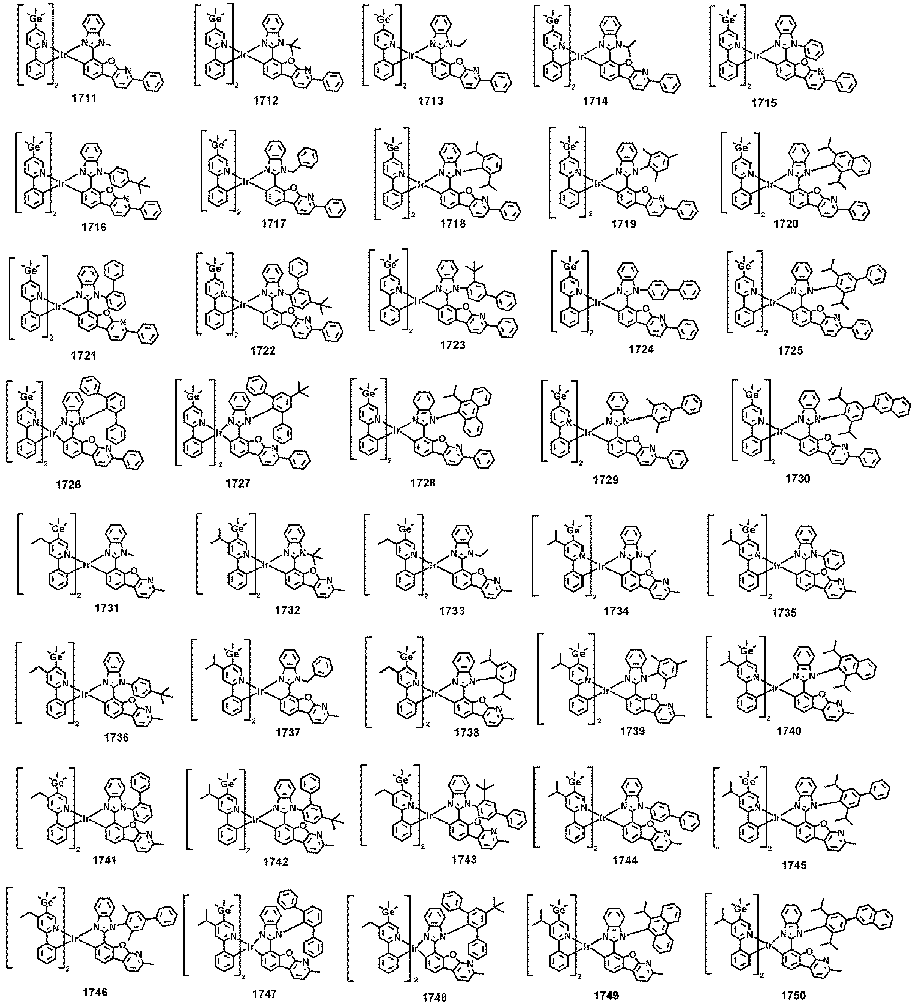

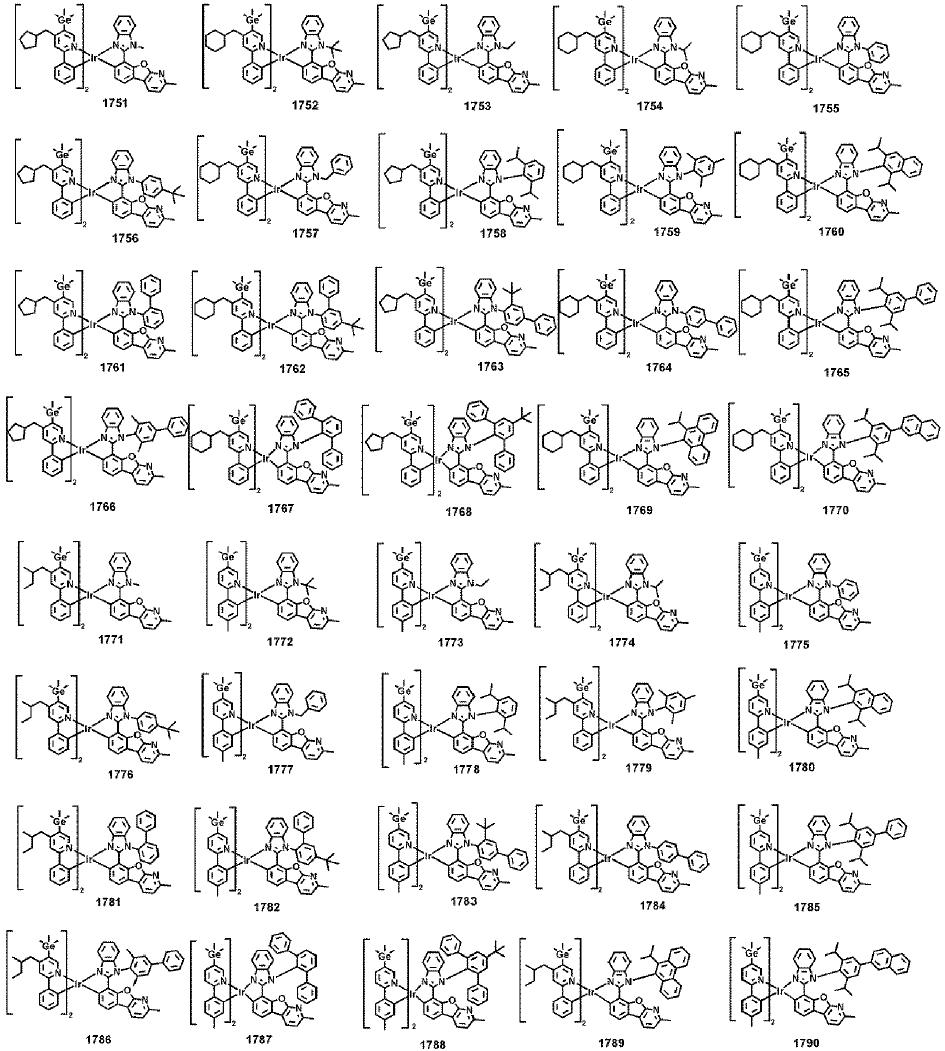

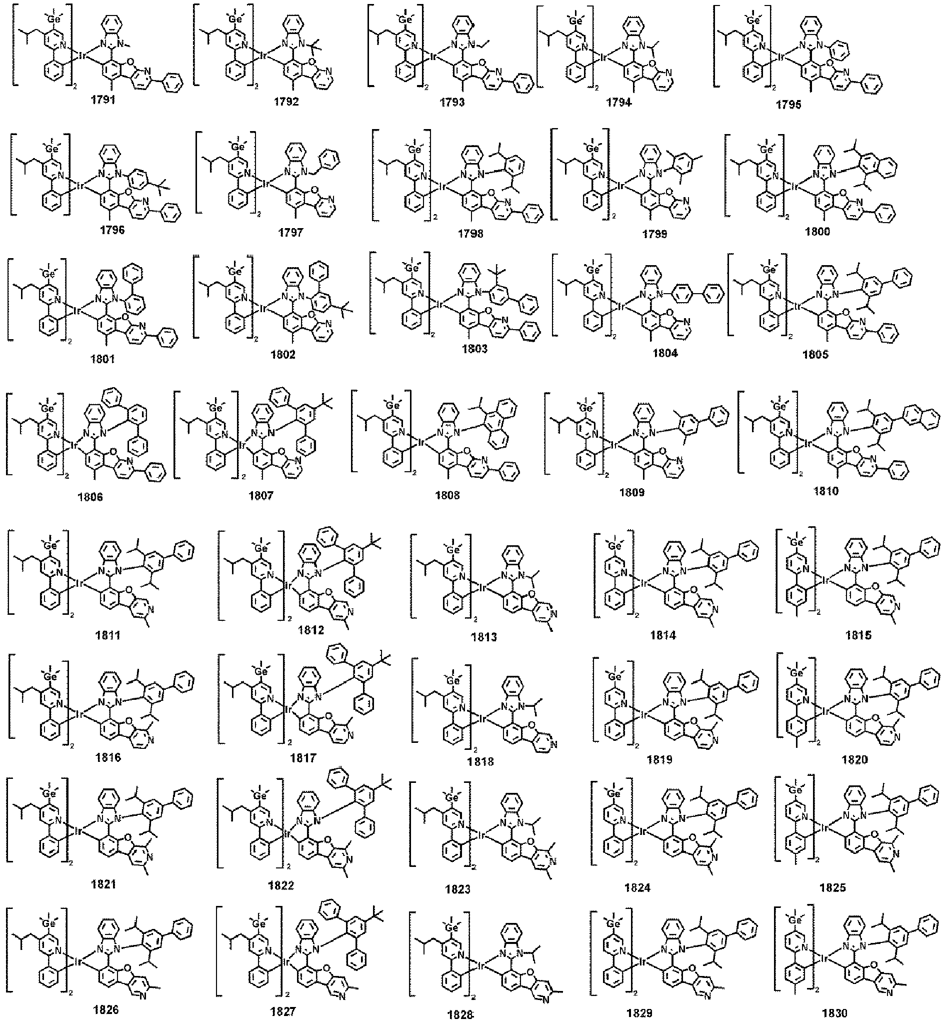

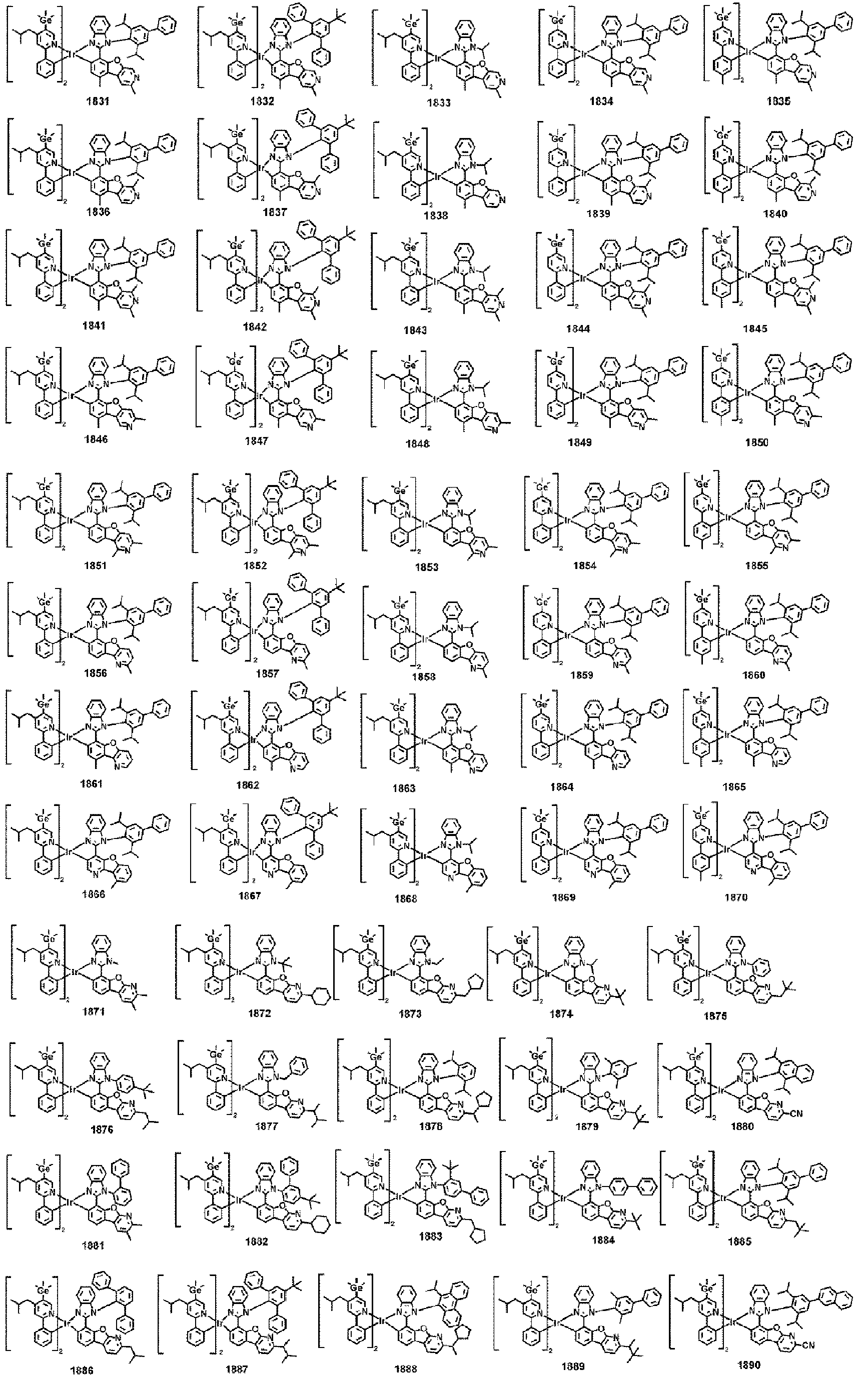

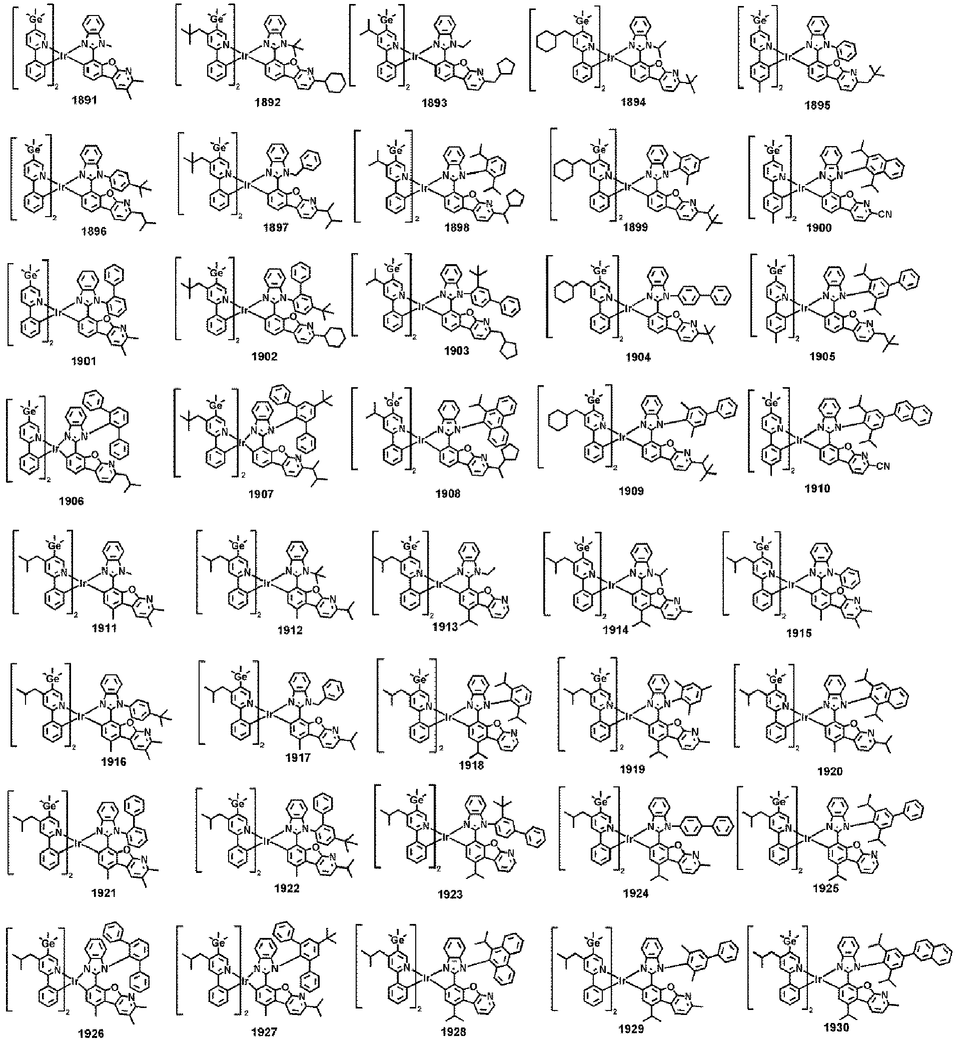

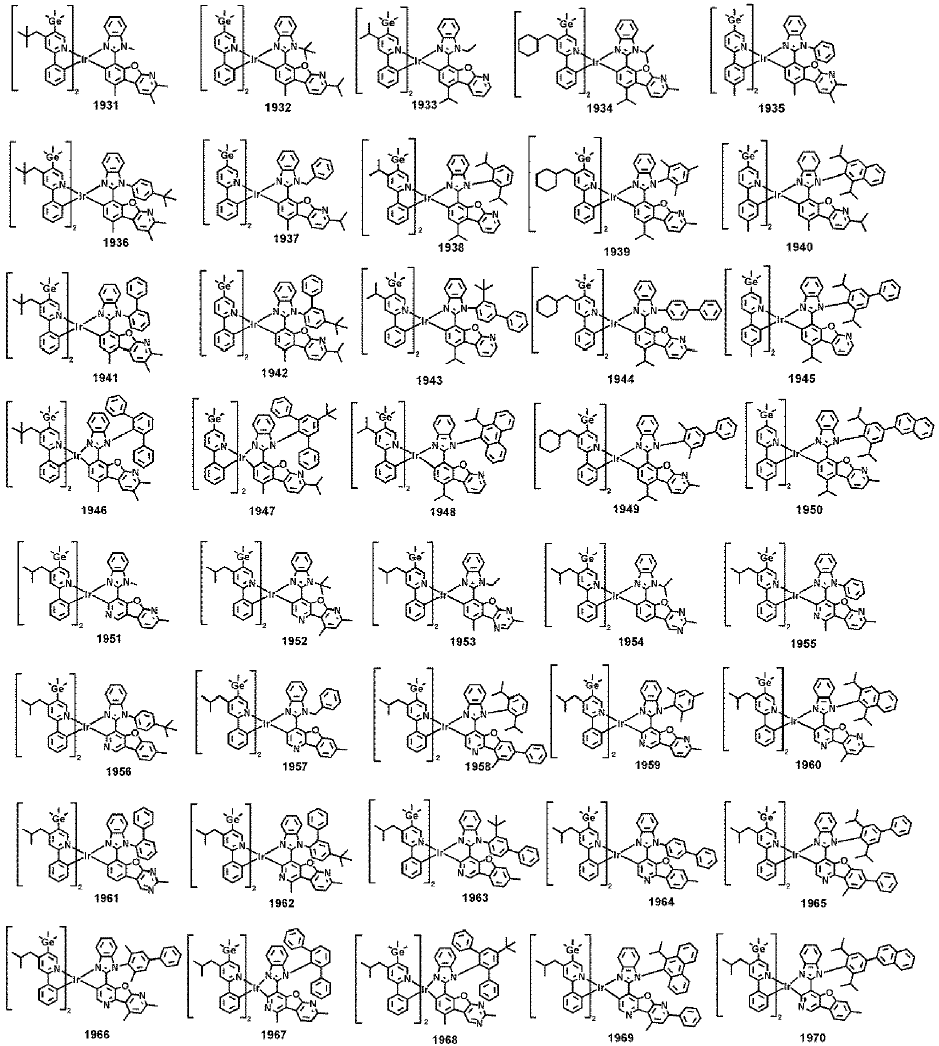

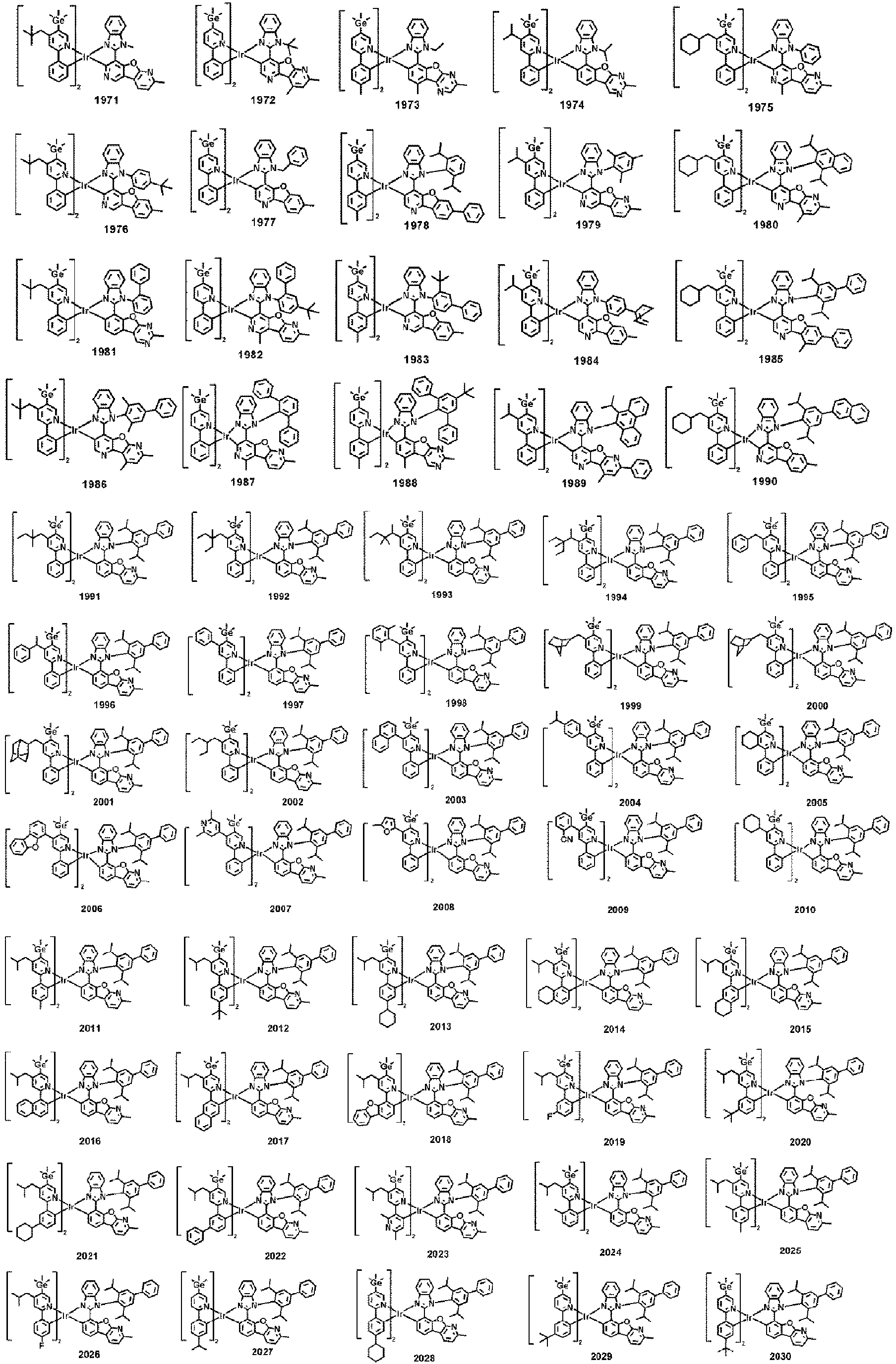

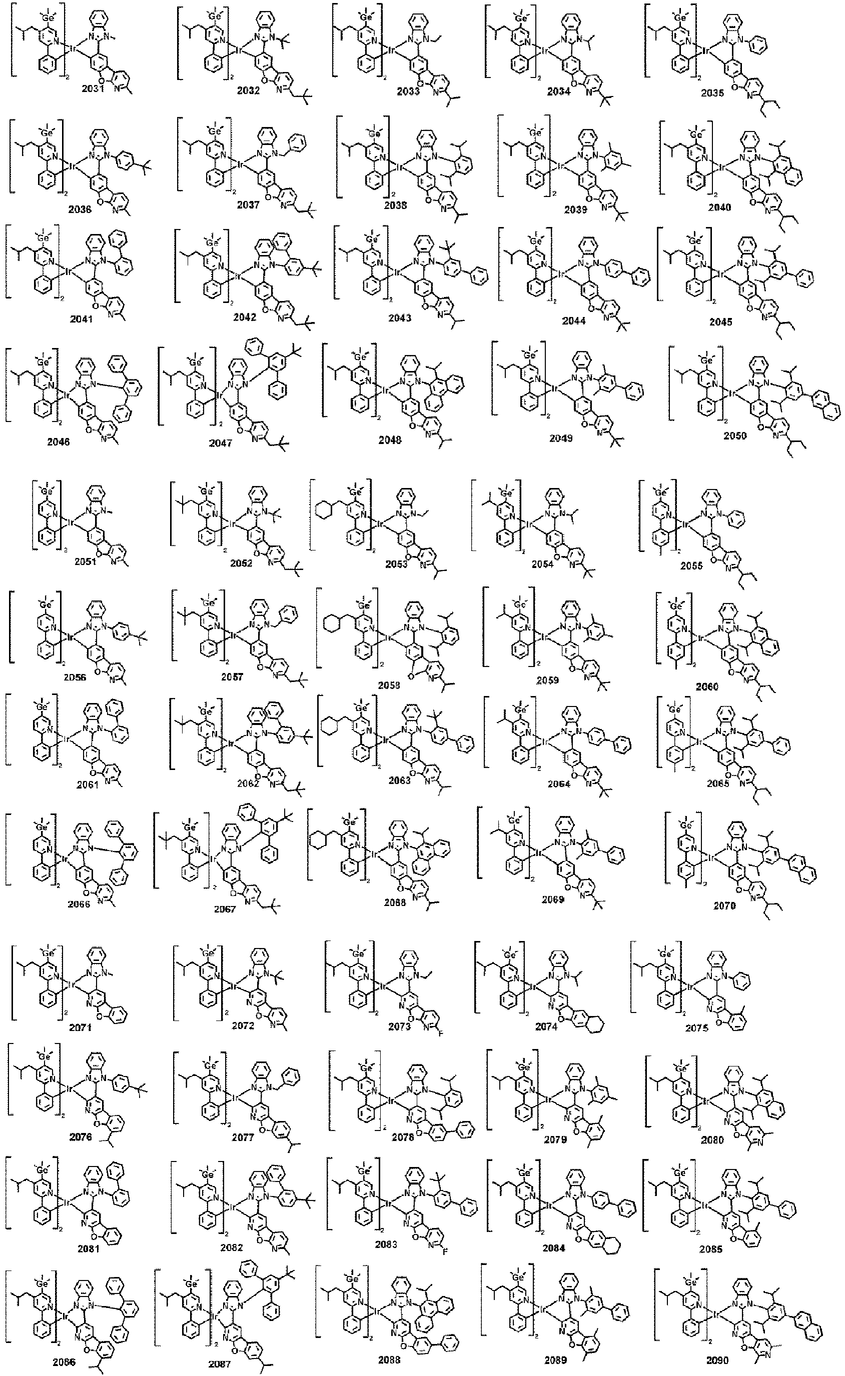

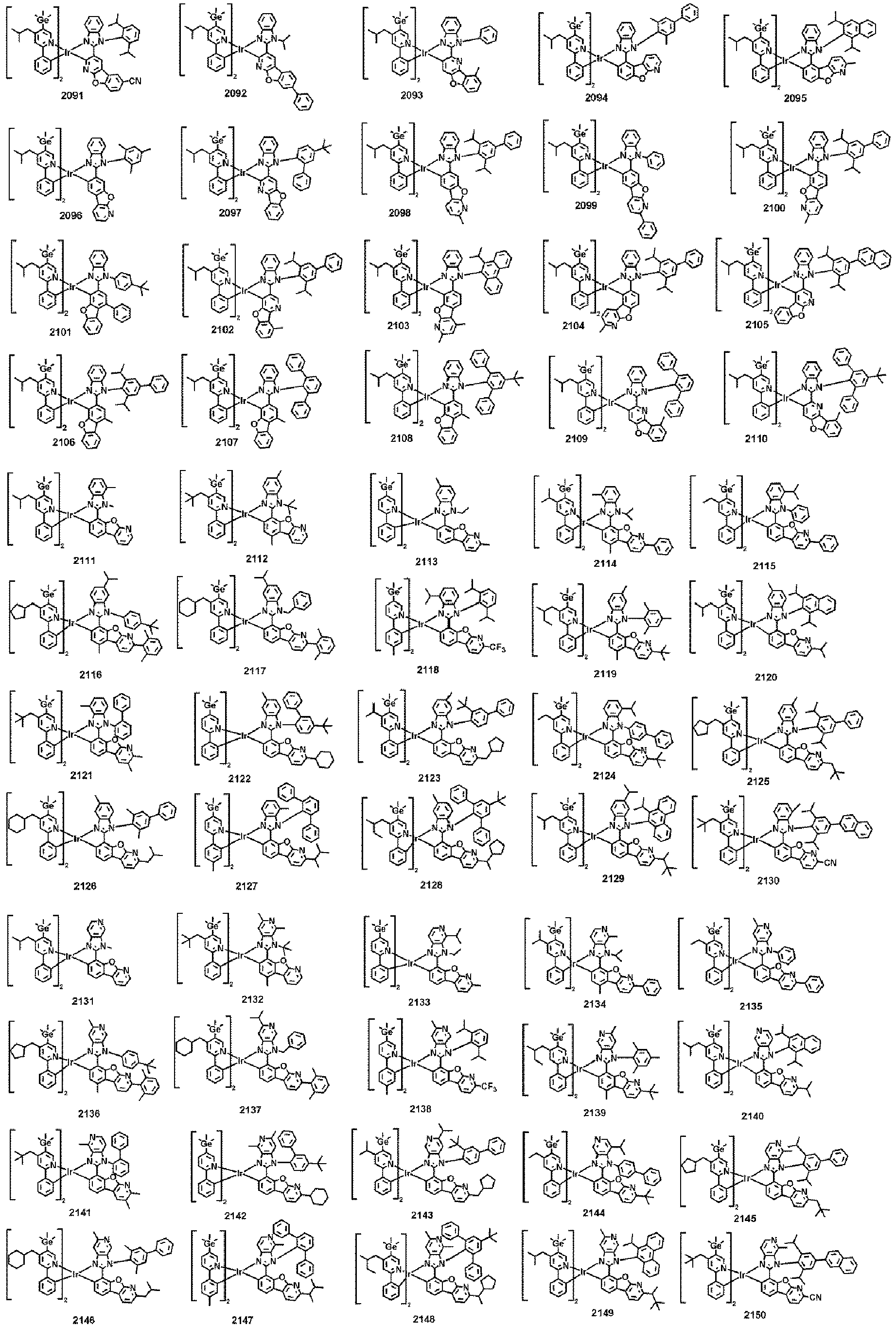

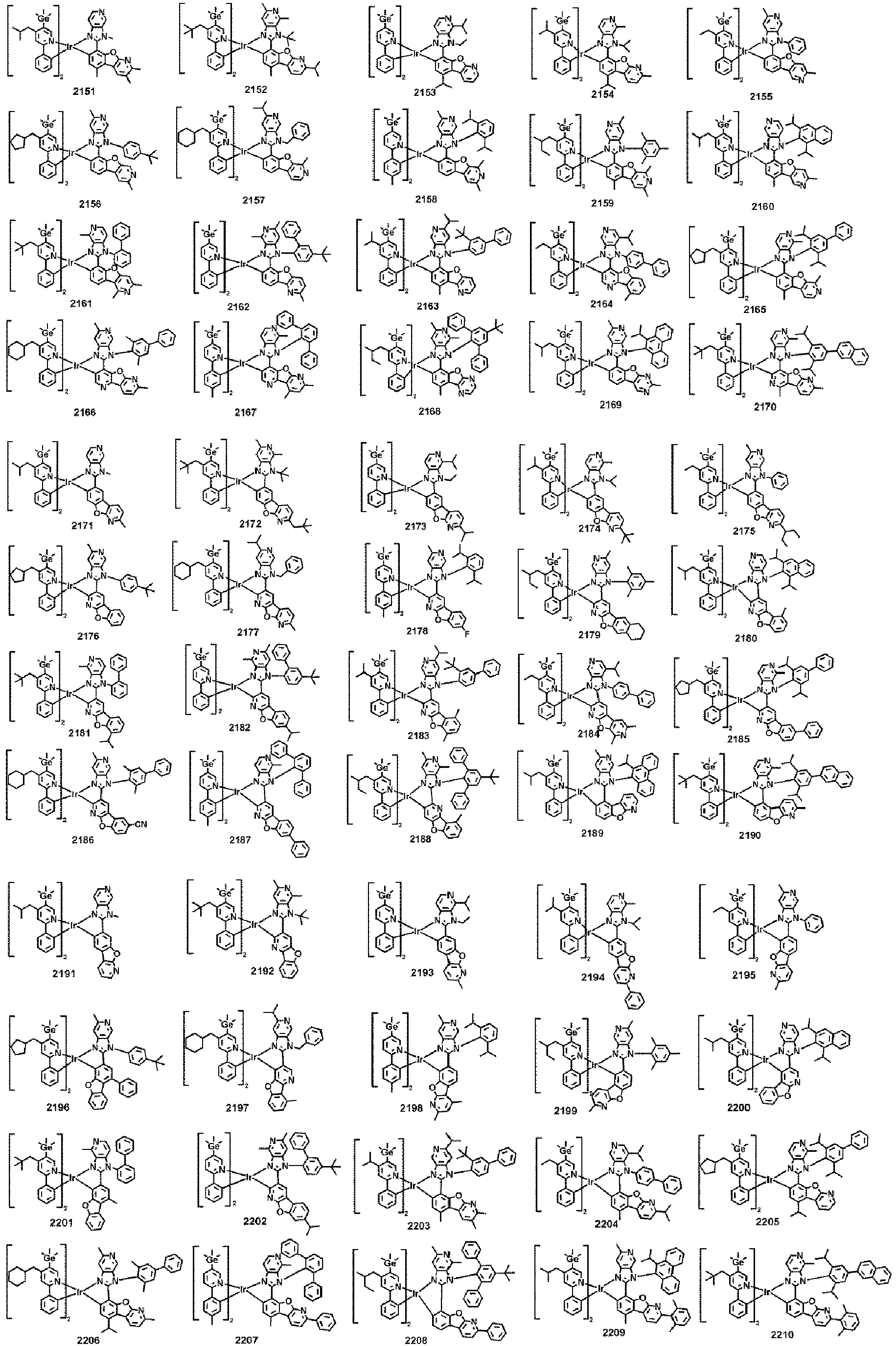

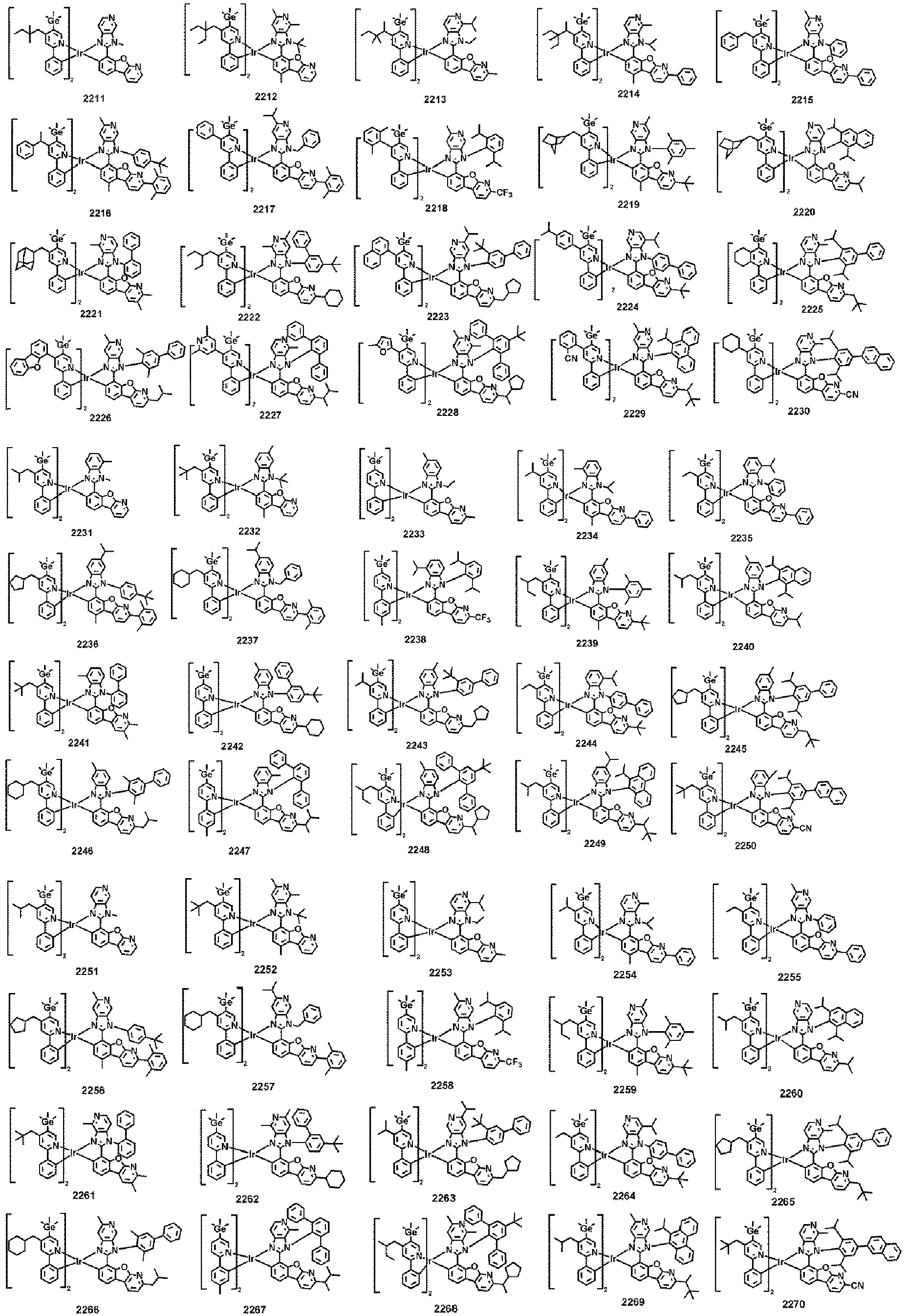

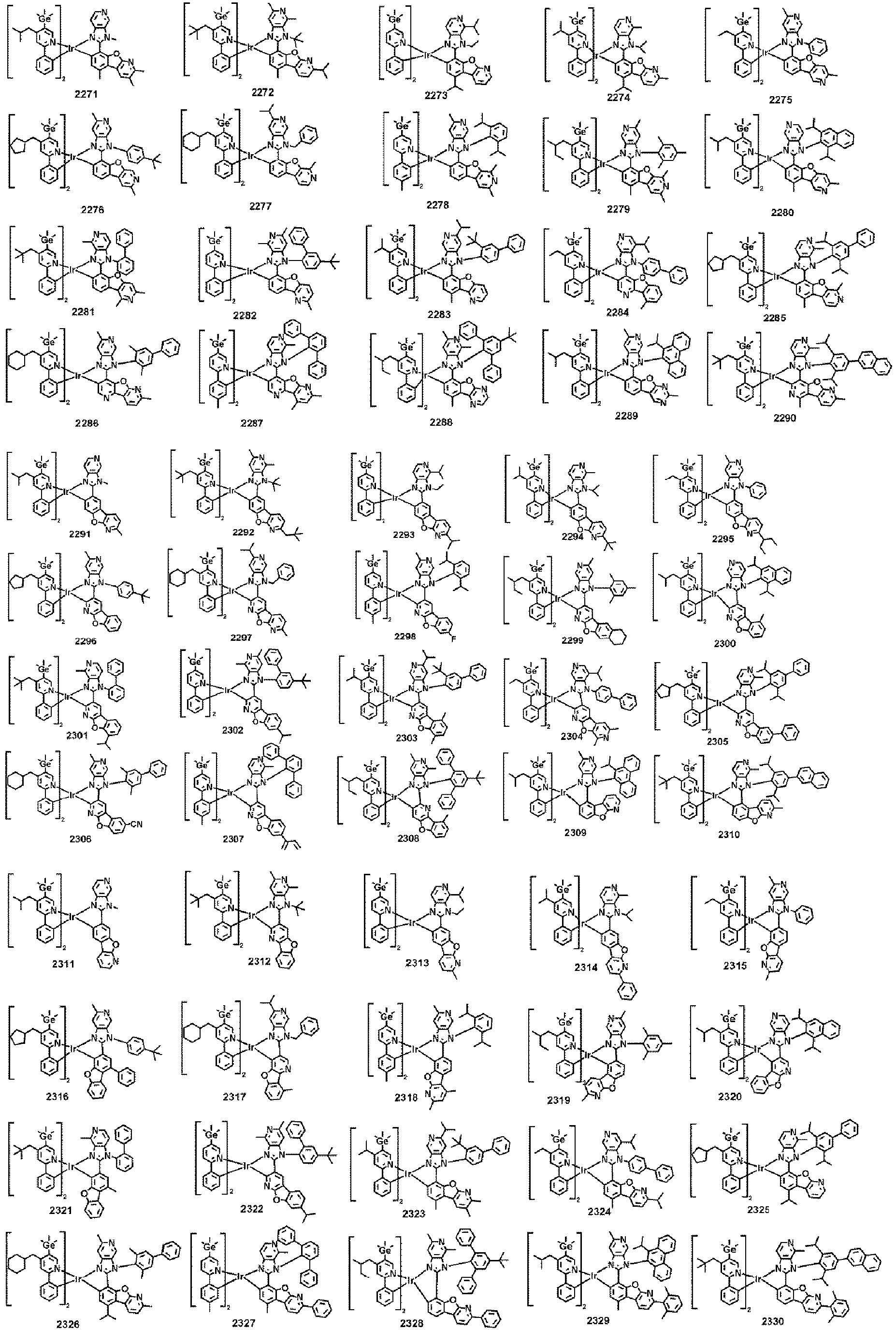

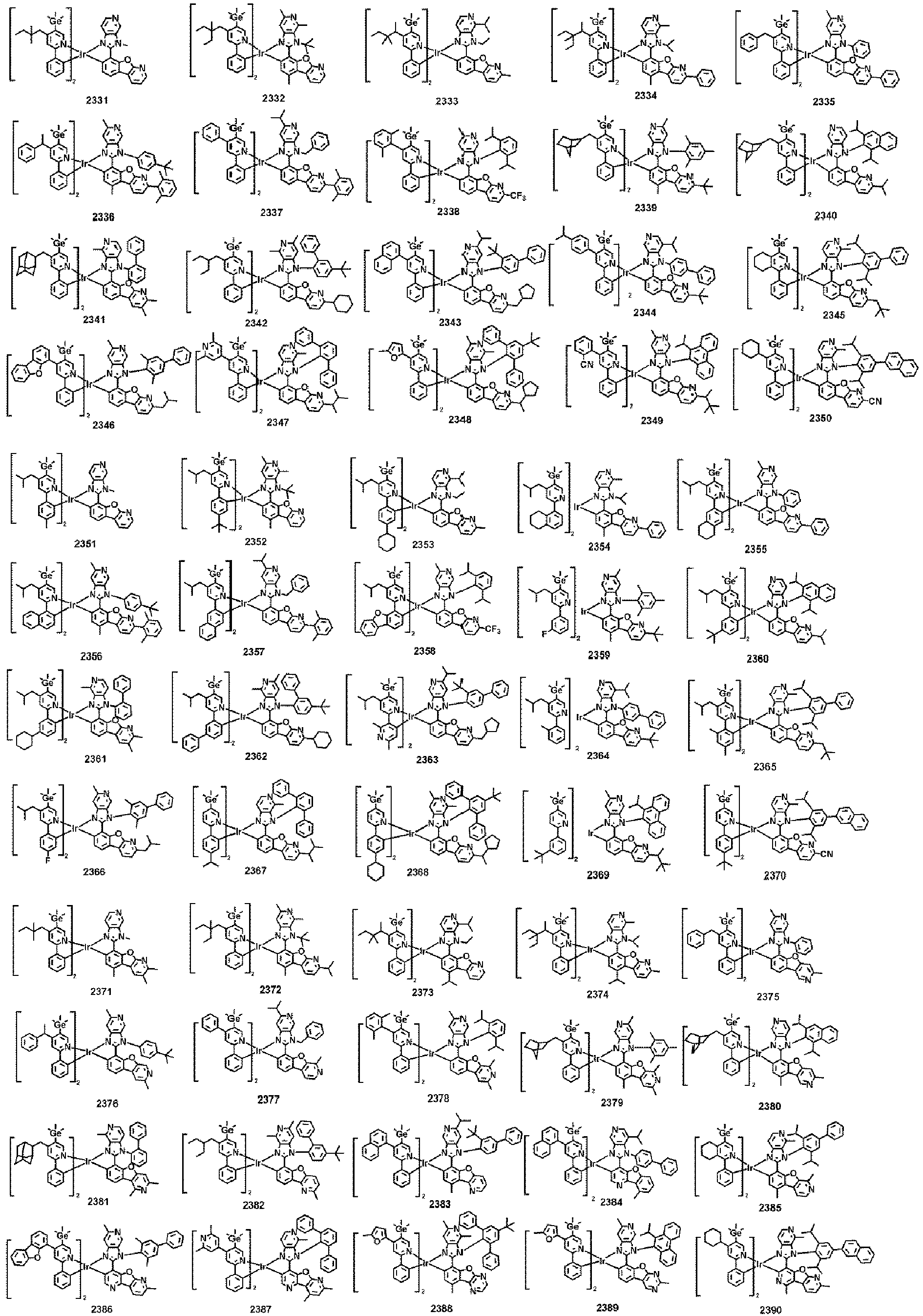

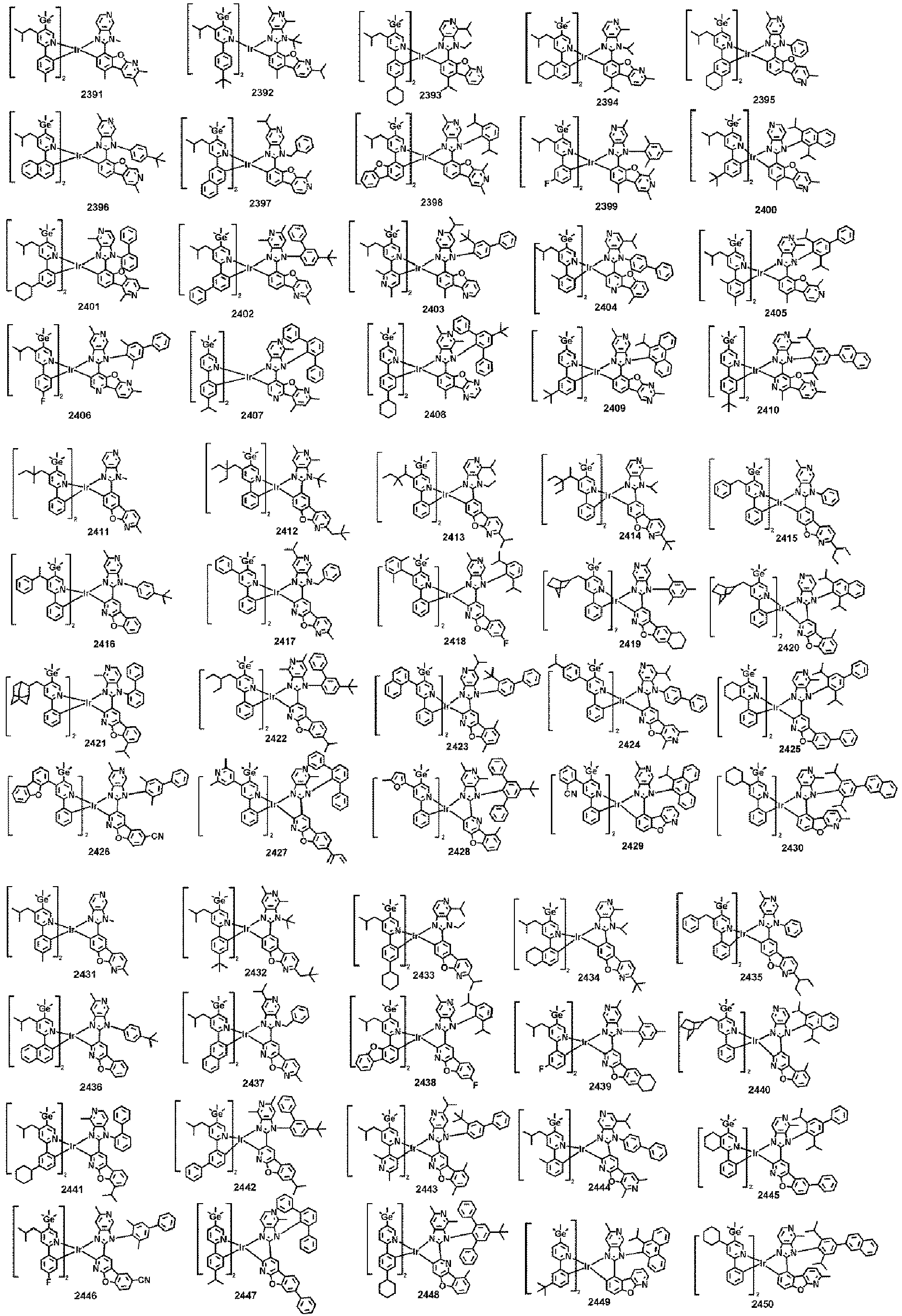

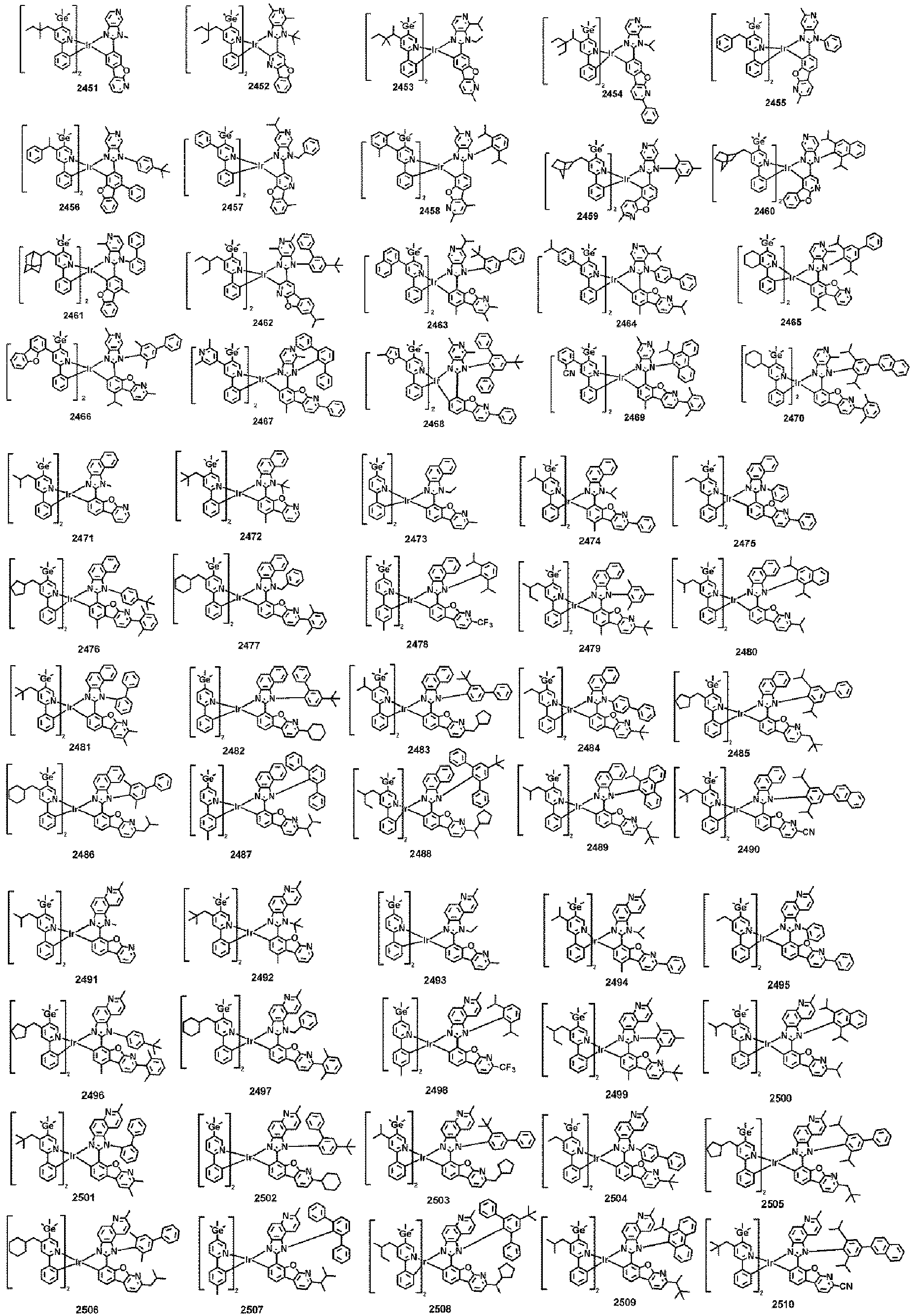

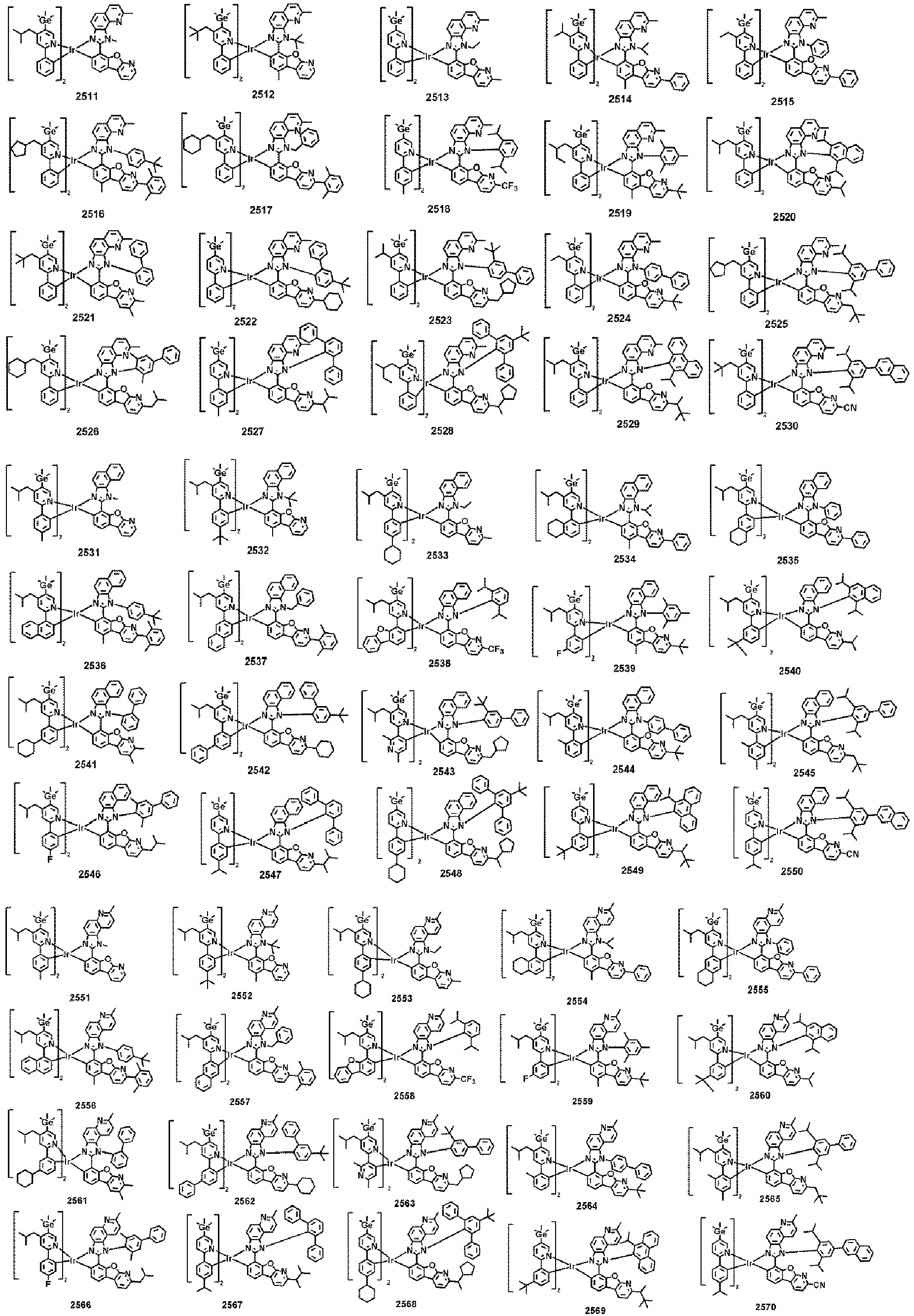

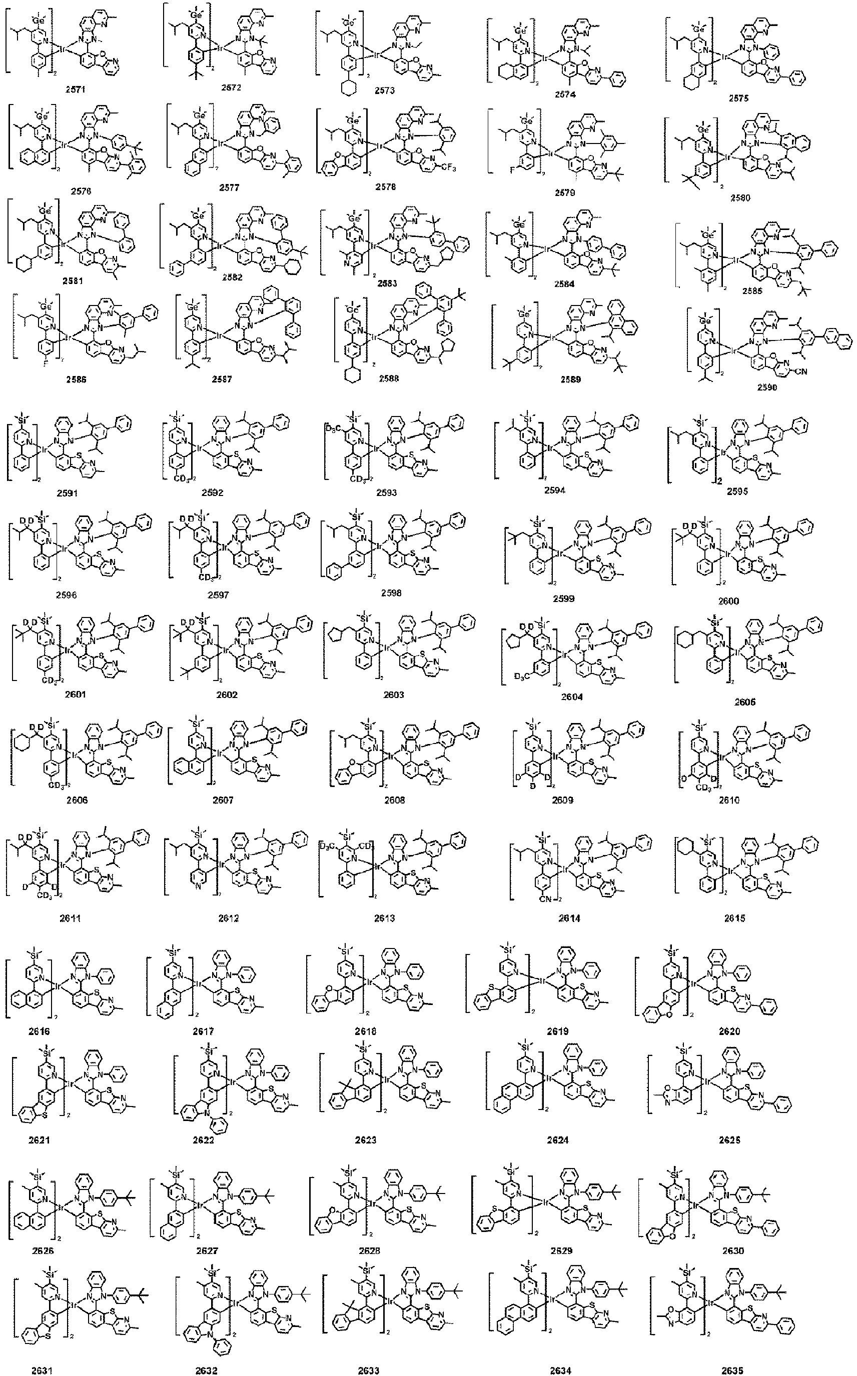

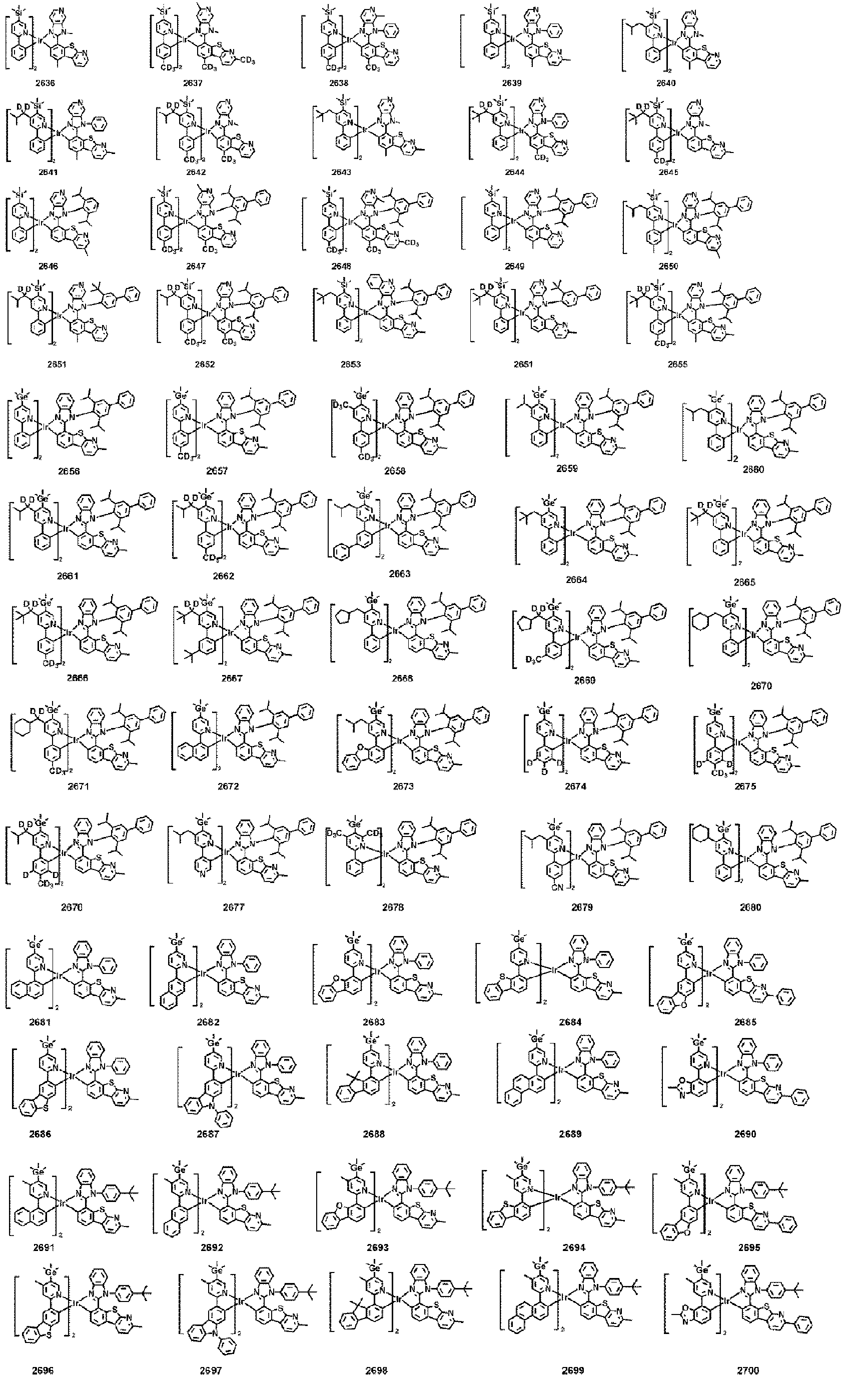

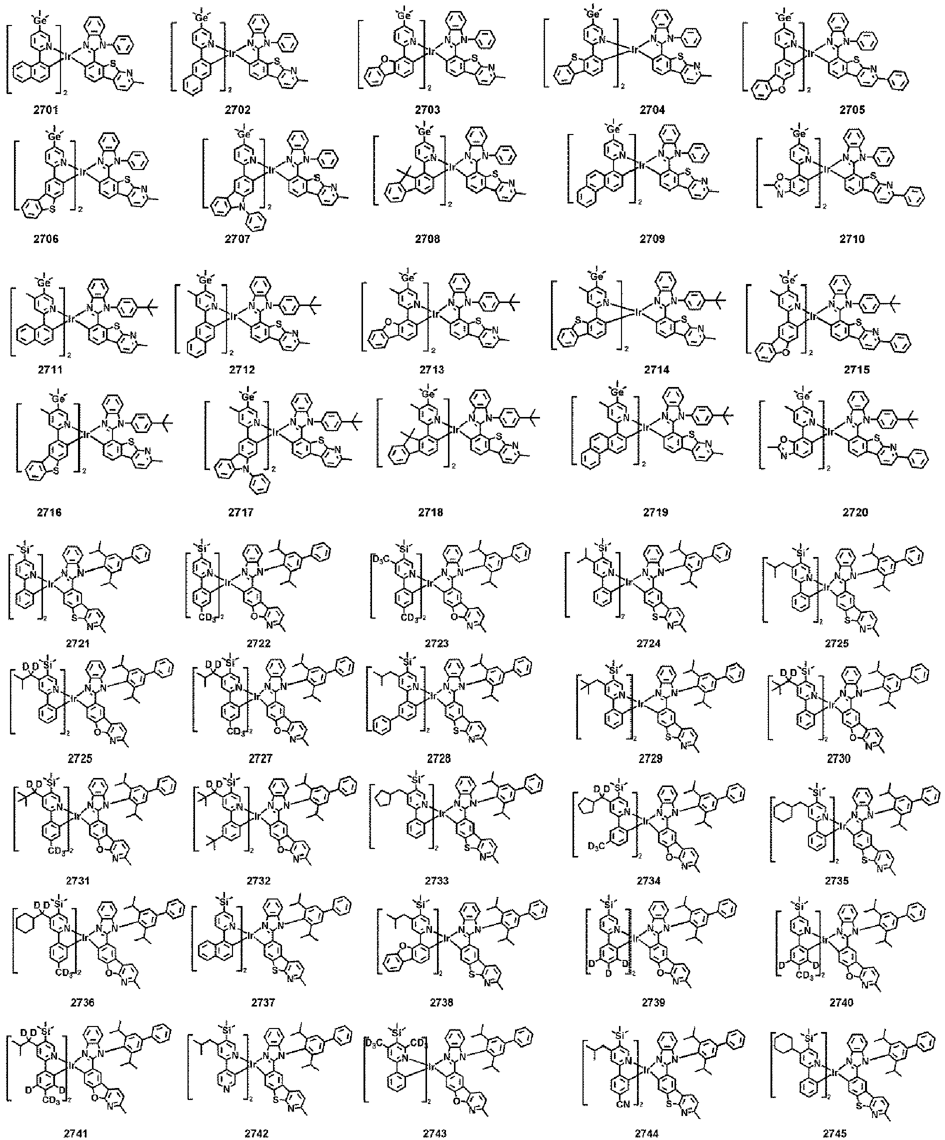

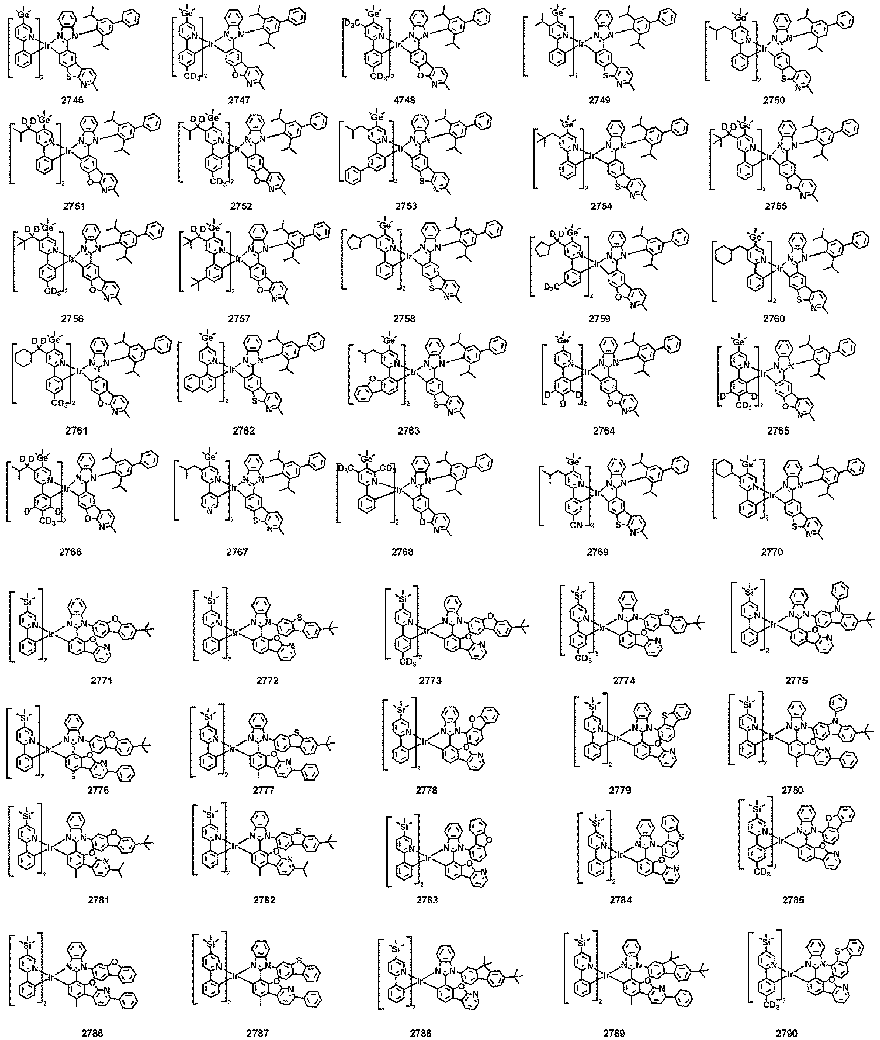

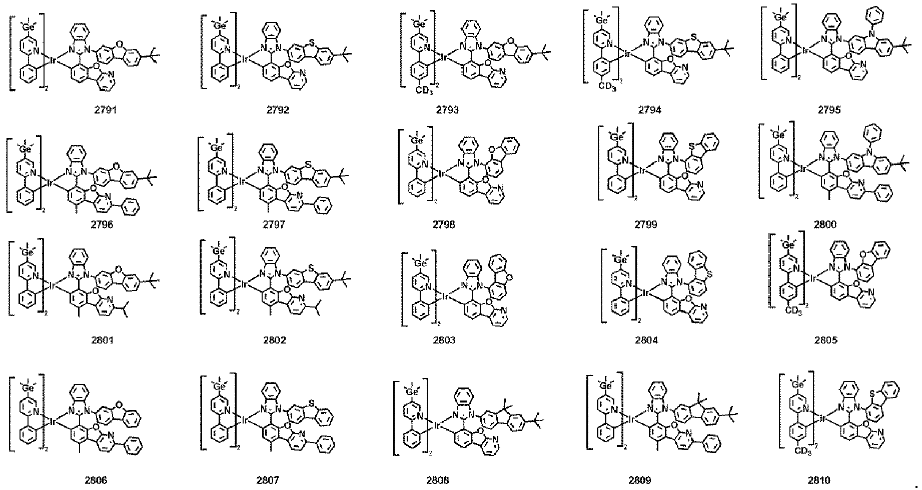

The organometallic compound may have a CCA of 4.0 to 10.5. In this regard, in an organic light-emitting device including the organometallic compound, even when a doping concentration of the organometallic compound is low, the charge flow among layers constituting an organic light-emitting device (for example, an emission layer) may be effectively controlled, and accordingly, phenomena, such as triplet-triplet annihilation, triplet-polaron quenching, or charge accumulation at an interface of an emission layer, may be substantially prevented, thereby significantly improving a lifespan of an organic light-emitting device. Considering that the transition metal included in the organometallic compound is expensive, use of the organometallic compound having a CCA of about 4.0 to about 10.5 may lead to mass production of a light-emitting device having a long lifespan at low cost. Meanwhile, an organic light-emitting device including an organometallic compound having a CCA of less than about 4.0 has to increase a doping concentration of the organometallic compound in order to have sufficient CCA, and thus, it is inevitable to have a high cost to produce an organic light-emitting device having equivalent performance. Therefore, when the organometallic compound having a CCA of less than about 4.0 is used, the productivity of the organic light-emitting device may be lowered.

Accordingly, the organometallic compound represented by Formula 1 may be suitable for use as an organic layer of an organic light-emitting device, for example, as a dopant of an emission layer in the organic layer. In this regard, according to one or more embodiments, an organic light-emitting device includes: a first electrode; a second electrode; an organic layer including an emission layer and the organometallic compound represented by Formula 1, wherein the organic layer is between the first electrode and the second electrode.

In one or more embodiments, the emission layer may include the organometallic compound.

In one or more embodiments, the emission layer may include the organometallic compound, and may emit green light. The green light may have, for example, a maximum emission wavelength from about 490 nm to about 550 nm.

In one or more embodiments, the emission layer may further include a host, wherein an amount of the host may be greater than that of the organometallic compound. For example, the amount of the organometallic compound per 100 mol% of the emission layer may be about 4.60 mol% or less, about 1.00 mol% to about 4.60 mol%, about 1.00 mol% to about 4.25 mol%, about 1.44 mol% to about 4.60 mol%, or about 1.44 mol% to about 4.25 mol%. Even when the amount of the organometallic compound is selected at a low concentration, such as about 4.6 mol% or less per 100 mol% of the emission layer, the organic light-emitting device may have a long lifespan. In this regard, use of the organometallic compound may lead to mass production of the organic light-emitting device having a long lifespan at low cost.

The expression "(an organic layer) includes at least one organometallic compounds" as used herein may include a case in which "(an organic layer) includes identical organometallic compounds represented by Formula 1" and a case in which "(an organic layer) includes two or more different organometallic compounds represented by Formula 1".

In one or more embodiments, the organic layer may include, as the organometallic compound, only Compound 1. Here, Compound 1 may be included in the emission layer of the organic light-emitting device. In one or more embodiments, the organic layer may include, as the organometallic compound, Compound 1 and Compound 2. Here, Compound 1 and Compound 2 may exist in an identical layer (for example, both Compound 1 and Compound 2 may exist in an emission layer).

The first electrode may be an anode, which is a hole injection electrode, and the second electrode may be a cathode, which is an electron injection electrode; or the first electrode may be a cathode, which is an electron injection electrode, and the second electrode may be an anode, which is a hole injection electrode.

In one or more embodiments, in the organic light-emitting device, the first electrode may be an anode, the second electrode may be a cathode, and the organic layer may further include a hole transport region between the first electrode and the emission layer and an electron transport region between the emission layer and the second electrode, wherein the hole transport region may include a hole injection layer, a hole transport layer, an electron blocking layer, a buffer layer, or any combination thereof, and the electron transport region may include a hole blocking layer, an electron transport layer, an electron injection layer, or any combination thereof.

The term "organic layer" as used herein refers to a single layer and/or a plurality of layers between the first electrode and the second electrode of the organic light-emitting device. The "organic layer" may include, in addition to an organic compound, an organometallic complex including metal.

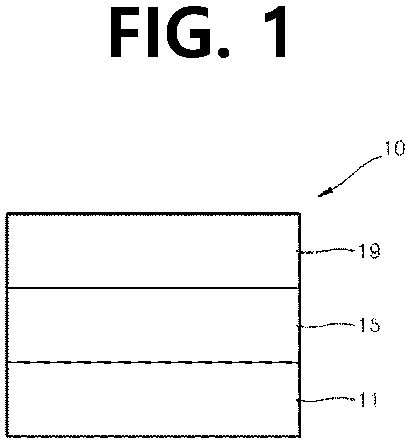

FIG. 1 is a schematic cross-sectional view of an organic light-emitting device 10 according to an embodiment. Hereinafter, the structure of an organic light-emitting device according to an embodiment of the present disclosure and a method of manufacturing an organic light-emitting device according to an embodiment of the present disclosure will be described in connection with FIG. 1. The organic light-emitting device 10 includes a first electrode 11, an organic layer 15, and a second electrode 19, which are sequentially stacked.

A substrate may be additionally located under the first electrode 11 or above the second electrode 19. For use as the substrate, any substrate that is used in organic light-emitting devices available in the art may be used, and the substrate may be a glass substrate or a transparent plastic substrate, each having excellent mechanical strength, thermal stability, transparency, surface smoothness, ease of handling, and water resistance.

### First electrode 11 in organic light-emitting device 10

The first electrode 11 may be, for example, formed by depositing or sputtering a material for forming the first electrode 11 on the substrate. The first electrode 11 may be an anode. The material for forming the first electrode 11 may include materials with a high work function to facilitate hole injection. The first electrode 11 may be a reflective electrode, a semi-transmissive electrode, or a transmissive electrode. The material for forming the first electrode 11 may be indium tin oxide (ITO), indium zinc oxide (IZO), tin oxide (SnO₂), or zinc oxide (ZnO). In one or more embodiments, the material for forming the first electrode 11 may be metal, such as magnesium (Mg), aluminum (Al), aluminum-lithium (Al-Li), calcium (Ca), magnesium-indium (Mg-In), or magnesium-silver (Mg-Ag).

The first electrode 11 may have a single-layered structure or a multi-layered structure including two or more layers. For example, the first electrode 11 may have a three-layered structure of ITO/Ag/ITO.

The organic layer 15 is located on the first electrode 11.

### Organic layer 15 in organic light-emitting device 10

The organic layer 15 may include a hole transport region, an emission layer, and an electron transport region.

### Hole transport region in organic layer 15

The hole transport region may be between the first electrode 11 and the emission layer.

The hole transport region may include a hole injection layer, a hole transport layer, an electron blocking layer, a buffer layer, or any combination thereof.

The hole transport region may include only either a hole injection layer or a hole transport layer. In one or more embodiments, the hole transport region may have a hole injection layer/hole transport layer structure or a hole injection layer/hole transport layer/electron blocking layer structure, wherein, for each structure, each layer is sequentially stacked in this stated order from the first electrode 11.

When the hole transport region includes a hole injection layer, the hole injection layer may be formed on the first electrode 11 by using one or more suitable methods, for example, vacuum deposition, spin coating, casting, and/or Langmuir-Blodgett (LB) deposition.

When a hole injection layer is formed by vacuum deposition, the deposition conditions may vary according to a material that is used to form the hole injection layer, and the structure and thermal characteristics of the hole injection layer. For example, the deposition conditions may include a deposition temperature of about 100 °C to about 500 °C, a vacuum pressure of about 10⁻⁸ torr to about 10⁻³ torr, and a deposition rate of about 0.01 Å/sec to about 100 Å/sec. However, the deposition conditions are not limited thereto.

When the hole injection layer is formed by spin coating, the coating conditions may vary according to a material that is used to form the hole injection layer, and the structure and thermal properties of the hole injection layer. For example, the coating conditions may include a coating speed from about 2,000 rpm to about 5,000 rpm, and a temperature at which a heat treatment is performed to remove a solvent after coating may be from about 80 °C to about 200 °C. However, the coating conditions are not limited thereto.

Conditions for forming a hole transport layer and an electron blocking layer may be understood by referring to conditions for forming the hole injection layer.

The hole transport region may be m-MTDATA, TDATA, 2-TNATA, NPB, β-NPB, TPD, spiro-TPD, spiro-NPB, methylated-NPB, TAPC, HMTPD, 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), a compound represented by Formula 201 below, a compound represented by Formula 202 below, or any combination thereof:

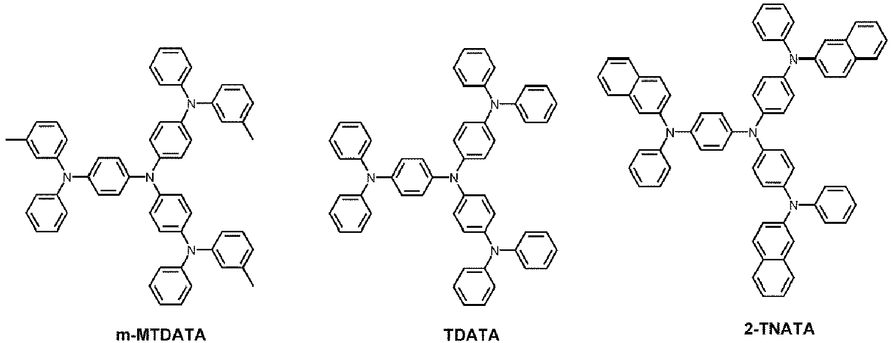

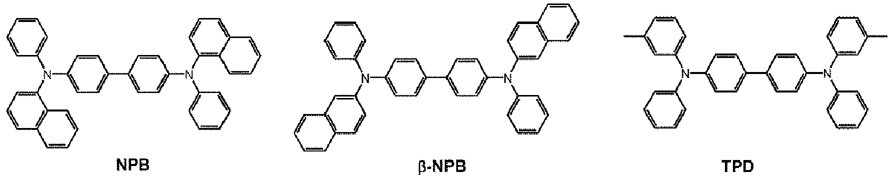

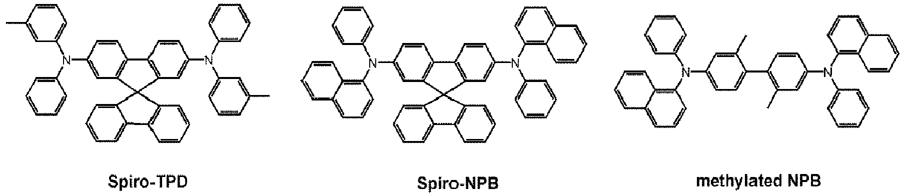

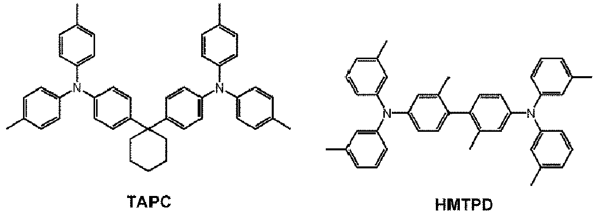

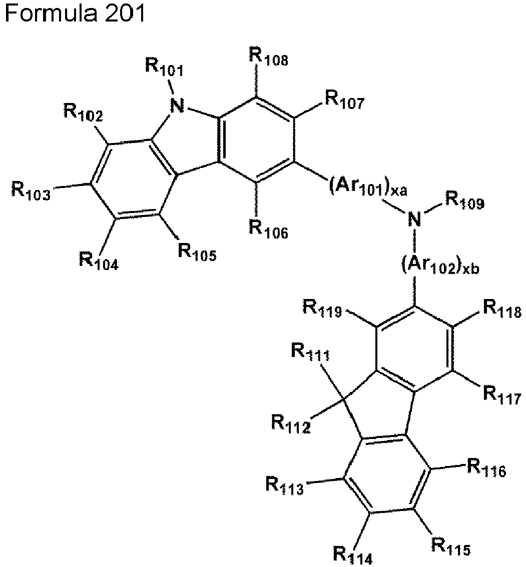

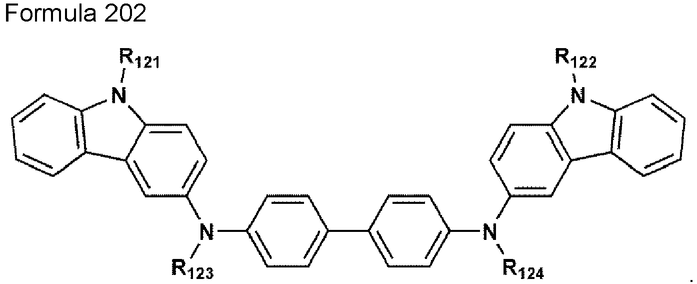

In Formula 201, Ar₁₀₁ and Ar₁₀₂ may each independently be a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, or a pentacenylene group, each unsubstituted or substituted with deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₃-C₁₀ cycloalkenyl group, a C₁-C₁₀ heterocycloalkyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, or any combination thereof.

In Formula 201, xa and xb may each independently be an integer from 0 to 5, or may be 0, 1, or 2. For example, xa may be 1 and xb may be 0, but xa and xb are not limited thereto.

In Formulae 201 and 202, R₁₀₁ to R₁₀₈, R₁₁₁ to R₁₁₉, and R₁₂₁ to R₁₂₄ may each independently be:
hydrogen, deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group (for example, a methyl group, an ethyl group, a propyl group, a butyl group, pentyl group, a hexyl group, etc.), or a C₁-C₁₀ alkoxy group (for example, a methoxy group, an ethoxy group, a propoxy group, a butoxy group, a pentoxy group, etc.);
a C₁-C₁₀ alkyl group or a C₁-C₁₀ alkoxy group, each unsubstituted or substituted with deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid or a salt thereof, or any combination thereof; or
phenyl group, a naphthyl group, an anthracenyl group, a fluorenyl group or a pyrenyl group, each unsubstituted or substituted with deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a C₁-C₁₀ alkoxy group, or any combination thereof. In Formula 201, R₁₀₉ may be a phenyl group, a naphthyl group, an anthracenyl
group, or a pyridinyl group, each unsubstituted or substituted with deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a phenyl group, a naphthyl group, an anthracenyl group, a pyridinyl group, or any combination thereof.

In one or more embodiments, the compound represented by Formula 201 may be represented by Formula 201A:

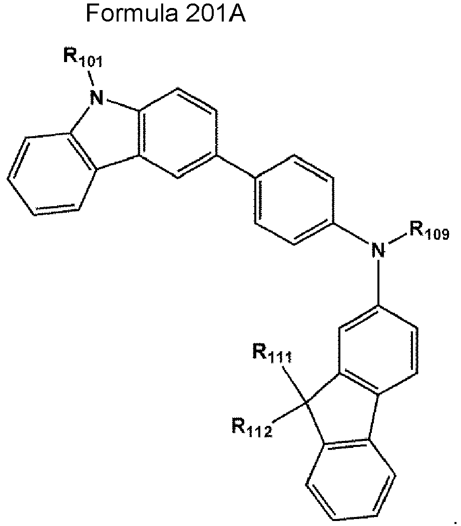

In Formula 201A, R₁₀₁, R₁₁₁, R₁₁₂, and R₁₀₉ may be the same as described herein.

For example, the hole transport region may include one of Compounds HT1 to HT21 or any combination thereof:

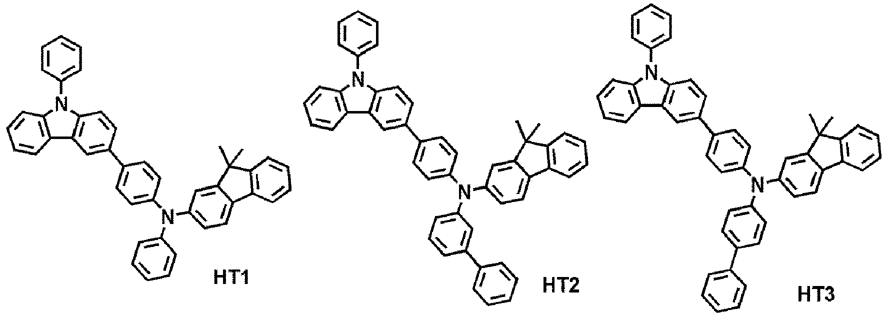

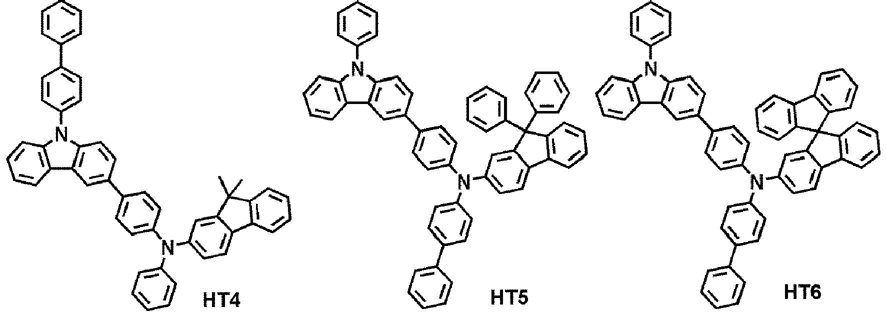

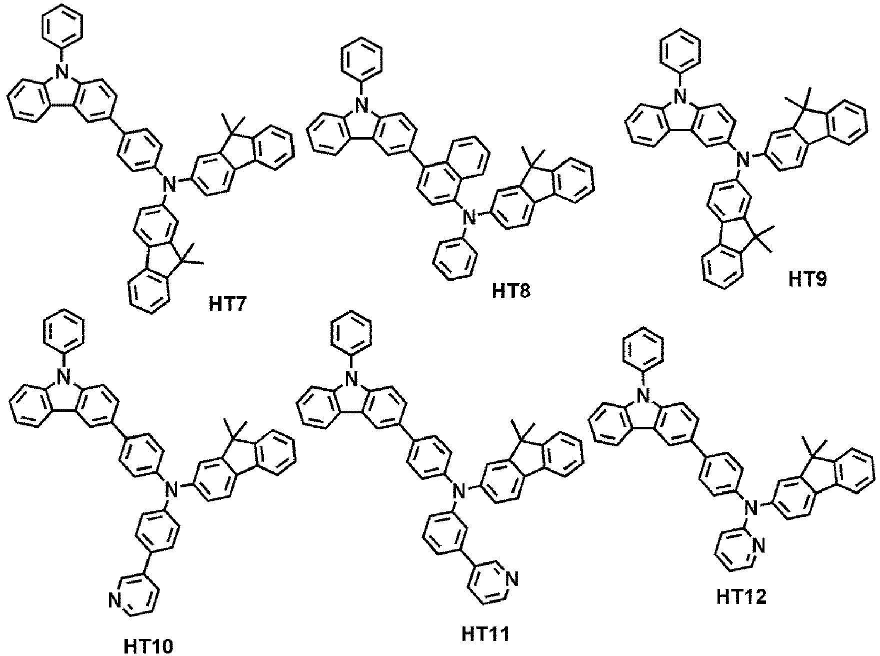

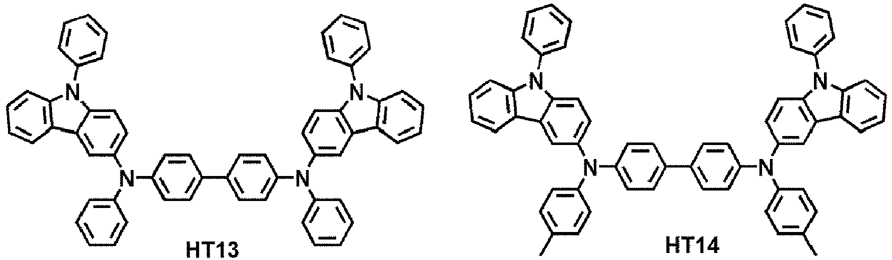

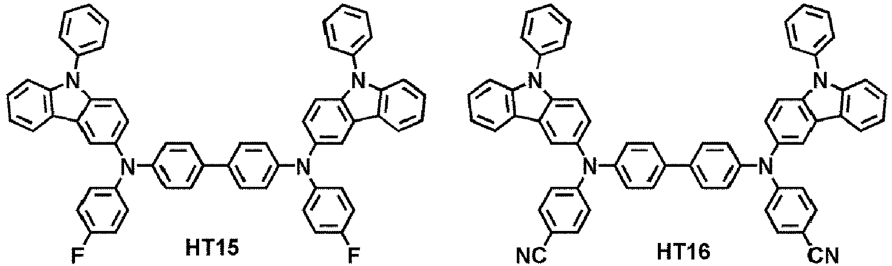

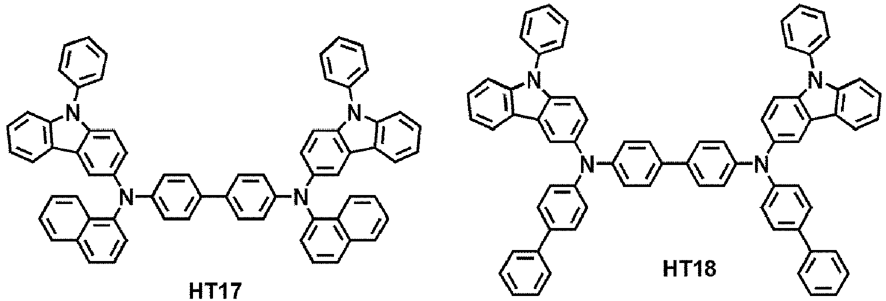

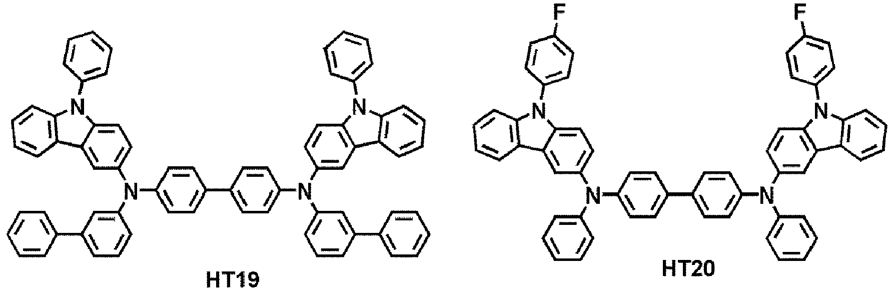

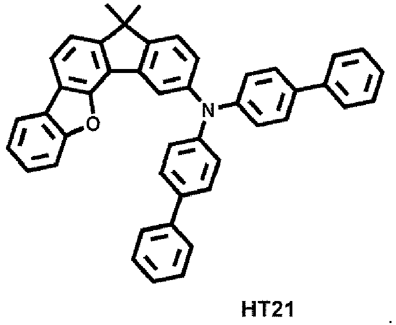

A thickness of the hole transport region may be in a range of about 100 Å to about 10,000 Å, for example, about 100 Å to about 3,000 Å. When the hole transport region includes a hole injection layer, a hole transport layer, an electron blocking layer, or any combination thereof, a thickness of the hole injection layer may be from about 50 Å to about 10,000 Å, for example, about 100 Å to about 1,000 Å, and a thickness of the hole transport layer may be from about 50 Å to about 2,000 Å, for example, about 100 Å to about 1,500 Å. When the thicknesses of the hole transport region, the hole injection layer, and the hole transport layer are within these ranges, satisfactory hole transporting characteristics may be obtained without a substantial increase in driving voltage.

The hole transport region may further include, in addition to these materials, a charge-generation material for the improvement of conductive properties. The charge-generation material may be homogeneously or non-homogeneously dispersed in the hole transport region.

The charge-generation material may be, for example, a p-dopant. The p-dopant may include a quinone derivative, a metal oxide, a cyano group-containing compound, or any combination thereof. For example, the p-dopant may be: a quinone derivative, such as tetracyanoquinonedimethane (TCNQ), 2,3,5,6-tetrafluoro-tetracyano-1,4-benzoquinonedimethane (F4-TCNQ), or F6-TCNNQ; a metal oxide, such as tungsten oxide and molybdenum oxide; a cyano group-containing compound, such as Compound HT-D1; or any combination thereof.

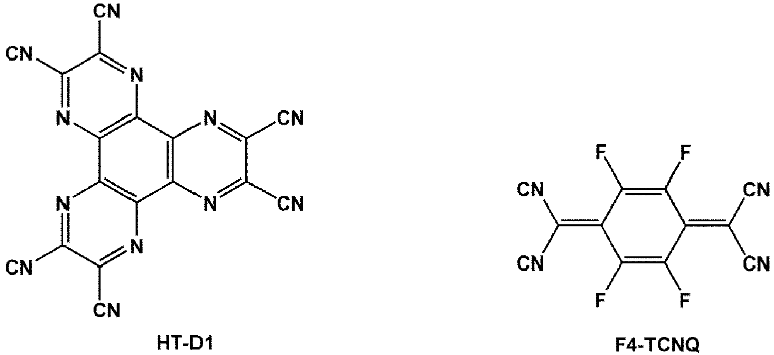

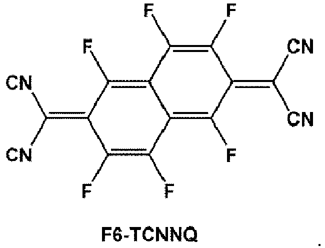

The hole transport region may further include a buffer layer.

Also, the buffer layer may compensate for an optical resonance distance according to a wavelength of light emitted from the emission layer, and thus, efficiency of a formed organic light-emitting device may be improved.

Meanwhile, when the hole transport region includes an electron blocking layer, a material for forming the electron blocking layer may include a material that is used in the hole transport region as described above, a host material described below, or any combination thereof. For example, when the hole transport region includes an electron blocking layer, mCP below, Compound H21, or any combination may be used as the material for forming the electron blocking layer.

### Emission layer in organic layer 15

Then, an emission layer may be formed on the hole transport region by vacuum deposition, spin coating, casting, LB deposition, or the like. When the emission layer is formed by vacuum deposition or spin coating, the deposition or coating conditions may be similar to those applied in forming the hole injection layer although the deposition or coating conditions may vary according to a material that is used to form the hole transport layer.

The emission layer may include a host and a dopant, and the dopant may include the organometallic compound represented by Formula 1.

### Host in emission layer

The host may include TPBi, TBADN, ADN (also referred to as "DNA"), CBP, CDBP, TCP, mCP, Compound H50, Compound H51, Compound H52, or any combination thereof:

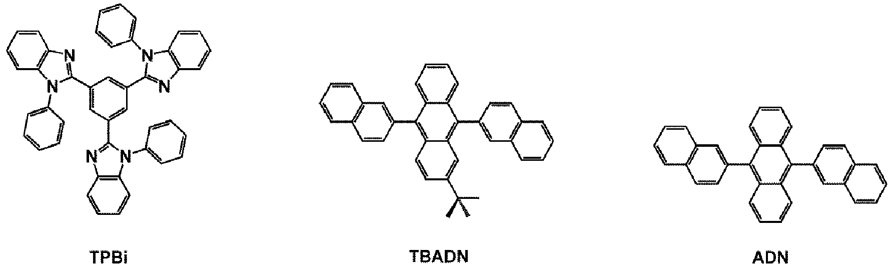

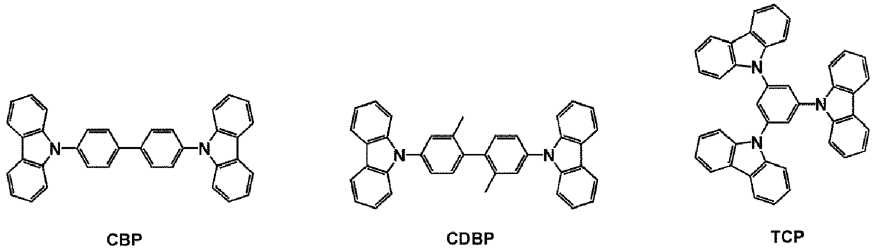

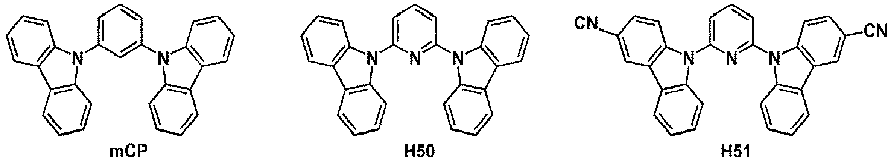

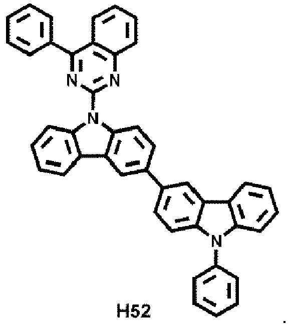

The host may include only one compound, or may be a mixture of two or more compounds that are different from each other.

In one or more embodiments, the host may include an electron transport host including at least one electron transport moiety, a hole transport host not including an electron transport moiety, or any combination thereof.

In the present specification, the electron transport moiety may include a cyano group, a π electron-deficient nitrogen-containing cyclic group, a group represented by one of the following formulae, or any combination thereof:

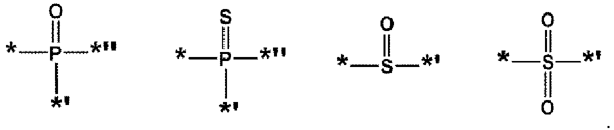

In the formulae above, *, *', and *" each indicate a binding site to a neighboring atom.

In one or more embodiments, the electron transport host may include at least one π electron-rich cyclic group and at least one electron transport moiety.

In one or more embodiments, the hole transport host may include at least one π electron-rich cyclic group, but may not include an electron transport moiety.

In one or more embodiments, the host may include an electron transport host and a hole transport host, wherein the electron transport host and the hole transport host may be different from each other.

In the present specification, the term "π electron-deficient nitrogen-containing cyclic group" as used herein refers to a cyclic group having at least one *-N=*' moiety, and non-limiting examples thereof include an imidazole group, a pyrazole group, a thiazole group, an isothiazole group, an oxazole group, an isoxazole group, a pyridine group, a pyrazine group, a pyridazine group, a pyrimidine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, an azacarbazole group.

In one or more embodiments, the π electron-rich cyclic group refers to a cyclic group not including a -N=*' moiety, and non-limiting examples thereof include a benzene group, a heptalene group, an indene group, a naphthalene group, an azulene group, an indacene group, an acenaphthylene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentacene group, a hexacene group, a pentacene group, a rubicene group, a corogen group, an avalene group, a pyrrole group, an isoindole group, an indole group, a furan group, a thiophene group, a benzofuran group, a benzothiophene group, a benzocarbazole group, a dibenzocarbazole group, a dibenzofuran group, a dibenzothiophene group, a dibenzothiophene sulfone group, a carbazole group, a dibenzosilole group, an indenocarbazole group, an indolocarbazole group, a benzofurocarbazole group, a benzothienocarbazole group, a triindolobenzene group, and the like.

In one or more embodiments, the electron transport host may include a compound represented by Formula E-1.

In one or more embodiments, the hole transport host may include a compound represented by Formula H-1:

Formula E-1 [Ar₃₀₁]_{xb11}-[(L₃₀₁)_{xb1}-R₃₀₁]_{xb21}.

In Formula E-1,
Ar₃₀₁ may be a C₅-C₆₀ carbocyclic group unsubstituted or substituted with at least one R₁₀ₐ or a C₁-C₆₀ heterocyclic group unsubstituted or substituted with at least one R₁₀ₐ,
xb11 may be 1, 2, or 3,
L₃₀₁ may be a single bond, a group represented by one of the following formulae, a C₅-C₆₀ carbocyclic group unsubstituted or substituted with at least one R₁₀ₐ or a C₁-C₆₀ heterocyclic group unsubstituted or substituted with at least one R₁₀ₐ, wherein *, *', and *" in the formulae above each indicate a binding site to a neighboring atom, 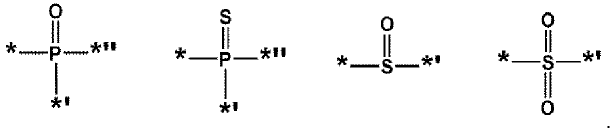 xb1 may be an integer from 0 to 5,
R₃₀₁ may be hydrogen, deuterium, -F, -CI, -Br, -I, -SF₅, a hydroxyl group, a cyano group, a nitro group, an amidino group, a hydrazine group, a hydrazone group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -Si(Q₃₀₁)(Q₃₀₂)(Q₃₀₃), -N(Q₃₀₁)(Q₃₀₂), -B(Q₃₀₁)(Q₃₀₂), -C(=O)(Q₃₀₁), -S(=O)₂(Q₃₀₁), -S(=O)(Q₃₀₁),-P(=O)(Q₃₀₁)(Q₃₀₂),or -P(=S)(Q₃₀₁)(Q₃₀₂),
xb21 may be an integer from 1 to 5,
Q301 to Q₃₀₃ may each independently be a C₁-C₁₀ alkyl group, a C₁-C₁₀ alkoxy group, a phenyl group, a biphenyl group, a terphenyl group, or a naphthyl group,
R₁₀ₐ may be the same as described in connection with R₁, and
at least one of <Condition 1> to <Condition 3> may be satisfied:
   Condition 1
      At least one of Ar₃₀₁, L₃₀₁, and R₃₀₁ in Formula E-1 each independently include a π electron-deficient nitrogen-containing cyclic group.
   Condition 2
      L₃₀₁ in Formula E-1 is a group represented by one of the following formulae 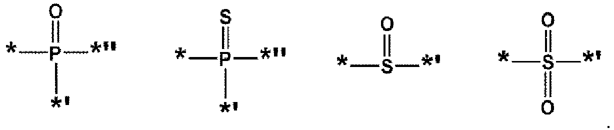
   Condition 3
      R₃₀₁ in Formula E-1 is a cyano group, -S(=O)₂(Q₃₀₁), -S(=O)(Q₃₀₁),-P(=O)(Q₃₀₁)(Q₃₀₂), or -P(=S)(Q301)(Q302).

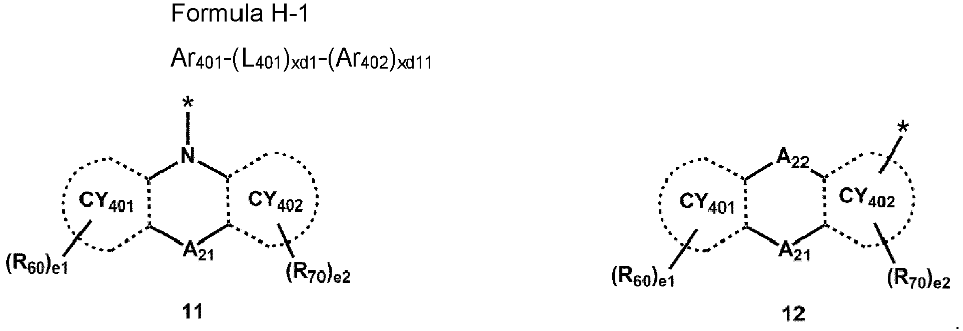

In Formulae H-1, 11, and 12,
L₄₀₁ may be selected from:
a single bond; or
a π electron-rich cyclic group (for example, a benzene group, a heptalene group, an indene group, a naphthalene group, an azulene group, an indacene group, an acenaphthylene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentacene group, a hexacene group, a rubicene group, a corogen group, an ovalene group, a pyrrole group, an isoindole group, an indole group, a furan group, a thiophene group, a benzofuran group, a benzothiophene group, a benzocarbazole group, a dibenzocarbazole group, a dibenzofuran group, a dibenzothiophene group, a dibenzothiophene sulfone group, a carbazole group, a dibenzosilole group, an indenocarbazole group, an indolocarbazole group, a benzofurocarbazole group, a benzothienocarbazole group, a triindolobenzene group, etc.), unsubstituted or substituted with deuterium, a C₁-C₁₀ alkyl group, a C₁-C₁₀ alkoxy group, a π electron-rich cyclic group (for example, a phenyl group, a naphthyl group, a fluorenyl group, a carbazolyl group, a dibenzofuranyl group, a dibenzothiophenyl group, a triphenylenyl group, a biphenyl group, a terphenyl group, a tetraphenyl group, etc.), -Si(Q₄₀₁)(Q₄₀₂)(Q₄₀₃), or any combination thereof,
xd1 may be an integer from 1 to 10, wherein when xd1 is 2 or more, two or more of L₄₀₁(s) may be identical to or different from each other,
   Ar₄₀₁ and Ar₄₀₂ each independently may be a group represented by Formula 11 or a group represented by Formula 12; or
a π electron-rich cyclic group (for example, a phenyl group, a naphthyl group, a fluorenyl group, a carbazolyl group, a dibenzofuranyl group, a dibenzothiophenyl group, a biphenyl group, a terphenyl group, a triphenylenyl group, etc.), unsubstituted or substituted with deuterium, a C₁-C₂₀ alkyl group, a C₁-C₂₀ alkoxy group, a π electron-rich cyclic group (for example, a phenyl group, a naphthyl group, a fluorenyl group, a carbazolyl group, a dibenzofuranyl group, a dibenzothiophenyl group, a biphenyl group, a terphenyl group, a triphenylenyl group, etc.), or any combination thereof;
CY₄₀₁ and CY₄₀₂ may each independently be a π electron-rich cyclic group (for example, a benzene group, a naphthalene group, a fluorene group, a carbazole group, a benzocarbazole group, an indolocarbazole group, a dibenzofuran group, a dibenzothiophene group, a dibenzosilole group, a benzonaphthofuran group, a benzonaphthothiophene group, a benzonaphthosilole group, etc.),
A₂₁ may be a single bond, O, S, N(R₅₁), C(R₅₁)(R₅₂), or Si(R₅₁)(R₅₂),
A₂₂ may be a single bond, O, S, N(R₅₃), C(R₅₃)(R₅₄), or Si(R₅₃)(R₅₄),
at least one selected from of A₂₁ and A₂₂ in Formula 12 may not be a single bond,
R₅₁ to R₅₄, R₆₀, and R₇₀ may each independently be:
   hydrogen or deuterium;
   a C₁-C₂₀ alkyl group and a C₁-C₂₀ alkoxy group, unsubstituted or substituted with deuterium, a π electron-rich cyclic group (for example, a phenyl group, a naphthyl group, a fluorenyl group, a carbazolyl group, a dibenzofuranyl group, a dibenzothiophenyl group, etc.), or any combination thereof;
   a π electron-rich cyclic group (for example, a phenyl group, a naphthyl group, a fluorenyl group, a carbazolyl group, a dibenzofuranyl group, a dibenzothiophenyl group, a biphenyl group, a terphenyl group, a triphenylenyl group, etc.) unsubstituted or substituted with deuterium, a C₁-C₂₀ alkyl group, a C₁-C₂₀ alkoxy group, a π electron-rich cyclic group (for example, a phenyl group, a naphthyl group, a fluorenyl group, a carbazolyl group, a dibenzofuranyl group, a dibenzothiophenyl group, a biphenyl group, etc.), or any combination thereof; or
   -Si(Q₄₀₄)(Q₄₀₅)(Q₄₀₆),
   e1 and e2 may each independently be an integer from 0 to 10,
   Q401 to Q₄₀₆ may each independently be hydrogen, deuterium, a C₁-C₂₀ alkyl group, a C₁-C₂₀ alkoxy group, or a π electron-rich cyclic group (for example, a phenyl group, a naphthyl group, a fluorenyl group, a carbazolyl group, a dibenzofuranyl group, a dibenzothiophenyl group, a biphenyl group, etc.), and
   * indicates a binding site to a neighboring atom.

In one or more embodiments, in Formula E-1, Ar₃₀₁ may be a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, or a dibenzothiophene group, each unsubstituted or substituted with deuterium, -F, -CI, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), -P(=O)(Q₃₁)(Q₃₂), or any combination thereof,
at least one of L₃₀₁(s) in the number of xb1 may each independently be an imidazole group, a pyrazole group, a thiazole group, an isothiazole group, an oxazole group, an isooxazole group, a pyridine group, a pyrazine group, a pyridazine group, a pyrimidine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzoimidazole group, an isobenzothiazole group, a benzoxazole group, an isobenzoxazole group, a triazole group, a tetrazole group, an oxadiazole group, triazine group, a thiadiazole group, an imidazopyridine group, an imidazopyrimidine group, or an azacarbazole group, each unsubstituted or substituted with deuterium, -F, -CI, -Br, -I, a hydroxyl group, a cyano group, a nitro group, an amidino group, a hydrazino group, a hydrazono group, a C₁-C₂₀ alkyl group, a C₁-C₂₀alkoxy group, a phenyl group, a biphenyl group, a terphenyl group, a naphthyl group, -Si(Q₃₁)(Q₃₂)(Q₃₃), -N(Q₃₁)(Q₃₂), -B(Q₃₁)(Q₃₂), -C(=O)(Q₃₁),-S(=O)₂(Q₃₁), -P(=O)(Q₃₁)(Q₃₂), or any combination thereof,
R₃₀₁ may be hydrogen, deuterium, -F, -CI, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a tetraphenyl group, a naphthyl group, -Si(Q₃₁)(Q₃₂)(Q₃₃),-N(Q₃₁)(Q₃₂), -B(Q₃₁)(Q₃₂), -C(=O)(Q₃₁), -S(=O)₂(Q₃₁), or -P(=O)(Q₃₁)(Q₃₂), and
Q₃₁ to Q₃₃ may each independently be a C₁-C₁₀ alkyl group, a C₁-C₁₀ alkoxy group, a phenyl group, a biphenyl group, a terphenyl group, or a naphthyl group.

In one or more embodiments, R₃₀₁ may be a group represented by one of Formulae 7-1 to 7-9:

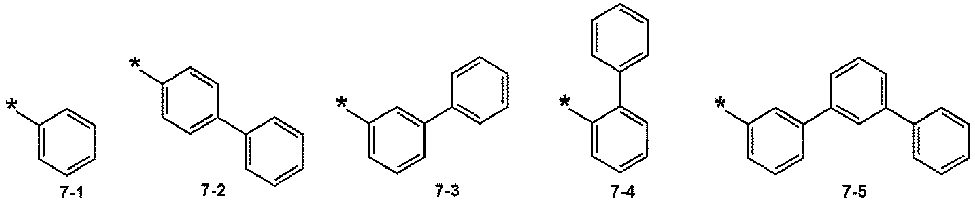

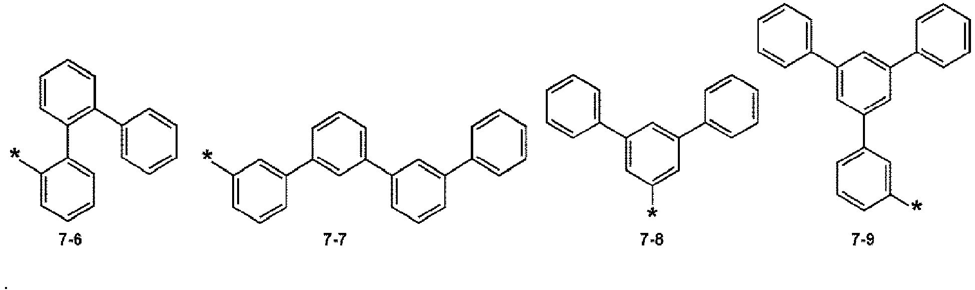

The electron transport host may be, for example, selected from Compounds H-E1 to H-E84:

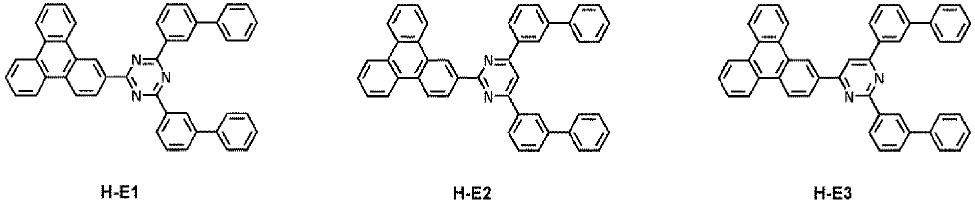

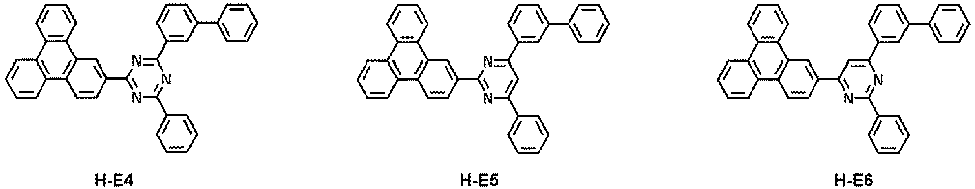

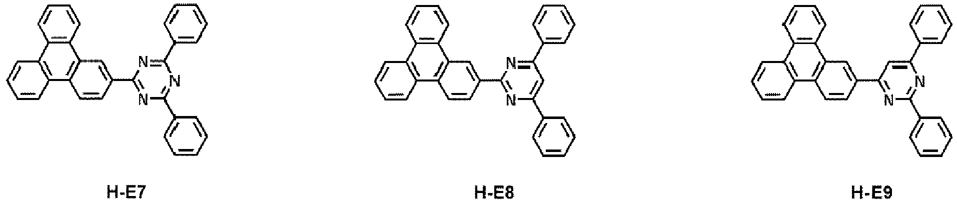

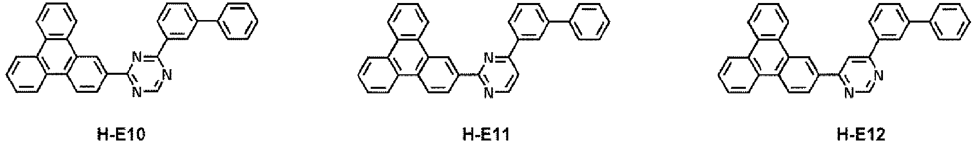

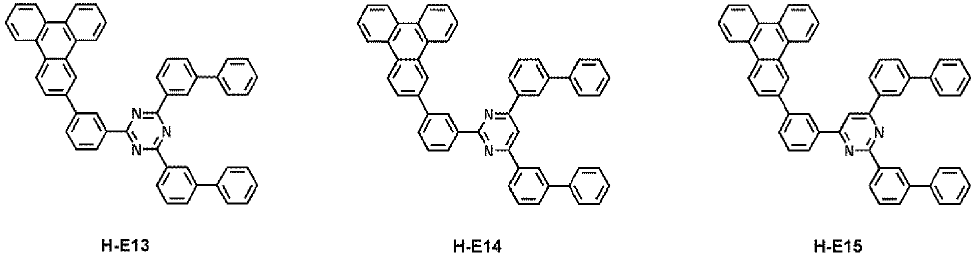

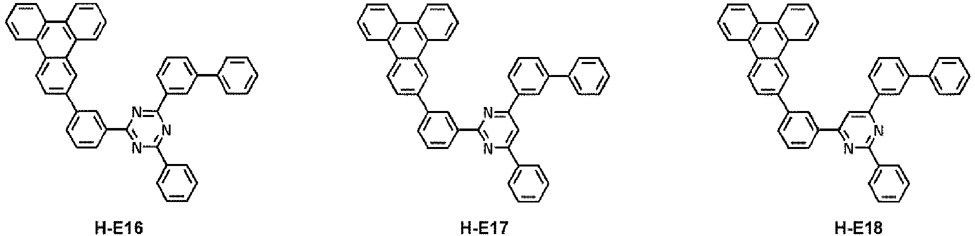

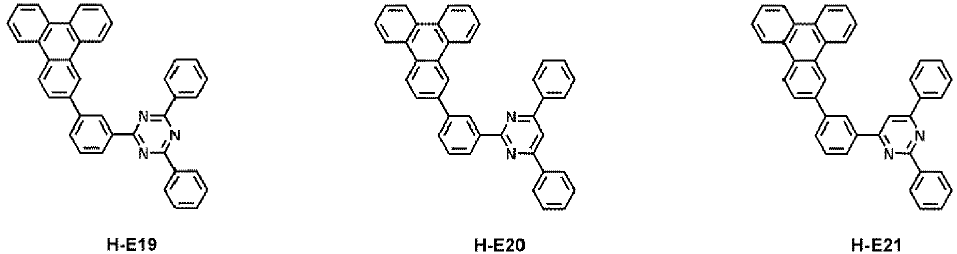

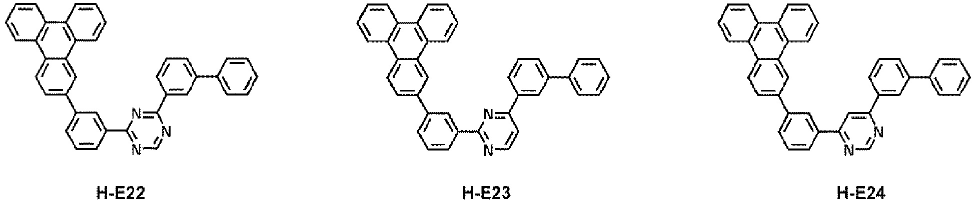

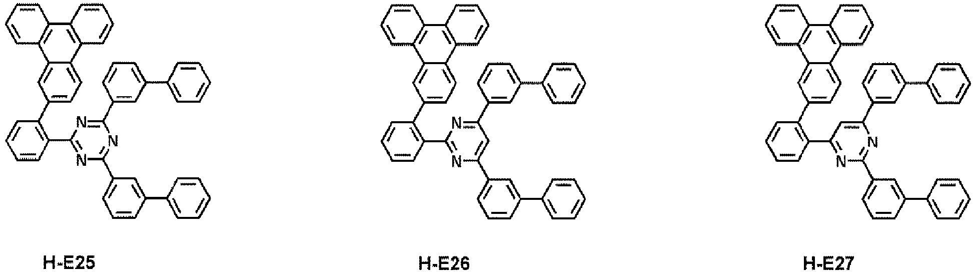

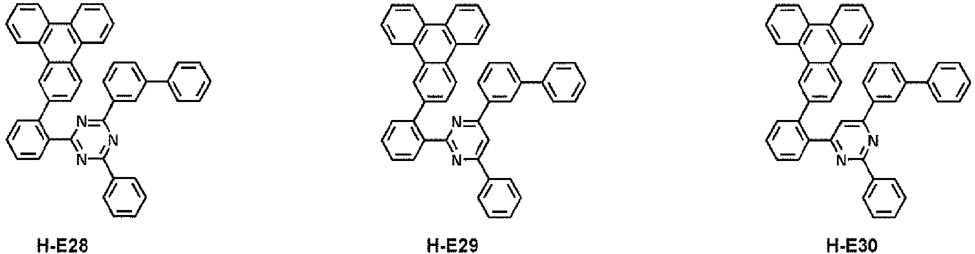

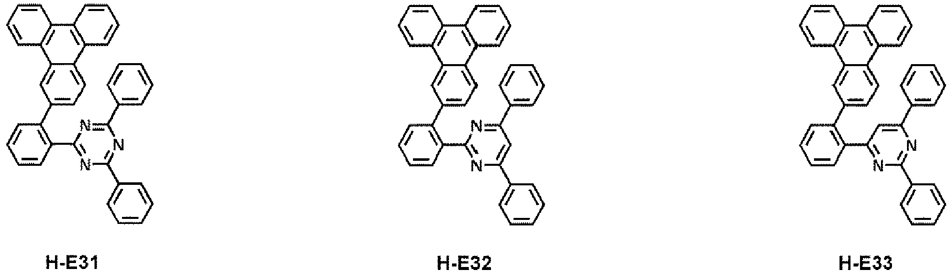

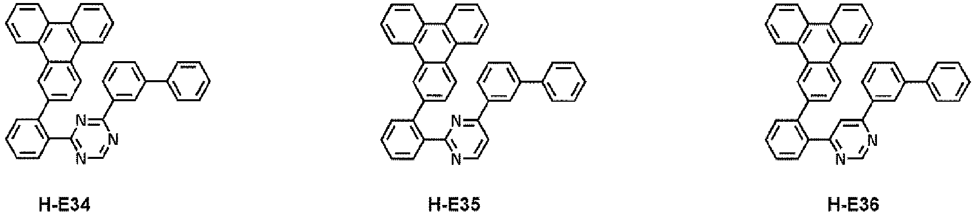

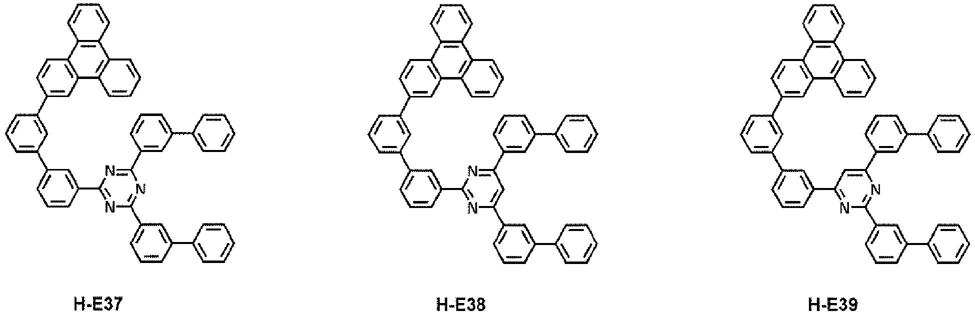

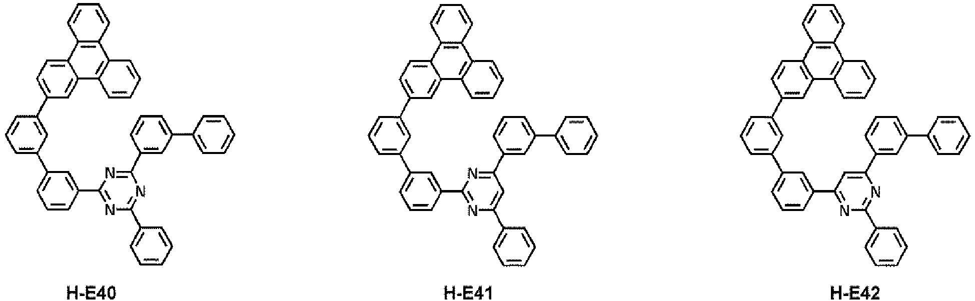

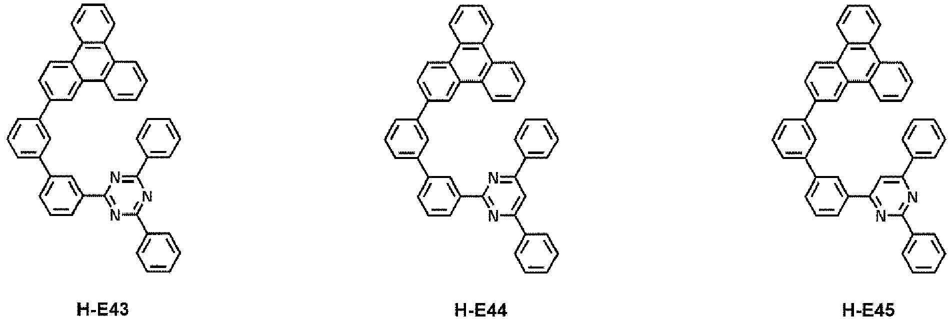

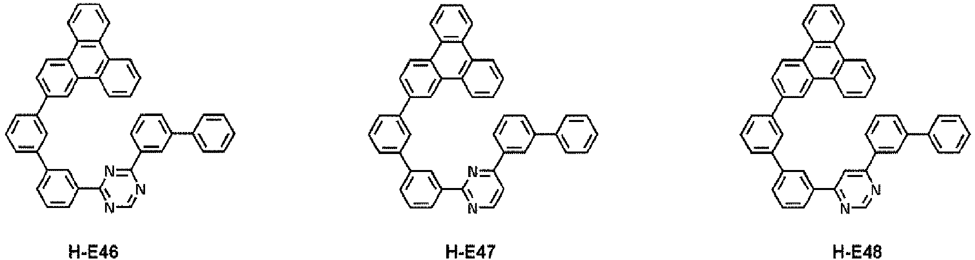

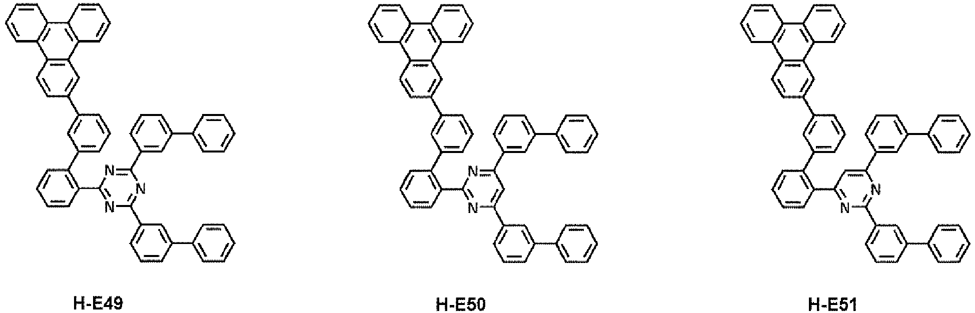

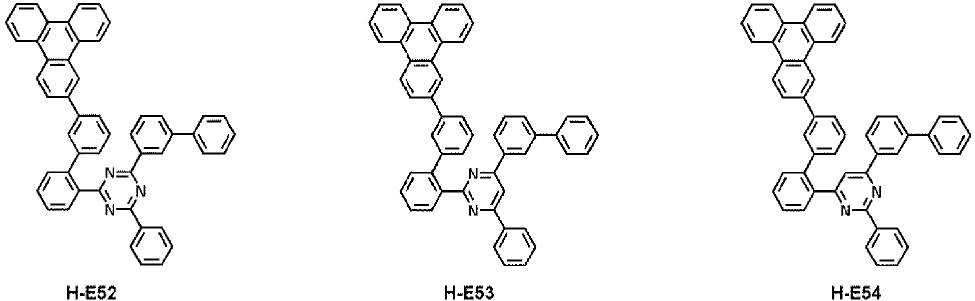

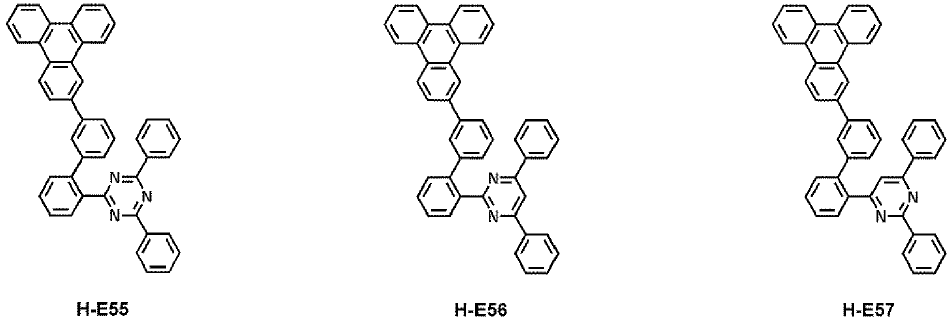

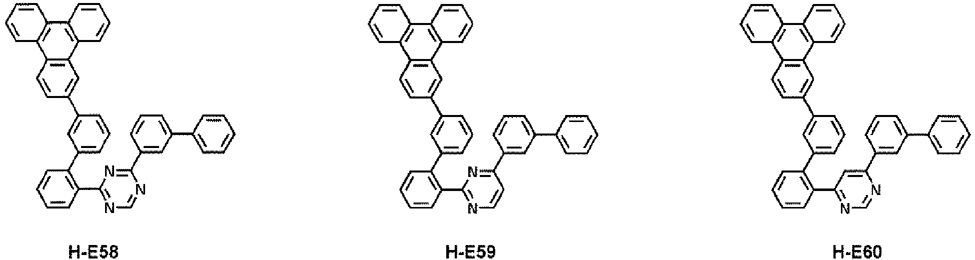

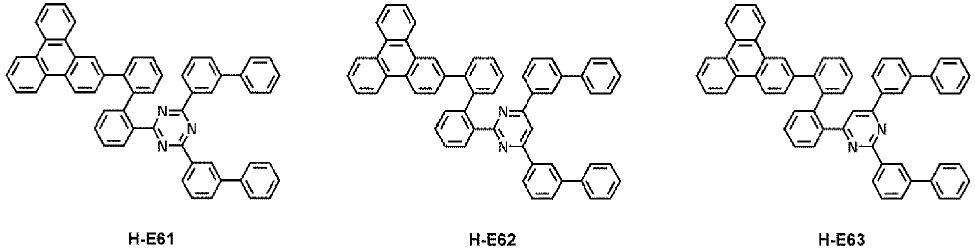

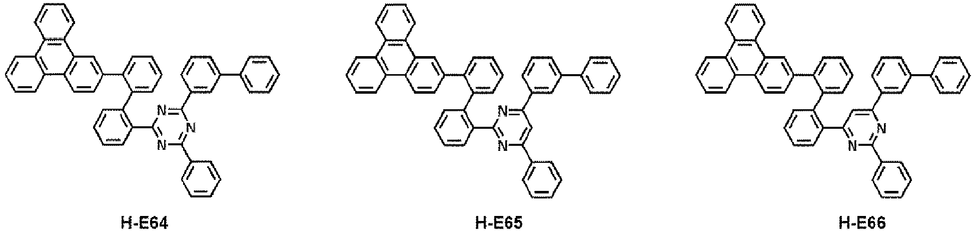

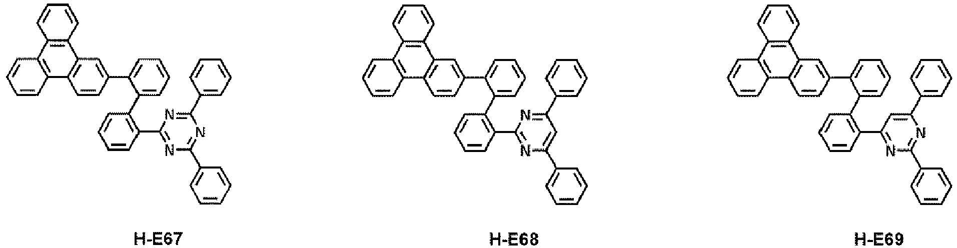

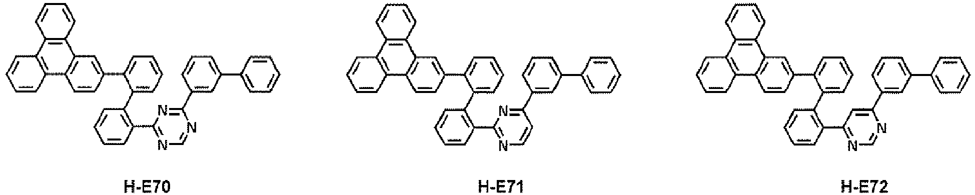

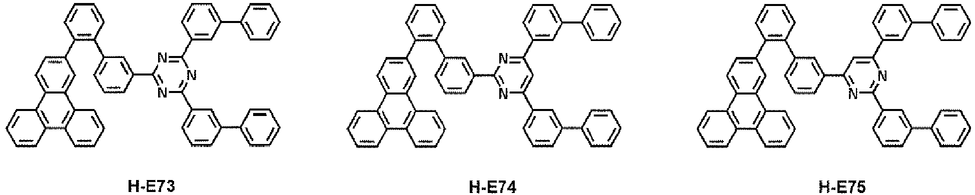

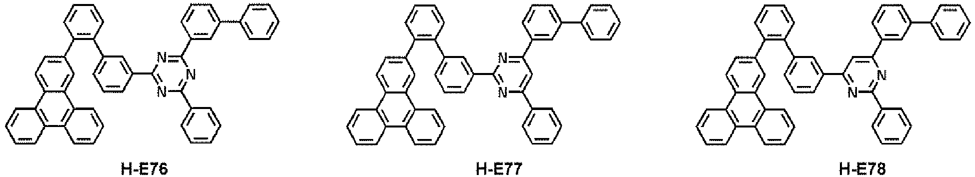

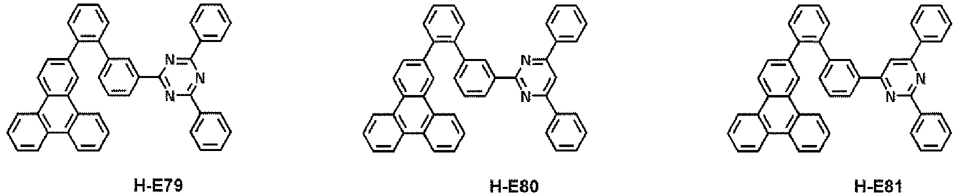

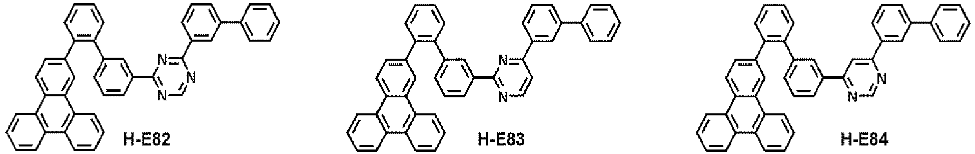

The hole transport host may be, for example, of Compounds H-H1 to H-H103:

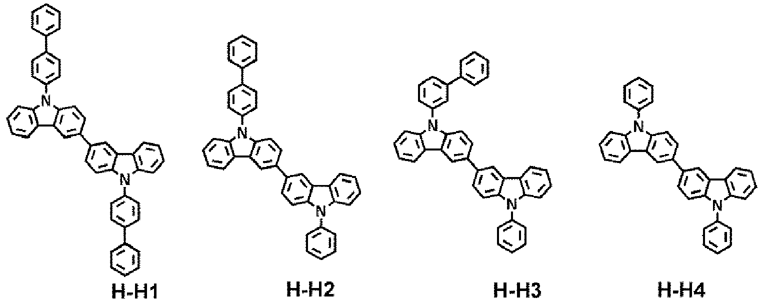

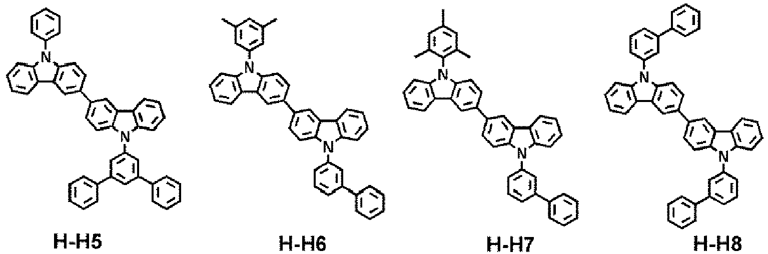

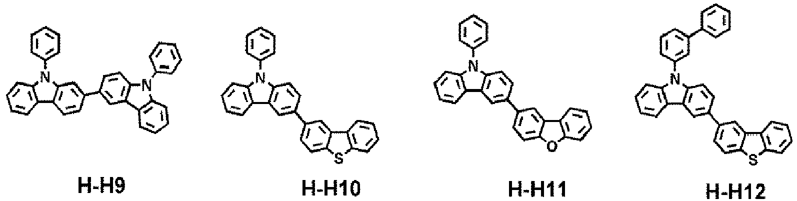

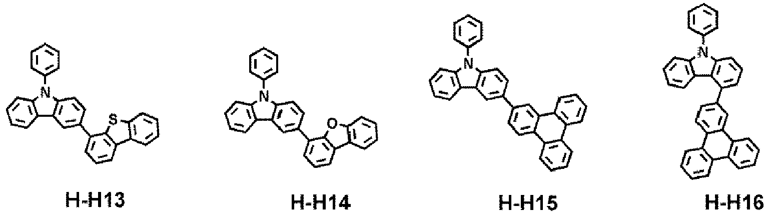

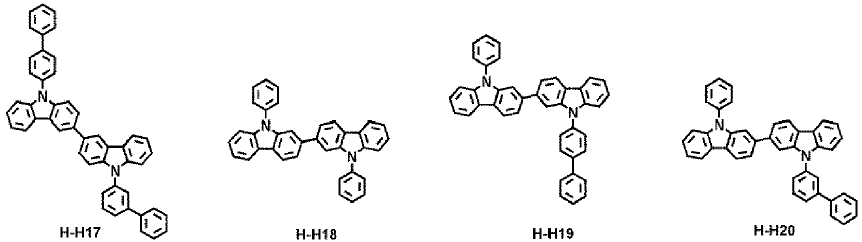

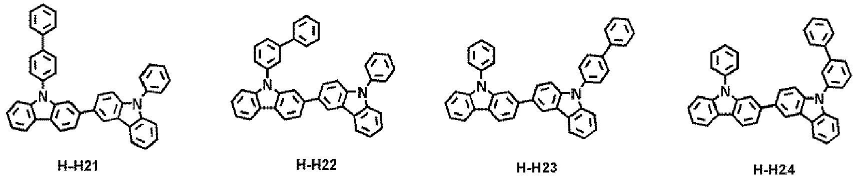

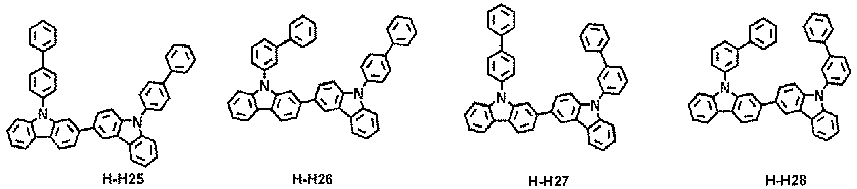

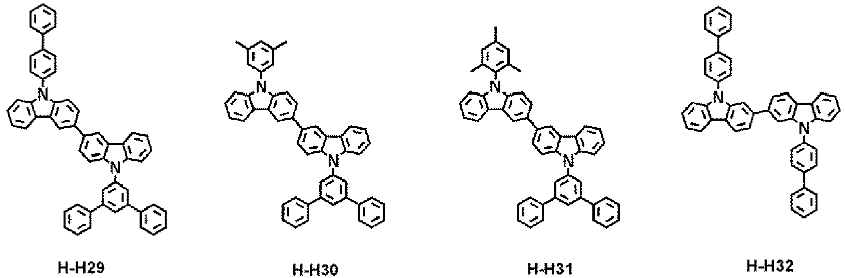

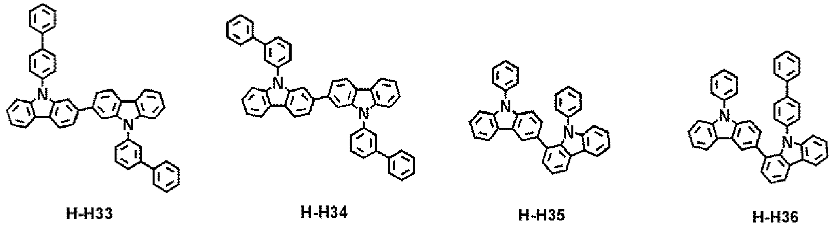

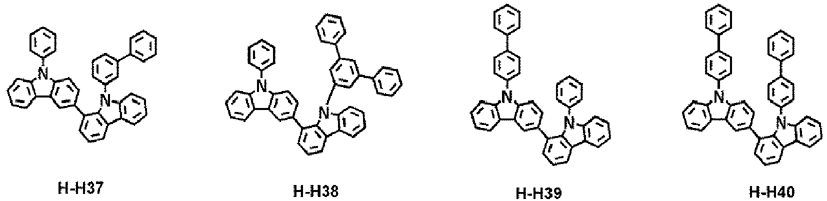

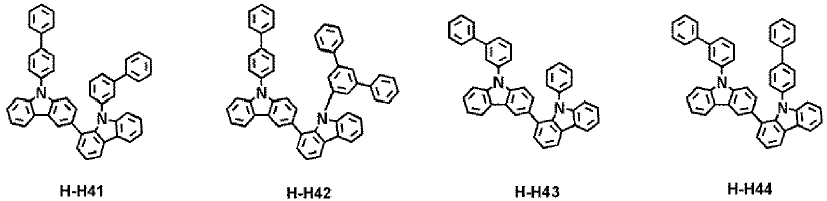

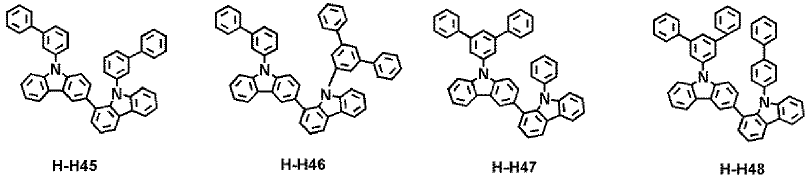

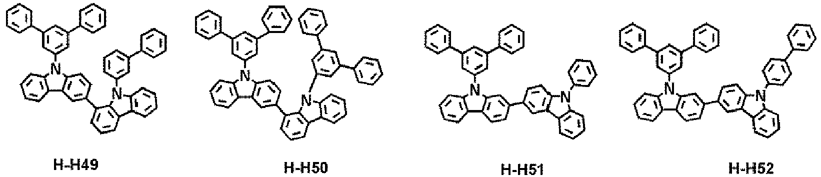

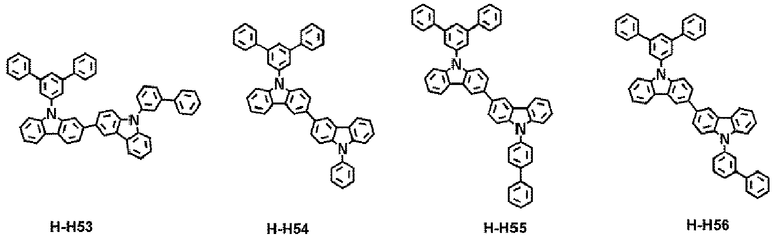

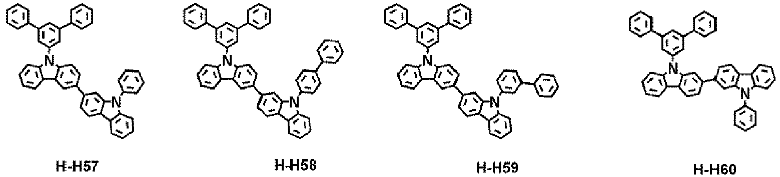

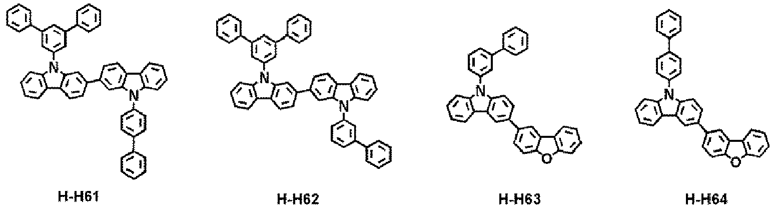

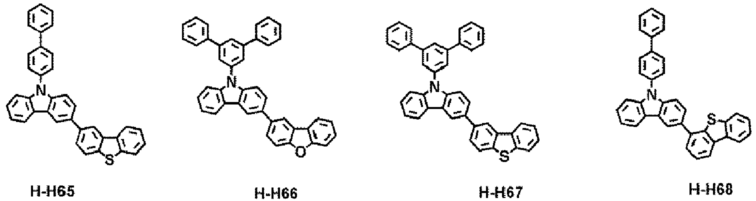

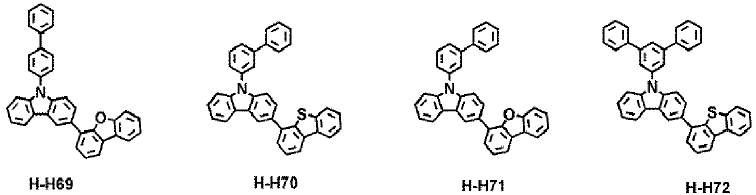

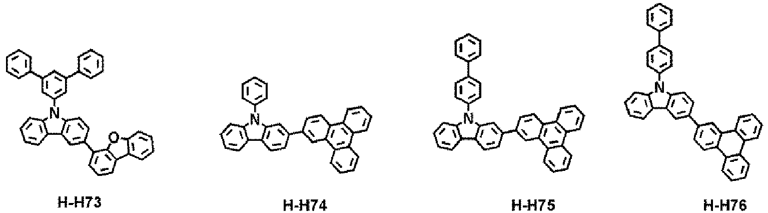

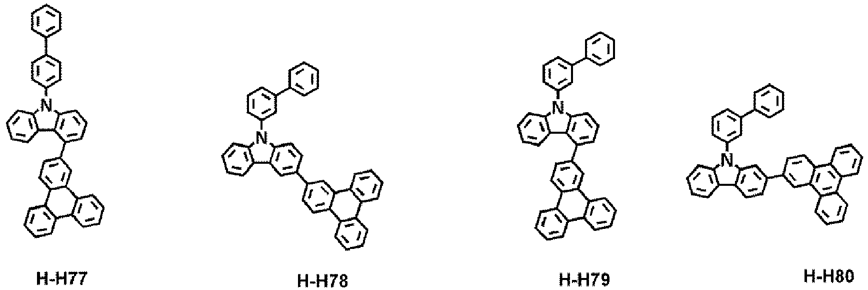

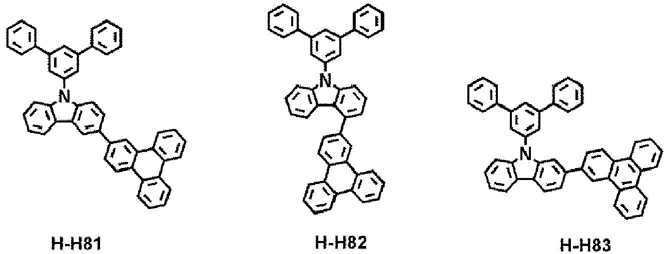

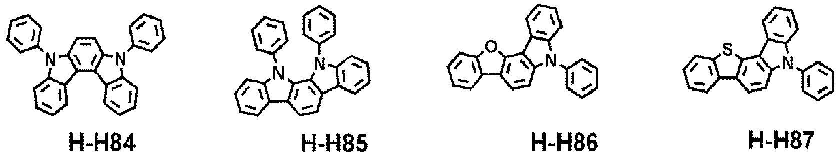

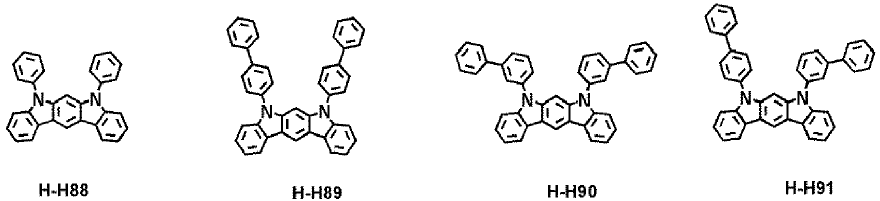

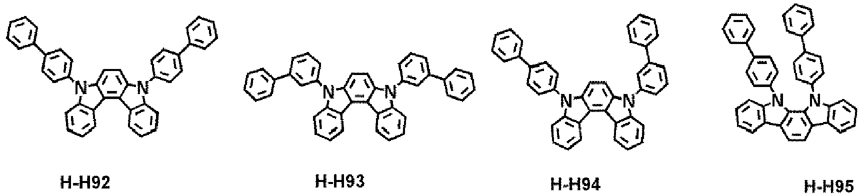

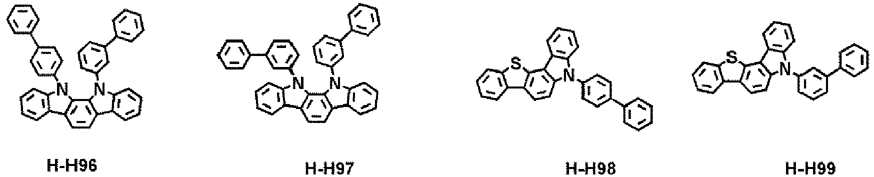

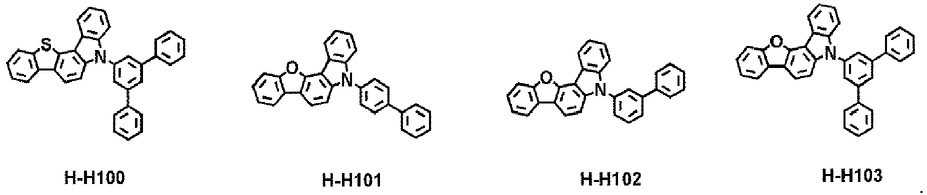

In one or more embodiments, the host may include an electron transport host and a hole transport host, wherein the electron transport host may include a triphenylene group and a triazine group, and the hole transport host may include a carbazole group.

A weight ratio of the electron transport host to the hole transport host may be in a range of 1 : 9 to 9 : 1, for example, 2 : 8 to 8 : 2, and for example, 4 : 6 to 6 : 4. When the weight ratio of the electron transport host to the hole transport host satisfies the above-described ranges, the hole-and-electron transport balance in the emission layer may be achieved.

When the organic light-emitting device 10 is a full-color organic light-emitting device, the emission layer may be patterned into a red emission layer, a green emission layer, and/or a blue emission layer. In one or more embodiments, due to a stacked structure including a red emission layer, a green emission layer, and/or a blue emission layer, the emission layer may emit white light.

A thickness of the emission layer may be in a range of about 100 Å to about 1,000 Å, for example, about 200 Å to about 600 Å. When the thickness of the emission layer satisfies the above-described ranges, excellent light-emission characteristics may be obtained without a substantial increase in driving voltage.

### Electron transport region in emission layer

Then, an electron transport region may be located on the emission layer.

The electron transport region may include a hole blocking layer, an electron transport layer, an electron injection layer, or any combination thereof.

For example, the electron transport region may have a hole blocking layer/electron transport layer/electron injection layer structure or an electron transport layer/electron injection layer structure. The electron transport layer may have a single-layered structure or a multi-layered structure including two or more different materials.

Conditions for forming the hole blocking layer, the electron transport layer, and the electron injection layer which constitute the electron transport region may be understood by referring to the conditions for forming the hole injection layer.

When the electron transport region includes a hole blocking layer, the hole blocking layer may include, for example, at least one of BCP, Bphen, and BAlq.

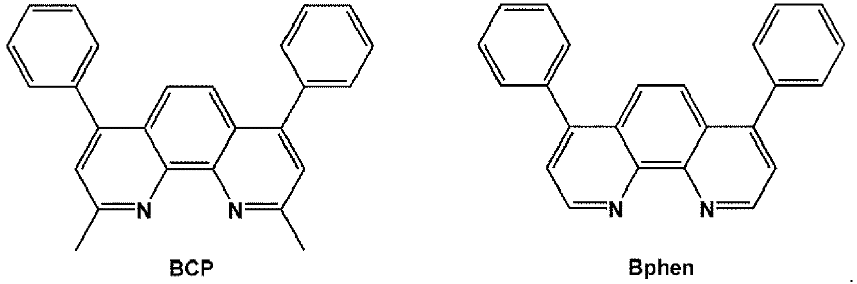

In one or more embodiments, the hole blocking layer may include the host, a material for forming an electron transport layer, a material for forming an electron injection layer, which will be described later, or any combination thereof.

A thickness of the hole blocking layer may be in a range of about 20 Å to about 1,000 Å, for example, about 30 Å to about 600 Å. When the thickness of the hole blocking layer satisfies the above-described ranges, excellent hole blocking characteristics may be obtained without a substantial increase in driving voltage.

The electron transport layer may include BCP, Bphen, TPBi, Alq₃, BAlq, TAZ, NTAZ, or any combination thereof:

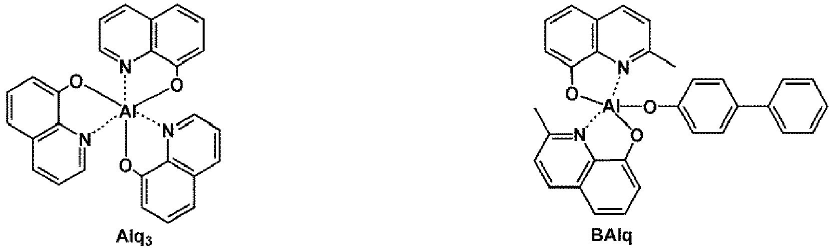

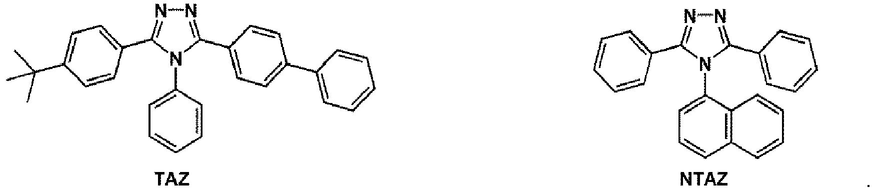

In one or more embodiments, the electron transport layer may include one of Compounds ET1 to ET25 or any combination thereof:

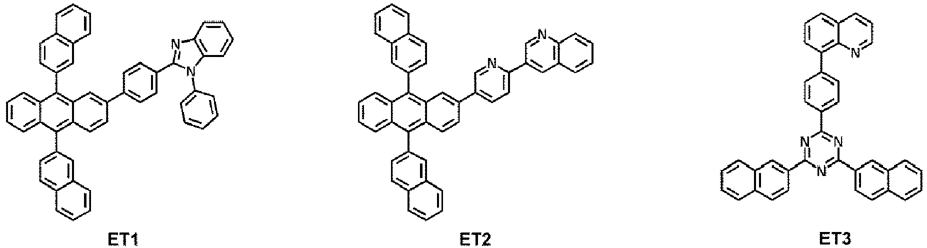

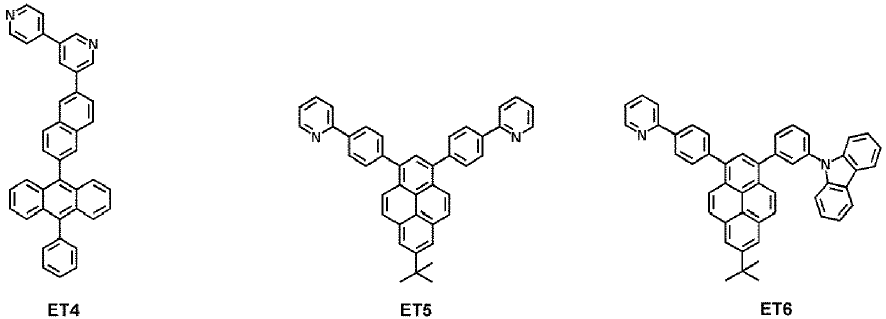

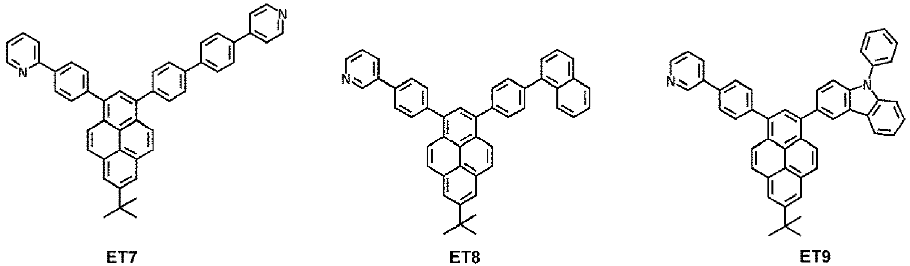

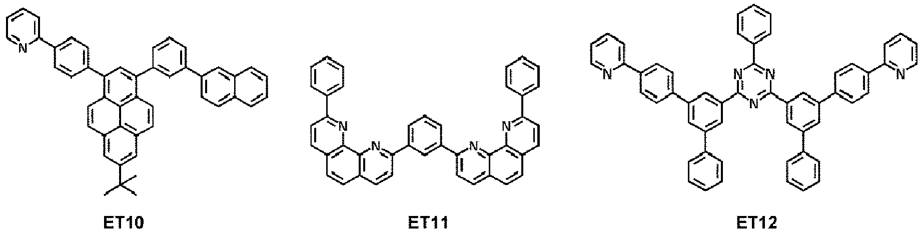

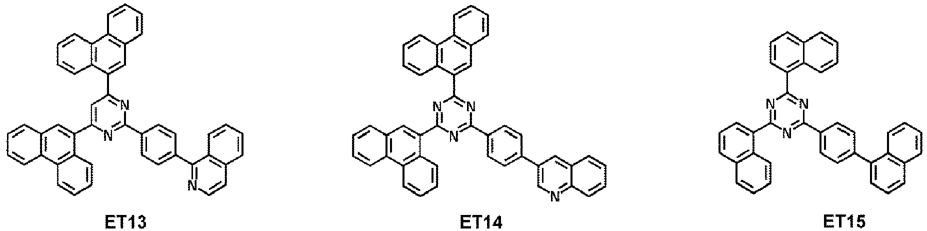

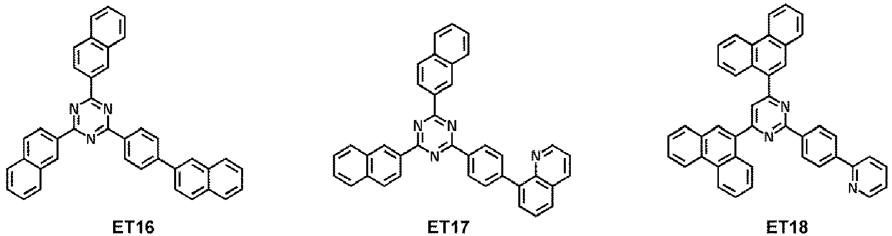

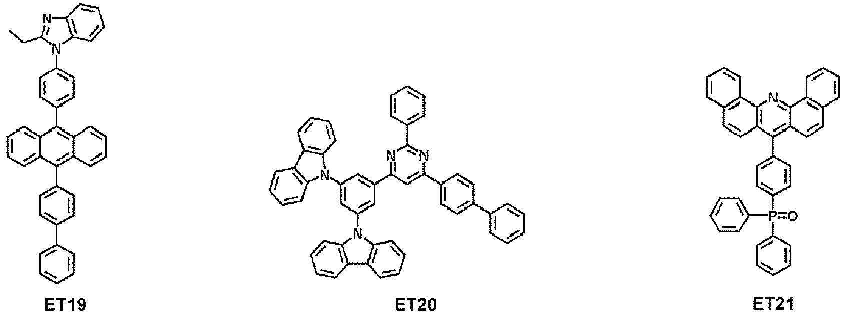

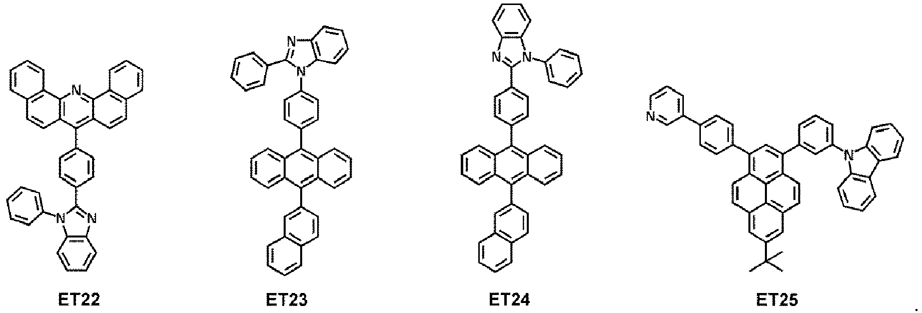

A thickness of the electron transport layer may be in a range of about 100 Å to about 1,000 Å, for example, about 150 Å to about 500 Å. When the thickness of the electron transport layer satisfies the above-described ranges, satisfactory electron transport characteristics may be obtained without a substantial increase in driving voltage.

Also, the electron transport layer may further include, in addition to the materials described above, a metal-containing material.

The metal-containing material may include a Li complex. The Li complex may include, for example, Compound ET-D1 or ET-D2:

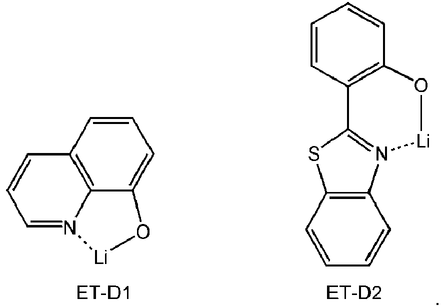

The electron transport region may include an electron injection layer that promotes the flow of electrons from the second electrode 19 thereinto.

The electron injection layer may include LiF, NaCl, CsF, Li₂O, BaO, or any combination thereof.

A thickness of the electron injection layer may be in a range of about 1 Å to about 100 Å, and, for example, about 3 Å to about 90 Å. When the thickness of the electron injection layer satisfies the above-described ranges, satisfactory electron injection characteristics may be obtained without a substantial increase in driving voltage.

The second electrode 19 may be located on the organic layer 15. The second electrode 19 may be a cathode. A material for forming the second electrode 19 may be metal, an alloy, an electrically conductive compound, or a combination thereof, which have a relatively low work function. For example, lithium (Li), magnesium (Mg), aluminum (Al), aluminum-lithium (Al-Li), calcium (Ca), magnesium-indium (Mg-In), or magnesium-silver (Mg-Ag) may be used as the material for forming the second electrode 19. In one or more embodiments, to manufacture a top-emission type light-emitting device, a transmissive electrode formed using ITO or IZO may be used as the second electrode 19.

Hereinbefore, the organic light-emitting device 10 has been described with reference to FIG. 1, but embodiments of the present disclosure are not limited thereto.

According to one or more embodiments, the organic light-emitting device 10 may be included in an electronic apparatus. Thus, an electronic apparatus including the organic light-emitting device 10 may be provided. The electronic apparatus may include, for example, a display, an illumination, a sensor, and the like.

According to one or more embodiments, a diagnostic composition includes at least one organometallic compound represented by Formula 1.

The organometallic compound represented by Formula 1 may be able to provide high luminescence efficiency, and accordingly, a diagnostic composition including the organometallic compound may have high diagnostic efficiency.

The diagnostic composition may be used in various applications including a diagnosis kit, a diagnosis reagent, a biosensor, and a biomarker.

The term "C₁-C₆₀ alkyl group" as used herein refers to a linear or branched saturated aliphatic hydrocarbon monovalent group having 1 to 60 carbon atoms, and the term "C₁-C₆₀ alkylene group" as used here refers to a divalent group having the same structure as the C₁-C₆₀ alkyl group.

Examples of the C₁-C₆₀ alkyl group, the C₁-C₂₀ alkyl group, and/or the C₁-C₁₀ alkyl group include a methyl group, an ethyl group, an n-propyl group, an isopropyl group, an *n*-butyl group, a *sec*-butyl group, an isobutyl group, a *tert*-butyl group, an *n*-pentyl group, a *tert*-pentyl group, a neopentyl group, an isopentyl group, a *sec*-pentyl group, a 3-pentyl group, a *sec*-isopentyl group, an n-hexyl group, an isohexyl group, a *sec*-hexyl group, a *tert*-hexyl group, an *n*-heptyl group, an isoheptyl group, a *sec*-heptyl group, a *tert*-heptyl group, an *n*-octyl group, an isooctyl group, a *sec*-octyl group, a *tert*-octyl group, an *n*-nonyl group, an isononyl group, a *sec*-nonyl group, a *tert*-nonyl group, an *n*-decyl group, an isodecyl group, a *sec*-decyl group, or a *tert*-decyl group, each unsubstituted or substituted with a methyl group, an ethyl group, an *n*-propyl group, an isopropyl group, an *n*-butyl group, a *sec*-butyl group, an isobutyl group, a *tert*-butyl group, an *n*-pentyl group, a *tert-*pentyl group, a neopentyl group, an isopentyl group, a sec-pentyl group, a 3-pentyl group, a sec-isopentyl group, an *n*-hexyl group, an isohexyl group, a sec-hexyl group, a *tert*-hexyl group, an *n*-heptyl group, an isoheptyl group, a sec-heptyl group, a *tert*-heptyl group, an *n*-octyl group, an isooctyl group, a *sec*-octyl group, a *tert*-octyl group, an *n*-nonyl group, an isononyl group, a sec-nonyl group, a *tert*-nonyl group, an *n*-decyl group, an isodecyl group, a sec-decyl group, a *tert*-decyl group, or any combination thereof. For example, Formula 9-33 is a branched C₆ alkyl group, such as a tert-butyl group that is substituted with two methyl groups.

The term "C₁-C₆₀ alkoxy group" as used herein refers to a monovalent group represented by -OA₁₀₁ (wherein A₁₀₁ is the C₁-C₆₀ alkyl group).

Examples of the C₁-C₆₀ alkoxy group, the C₁-C₂₀ alkoxy group, or the C₁-C₁₀ alkoxy group include a methoxy group, an ethoxy group, a propoxy group, a butoxy group, or a pentoxy group.

The term "C₂-C₆₀ alkenyl group" as used herein refers to a hydrocarbon group formed by substituting at least one carbon-carbon double bond in the middle or at the terminus of the C₂-C₆₀ alkyl group, and examples thereof include an ethenyl group, a propenyl group, and a butenyl group. The term "C₂-C₆₀ alkenylene group" as used herein refers to a divalent group having the same structure as the C₂-C₆₀ alkenyl group.

The term "C₂-C₆₀ alkynyl group" as used herein refers to a hydrocarbon group formed by substituting at least one carbon-carbon triple bond in the middle or at the terminus of the C₂-C₆₀ alkyl group, and examples thereof include an ethynyl group and a propynyl group. The term "C₂-C₆₀ alkynylene group" as used herein refers to a divalent group having the same structure as the C₂-C₆₀ alkynyl group.

The term "C₃-C₁₀ cycloalkyl group" as used herein refers to a monovalent saturated hydrocarbon cyclic group having 3 to 10 carbon atoms, and the term "C₃-C₁₀ cycloalkylene group" as used herein refers to a divalent group having the same structure as the C₃-C₁₀ cycloalkyl group.

Examples of the C₃-C₁₀ cycloalkyl group include a cyclopropyl group, a cyclobutyl group, a cyclopentyl group, a cyclohexyl group, a cycloheptyl group, a cycloctyl group, an adamantanyl group, a norbornanyl group (bicyclo[2.2.1]heptyl group), a bicyclo[1.1.1]pentyl group, a bicyclo[2.1.1]hexyl group, a bicyclo[2.2.2]octyl group, and the like.

The term "C₁-C₁₀ heterocycloalkyl group" as used herein refers to a monocyclic group that includes at least one heteroatom selected from N, O, P, Si, S, Ge, Se and B as a ring-forming atom and 1 to 10 carbon atoms, and the term "C₁-C₁₀ heterocycloalkylene group" as used herein refers to a divalent group having the same structure as the C₁-C₁₀ heterocycloalkyl group.

Examples of the C₁-C₁₀ heterocycloalkyl group include a silolanyl group, a tetrahydrofuranyl group, a tetrahydro-2H-pyranyl group, a tetrahydrothiophenyl group, and the like.

The term "C₃-C₁₀ cycloalkenyl group" as used herein refers to a monovalent monocyclic group that has 3 to 10 carbon atoms and at least one carbon-carbon double bond in the ring thereof and no aromaticity, and non-limiting examples thereof include a cyclopentenyl group, a cyclohexenyl group, and a cycloheptenyl group. The term "C₃-C₁₀ cycloalkenylene group" as used herein refers to a divalent group having the same structure as the C₃-C₁₀ cycloalkenyl group.

The term "C₁-C₁₀ heterocycloalkenyl group" as used herein refers to a monovalent monocyclic group that has at least one heteroatom selected from N, O, P, Si, S, Ge, Se and B as a ring-forming atom, 1 to 10 carbon atoms, and at least one carbon-carbon double bond in its ring. Examples of the C₁-C₁₀ heterocycloalkenyl group include a 2,3-dihydrofuranyl group and a 2,3-dihydrothiophenyl group. The term "C₁-C₁₀ heterocycloalkenylene group" as used herein refers to a divalent group having the same structure as the C₁-C₁₀ heterocycloalkenyl group.

The term "C₆-C₆₀ aryl group" as used herein refers to a monovalent group having a carbocyclic aromatic system having 6 to 60 carbon atoms, and the term "C₆-C₆₀ arylene group" as used herein refers to a divalent group having a carbocyclic aromatic system having 6 to 60 carbon atoms. Examples of the C₆-C₆₀ aryl group include a phenyl group, a naphthyl group, an anthracenyl group, a phenanthrenyl group, a pyrenyl group, a chrysenyl group, and the like. When the C₆-C₆₀ aryl group and the C₆-C₆₀ arylene group each include two or more rings, the rings may be fused to each other.

The term "C₇-C₆₀ alkylaryl group" as used herein refers to a C₆-C₆₀ aryl group substituted with at least one C₁-C₆₀ alkyl group.

The term "C₁-C₆₀ heteroaryl group" as used herein refers to a monovalent group having at least one hetero atom selected from N, O, P, Si, S, Ge, Se and B as a ring-forming atom and a cyclic aromatic system having 1 to 60 carbon atoms, and the term "C₁-C₆₀ heteroarylene group" as used herein refers to a divalent group having at least one hetero atom selected from N, O, P, Si, S, Ge, Se and B as a ring-forming atom and a carbocyclic aromatic system having 1 to 60 carbon atoms. Examples of the C₁-C₆₀ heteroaryl group include a pyridinyl group, a pyrimidinyl group, a pyrazinyl group, a pyridazinyl group, a triazinyl group, a quinolinyl group, an isoquinolinyl group, and the like. When the C₆-C₆₀ heteroaryl group and the C₆-C₆₀ heteroarylene group each include two or more rings, the rings may be fused to each other.

The term "C₇-C₆₀ alkylaryl group" as used herein refers to a C₆-C₆₀ aryl group substituted with at least one C₁-C₆₀ alkyl group.

The term "C₆-C₆₀ aryloxy group" as used herein indicates -OA₁₀₂ (wherein A₁₀₂ indicates the C₆-C₆₀ aryl group), the term "C₆-C₆₀ arylthio group" as used herein indicates -SA₁₀₃ (wherein A₁₀₃ indicates the C₆-C₆₀ aryl group), and the term "C₁-C₆₀ alkylthio group" as used herein indicates -SA₁₀₄ (wherein A₁₀₄ indicates the C₁-C₆₀ alkyl group).

The term "monovalent non-aromatic condensed polycyclic group" as used herein refers to a monovalent group (for example, having 8 to 60 carbon atoms) having two or more rings condensed to each other, only carbon atoms as ring-forming atoms, and no aromaticity in its entire molecular structure. Examples of the monovalent non-aromatic condensed polycyclic group include a fluorenyl group and the like. The term "divalent non-aromatic condensed polycyclic group" as used herein refers to a divalent group having the same structure as the monovalent non-aromatic condensed polycyclic group.

The term "monovalent non-aromatic condensed heteropolycyclic group" as used herein refers to a monovalent group (for example, having 2 to 60 carbon atoms) having two or more rings condensed to each other, a heteroatom selected from N, O, P, Si, S, Ge, Se and B other than carbon atoms, as a ring-forming atom, and no aromaticity in its entire molecular structure. Examples of the monovalent non-aromatic condensed heteropolycyclic group include a carbazolyl group and the like. The term "divalent non-aromatic condensed heteropolycyclic group" as used herein refers to a divalent group having the same structure as the monovalent non-aromatic condensed heteropolycyclic group.

The term "C₅-C₃₀ carbocyclic group" as used herein refers to a saturated or unsaturated cyclic group having, as a ring-forming atom, 5 to 30 carbon atoms only. The C₅-C₃₀ carbocyclic group may be a monocyclic group or a polycyclic group. The term "C₅-C₃₀ carbocyclic group (unsubstituted or substituted with at least one R₁₀ₐ)" as used herein refers to, for example, an adamantane group, a norbornene group, a norbornane group(bicyclo[2.2.1]heptane group), a bicyclo[1.1.1]pentane group, a bicyclo[2.1.1]hexane group, a bicyclo[2.2.2]octane group, a cyclopentane group, a cyclohexane group, a cyclohexene group, a benzene group, a naphthalene group, am anthracene group, a phenanthrene group, a triphenylene group, a pyrene group, a chrysene group, a 1,2,3,4-tetrahydronaphthalene group, a cyclopentadiene group, a fluorene group, and the like (each unsubstituted or substituted with at least one R₁₀ₐ).

The term "C₁-C₃₀ heterocyclic group" as used herein refers to a saturated or unsaturated cyclic group having, as a ring-forming atom, at least one heteroatom selected from N, O, P, Si, Se, Ge, B, and S other than 1 to 30 carbon atoms. The C₁-C₃₀ heterocyclic group may be a monocyclic group or a polycyclic group. The term "C₁-C₃₀ heterocyclic group (unsubstituted or substituted with at least one R₁₀ₐ)" as used herein refers to, for example, a thiophene group, a furan group, a pyrrole group, a silole group, borole group, a phosphole group, a selenophene group, a germole group, a benzothiophene group, a benzofuran group, an indole group, a benzosilole group, a benzoborole group, a benzophosphole group, a benzoselenophene group, a benzogermole group, a dibenzothiophene group, a dibenzofuran group, a carbazole group, a dibenzosilole group, a dibenzoborole group, a dibenzophosphole group, a dibenzoselenophene group, a dibenzogermole group, a dibenzothiophene 5-oxide group, a 9H-fluorene-9-one group, a dibenzothiophene 5,5-dioxide group, an azabenzothiophene group, an azabenzofuran group, an azaindole group, an azaindene group, an azabenzosilole group, an azabenzoborole group, an azabenzophosphole group, an azabenzoselenophene group, an azabenzogermole group, an azadibenzothiophene group, an azadibenzofuran group, an azacarbazole group, an azafluorene group, an azadibenzosilole group, an azadibenzoborole group, an azadibenzophosphole group, an azadibenzoselenophene group, an azadibenzogermole group, an azadibenzothiophene 5-oxide group, an aza-9H-fluorene-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, or a 5,6,7,8-tetrahydroquinoline group (each unsubstituted or substituted with at least one R₁₀ₐ).

The terms "deuterated C₁-C₆₀ alkyl group (or a deuterated C₁-C₂₀ alkyl group or the like)", "deuterated C₃-C₁₀ cycloalkyl group", "deuterated C₁-C₁₀ heterocycloalkyl group," and "deuterated phenyl group" as used herein respectively indicate a C₁-C₆₀ alkyl group (or a C₁-C₂₀ alkyl group or the like), a C₃-C₁₀ cycloalkyl group, a C₁-C₁₀ heterocycloalkyl group, and a phenyl group, each substituted with at least one deuterium. For example, the "deuterated C₁ alkyl group (that is, the deuterated methyl group)" may include -CD₃, -CD₂H, and -CDH₂, and examples of the "deuterated C₃-C₁₀ cycloalkyl group" include Formula 10-501 and the like. The "deuterated C₁-C₆₀ alkyl group (or, the deuterated C₁-C₂₀ alkyl group or the like)", "the deuterated C₃-C₁₀ cycloalkyl group", "the deuterated C₁-C₁₀ heterocycloalkyl group", or "the deuterated phenyl group" may be i) a fully deuterated C₁-C₆₀ alkyl group (or, a fully deuterated C₁-C₂₀ alkyl group or the like), a fully deuterated C₃-C₁₀ cycloalkyl group, a fully deuterated C₁-C₁₀ heterocycloalkyl group, or a fully deuterated phenyl group, in which, in each group, all hydrogen included therein are substituted with deuterium, or ii) a partially deuterated C₁-C₆₀ alkyl group (or, a partially deuterated C₁-C₂₀ alkyl group or the like), a partially deuterated C₃-C₁₀ cycloalkyl group, a partially deuterated C₁-C₁₀ heterocycloalkyl group, or a partially deuterated phenyl group, in which, in each group, all hydrogen included therein are not substituted with deuterium.

The term "(C₁-C₂₀ alkyl) 'X' group" as used herein refers to a 'X' group that is substituted with at least one C₁-C₂₀ alkyl group. For example, the term "(C₁-C₂₀ alkyl)C₃-C₁₀ cycloalkyl group" as used herein refers to a C₃-C₁₀ cycloalkyl group substituted with at least one C₁-C₂₀ alkyl group, and the term "(C₁-C₂₀ alkyl)phenyl group" as used herein refers to a phenyl group substituted with at least one C₁-C₂₀ alkyl group. An example of a (C₁ alkyl)phenyl group is a toluyl group.

The terms "an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluorene-9-one group, and an azadibenzothiophene group, and a 5,5-dioxide group" respectively refer to heterocyclic groups having the same backbones as "an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluorene-9-one group, a dibenzothiophene group, and a 5,5-dioxide group," in which, in each group, at least one carbon selected from ring-forming carbons is replaced with nitrogen.

At least one substituent of the substituted C₅-C₃₀ carbocyclic group, the substituted C₂-C₃₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkylaryl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted monovalent non-aromatic condensed polycyclic group, and the substituted monovalent non-aromatic condensed heteropolycyclic group may each independently be:
deuterium, -F, -Cl, -Br, -I, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, or a C₁-C₆₀ alkoxy group;
a C₁-C₆₀ alkyl group, a C₂-C₆₀ alkenyl group, a C₂-C₆₀ alkynyl group, or a C₁-C₆₀ alkoxy group, each substituted with deuterium, -F, -Cl, -Br, -I, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkylaryl group, a C₆-C₆₀ aryloxy group, a C₆-C₆₀ arylthio group, a C₁-C₆₀ heteroaryl group, a C₂-C₆₀ alkyl heteroaryl group, a monovalent non-aromatic condensed polycyclic group, a monovalent non-aromatic condensed heteropolycyclic group, -N(Q₁₁)(Q₁₂), -Si(Q₁₃)(Q₁₄)(Q₁₅), -B(Q₁₆)(Q₁₇), - P(=O)(Q₁₈)(Q₁₉), -P(Q₁₈)(Q₁₉), or any combination thereof;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a monovalent non-aromatic condensed polycyclic group, or a monovalent non-aromatic condensed heteropolycyclic group, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid or a salt thereof, a sulfonic acid or a salt thereof, a phosphoric acid or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a monovalent non-aromatic condensed polycyclic group, a monovalent non-aromatic condensed heteropolycyclic group, -N(Q₂₁)(Q₂₂), -Si(Q₂₃)(Q₂₄)(Q₂₅), -B(Q₂₆)(Q₂₇), - P(=O)(Q₂₈)(Q₂₉), -P(Q₂₈)(Q₂₉), or any combination thereof;
-N(Q₃₁)(Q₃₂), -Si(Q₃₃)(Q₃₄)(Q₃₅), -B(Q₃₆)(Q₃₇), -P(=O)(Q₃₆)(Q₃₉), or - P(Q₃₈)(Q₃₉); or
any combination thereof.

In the present specification, Q₁ to Q₉, Q₁₁ to Q₁₉, Q₂₁ to Q₂₉, and Q₃₁ to Q₃₉ may each independently be: hydrogen; deuterium; -F; -Cl; -Br; -I; a hydroxyl group; a cyano group; a nitro group; an amidino group; a hydrazine group; a hydrazone group; a carboxylic acid or a salt thereof; a sulfonic acid or a salt thereof; a phosphoric acid or a salt thereof; a C₁-C₆₀ alkyl group which is unsubstituted or substituted with deuterium, a C₁-C₆₀ alkyl group, a C₆-C₆₀ aryl group, or any combination thereof; a C₂-C₆₀ alkenyl group; a C₂-C₆₀ alkynyl group; a C₁-C₆₀ alkoxy group; a C₃-C₁₀ cycloalkyl group; a C₁-C₁₀ heterocycloalkyl group; a C₃-C₁₀ cycloalkenyl group; a C₁-C₁₀ heterocycloalkenyl group; a C₆-C₆₀ aryl group which is unsubstituted or substituted with deuterium, a C₁-C₆₀ alkyl group, a C₆-C₆₀ aryl group, or any combination thereof; a C₆-C₆₀ aryloxy group; a C₆-C₆₀ arylthio group; a C₁-C₆₀ heteroaryl group; a monovalent non-aromatic condensed polycyclic group; or a monovalent non-aromatic condensed heteropolycyclic group.

Hereinafter, a compound and an organic light-emitting device according to embodiments are described in detail with reference to Synthesis Example and Examples. However, the organic light-emitting device is not limited thereto. The wording "B was used instead of A" used in describing Synthesis Examples means that an amount of A used was identical to an amount of B used, in terms of a molar equivalent.

### Examples

### Synthesis Example 1 (Compound D10)

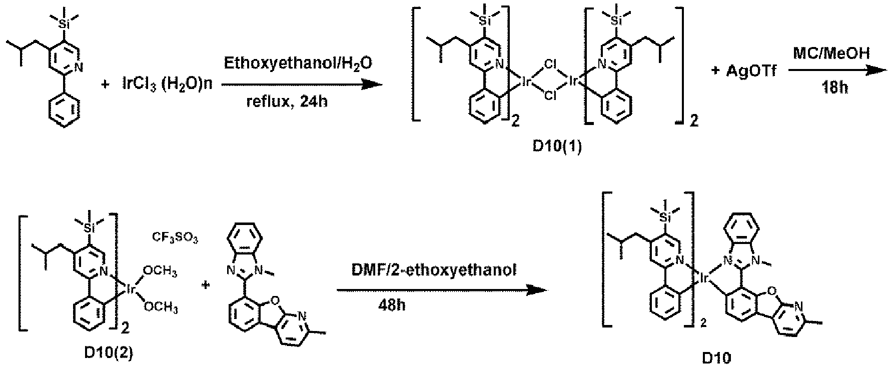

### Synthesis of Compound D10(1)

4-isobutyl-2-phenyl-5-(trimethylsilyl)pyridine (7.5 g, 26.7 mmol) and iridium chloride (4.1 g, 11.9 mmol) were mixed with 120 mL of ethoxyethanol and 40 mL of distilled water, and the mixed solution was stirred under reflux for 24 hours. Then, the reaction temperature was lowered to room temperature. A resulting solid was separated by filtration, sufficiently washed with water/methanol/hexane in order, and dried in a vacuum oven, so as to obtain 7.43 g of Compound D10(1) (yield of 79 %).

### Synthesis of Compound D10(2)

Compound D10(1) (3.0 g, 1.91 mmol) was mixed with 60 mL of methylene chloride, and AgOTf (0.98 g, 3.81 mmol) was mixed with 20 mL of methanol and added to the previous mixed solution. Then, the reaction solution was stirred at room temperature for 18 hours while blocking light with aluminum foil. A solid produced by filtering the reaction solution through celite was removed, and a solid (Compound D10(2)) obtained by concentrating the filtrate was used for the next reaction without further purification.

### Synthesis of Compound D10

Compound D10(2) (3.68 g, 3.79 mmol) was mixed with 2-methyl-8-(1-methyl-1H-benzo[d]imidazol-2-yl)benzofuro[2,3-b]pyridine (4.17 mmol), and 50 mL of 2-ethoxyethanol and 50 mL of dimethylformamide were mixed and added to the previous mixed solution. The reaction solution was stirred under reflux at a temperature of 130 °C for 48 hours, and then, the reaction temperature was lowered. The mixture obtained therefrom was concentrated to obtain a solid, which was then subjected to column chromatography under methylene chloride (MC):hexane conditions, so as to obtain 1.8 g of Compound D10 (yield of 44 %). The compound was confirmed by Mass Spectrum and HPLC analysis.

HRMS(MALDI) calcd for C₅₆H₆₂IrN₅OSi₂ m/z 1069.4122 Found: 1069.4128

### Synthesis Example 2 (Compound D11)

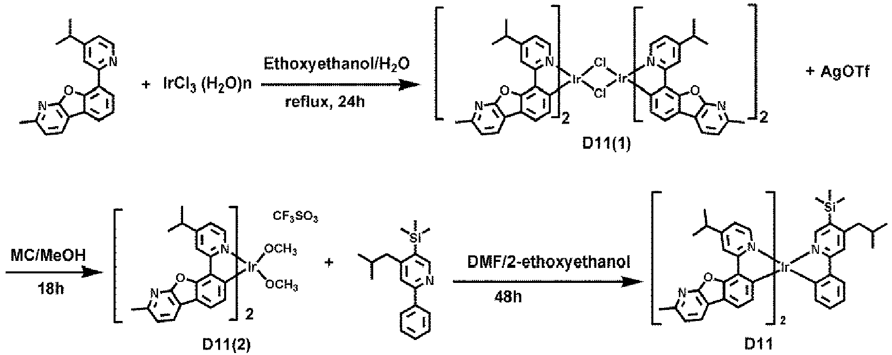

### Synthesis of Compound D11(1)

Compound D11(1) was synthesized in the same manner as used to synthesize Compound D10(1) of Synthesis Example 1, except that 8-(4-isopropylpyridin-2-yl)-2-methylbenzofuro[2,3-b]pyridine was used instead of 4-isobutyl-2-phenyl-5-(trimethylsilyl)pyridine.

### Synthesis of Compound D11(2)

Compound D11(2) was synthesized in the same manner as used to synthesize Compound D10(2) of Synthesis Example 1, except that Compound D11(1) was used instead of Compound D10(1).

### Synthesis of Compound D11

0.7 g (yield of 32 %) of Compound D11 was synthesized in the same manner as used to synthesize Compound D10 of Synthesis Example 1, except that Compound D11(2) and 4-isobutyl-2-phenyl-5-(trimethylsilyl)pyridine were used instead of Compound D10(2) and 2-methyl-8-(1-methyl-1 H-benzo[d]imidazol-2-yl)benzofuro[2,3-b]pyridine (4.17 mmol), respectively. The compound was confirmed by Mass Spectrum and HPLC analysis.

HRMS(MALDI) calcd for C₅₈H₅₈IrN₅O₂Si : m/z 1077.3989 Found: 1077.3995

### Synthesis Example 3 (Compound D12)

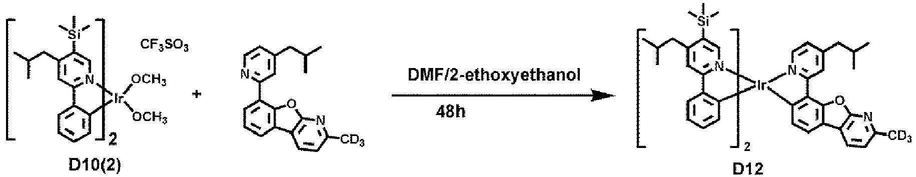

0.8 g (yield of 36 %) of Compound D12 was synthesized in the same manner as used to synthesize Compound D10 of Synthesis Example 1, except that 8-(4-isobutylpyridin-2-yl)-2-methylbenzofuro[2,3-b]pyridine was used instead of 2-methyl-8-(1-methyl-1H-benzo[d]imidazol-2-yl)benzofuro[2,3-b]pyridine. The compound was confirmed by Mass Spectrum and HPLC analysis.

HRMS(MALDI) calcd for C₅₇H₆₇IrN₄OSi₂ m/z 1072.4483 Found: 1072.4476

### Synthesis Example 4 (Compound D13)

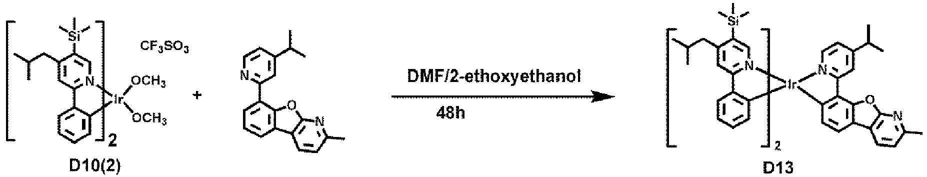

0.7 g (yield of 41 %) of Compound D13 was synthesized in the same manner as used to synthesize Compound D10 of Synthesis Example 1, except that 8-(4-isopropylpyridin-2-yl)-2-methylbenzofuro[2,3-b]pyridine was used instead of 2-methyl-8-(1-methyl-1H-benzo[d]imidazol-2-yl)benzofuro[2,3-b]pyridine. The compound was confirmed by Mass Spectrum and HPLC analysis.

HRMS(MALDI) calcd for C₅₆H₆₅IrN₄OSi₂ m/z 1058.4326 Found: 1058.4321

### Synthesis Example 5 (Compound D14)

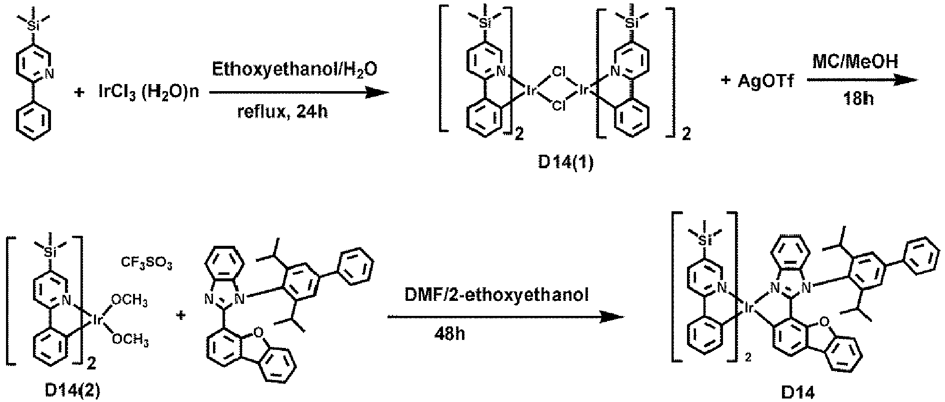

### Synthesis of Compound D14(1)

Compound D14(1) was synthesized in the same manner as used to synthesize Compound D10(1) of Synthesis Example 1, except that 5-(trimethylsilyl)-2-phenylpyridine was used instead of 4-isobutyl-2-phenyl-5-(trimethylsilyl)pyridine.

### Synthesis of Compound D14(2)

Compound D14(2) was synthesized in the same manner as used to synthesize Compound D10(2) of Synthesis Example 1, except that Compound D14(1) was used instead of Compound D10(1).

### Synthesis of Compound D14

1.2 g (yield of 30 %) of Compound D14 was synthesized in the same manner as used to synthesize Compound D10 of Synthesis Example 1, except that Compound D14(2) and 8-(1-(3,5-diisopropyl-[1,1'-biphenyl]-4-yl)-1H-benzo[d]imidazol-2-yl)-4-dibenzofuran were used instead of Compound D10(2) and 2-methyl-8-(1-methyl-1H-benzo[d]imidazol-2-yl)benzofuro[2,3-b]pyridine, respectively. The compound was confirmed by Mass Spectrum and HPLC analysis.

HRMS(MALDI) calcd for C₆₄H₆₁IrN₄OSi₂ : m/z 1150.4013 Found: 1150.4019 Synthesis Example 6 (Compound D15)

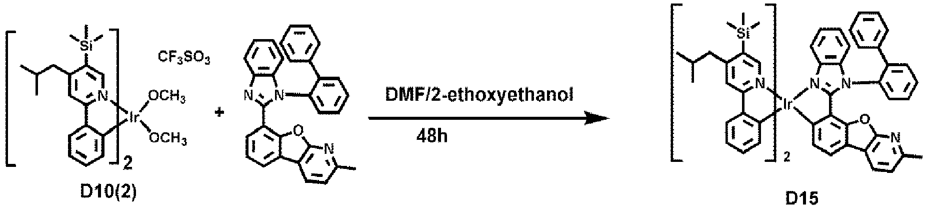

1.8 g (yield of 47 %) of Compound D15 was synthesized in the same manner as used to synthesize Compound D10 of Synthesis Example 1, except that 2-methyl-8-(1-biphenyl-1H-benzo[d]imidazol-2-yl)benzofuro[2,3-b]pyridine was used instead of 2-methyl-8-(1-methyl-1H-benzo[d]imidazol-2-yl)benzofuro[2,3-b]pyridine. The compound was confirmed by Mass Spectrum and HPLC analysis.

HRMS(MALDI) calcd for C₆₇H₆₈IrN₅OSi₂ m/z 1207.4592 Found: 1207.4585

### Synthesis Example 7 (Compound D16)

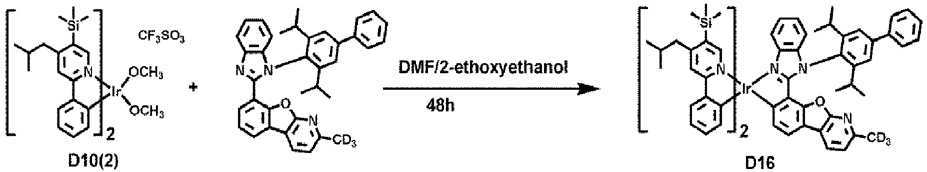

1.8 g (yield of 47 %) of Compound D16 was synthesized in the same manner as used to synthesize Compound D10 of Synthesis Example 1, except that 8-(1-(3,5-diisopropyl-[1,1'-biphenyl]-4-yl)-1H-benzo[d]imidazol-2-yl)-2-(methyl-d3)benzofuro[2,3-b]pyridine was used instead of 2-methyl-8-(1-methyl-1H-benzo[d]imidazol-2-yl)benzofuro[2,3-b]pyridine. The compound was confirmed by Mass Spectrum and HPLC analysis.

HRMS(MALDI) calcd for C₆₇H₆₈IrN₅OSi₂ m/z 1207.4592 Found: 1207.4585

### Synthesis Example 8 (Compound D17)

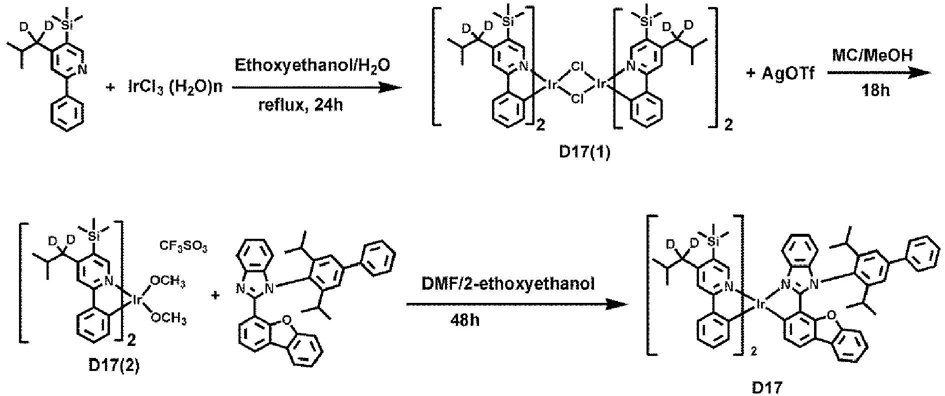

### Synthesis of Compound D17(1)

Compound D17(1) was synthesized in the same manner as used to synthesize Compound D10(1) of Synthesis Example 1, except that 4-(2-methylpropyl-1,1-d2)-2-phenyl-5-(trimethylsilyl)pyridine was used instead of 4-isobutyl-2-phenyl-5-(trimethylsilyl)pyridine.

### Synthesis of Compound D17(2)

Compound D17(2) was synthesized in the same manner as used to synthesize Compound D10(2) of Synthesis Example 1, except that Compound D17(1) was used instead of Compound D10(1).

### Synthesis of Compound D17

1.9 g (yield of 43 %) of Compound D17 was synthesized in the same manner as used to synthesize Compound D10 of Synthesis Example 1, except that Compound D17(2) and 2-(dibenzo[b,d]furan-4-yl)-1-(3,5-diisopropyl-[1,1'-biphenyl]-4-yl)-1H-benzo[d]imidazole were used instead of Compound D10(2) and 2-methyl-8-(1-methyl-1H-benzo[d]imidazol-2-yl)benzofuro[2,3-b]pyridine, respectively. The compound was confirmed by Mass Spectrum and HPLC analysis.

HRMS(MALDI) calcd for C₇₃H₇₅IrN₄OSi₂ : m/z 1280.5673 Found: 1280.5671

### Synthesis Example 9 (Compound D18)

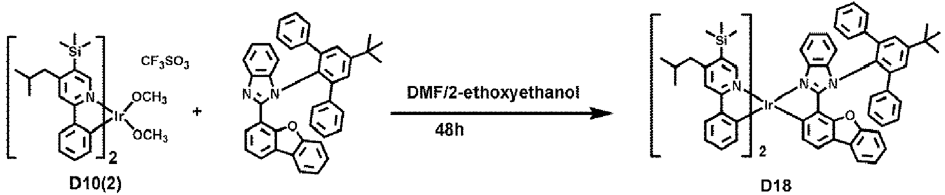

2.5 g (yield of 32 %) of Compound D18 was synthesized in the same manner as used to synthesize Compound D10 of Synthesis Example 1, except that 8-(1-(5'-(tert-butyl)-[1,1':3',1"-terphenyl]-2'-yl)-1H-benzo[d]imidazol-2-yl)-4-dibenzofuran was used instead of 2-methyl-8-(1-methyl-1H-benzo[d]imidazol-2-yl)benzofuro[2,3-b]pyridine. The compound was confirmed by Mass Spectrum and HPLC analysis.

HRMS(MALDI) calcd for C₇₇H₇₉IrN₄OSi₂ : m/z 1324.5422 Found: 1324.5416

### Evaluation Example 1

Regarding each of Compounds D1 to D8 and D10 to D18, a dipole moment (DM) and a polarizability determinant (PD) were evaluated by density functional theory (DFT) calculation based on Hartree atomic units, and accordingly, the charge capture ability (CCA) of each compound was calculated according to Equation 1 (i.e., 5 x 10⁻⁹ x DM x PD). The results are shown in Table 1. In detail, the Gaussian 09 program was used for evaluation of DM and PD. When using the Gaussian 09, a B3LYP/LanL2DZ function was used for a metal included in Compounds D1 to D8 and D10 to D18, and a B3LYP/6-31G(D,P) function was used for an organic ligand included in Compounds D1 to D8 and D10 to D18, thereby optimizing a molecular structure of each compound.

**Table 1**

| Compound No. | Dipole moment DM | Polarizability Determinant PD | 5 x 10⁻⁹ x DM x PD (Charge Capture Ability, CCA) |
|---|---|---|---|
| D1 | 2.47 | 7.60 x 10⁷ | 0.94 |
| D2 | 2.29 | 1.10 x 10⁸ | 1.26 |
| D3 | 2.58 | 1.13 x 10⁸ | 1.45 |
| D4 | 2.59 | 1.15 x 10⁸ | 1.49 |
| D5 | 2.62 | 1.50 x 10⁸ | 1.96 |
| D6 | 2.67 | 1.60 x 10⁸ | 2.13 |
| D7 | 2.77 | 2.18 x 10⁸ | 3.02 |
| D8 | 2.78 | 2.75 x 10⁸ | 3.82 |
| D10 | 1.83 | 4.70 x 10⁸ | 4.30 |
| D11 | 2.07 | 5.35 x 10⁸ | 5.53 |
| D12 | 2.43 | 4.85 x 10⁸ | 5.88 |
| D13 | 2.53 | 4.67 x 10⁸ | 5.91 |
| D14 | 2.12 | 6.07 x 10⁸ | 6.44 |
| D15 | 2.07 | 6.88 x 10⁸ | 7.13 |
| D16 | 1.85 | 8.64 x 10⁸ | 7.99 |
| D17 | 2.17 | 8.41 x 10⁸ | 9.13 |
| D18 | 2.24 | 9.14 x 10⁸ | 10.25 |

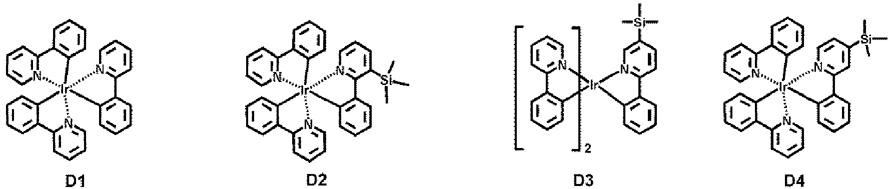

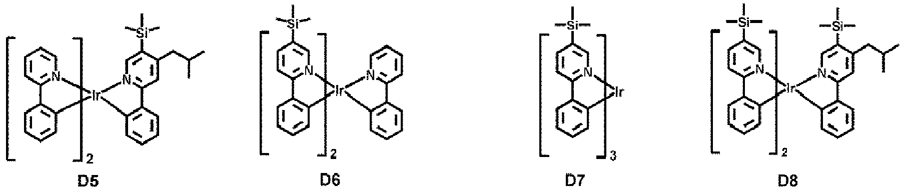

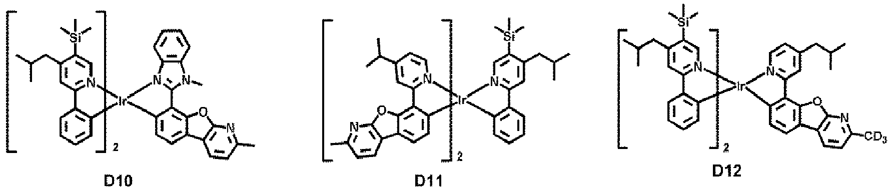

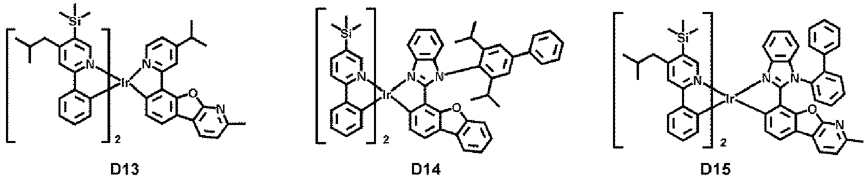

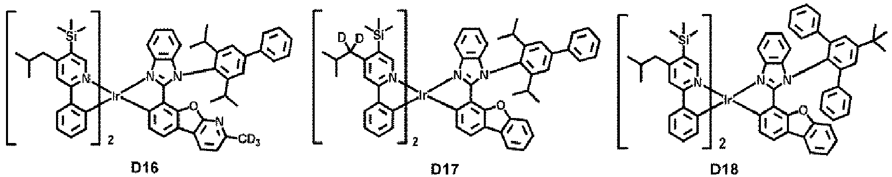

Referring to Table 1, it was confirmed that Compounds D1 to D8 each had a CCA of less than 4.0, whereas Compounds D10 to D18 each had a CCA of 4.0 to 10.5.

### Manufacture of OLED D1-1

As an anode, an ITO-patterned glass substrate was cut to a size of 50 mm x 50 mm x 0.5 mm, sonicated with isopropyl alcohol and pure water each for 5 minutes, and then, cleaned by exposure to ultraviolet rays and ozone for 30 minutes. The resultant glass substrate was then loaded onto a vacuum deposition apparatus.

On the anode, Compounds HT3 and F6TCNNQ were vacuum-co-deposited at a weight ratio of 98 : 2 to form a hole injection layer having a thickness of 100 Å, Compound HT3 was vacuum-deposited on the hole injection layer to form a hole transport layer having a thickness of 1,350 Å, and Compound H-H1 was vacuum-deposited on the hole transport layer to form an electron blocking layer having a thickness of 300 Å.

Then, Compound H-H1, Compound H-E43, and Compound D1 (dopant) were co-deposited on the electron blocking layer to form an emission layer having a thickness of 400 Å. Here, a weight ratio of Compound H-H1 to Compound H-E43 was 1:1, and an amount of Compound D1 was, as shown in Table 2, 2.86 mol% per 100 mol% of the emission layer.

Next, Compounds ET3 and ET-D1 were co-deposited at a volume ratio of 50:50 on the emission layer to form an electron transport layer having a thickness of 350 Å, Compound ET-D1 was vacuum-deposited on the electron transport layer to form an electron injection layer having a thickness of 10 Å, and Al was vacuum-deposited on the electron injection layer to form a cathode having a thickness of 1,000 Å, thereby completing the manufacture of an organic light-emitting device.

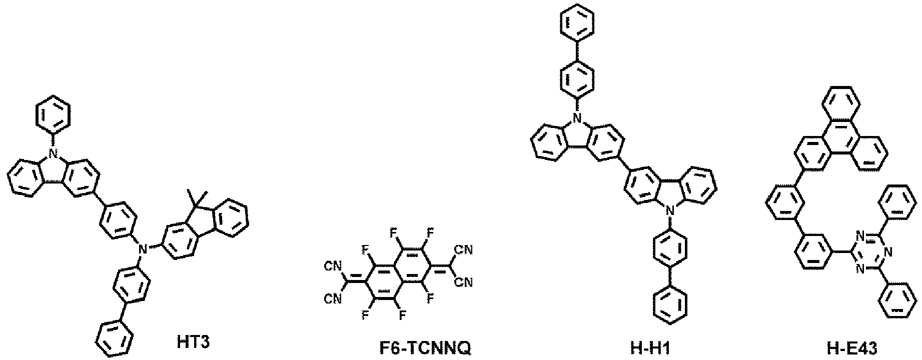

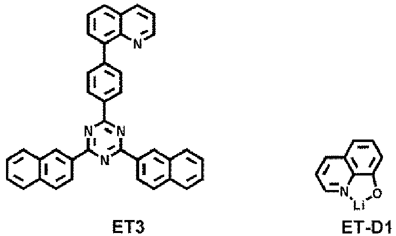

### Manufacture of OLED D1-2 to OLED D8-5 and OLED D10-1 to OLED D18-5

OLED D1-2 to OLED D8-5 and OLED D10-1 to OLED D18-5 were each manufactured in the same manner as used to synthesize OLED D1-1, except that amounts of compounds used as dopants and/or amount of dopants were each changed as shown in Tables 2 and 3.

### Evaluation Example 2

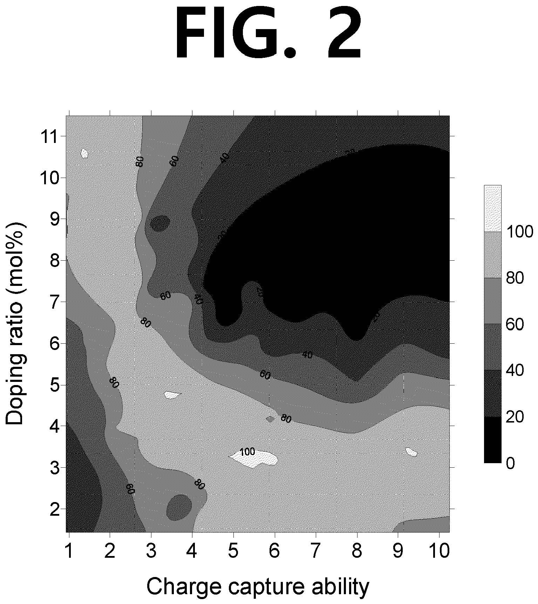

Regarding each of OLED D1-1 to OLED D8-5 and OLED D10-1 to OLED D18-5 (total 85 OLEDs), a lifespan (LT₉₇) was evaluated, and the results are shown in Tables 2 and 3. As an evaluation device, a current-voltmeter (Keithley 2400) and luminance meter (Minolta Cs-1000A) were used, and the lifespan (LT₉₇) (at 16000 nit) was evaluated as the time taken for luminance to reduce to 97% of 100% of the initial luminance. The lifespan (LT₉₇) of Tables 2 and 3 was described as a relative value (%), where the highest lifespan (LT₉₇) among five devices each including the same dopant was set to be 100 %, and the lifespan (LT₉₇) of the remaining devices was described as a relative value to the highest lifespan. Thus, even when the relative value (%) of the lifespan (LT₉₇) of devices including different dopants was described as 100 %, the absolute value (hr) of the lifespan (LT₉₇) of the devices are not necessarily the same. For example, the relative values of the lifespan (LT₉₇) of OLED D1-5 and OLED D2-5 are both 100 %, but the absolute values (hr) of the lifespan (LT₉₇) of OLED D1-5 and OLED D2-5 may be different from each other. Meanwhile, FIG. 2 shows data of Tables 2 and 3 represented in contour plots, wherein the x-axis represents CCA, the y-axis represents a dopant amount per 100 mol% of an emission layer, and the z-axis represents a relative lifespan (%) of an organic light-emitting device shown in shades, the organic light-emitting device including an emission layer including a dopant with CCA of the corresponding x-axis at an amount (mol%) of the corresponding y-axis.

**Table 2**

| Dopan t Comp ound No. | CCA | Dopant amount (mol%) per 100 mol% of emission layer | | | | | Lifespan (LT₉₇)(at 16000 nit) (relative value, %) | | | | |
|---|---|---|---|---|---|---|---|---|---|---|---|
| D1 | 0.94 | OLED D1-1 | OLED D1-2 | OLED D1-3 | OLED D1-4 | **OLED D1-5** | OLED D1-1 | OLED D1-2 | OLED D1-3 | OLED D1-4 | **OLED D1-5** |
| | | 2.86 | 4.78 | 6.69 | 9.57 | **11.50** | 26 % | 41 % | 61 % | 79 % | **100** % |
| D2 | 1.26 | OLED D2-1 | OLED D2-2 | OLED D2-3 | OLED D2-4 | **OLED D2-5** | OLED D2-1 | OLED D2-2 | OLED D2-3 | OLED D2-4 | **OLED D2-5** |
| | | 2.59 | 4.32 | 6.07 | 8.71 | **10.47** | 30 % | 41 % | 50 % | 83% | **100** % |
| D3 | 1.45 | OLED D3-1 | OLED D3-2 | OLED D3-3 | OLED D3-4 | **OLED D3-5** | OLED D3-1 | OLED D3-2 | OLED D3-3 | OLED D3-4 | **OLED D3-5** |
| | | 2.59 | 4.32 | 6.07 | 8.71 | **1.47** | 25 % | 48 % | 74 % | 97 % | **100** % |
| D4 | 1.49 | OLED D4-1 | OLED D4-2 | OLED D4-3 | OLED D4-4 | **OLED D4-5** | OLED D4-1 | OLED D4-2 | OLED D4-3 | OLED D4-4 | **OLED D4-5** |
| | | 2.59 | 4.32 | 6.07 | 8.71 | **10.47** | 32 % | 40 % | 58 % | 83 % | **100** % |
| D5 | 1.96 | OLED D5-1 | OLED D5-2 | OLED D5-3 | OLED D5-4 | **OLED D5-5** | OLED D5-1 | OLED D5-2 | OLED D5-3 | OLED D5-4 | **OLED D5-5** |
| | | 2.40 | 4.03 | 5.66 | 8.13 | **9.80** | 44 % | 62 % | 81% | 96 % | **100** % |
| D6 | 2.13 | OLED D6-1 | OLED D6-2 | OLED D6-3 | **OLED D6-4** | OLED D6-5 | OLED D6-1 | OLED D6-2 | OLED D6-3 | **OLED D6-4** | OLED D6-5 |
| | | 2.36 | 3.95 | 5.55 | **7.98** | 9.62 | 45 % | 81 % | 94 % | **100** % | 85 % |
| D7 | 3.02 | OLED D7-1 | OLED D7-2 | **OLED D7-3** | OLED D7-4 | OLED D7-5 | OLED D7-1 | OLED D7-2 | **OLED D7-3** | OLED D7-4 | OLED D7-5 |
| | | 2.17 | 3.64 | **5.12** | 7.37 | 8.89 | 73 % | 98% | **100 %** | 43 % | 29 % |
| D8 | 3.82 | OLED D8-1 | OLED D8-2 | **OLED D8-3** | OLED D8-4 | OLED D8-5 | OLED D8-1 | OLED D8-2 | **OLED D8-3** | OLED D8-4 | OLED D8-5 |
| | | 2.04 | 3.42 | **4.82** | 6.96 | 8.40 | 43 % | 89 % | **100 %** | 78 % | 58 % |

**Table 3**

| Dopant Compound No. | CCA | Dopant amount (mol%) per 100 mol% of emission layer | | | | | Lifespan (LT₉₇)(at 16000 nit) (relative value, %) | | | | |
|---|---|---|---|---|---|---|---|---|---|---|---|
| D10 | 4.30 | **OLED D10-1** | OLED D10-2 | OLED D10-3 | OLED D10-4 | OLED D10-5 | **OLED D10-1** | OLED D10-2 | OLED D10-3 | OLED D10-4 | OLED D10-5 |
| | | **1.77** | 2.98 | 4.21 | 6.09 | 7.37 | **100 %** | 92 % | 83 % | 42 % | 17 % |
| D11 | 5.53 | OLED D11-1 | **OLED D11-2** | OLED D11-3 | OLED D11-4 | OLED D11-5 | OLED D11-1 | **OLED D11-2** | OLED D11-3 | OLED D11-4 | OLED D11-5 |
| | | 1.76 | **2.96** | 4.18 | 6.04 | 7.31 | 97 % | **100 %** | 90 % | 51 % | 32 % |
| D12 | 5.88 | **OLED D12-1** | OLED D12-2 | OLED D12-3 | OLED D12-4 | OLED D12-5 | **OLED D12-1** | OLED D12-2 | OLED D12-3 | OLED D12-4 | OLED D12-5 |
| | | **1.77** | 2.98 | 4.20 | 6.07 | 7.35 | **100 %** | 80 % | 75 % | 14 % | 6% |
| D13 | 5.91 | OLED D13-1 | **OLED D13-2** | OLED D13-3 | OLED D13-4 | OLED D13-5 | OLED D13-1 | **OLED D13-2** | OLED D13-3 | OLED D13-4 | OLED D13-5 |
| | | 1.79 | **3.01** | 4.25 | 6.15 | 7.44 | 92 % | **100 %** | 83 % | 42 % | 17 % |
| D14 | 6.44 | OLED D14-1 | **OLED D14-2** | OLED D14-3 | OLED D14-4 | OLED D14-5 | OLED D14-1 | **OLED D14-2** | OLED D14-3 | OLED D14-4 | OLED D14-5 |
| | | 1.63 | **2.74** | 3.88 | 5.62 | 6.81 | 93 % | **100 %** | 85 % | 45 % | 9% |
| D15 | 7.13 | OLED D15-1 | **OLED D15-2** | OLED D15-3 | OLED D15-4 | OLED D15-5 | OLED D15-1 | **OLED D15-2** | OLED D15-3 | OLED D15-4 | OLED D15-5 |
| | | 1.57 | **2.65** | 3.75 | 5.43 | 6.58 | 96 % | **100 %** | 85 % | 46 % | 24 % |
| D16 | 7.99 | OLED D16-1 | **OLED D16-2** | OLED D16-3 | OLED D16-4 | OLED D16-5 | OLED D16-1 | **OLED D16-2** | OLED D16-3 | OLED D16-4 | OLED D16-5 |
| | | 1.47 | **2.48** | 3.51 | 5.10 | 6.18 | 91 % | **100** % | 85 % | 39 % | 17 % |
| D17 | 9.13 | OLED D17-1 | OLED D17-2 | **OLED D17-3** | OLED D17-4 | OLED D17-5 | OLED D17-1 | OLED D17-2 | **OLED D17-3** | OLED D17-4 | OLED D17-5 |
| | | 1.49 | 2.51 | **3.55** | 5.15 | 6.25 | 76 % | 93 % | **100 %** | 65 % | 37 % |
| D18 | 10.25 | OLED D18-1 | OLED D18-2 | **OLED D18-3** | OLED D18-4 | OLED D18-5 | OLED D18-1 | OLED D18-2 | **OLED D18-3** | OLED D18-4 | OLED D18-5 |
| | | 1.44 | 2.42 | **3.42** | 4.97 | 6.03 | 73 % | 92 % | **100 %** | 66 % | 23 % |

Referring to Table 2 and FIG. 2, it was confirmed that, among the devices including Compounds D1 to D8 having a CCA of less than 4.0, the devices having a relative lifespan (LT₉₇) of 100 % were devices in which the dopant amount per 100 mol% of the emission layer was more than 4.6 mol%. Furthermore, it was confirmed that, among the devices including Compounds D1 to D4, the devices having a relative lifespan (LT₉₇) of 100 % were devices in which the dopant amount per 100 mol% of the emission layer was 10 mol% or more. However, referring to Table 3 and FIG. 2, it was confirmed that, among the devices including Compounds D10 to D18 having a CCA of more than 4.0, the devices having a relative lifespan (LT₉₇) of 100 % were devices in which the dopant amount per 100 mol% of the emission layer was 4.6 mol% or less.

From the above, it was confirmed that, when using a dopant having a CCA of less than 4.0, a dopant having a relatively high concentration should be used to implement an organic light-emitting device having a long lifespan, but even when using a dopant having a CCA of 4.0 or more, a dopant having a relatively low concentration may also be able to implement an organic light-emitting device having a long lifespan. Therefore, use of the dopant having a CCA of 4.0 or more may lead to mass production of an organic light-emitting device having a long lifespan at low cost.

According to one or more embodiments, when an organometallic compound is used as a dopant in an emission layer of an organic light-emitting device, an organic light-emitting device having a long light-emitting device may be implemented when doped at a relatively concentration. Thus, use of the organometallic compound may lead to mass production of an organic light-emitting device having a long lifespan at low cost.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. An organometallic compound having a charge capture ability (CCA) of 4.0 to 10.5, wherein
the CCA is represented by Equation 1,
wherein the organometallic compound comprises a transition metal and a ligand(s) in a number of n linked to the transition metal, wherein
n is an integer from 1 to 6,
at least one ligand in the number of n is linked to the transition metal through carbon, nitrogen, or a combination thereof, and
the ligand(s) in the number of n does not include a ligand linked to the transition metal through two oxygens:$C C A = 5 \times {10}^{- 9} \times D M \times P D ,$ wherein, in Equation 1,
DM indicates a dipole moment of the organometallic compound evaluated by a density functional theory (DFT) calculation based on Hartree atomic units, and
PD indicates a polarizability determinant of the organometallic compound evaluated by a DFT calculation based on Hartree atomic units.

2. The organometallic compound of claim 1, wherein
the organometallic compound has a CCA of 4.30 to 10.25; and/or
wherein the organometallic compound emits green light; and/or
wherein the organometallic compound emits light having a maximum emission wavelength of 490 nm to 550 nm.

3. The organometallic compound of claims 1 or 2, wherein
the transition metal is iridium, osmium, rhodium, or rhenium,
n is 3, and
each of the ligands in the number of n is a bidentate ligand linked to the transition metal through carbon, nitrogen, or a combination thereof.

4. The organometallic compound of any of claims 1-3, wherein
the organometallic compound is represented by Formula 1 or 2:
| | |
|---|---|
| Formula 1 | Formula 2 |
| M₁(L₁)ₙ₁(L₂)ₙ₂ | M₂(L₁)(L₁₁) |
wherein, M₁ in Formula 1 is iridium, osmium, rhodium, or rhenium,
n1 and n2 in Formula 1 are each independently 1 or 2, and the sum of n1 and n2 is 3,
M₂ in Formula 2 is platinum, palladium, or gold,
L₁ and L₂ in Formulae 1 and 2 are each independently a bidentate ligand linked to the transition metal through carbon, nitrogen, or a combination thereof,
L₁₁ in Formula 2 is a bidentate ligand,
in Formula 1, i) L₁ and L₂ are identical to each other; or ii) L₁ and L₂ are different from each other,
in Formula 2, i) when n1 is 2, two L₁(s) are identical to each other; ii) when n1 is 2, two L₁(s) are different from each other; iii) when n2 is 2, two L₂(s) are identical to each other; or iv) when n2 is 2, two L₂(s) are different from each other,
in Formula 2, i) L₁ and L₁₁ are identical to each other; or ii) L₁ and L₁₁ are different from each other,
in Formula 1, two or more L₁(s) in the number of n1, L₂(s) in the number of n2, or a combination thereof are optionally linked to each other through a first linking group to form a tetradentate ligand or a hexadentate ligand, and
in Formula 2, L₁ and L₁₁ are optionally linked to each other through a first linking group to form a tetradentate ligand.

5. The organometallic compound of claim 4, wherein
L₁ in Formulae 1 and 2 is a ligand represented by Formula 3-1, and
L₂ in Formula 1 is a ligand represented by Formula 3-2: 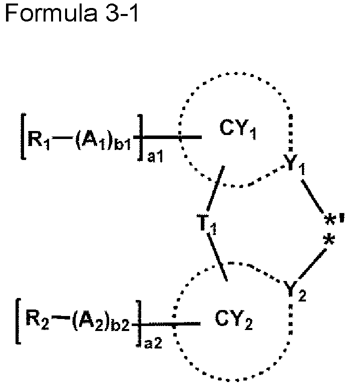 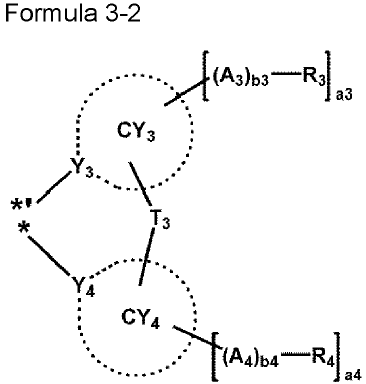 wherein, in Formulae 3-1 and 3-2,
* and *' each indicate a binding site to M₁ in Formula 1 or M₂ in Formula 2,
Y₁ to Y₄ are each independently N or C,
a bond between Y₁ in Formula 3-1 and each of M₁ in Formula 1 and M₂ in Formula 2 is a coordinate bond, a bond between Y₂ in Formula 3-1 and each of M₁ in Formula 1 and M₂ in Formula 2 is a covalent bond, a bond between M₁ in Formula 1 and Y₃ in Formula 3-2 is a coordinate bond, and a bond between M₁ in Formula 1 and Y₄ in Formula 3-2 is a covalent bond,
ring CY₁ to ring CY₄ are each independently a C₅-C₃₀ carbocyclic group or a C₂-C₃₀ heterocyclic group,
T₁ and T₃ are each independently a single bond, a double bond, *-N(R₇)-*', *-B(R₇)-*', *-P(R₇)-*', *-C(R₇)(R₈)-*', *-Si(R₇)(R₈)-*', *-Ge(R₇)(R₈)-*', *-S-*', *-Se-*', *-O-*', *-C(=O)-*', *-S(=O)-*', *-S(=O)₂-*', *-C(R₇)=*', *=C(R₇)-*', *-C(R₇)=C(R₈)-*', *-C(=S)-*', or *-C≡C-*', wherein * and *' each indicate a binding site to a neighboring atom,
A₁ to A₄ are each independently a single bond, a C₅-C₃₀ carbocyclic group unsubstituted or substituted with at least one R₁₀ₐ, or a C₂-C₃₀ heterocyclic group unsubstituted or substituted with at least one R₁₀ₐ,
b1 to b4 are each independently an integer from 1 to 10, wherein, when b1 is 2 or more, two or more of A₁(s) are identical to or different from each other, when b2 is 2 or more, two or more of A₂(s) are identical to or different from each other, when b3 is 2 or more, two or more of A₃(s) are identical to or different from each other, and when b4 is 2 or more, two or more of A₄(s) are identical to or different from each other,
R₁ to R₄, R₇, and R₈ are each independently hydrogen, deuterium, -F, -Cl, -Br, -I, -SF₅, a hydroxyl group, a cyano group, a nitro group, an amino group, an amidino group, a hydrazine group, a hydrazone group, a carboxylic acid or a salt thereof, a sulfonic acid or a salt thereof, a phosphoric acid or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -Ge(Q₃)(Q₄)(Q₅), -B(Q₆)(Q₇), - P(=O)(Q₈)(Q₉), or -P(Q₈)(Q₉),
a1 to a4 are each independently an integer from 0 to 20, wherein, when a1 is 2 or more, two or more groups represented by *-(A₁)_{b1}-R₁ are identical to or different from each other, when a2 is 2 or more, two or more groups represented by *-(A₂)_{b2}-R₂ are identical to or different from each other, when a3 is 2 or more, two or more groups represented by *-(A₃)_{b3}-R₃ are identical to or different from each other, and when a4 is 2 or more, two or more groups represented by *-(A₄)_{b4}-R₄ are identical to or different from each other,
two or more of a plurality of R₁(s) are optionally linked together to form a C₅-C₃₀ carbocyclic group unsubstituted or substituted with at least one R₁₀ₐ or a C₂-C₃₀ heterocyclic group unsubstituted or substituted with at least one R₁₀ₐ,
two or more of a plurality of R₂(s) are optionally linked together to form a C₅-C₃₀ carbocyclic group unsubstituted or substituted with at least one R₁₀ₐ or a C₂-C₃₀ heterocyclic group unsubstituted or substituted with at least one R₁₀ₐ,
two or more of a plurality of R₃(s) are optionally linked together to form a C₅-C₃₀ carbocyclic group unsubstituted or substituted with at least one R₁₀ₐ or a C₂-C₃₀ heterocyclic group unsubstituted or substituted with at least one R₁₀ₐ,
two or more of a plurality of R₄(s) are optionally linked together to form a C₅-C₃₀ carbocyclic group unsubstituted or substituted with at least one R₁₀ₐ or a C₂-C₃₀ heterocyclic group unsubstituted or substituted with at least one R₁₀ₐ,
two or more of R₁ to R₄, R₇, and R₈ are optionally linked together to form a C₅-C₃₀ carbocyclic group unsubstituted or substituted with at least one R₁₀ₐ or a C₂-C₃₀ heterocyclic group unsubstituted or substituted with at least one R₁₀ₐ,
R₁₀ₐ is the same as described in connection with R₁,
a substituent of the substituted C₁-C₆₀ alkyl group, the substituted C₂-C₆₀ alkenyl group, the substituted C₂-C₆₀ alkynyl group, the substituted C₁-C₆₀ alkoxy group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₆-C₆₀ aryloxy group, the substituted C₆-C₆₀ arylthio group, the substituted C₁-C₆₀ heteroaryl group, the substituted monovalent non-aromatic condensed polycyclic group, and the substituted monovalent non-aromatic condensed heteropolycyclic group is:
deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazino group, a hydrazono group, a carboxylic acid or a salt thereof, a sulfonic acid or a salt thereof, a phosphoric acid or a salt thereof, a C₁-C₆₀ alkyl group, a C₂-C₆₀ alkenyl group, a C₂-C₆₀ alkynyl group, or a C₁-C₆₀ alkoxy group;
a C₁-C₆₀ alkyl group, a C₂-C₆₀ alkenyl group, a C₂-C₆₀ alkynyl group, or a C₁-C₆₀ alkoxy group, each substituted with deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid or a salt thereof, a sulfonic acid or a salt thereof, a phosphoric acid or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₁₁)(Q₁₂), -Si(Q₁₃)(Q₁₄)(Q₁₅), - Ge(Q₁₃)(Q₁₄)(Q₁₅), -B(Q₁₆)(Q₁₇), -P(=O)(Q₁₈)(Q₁₉), -P(Q₁₈)(Q₁₉), or any combination thereof;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, or a monovalent non-aromatic condensed heteropolycyclic group, each unsubstituted or substituted with deuterium, -F, -Cl, -Br, -I, -CD₃, -CD₂H, -CDH₂, -CF₃, - CF₂H, -CFH₂, a hydroxyl group, a cyano group, a nitro group, an amino group, an amidino group, a hydrazine group, a hydrazone group, a carboxylic acid or a salt thereof, a sulfonic acid or a salt thereof, a phosphoric acid or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₂₁)(Q₂₂), -Si(Q₂₃)(Q₂₄)(Q₂₅), - Ge(Q₂₃)(Q₂₄)(Q₂₅), -B(Q₂₆)(Q₂₇), -P(=O)(Q₂₈)(Q₂₉), -P(Q₂₈)(Q₂₉), or any combination thereof;
-N(Q₃₁)(Q₃₂), -Ge(Q₃₃)(Q₃₄)(Q₃₅), -B(Q₃₆)(Q₃₇), -P(=O)(Q₃₈)(Q₃₉), or -P(Q₃₈)(Q₃₉); or
any combination thereof,
wherein Q₁ to Q₉, Q₁₁ to Q₁₉, Q₂₁ to Q₂₉, and Q₃₁ to Q₃₉ are each independently: hydrogen; deuterium; -F; -Cl; -Br; -I; a hydroxyl group; a cyano group; a nitro group; an amidino group; a hydrazine group; a hydrazone group; a carboxylic acid or a salt thereof; a sulfonic acid or a salt thereof; a phosphoric acid or a salt thereof; a C₁-C₆₀ alkyl group which is unsubstituted or substituted with deuterium, a C₁-C₆₀ alkyl group, a C₆-C₆₀ aryl group, or any combination thereof; a C₂-C₆₀ alkenyl group; a C₂-C₆₀ alkynyl group; a C₁-C₆₀ alkoxy group; a C₃-C₁₀ cycloalkyl group; a C₁-C₁₀ heterocycloalkyl group; a C₃-C₁₀ cycloalkenyl group; a C₁-C₁₀ heterocycloalkenyl group; a C₆-C₆₀ aryl group which is unsubstituted or substituted with deuterium, a C₁-C₆₀ alkyl group, a C₆-C₆₀ aryl group, or any combination thereof; a C₆-C₆₀ aryloxy group; a C₆-C₆₀ arylthio group; a C₁-C₆₀ heteroaryl group; a monovalent non-aromatic condensed polycyclic group; or a monovalent non-aromatic condensed heteropolycyclic group.

6. The organometallic compound of claim 5, wherein
in Formulae 3-1 and 3-2, Y₁ and Y₃ are each N, and Y₂ and Y₄ are each C.

7. The organometallic compound of claims 5 or 6, wherein
in Formulae 3-1 and 3-2, ring CY₂ to ring CY₄ are each independently i) a first ring, ii) a second ring, iii) a condensed ring in which two or more first rings are condensed with each other, iv) a condensed ring in which two or more second rings are condensed with each other, or v) a condensed ring in which one or more first rings and one or more second rings are condensed with each other,
the first ring is a cyclopentane group, a cyclopentadiene group, a furan group, a thiophene group, a pyrrole group, a silole group, a germole group, a borole group, a phosphole group, an oxazole group, an oxadiazole group, an oxatriazole group, a thiazole group, a thiadiazole group, a thiatriazole group, a pyrazole group, an imidazole group, a triazole group, a tetrazole group, an azasilole group, an azagermole group, an azaborole group, or an azaphosphole group, and
the second ring is an adamantane group, a norbornane group, a norbornene group, a bicyclo[1.1.1]pentane group, a bicyclo[2.1.1]hexane group, a bicyclo[2.2.2]octane group, a cyclohexane group, a cyclohexene group, a benzene group, a pyridine group, a pyrimidine group, a pyrazine group, a pyridazine group, or a triazine group.

8. The organometallic compound of any of claims 5-7, wherein
in Formulae 3-1 and 3-2, Y₁ and Y₃ are each N, and ring CY₁ and ring CY₃ are each independently a group represented by one of Formulae CYN-1 to CYN-52, and
in Formulae 3-1 and 3-2, Y₂ and Y₄ are each C, and ring CY₂ and ring CY₄ are each independently a group represented by one of Formulae CYC-1 to CYC-65: 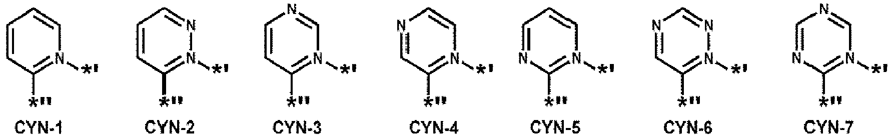 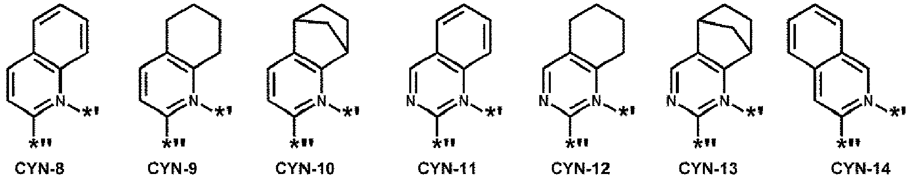 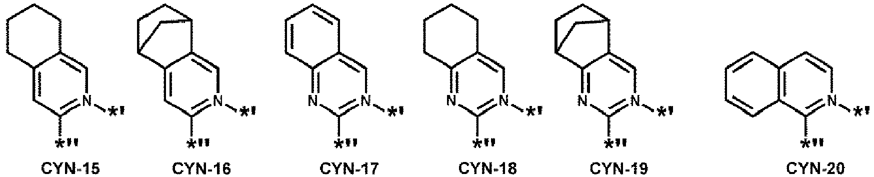 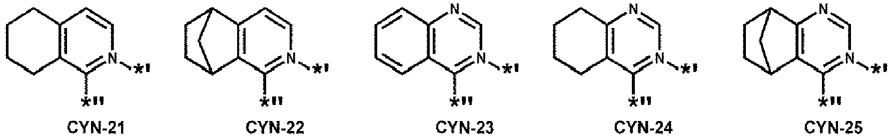 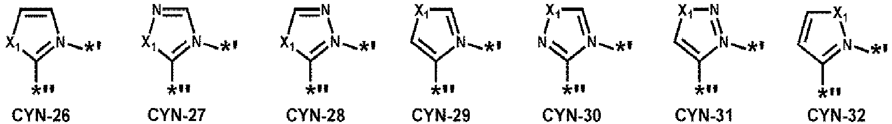 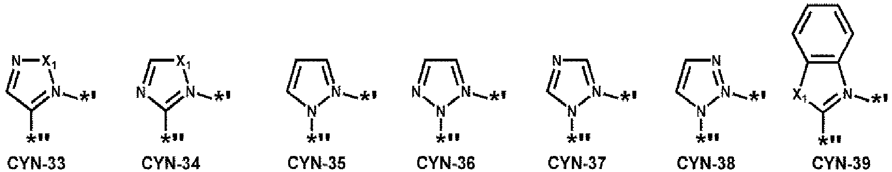 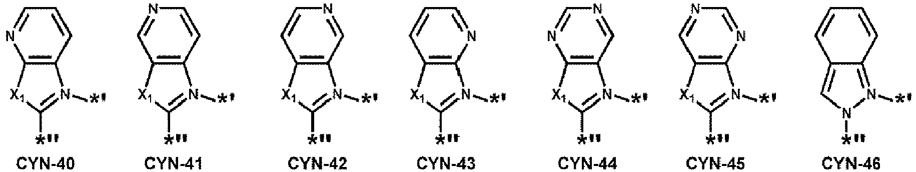 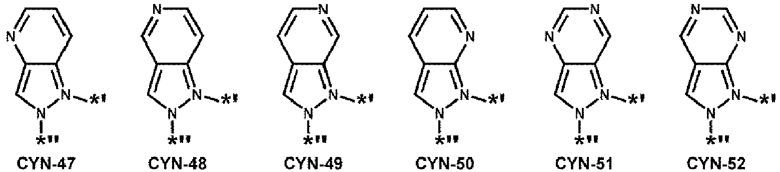 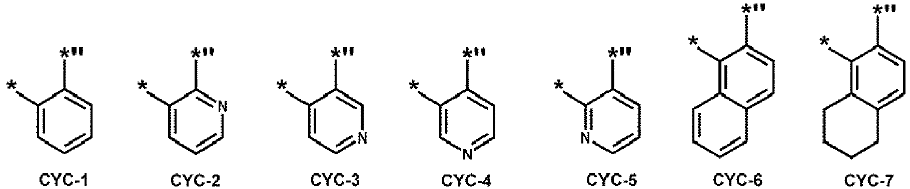 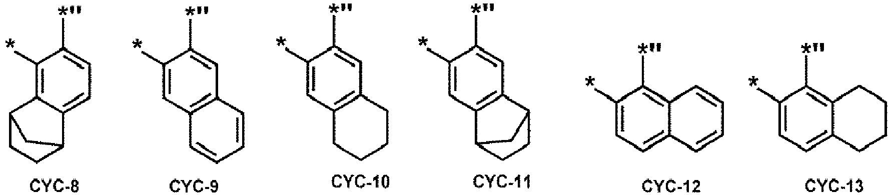 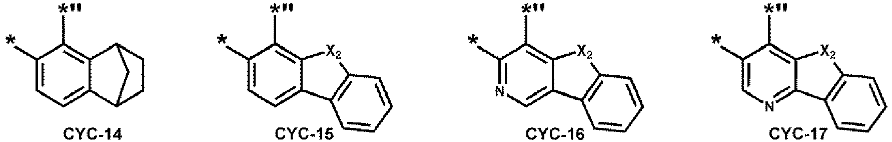 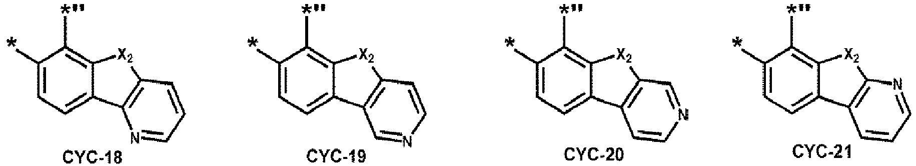 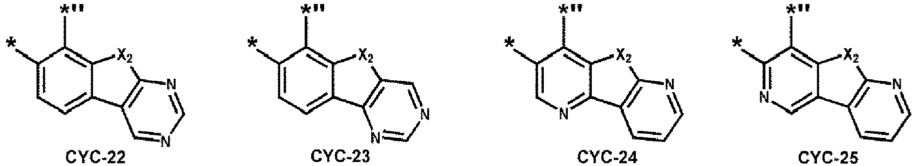 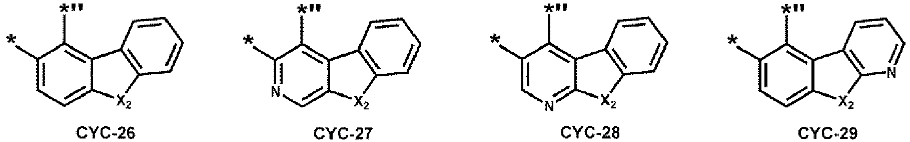 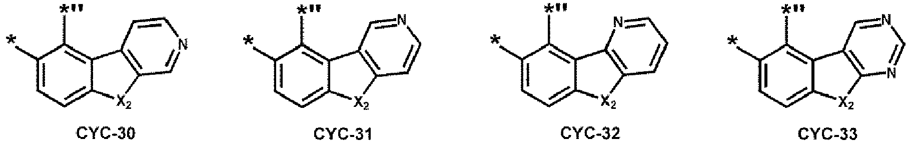 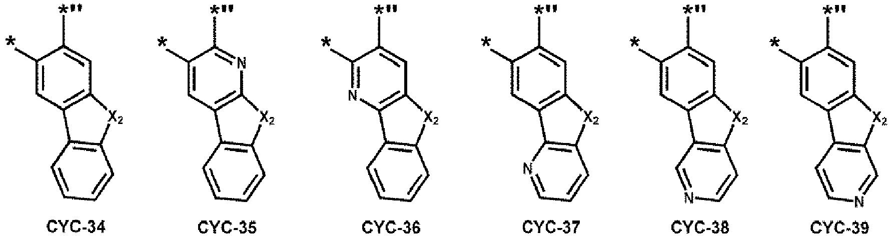 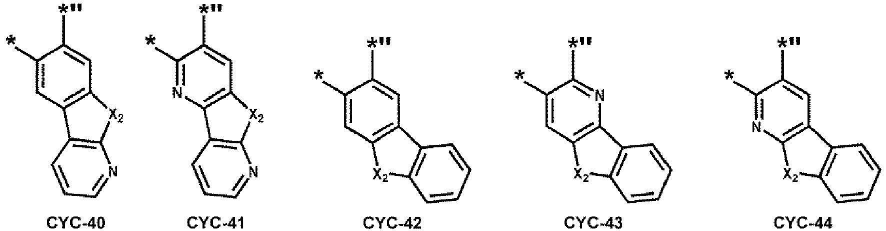 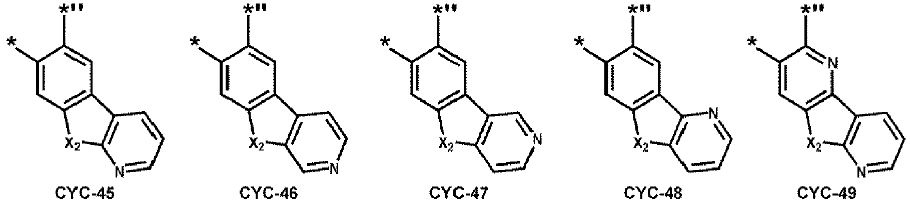 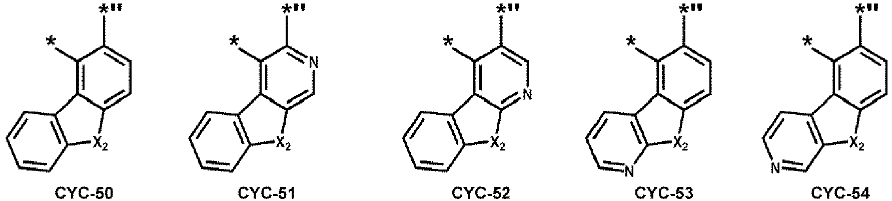 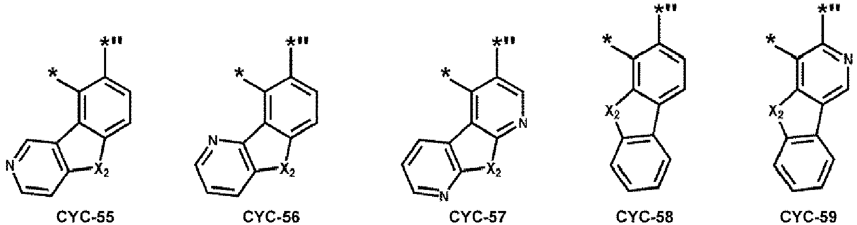 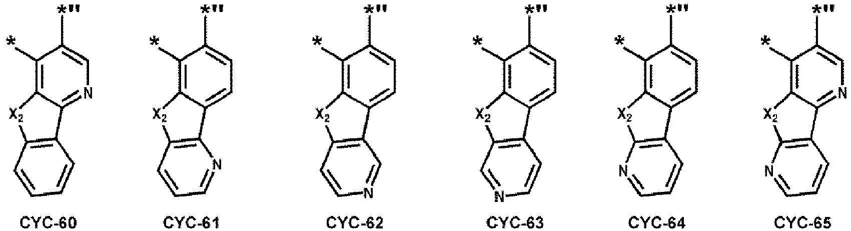 wherein, in Formulae CYN-1 to CYN-52, X₁ is O, S, N(R₁₉), C(R₁₉)(R₂₀), or Si(R₁₉)(R₂₀), *' indicates a binding site to M₁ in Formula 1 or M₂ in Formula 2, and *" indicates a binding site to T₁ or T₃ in Formulae 3-1 and 3-2, and
in Formulae CYC-1 to CYC-65, X₂ is O, S, N(R₁₉), C(R₁₉)(R₂₀), or Si(R₁₉)(R₂₀),
R₁₉ and R₂₀ are the same as described in connection with R₇ in claim 5,
* indicates a binding site to M₁ in Formula 1 or M₂ in Formula 2, and *" indicates a binding site to T₁ or T₃ in Formulae 3-1 and 3-2.

9. The organometallic compound of any of claims 5-8, wherein
ring CY₁ is a pyridine group or a pyrimidine group,
ring CY₂ is a benzene group, a dibenzofuran group, a dibenzothiophene group, a carbazole group, a fluorene group, or a dibenzosilole group,
ring CY₃ is a benzimidazole group, a pyridoimidazole group, a pyridine group, or a pyrimidine group, and
ring CY₄ is a dibenzofuran group, a dibenzothiophene group, a carbazole group, a fluorene group, a dibenzosilole group, an azadibenzofuran group, an azadibenzothiophene group, an azacarbazole group, an azafluorene group, or an azadibenzosilole group.

10. The organometallic compound of any of claims 5-9, wherein
the organometallic compound is represented by Formula 1, and Formula 1 comprises a group represented by -Si(Q₃)(Q₄)(Q₅), a group represented by - Ge(Q₃)(Q₄)(Q₅), or any combination thereof; and/or
wherein
a group represented by 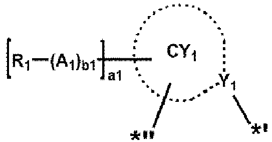 in Formula 3-1 is a group represented by one of Formulae CY1-1 to CY1-4: 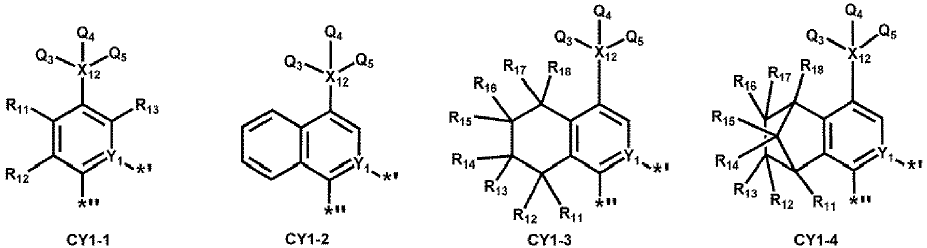 wherein, in Formulae CY1-1 to CY1-4,
Y₁ is N,
X₁₂ is Si or Ge,
R₁₁ to R₁₈ are each the same as described in connection with R₁ in claim 5,
Q₃ to Q₅ are each the same as described in claim 5,
*' indicates a binding site to M₁ in Formula 1 or M₂ in Formula 2, and
*" indicates a binding site to T₁ in Formula 3-1.

11. An organic light-emitting device comprising:
a first electrode;
a second electrode facing the first electrode; and
an organic layer comprising an emission layer and the at least one organometallic compound of any of claims 1-10, wherein the organic layer is between the first electrode and the second electrode.

12. The organic light-emitting device of claim 11, wherein
the emission layer comprises the at least one organometallic compound, and emits green light.

13. The organic light-emitting device of claim 12, wherein
the emission layer further comprises a host, and an amount of the host is greater than that of the at least one organometallic compound.

14. The organic light-emitting device of claim 13, wherein
an amount of the at least one organometallic compound is 4.60 mol% or less per 100 mol% of the emission layer, preferably from 1.00 mol% to 4.25 mol% per 100 mol% of the emission layer, preferably from 1.44 mol% to 4.25 mol% per 100 mol% of the emission layer.

15. An electronic apparatus comprising the organic light-emitting device of claims 13 or 14.
